# EUROPEAN PATENT SPECIFICATION

(11) **EP 3 540 803 B1**
(45) Date of publication and mention of the grant of the patent: **26.01.2022**
(21) Application number: 18202929.8
(22) Date of filing: 26.10.2018
(51) Int. Cl.: H01L 51/54, C07D 491/00, C07C 13/00, C07C 15/00

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 13.03.2018 KR 20180029286
(43) Date of publication of application: 18.09.2019
(73) Proprietor: Samsung Display Co., Ltd., Gyeonggi-Do (KR)
(72) Inventor: KIM, Youngkook, Gyeonggi-do (KR); KIM, Jongwoo, Gyeonggi-do (KR); BAEK, Jangyeol, Gyeonggi-do (KR); JEONG, Eunjae, Gyeonggi-do (KR); HAN, Sanghyun, Gyeonggi-do (KR); HWANG, Seokhwan, Gyeonggi-do (KR)
(74) Representative: Mounteney, Simon James

(56) References cited:
- US-A1- 2017 062 728
- US-A1- 2017 365 788

## Description

### BACKGROUND

### FIELD

Embodiments of the invention relate generally to an organic light-emitting device, and more particularly, to the hole transport region of the organic light-emitting device.

### Discussion of the Background

Organic light-emitting devices are self-emission devices that produce full-color images. Organic light-emitting devices also have wide viewing angles, high contrast ratios, short response times, as well as excellent characteristics in terms of brightness, driving voltage, and response speed.

An example of such organic light-emitting devices may include a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state, thereby generating light.

The above information disclosed in this Background section is only for understanding of the background of the inventive concepts, and, therefore, it may contain information that does not constitute prior art.

US 2017/0062728 A1 relates to compounds for organic electric elements and organic electric elements comprising the same.

US 2017/0365788 A1 relates to an amine compound and an organic light emitting element comprising the same.

### SUMMARY

Applicant discovered that hole transport regions of organic light-emitting devices having two or more different compounds constructed according to the present claims provide the organic light emitting devices with remarkable low driving voltage, high efficiency, and especially long lifespan when compared with organic light emitting devices having hole transport regions containing other compounds. In particular, organic light-emitting devices having hole transport regions constructed from two or more different compounds according to the claims show an unexpectedly high increase in lifespan.

For example, organic light-emitting devices having at least two layers in the hole transport region constructed according to the principles and embodiments of the invention facilitate the adjustment of balance between holes and electrons, improving both efficiency and lifespan of the organic light-emitting device at the same time.

Additional features of the inventive concepts will be set forth in the description which follows, and in part will be apparent from the description, or may be learned by practice of the inventive concepts.

According to one or more embodiments of the invention, an organic light-emitting device includes a first electrode; a second electrode; and an organic layer disposed between the first electrode and the second electrode and including an emission layer and a hole transport region according to the claims.

The hole transport region is disposed between the first electrode and the emission layer and includes a first layer and a second layer. The first layer includes at least one compound of compounds represented by Formula 1. The second layer includes at least one compound of compounds represented by Formulae 2 to 6. The first layer and the second layer include different compounds from each other:

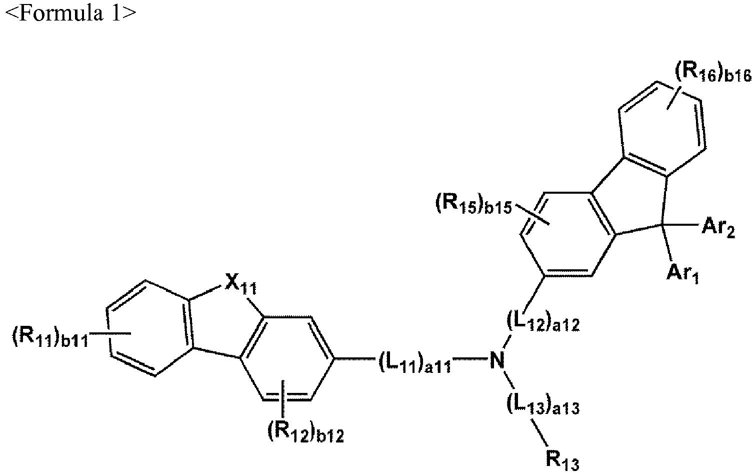

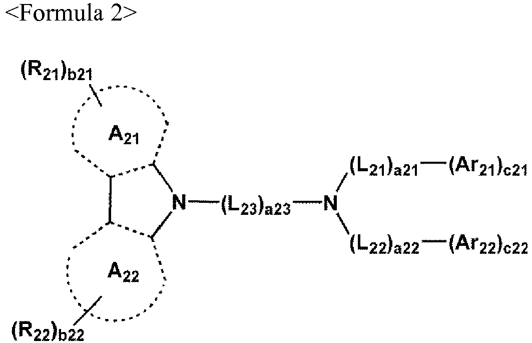

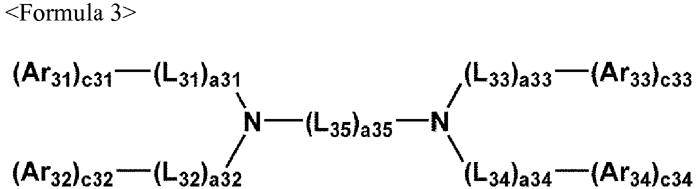

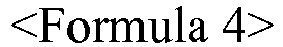

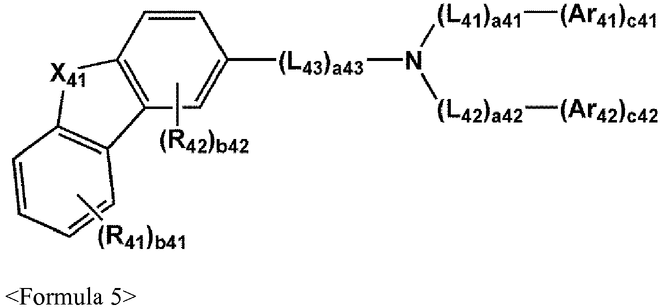

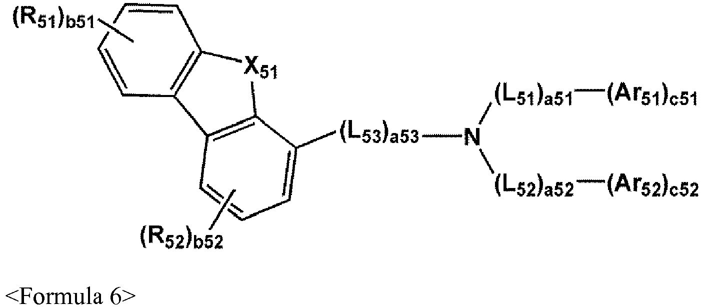

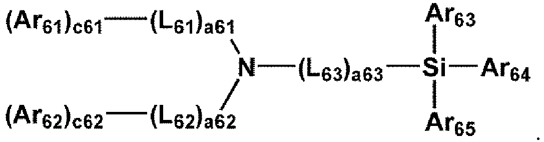

In Formulae 1 to 6,
X₁₁ is N-(L₁₄)ₐ₁₄-(R₁₄)_{b14}, O, or S,
X₄₁ is N-(L₄₄)ₐ₄₄-(R₄₃)_{b43}, O, or S,
X₅₁ is N-(L₅₄)ₐ₅₄-(R₅₃)_{b53}, O, or S,
A₂₁ and A₂₂ are each independently a C₄-C₂₀ carbocyclic group or a C₂-C₂₀ heterocyclic group,
L₁₁ to L₁₄, L₂₁ to L₂₃, L₃₁ to L₃₅, L₄₁ to L₄₄, L₅₁ to L₅₄, and L₆₁ to L₆₃ are each independently a single bond, a substituted or unsubstituted C₃-C₆₀ carbocyclic group, or a substituted or unsubstituted C₁-C₆₀ heterocyclic group,
a11 to a14, a21 to a23, a31 to a35, a41 to a44, a51 to a54, and a61 to a63 are each independently 1, 2, 3, 4, or 5,
when a11 to a14 are each independently two or more, two or more L₁₁(S) are identical to or different from each other, two or more L₁₂(s) are identical to or different from each other, two or more L₁₃(s) are identical to or different from each other, and two or more L₁₄(s) are identical to or different from each other,
when a21 to a23 are each independently two or more, two or more L₂₁(s) are identical to or different from each other, two or more L₂₂(s) are identical to or different from each other, and two or more L₂₃(s) are identical to or different from each other,
when a31 to a35 are each independently two or more, two or more L₃₁(s) are identical to or different from each other, two or more L₃₂(s) are identical to or different from each other, two or more L₃₃(s) are identical to or different from each other, two or more L₃₄(s) are identical to or different from each other, and two or more L₃₅(s) are identical to or different from each other,
when a41 to a44 are each independently two or more, two or more L₄₁(s) are identical to or different from each other, two or more L₄₂(s) are identical to or different from each other, two or more L₄₃(s) are identical to or different from each other, and two or more L₄₄(s) are identical to or different from each other,
when a51 to a54 are each independently two or more, two or more L₅₁(s) are identical to or different from each other, two or more L₅₂(s) are identical to or different from each other, two or more L₅₃(s) are identical to or different from each other, and two or more L₅₄(s) are identical to or different from each other,
when a61 to a63 are each independently two or more, two or more L₆₁(s) are identical to or different from each other, two or more L₆₂(s) are identical to or different from each other, and two or more L₆₃(s) are identical to or different from each other,
R₁₁ to R₁₆, R₂₁, R₂₂, R₄₁ to R₄₃, and R₅₁ to R₅₃ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group; a C₁-C₂₀ alkyl group and a C₁-C₂₀ alkoxy group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group; and groups represented by Formulae 8-1 to 8-12 as defined in the claims, , and two neighboring groups selected from R₁₁ to R₁₆, R₂₁, R₂₂, R₄₁ to R₄₃, and R₅₁ to R₅₃ are optionally linked to form a condensed ring,
b11, b12, b14 to b16, b21, b22, b41 to b43, and b51 to b53 are each independently 1, 2, 3, 4, 5, or 6,
when b11, b12 and b14 to b16 are each independently two or more, two or more R₁₁(s) are identical to or different from each other, two or more R₁₂(s) are identical to or different from each other, two or more R₁₄(s) are identical to or different from each other, two or more R₁₅(s) are identical to or different from each other, and two or more R₁₆(s) are identical to or different from each other,
when b21 and b22 are each independently two or more, two or more R₂₁(s) are identical to or different from each other, and two or more R₂₂(s) are identical to or different from each other,
when b41 to b43 are each independently two or more, two or more R₄₁(s) are identical to or different from each other, two or more R₄₂(s) are identical to or different from each other, and two or more R₄₃(s) are identical to or different from each other,
when b51 to b53 are each independently two or more, two or more R₅₁(s) are identical to or different from each other, two or more R₅₂(s) are identical to or different from each other, and two or more R₅₃(s) are identical to or different from each other,
Ar₁, Ar₂, Ar₂₁, Ar₂₂, Ar₃₁ to Ar₃₄, Ar_{41,} Ar₄₂, Ar_{51,} Ar₅₂, and Ar₆₁ to Ar₆₅ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and Ar₁ and Ar₂ are optionally linked via a single bond,
c21, c22, c31 to c34, c41, c42, c51, c52, c61, and c62 are each independently 1, 2, 3, 4, or 5,
when c21 and c22 are each independently two or more, two or more Ar₂₁(s) are identical to or different from each other, and two or more Ar₂₂(s) are identical to or different from each other,
when c31 to c34 are each independently two or more, two or more Ar₃₁(s) are identical to or different from each other, two or more Ar₃₂(s) are identical to or different from each other, two or more Ar₃₃(s) are identical to or different from each other, and two or more Ar₃₄(s) are identical to or different from each other,
when c41 and c42 are each independently two or more, two or more Ar₄₁(s) are identical to or different from each other, and two or more Ar₄₂(s) are identical to or different from each other,
when c51 and c52 are each independently two or more, two or more Ar₅₁(s) are identical to or different from each other, and two or more Ar₅₂(s) are identical to or different from each other,
when c61 and c62 are each independently two or more, two or more Ar₆₁(s) are identical to or different from each other, and two or more Ar₆₂(s) are identical to or different from each other,
at least one substituent of the substituted C₃-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one substituent selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one substituent selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

According to one or more embodiments of the invention, an organic light-emitting device according to the claims includes a substrate divided into a first sub-pixel region, a second sub-pixel region, and a third sub-pixel region; a plurality of first electrodes disposed in the first sub-pixel region, the second sub-pixel region, and the third sub-pixel region of the substrate, respectively; a second electrode facing the plurality of first electrodes; and an organic layer disposed between the plurality of first electrodes and the second electrode and including an emission layer and a hole transport region. The hole transport region is disposed between the plurality of first electrodes and the emission layer and includes a first layer and a second layer. The first layer includes at least one compound of compounds represented by Formula 1. The second layer includes at least one compound of compounds represented by Formulae 2 to 6. The first layer and the second layer include different compounds from each other.
<Formula 2>

It is to be understood that both the foregoing general description and the following detailed description are explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.
FIG. 1 is a schematic cross-sectional view of an organic light-emitting device according to an embodiment.
FIG. 2 is a schematic cross-sectional view of a full-color organic light-emitting device according to an embodiment.

### DETAILED DESCRIPTION

In the following description, for the purposes of explanation, numerous specific details are set forth in order to provide a thorough understanding of various embodiments or implementations of the invention. As used herein "embodiments" are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the claims.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. For the purposes of this disclosure, "at least one of X, Y, and Z," "at least one element selected from X, Y, and Z," "at least one selected from X, Y, and Z," and "at least one selected from the group consisting of X, Y, and Z" may be construed as X only, Y only, Z only, or any combination of two or more of X, Y, and Z, such as, for instance, XYZ, XYY, YZ, and ZZ. In addition, "A and B are each independently selected from X, Y, and Z" may be construed as A is equal to X only, A is equal to Y only, or A is equal to Z only and B is equal to X only, B is equal to Y only, or B is equal to Z only. Similarly, "A and B are each independently X or Y" may be construed as A is equal to X only or A is equal to Y only and B is equal to X only or B is equal to Y only. Also similarly, "A is X, Y, or Z" may be construed as A is X only, A is Y only, or A is Z only. Moreover, "A is selected from X, Y, and Z" may be construed as A is X only, A is Y only, or A is Z only. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

The expression "(an organic layer) includes an amine-based compound" used herein may include a case in which "(an organic layer) includes identical amine-based compounds represented by Formula 1" and a case in which "(an organic layer) includes two or more different amine-based compounds represented by Formula 1."

The term "organic layer" as used herein refers to a single layer and/or a plurality of layers between the first electrode and the second electrode of an organic light-emitting device. A material included in the "organic layer" is not limited to an organic material.

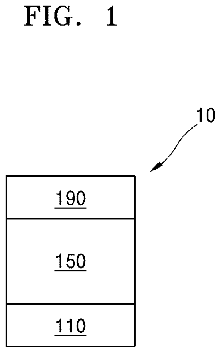

FIG. 1 is a schematic view of an organic light-emitting device 10 according to an embodiment. The organic light-emitting device 10 includes a first electrode 110, an organic layer 150, and a second electrode 190.

Hereinafter, the structure of an organic light-emitting device according to an embodiment and a method of manufacturing an organic light-emitting device according to an embodiment will be described in connection with FIG. 1.

In FIG. 1, a substrate may be additionally disposed under the first electrode 110 or above the second electrode 190. The substrate may be a glass substrate or a transparent plastic substrate. The substrate may have excellent mechanical strength, thermal stability, transparency, surface smoothness, ease of handling, and water resistance.

The first electrode 110 may be formed by depositing or sputtering a material for forming the first electrode 110 on the substrate. When the first electrode 110 is an anode, the material for forming the first electrode 110 may be selected from materials with a high work function to facilitate hole injection. The first electrode 110 may be a reflective electrode, a semi-transmissive electrode, or a transmissive electrode. The material for forming a first electrode may be a transparent and highly conductive material, and examples of such a material are indium tin oxide (ITO), indium zinc oxide (IZO), tin oxide (SnO₂), and zinc oxide (ZnO). When the first electrode 110 is a semi-transmissive electrode or a reflective electrode, as a material for forming the first electrode 110 , at least one selected from magnesium (Mg), aluminium (Al), aluminium-lithium (Al-Li), calcium (Ca), magnesium-indium (Mg-In), and magnesium-silver (Mg-Ag) may be used.

The first electrode 110 may have a single-layered structure, or a multi-layered structure including two or more layers. For example, the first electrode 110 may have a threelayered structure of ITO/Ag/ITO, but the structure of the first electrode 110 is not limited thereto.

The organic layer 150 is disposed on the first electrode 110. The organic layer 150 may include an emission layer (not shown).

The organic layer 150 may further include a hole transport region (not shown) disposed between the first electrode and the emission layer. The organic layer 150 may further include an electron transport region (not shown) disposed between the emission layer and the second electrode.

The hole transport region has a multi-layered structure having a plurality of layers including a plurality of different materials.

The hole transport region includes layer selected from a hole injection layer, a hole transport layer, an emission auxiliary layer, and an electron blocking layer.

For example, the hole transport region may have a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode 110 in this stated order, but the structure of the hole transport region is not limited thereto.

When the hole transport region includes a hole injection layer, the hole injection layer may be formed on the first electrode 110 by using one or more suitable methods selected from vacuum deposition, spin coating, casting, Langmuir-Blodgett (LB) deposition, ink-jet printing, laser-printing, and laser-induced thermal imaging.

When the hole injection layer is formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec by taking into account a material to be included in a layer to be formed, and the structure of a layer to be formed.

When a hole injection layer is formed by spin coating, the spin coating may be performed at a coating rate of about 2,000 rpm to about 5,000 rpm, and at a temperature of about 80 °C to about 200 °C by taking into account the compound for the hole injection layer to be deposited, and the structure of the hole injection layer to be formed.

When the hole transport region includes a hole transport layer, the hole transport layer may be formed on the first electrode 110 or the hole injection layer by using one or more suitable methods selected from vacuum deposition, spin coating, casting, a LB method, ink-jet printing, laser-printing, and laser-induced thermal imaging. When the hole transport layer is formed by vacuum deposition or spin coating, deposition and coating conditions for the hole transport layer may be determined by referring to the deposition and coating conditions for the hole injection layer.

The hole transport region includes at least one compound selected from compounds represented by Formulae 1, and one compound selected from compounds represented by Formulae 2 to 6.

The hole transport region includes a first layer and a second layer.

The hole transport region includes at least one compound of the compounds represented by Formula 1 and at least one compound of the compounds represented by Formulae 2 to 6. The hole transport region includes a first compound represented by Formula 1 and a second compound represented by one selected from Formulae 2 to 6.

For example, the hole transport region includes a first layer and a second layer, wherein the first layer may include the first compound represented by Formula 1, and the second layer includes the second compound represented by one compound selected from Formulae 2 to 6.

The first layer is disposed between the second layer and the first electrode, and the second layer is directly contact the emission layer:

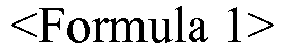

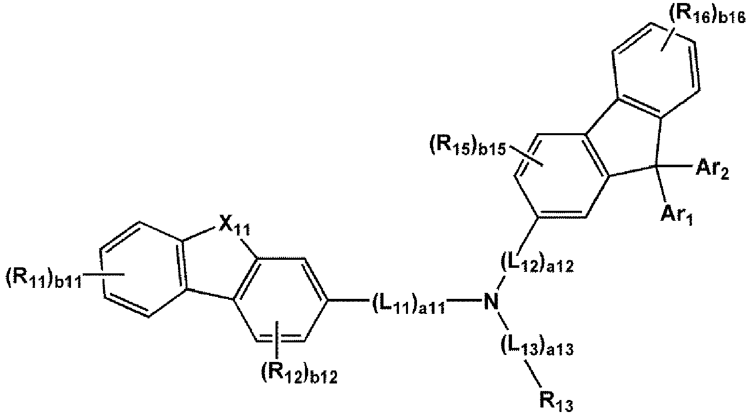

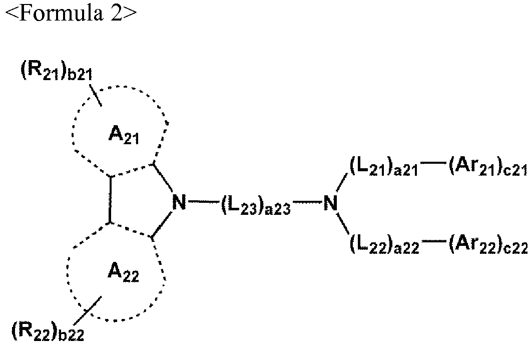

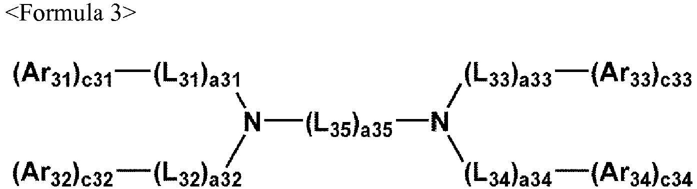

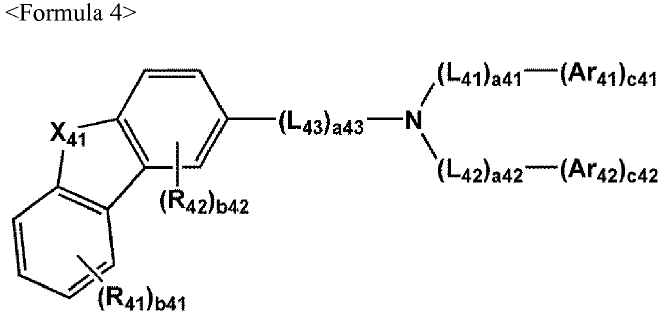

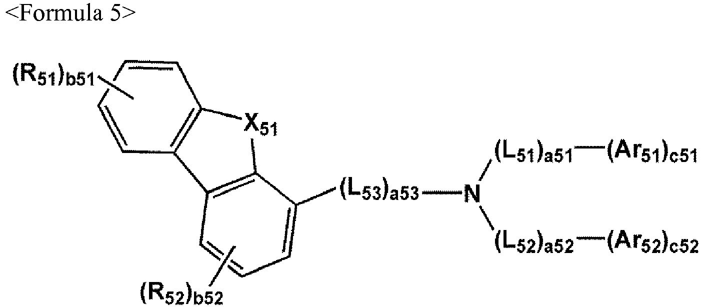

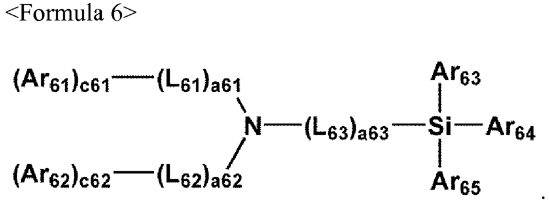

Formulae 1 to 6 are respectively the same as defined above.

In Formula 1, X₁₁ is N-(L₁₄)ₐ₁₄-(R₁₄)_{b14}, O, or S.

In an embodiment, X₁₁ may be N-(L₁₄)ₐ₁₄-(R₁₄)_{b14}, but embodiments of the invention are not limited thereto.

In Formula 4, X₄₁ is N-(L₄₄)ₐ₄₄-(R₄₃)_{b43}, O, or S.

In an embodiment, X₄₁ may be N-(L₄₄)_{A44}-(R₄₃)_{B43}, but embodiments of the invention are not limited thereto.

In Formula 5, X₅₁ is N-(L₅₄)ₐ₅₄-(R₅₃)_{b53}, O, or S.

In one embodiment, X₅₁ may be O or S, but embodiments of the invention are not limited thereto.

In Formula 2, A₂₁ and A₂₂ are each independently a C₄-C₂₀ carbocyclic group or a C₂-C₂₀ heterocyclic group. For example, A₂₁ and A₂₂ may each independently be a C₅-C₂₀ carbocyclic group or a C₂-C₁₅ heterocyclic group. For example, A₂₁ and A₂₂ may each independently be a C₅-C₁₈ carbocyclic group or a C₂-C₁₂ heterocyclic group.

In an embodiment, in Formula 2, A₂₁ and A₂₂ may each independently be selected from a benzene group, a naphthalene group, an anthracene group, a phenanthrene group, a triphenylene group, a pyrene group, a chrysene group, a cyclopentadiene group, a thiophene group, a furan group, a pyrrole group, an indole group, an indene group, a benzosilole group, a benzothiophene group, a benzofuran group, a carbazole group, a fluorene group, a dibenzosilole group, a dibenzothiophene group, a dibenzofuran group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, and a benzoquinazoline group.

For example, in Formula 2, A₂₁ and A₂₂ may each independently be a benzene group or a naphthalene group, but embodiments of the invention are not limited thereto.

In Formulae 1 to 6, L₁₁ to L₁₄, L₂₁ to L₂₃, L₃₁ to L₃₅, L₄₁ to L₄₄, L₅₁ to L₅₄, and L₆₁ to L₆₃ are each independently a single bond, a substituted or unsubstituted C₃-C₆₀ carbocyclic group, or a substituted or unsubstituted C₁-C₆₀ heterocyclic group. For example, L₁₁ to L₁₄, L₂₁ to L₂₃, L₃₁ to L₃₅, L₄₁ to L₄₄, L₅₁ to L₅₄, and L₆₁ to L₆₃ may each independently be a single bond, a substituted or unsubstituted C₃-C₃₂ carbocyclic group, or a substituted or unsubstituted C₁-C₂₀ heterocyclic group.

In one or more embodiments, in Formulae 1 and 6,

L₁₁ to L₁₄, L₂₁ to L₂₃, L₃₁ to L₃₅, L₄₁ to L₄₄, L₅₁ to L₅₄, and L₆₁ to L₆₃ may each independently be selected from:
a single bond;
a benzene group, a naphthalene group, a pentalene group, an indene group, an azulene group, a heptalene group, an indacene group, an acenaphthene group, a fluorene group, a spiro-fluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an indole group, an isoindole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzimidazole group, a benzofuran group, a benzothiophene group, an isobenzothiazole group, a benzoxazole group, an isobenzoxazole group, a triazole group, a tetrazole group, an oxadiazole group, a triazine group, a dibenzofuran group, a dibenzothiophene group, a benzocarbazole group, and a dibenzocarbazole group; and
a benzene group, a naphthalene group, a pentalene group, an indene group, an azulene group, a heptalene group, an indacene group, an acenaphthene group, a fluorene group, a spiro-fluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an indole group, an isoindole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzimidazole group, a benzofuran group, a benzothiophene group, an isobenzothiazole group, a benzoxazole group, an isobenzoxazole group, a triazole group, a tetrazole group, an oxadiazole group, a triazine group, a dibenzofuran group, a dibenzothiophene group, a benzocarbazole group, and a dibenzocarbazole group, each substituted with at least one substituent selected from deuterium, -F, -Cl, -Br, -I, a hydroxyl group, a cyano group, a nitro group, an amidino group, a hydrazino group, a hydrazono group, a C₁-C₂₀alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group.

For example, in Formulae 1 to 6,

L₁₁ to L₁₄, L₂₁ to L₂₃, L₃₁ to L₃₅, L₄₁ to L₄₄, L₅₁ to L₅₄, and L₆₁ to L₆₃ may each independently be selected from a single bond and groups represented by Formulae 7-1 to 7-21, but embodiments of the invention are not limited thereto:

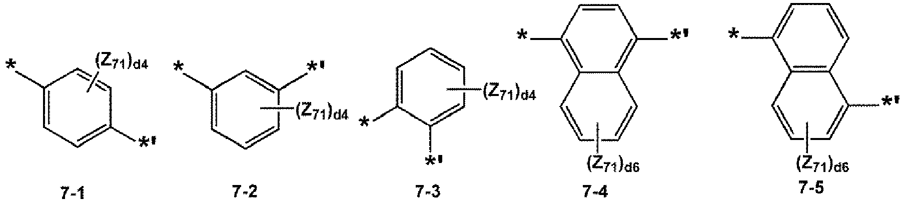

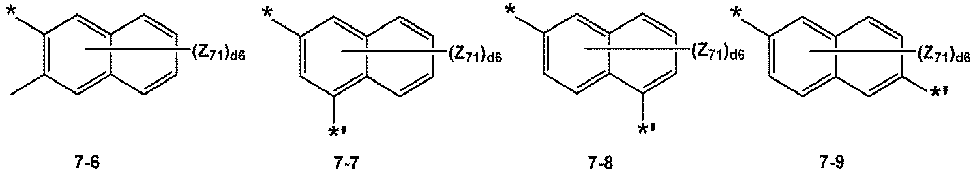

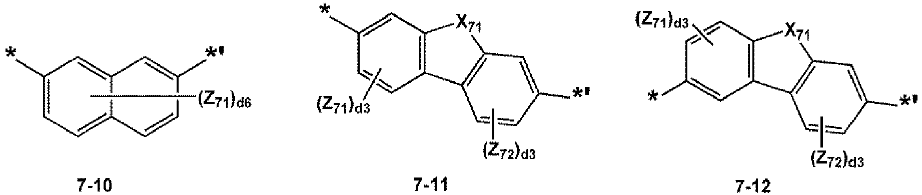

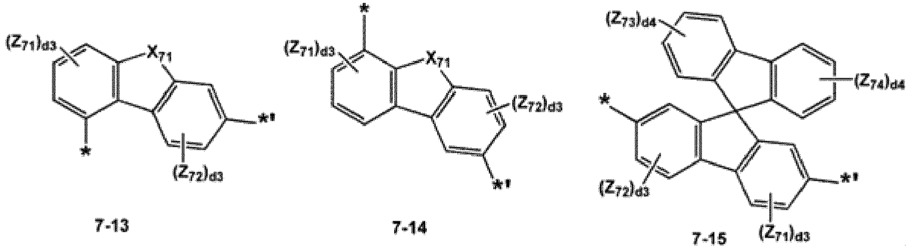

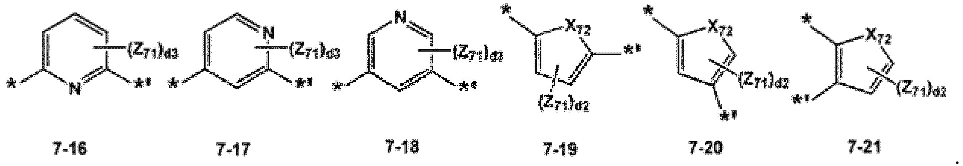

In Formulae 7-1 to 7-21, X₇₁ and X₇₂ are each independently selected from O, S, C(Z₇₅)(Z₇₆), N(Z₇₇), and Si(Z₇₈)(Z₇₉),
Z₇₁ to Z₇₉ are each independently selected from:
hydrogen, deuterium, -F, -Cl, -Br, -I, a hydroxyl group, a cyano group, a nitro group, an amidino group, a hydrazino group, a hydrazono group, a C₁-C₂₀alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group,
d2 is an integer of 0 to 2,
d3 is an integer of 0 to 3,
d4 is an integer of 0 to 4,
d6 is an integer of 0 to 6, and
^{∗} and ^{∗}' each indicate binding sites to a neighboring atom.

In Formulae 1 to 6, a11 to a14, a21 to a23, a31 to a35, a41 to a44, a51 to a54, and a61 to a63 are each independently 1, 2, 3, 4, or 5.

When a11 to a14 are each independently two or more, two or more L₁₁(s) are identical to or different from each other, two or more L₁₂(s) are identical to or different from each other, two or more L₁₃(s) are identical to or different from each other, and two or more L₁₄(s) are identical to or different from each other.

When a21 to a23 are each independently two or more, two or more L₂₁(s) are identical to or different from each other, two or more L₂₂(s) are identical to or different from each other, and two or more L₂₃(s) are identical to or different from each other.

When a31 to a35 are each independently two or more, two or more L₃₁(s) are identical to or different from each other, two or more L₃₂(s) are identical to or different from each other, two or more L₃₃(s) are identical to or different from each other, two or more L₃₄(s) are identical to or different from each other, and two or more L₃₅(s) are identical to or different from each other.

When a41 to a44 are each independently two or more, two or more L₄₁(s) are identical to or different from each other, two or more L₄₂(s) are identical to or different from each other, two or more L₄₃(s) are identical to or different from each other, and two or more L₄₄(s) are identical to or different from each other.

When a51 to a54 are each independently two or more, two or more L₅₁(s) are identical to or different from each other, two or more L₅₂(s) are identical to or different from each other, two or more L₅₃(s) are identical to or different from each other, and two or more L₅₄(s) are identical to or different from each other.

When a61 to a63 are each independently two or more, two or more L₆₁(s) are identical to or different from each other, two or more L₆₂(s) are identical to or different from each other, and two or more L₆₃(s) are identical to or different from each other.

In Formulae 1, 2, 4, and 5, R₁₁ to R₁₆, R₂₁, R₂₂, R₄₁ to R₄₃, and R₅₁ to R₅₃ are independently selected from:

hydrogen, deuterium, -F, -Cl, -Br, -I, a hydroxyl group, a cyano group, a nitro group, an amidino group, a hydrazino group, a hydrazono group, a C₁-C₂₀alkyl group, and a C₁-C₂₀ alkoxy group;

a C₁-C₂₀alkyl group and a C₁-C₂₀alkoxy group, each substituted with at least one substituent selected from deuterium, -F, -Cl, -Br, -I, a hydroxyl group, a cyano group, a nitro group, an amidino group, a hydrazino group, a hydrazono group, a C₁-C₂₀alkyl group, and a C₁-C₂₀ alkoxy group; and

groups represented by Formulae 8-1 to 8 -12:

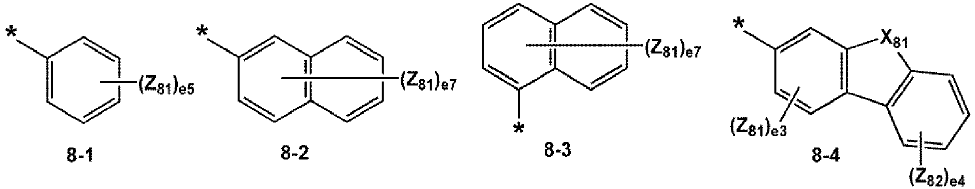

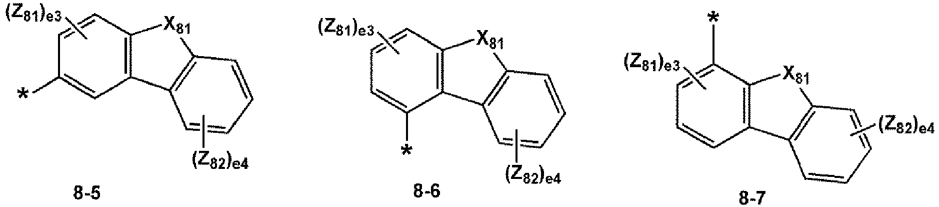

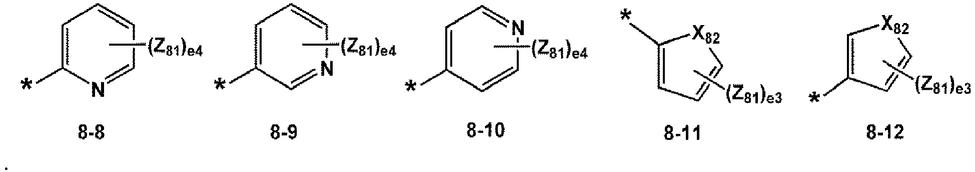

In Formulae 8-1 to 8-12,
X₈₁ and X₈₂ are each independently selected from O, S, C(Z₈₃)(Z₈₄), N(Z₈₅), and Si(Z₈₆)(Z₈₇),
Z₈₁ to Z₈₇ are each independently selected from:
   hydrogen, deuterium, -F, -Cl, -Br, -I, a hydroxyl group, a cyano group, a nitro group, an amidino group, a hydrazino group, a hydrazono group, a C₁-C₂₀alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group,
   e3 is an integer of 0 to 3,
   e4 is an integer of 0 to 4,
   e5 is an integer of 0 to 5,
   e7 is an integer of 0 to 7, and
   ^{∗} and ^{∗}' each indicate a binding sites to a neighboring atom.

In Formulae 1, 2, 4, and 5, b11, b12, b14 to b16, b21, b22, b41 to b43, and b51 to b53 are each independently 1, 2, 3, 4, 5, or 6.

When b11, b12 and b14 to b16 are each independently two or more, two or more R₁₁(s) are identical to or different from each other, two or more R₁₂(s) are identical to or different from each other, two or more R₁₄(s) are identical to or different from each other, two or more R₁₅(s) are identical to or different from each other, and two or more R₁₆(s) are identical to or different from each other.

When b21 and b22 are each independently two or more, two or more R₂₁(s) are identical to or different from each other, and two or more R₂₂(s) are identical to or different from each other.

When b41 to b43 are each independently two or more, two or more R₄₁(s) are identical to or different from each other, two or more R₄₂(s) are identical to or different from each other, and two or more R₄₃(s) are identical to or different from each other.

When b51 to b53 are each independently two or more, two or more R₅₁(s) are identical to or different from each other, two or more R₅₂(s) are identical to or different from each other, and two or more R₅₃(s) are identical to or different from each other.

In Formulae 1 to 6, Ar₁, Ar₂, Ar₂₁, Ar₂₂, Ar₃₁ to Ar₃₄, Ar_{41,} Ar₄₂, Ar₅₁, Ar₅₂, and Ar₆₁ to Ar₆₅ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ *(e.g.* C₆-C₃₂) aryl group, a substituted or unsubstituted C₆-C₆₀ *(e.g.* C₆-C₃₂) aryloxy group, a substituted or unsubstituted C₆-C₆₀ *(e.g.* C₆-C₃₂) arylthio group, a substituted or unsubstituted C₁-C₆₀ *(e.g.* C₁-C₂₀) heteroaryl group, a substituted or unsubstituted monovalent non-aromatic condensed polycyclic group, and a substituted or unsubstituted monovalent non-aromatic condensed heteropolycyclic group, wherein Ar₁ and Ar₂ are optionally linked each other via a single bond.

In an embodiment, in Formulae 1 to 6, Ar₁, Ar₂, Ar₂₁, Ar₂₂, Ar₃₁ to Ar₃₄, Ar_{41,} Ar₄₂, Ar_{51,} Ar₅₂, and Ar₆₁ to Ar₆₅ may each independently be selected from:
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, an imidazopyrimidinyl group, a thianthrenyl group, a phenoxathiinyl group, and a dibenzodioxinyl group; and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyrimidinyl group, a thianthrenyl group, a phenoxathiinyl group, and a dibenzodioxinyl group, each substituted with at least one substituent selected from deuterium, -F, -Cl, -Br, -I, a hydroxyl group, a cyano group, a nitro group, an amino group, an amidino group, a hydrazino group, a hydrazono group, a C₁-C₂₀alkyl group, a C₁-C₂₀alkoxy group, a phenyl group, a biphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, an imidazopyrimidinyl group, and -Si(Q₃₃)(Q₃₄)(Q₃₅), but embodiments of the invention are not limited thereto, and
Q₃₃ to Q₃₅ may each independently be selected from a C₁-C₆₀ *(e.g.* C₁-C₂₀) alkyl group and a C₆-C₆₀ *(e.g.* C₆-C₃₀) aryl group.

For example, in Formulae 1 to 6, Ar₁, Ar₂, Ar₂₁, Ar₂₂, Ar₃₁ to Ar₃₄, Ar_{41,} Ar₄₂, Ar_{51,} Ar₅₂, and Ar₆₁ to Ar₆₅ may each independently be selected from:
a phenyl group, a naphthyl group, a fluorenyl group, a spiro-fluorenyl group, a phenanthrenyl group, a carbazolyl group, a dibenzofuranyl group, a dibenzothiophenyl group, a pyridinyl group, a quinolinyl group, and an isoquinolinyl group; and
a phenyl group, a naphthyl group, a fluorenyl group, a spiro-fluorenyl group, a phenanthrenyl group, a carbazolyl group, a dibenzofuranyl group, a dibenzothiophenyl group, a pyridinyl group, a quinolinyl group, and an isoquinolinyl group, each substituted with at least one substituent selected from deuterium, -F, -Cl, -Br, -I, a cyano group, a C₁-C₂₀ alkyl group, a C₁-C₂₀alkoxy group, a phenyl group, a naphthyl group, a fluorenyl group, a spiro-fluorenyl group, a phenanthrenyl group, a carbazolyl group, a dibenzofuranyl group, a dibenzothiophenyl group, a pyridinyl group, a quinolinyl group, an isoquinolinyl group, and -Si(Q₃₃)(Q₃₄)(Q₃₅), but embodiments of the invention are not limited thereto, and
Q₃₃ to Q₃₅ may each independently be selected from a methyl group, an ethyl group, a propyl group, an isopropyl group, a butyl group, a tert-butyl group, a sec-butyl group, a phenyl group, a naphthyl group, a biphenyl group, and a terphenyl group.

In one or more embodiments, in Formulae 1 to 6, Ar₁, Ar₂, Ar₂₁, Ar₂₂, Ar₃₁ to Ar₃₄, Ar_{41,} Ar₄₂, Ar_{51,} Ar₅₂, and Ar₆₁ to Ar₆₅ may each independently be selected from groups represented by Formulae 9-1 to 9-22, but embodiments of the invention are not limited thereto:

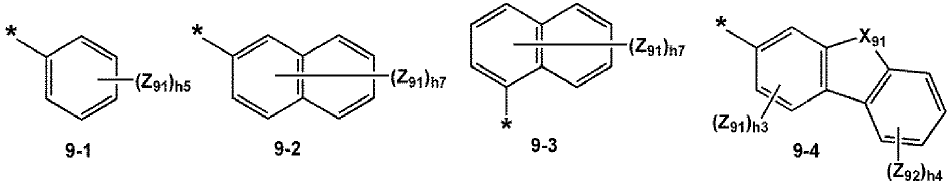

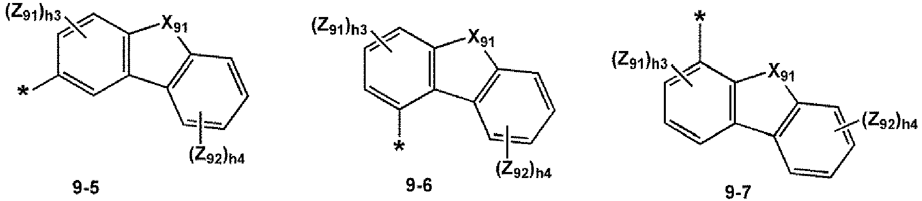

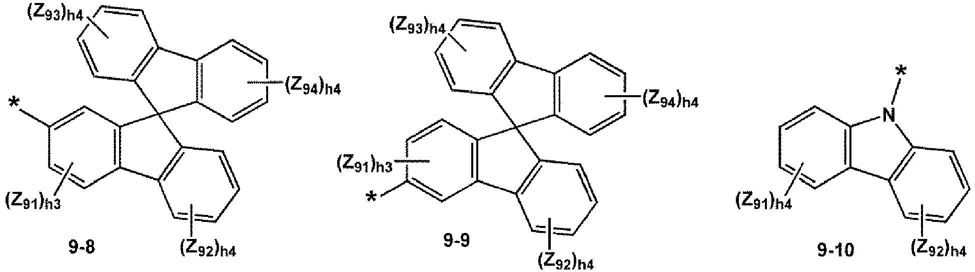

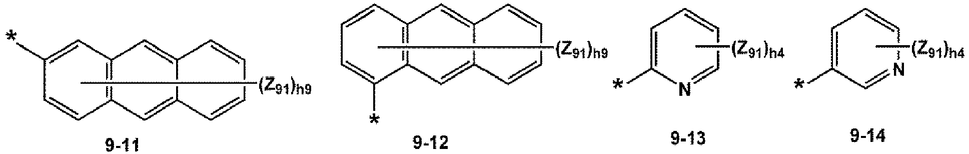

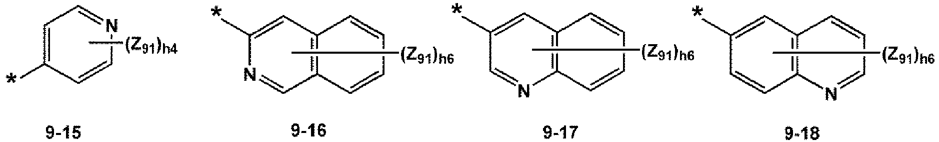

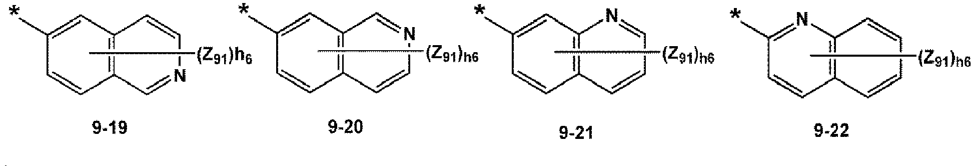

In Formulae 9-1 to 9-22,
X₉₁ is selected from O, S, C(Z₉₅)(Z₉₆), N(Z₉₇), and Si(Z₉₈)(Z₉₉),
Z₉₁ to Z₉₉ are each independently selected from:
   hydrogen, deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀alkoxy group, a phenyl group, a biphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, and an imidazopyrimidinyl group,
   h3 is an integer of 0 to 3,
   h4 is an integer of 0 to 4,
   h5 is an integer of 0 to 5,
   h6 is an integer of 0 to 6,
   h7 is an integer of 0 to 7,
   h9 is an integer of 0 to 9, and
   ^{∗} and ^{∗}' each indicate a binding site to a neighboring atom.

In Formulae 2 to 6, c21, c22, c31 to c34, c41, c42, c51, c52, c61, and c62 are each independently 1, 2, 3, 4, or 5.

When c21 and c22 are each independently two or more, two or more Ar₂₁(s) are identical to or different from each other, and two or more Ar₂₂(s) are identical to or different from each other.

When c31 to c34 are each independently two or more, two or more Ar₃₁(s) are identical to or different from each other, two or more Ar₃₂(s) are identical to or different from each other, two or more Ar₃₃(s) are identical to or different from each other, and two or more Ar₃₄(s) are identical to or different from each other.

When c41 and c42 are each independently two or more, two or more Ar₄₁(s) are identical to or different from each other, and two or more Ar₄₂(s) are identical to or different from each other.

When c51 and c52 are each independently two or more, two or more Ar₅₁(s) are identical to or different from each other, and two or more Ar₅₂(s) are identical to or different from each other.

When c61 and c62 are each independently two or more, two or more Ar₆₁(s) are identical to or different from each other, and two or more Ar₆₂(s) are identical to or different from each other.

In one or more embodiments, in Formula 1,
^{∗}-(L₁₁)ₐ₁₁-^{∗}' and ^{∗}-(L₁₂)ₐ₁₂-^{∗}' may each independently be a single bond,
^{∗}-(L₁₂)ₐ₁₂-^{∗}' may be a single bond, and
^{∗}-(L₁₂)ₐ₁₂-^{∗}' and ^{∗}-(L₁₃)ₐ₁₃-^{∗}' may each independently be a single bond.

In one or more embodiments, Formula 1 may be represented by Formula 1-1 or 1-2:

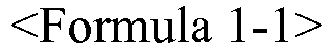

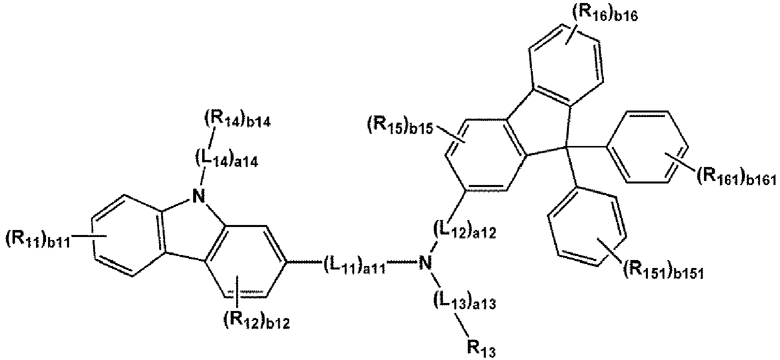

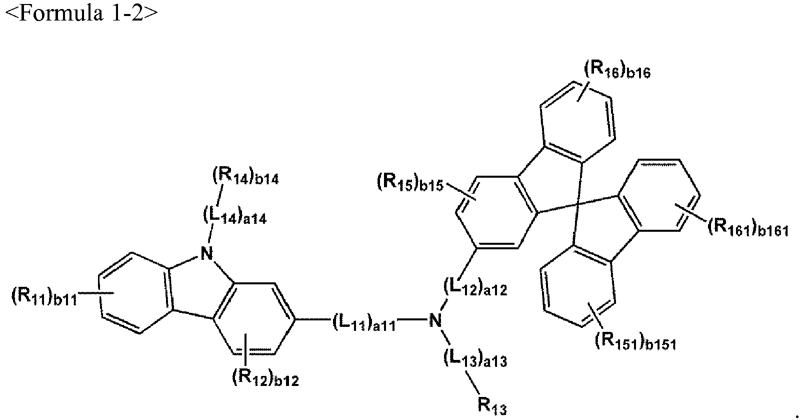

In Formulae 1-1 and 1-2,
L₁₁ to L₁₃, a11 to a13, R₁₁ to R₁₆, b11, b12, b14, b15, and b16 are respectively the same as defined above,
R₁₅₁ and R₁₆₁ are respectively the same as defined in connection with R₁₅ and R₁₆, and
b151 and b161 are respectively the same as defined in connection with b15 and b16.
The compound represented by Formula 1 may be selected from Compounds 1-1 to 1-63:

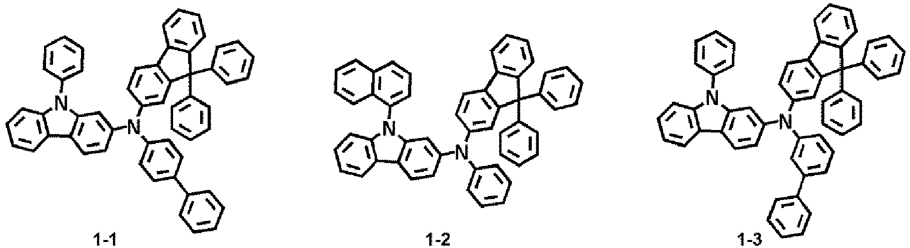

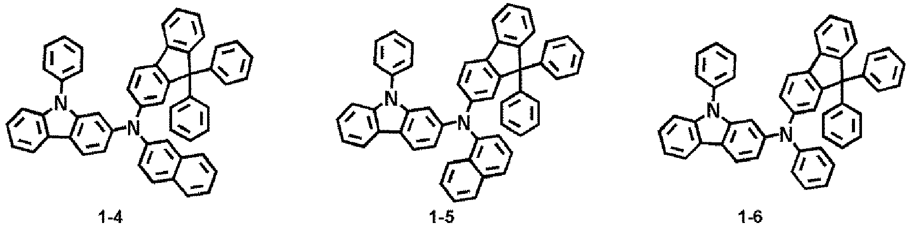

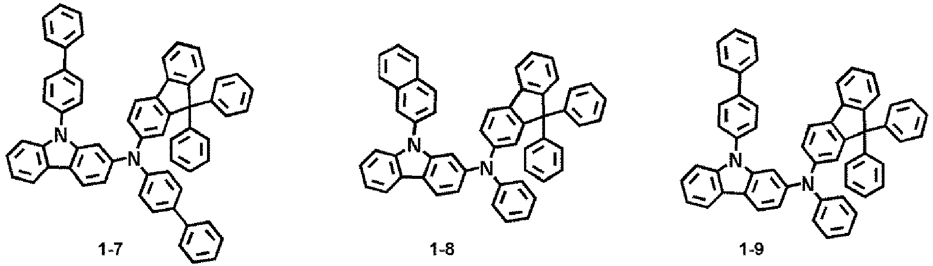

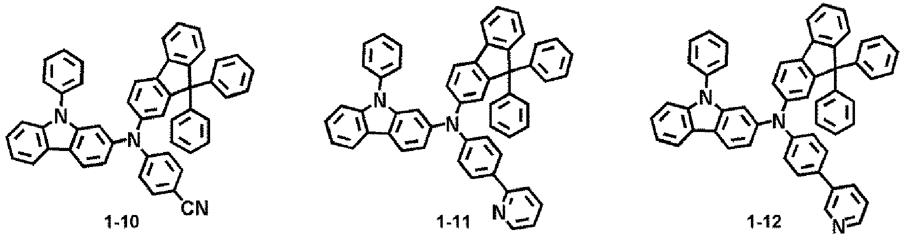

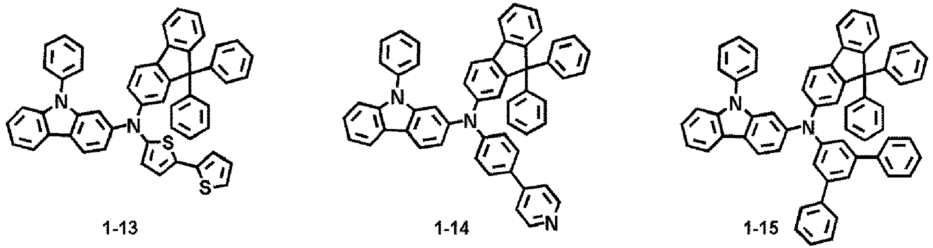

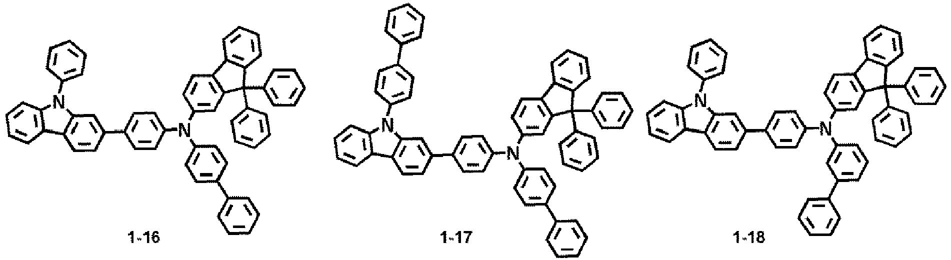

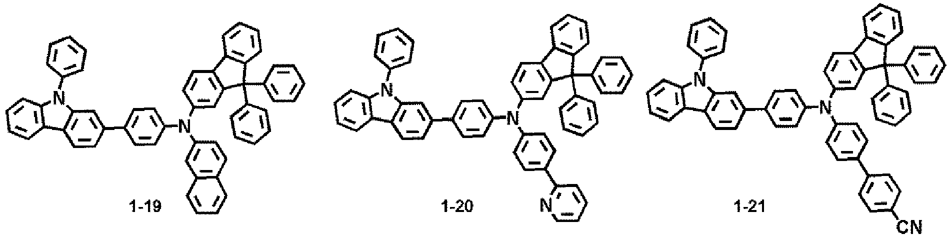

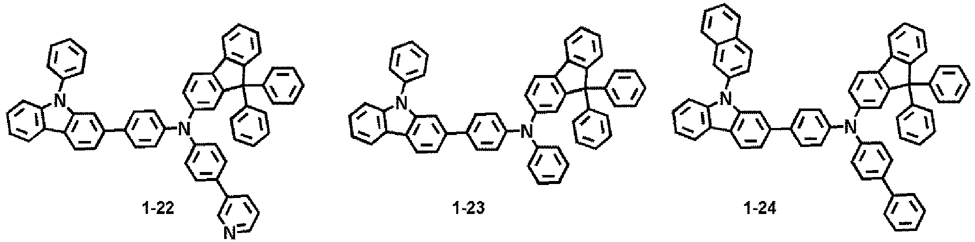

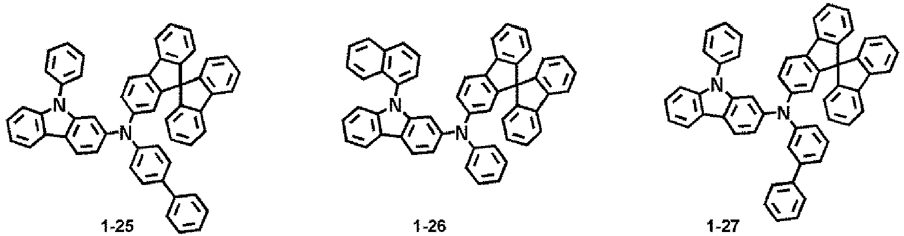

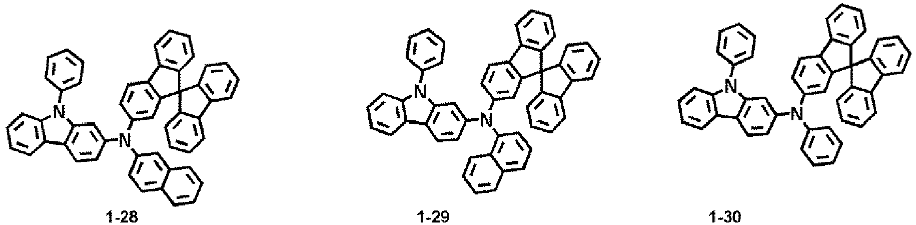

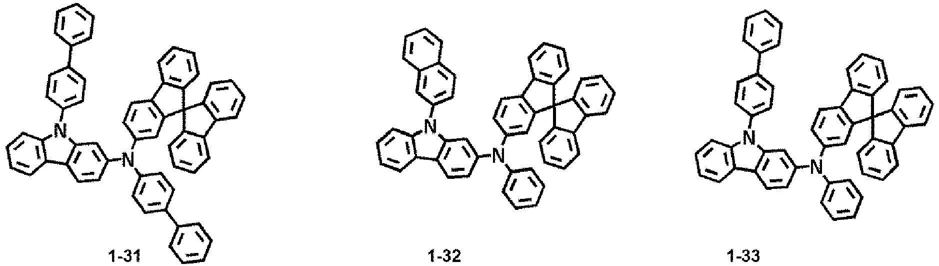

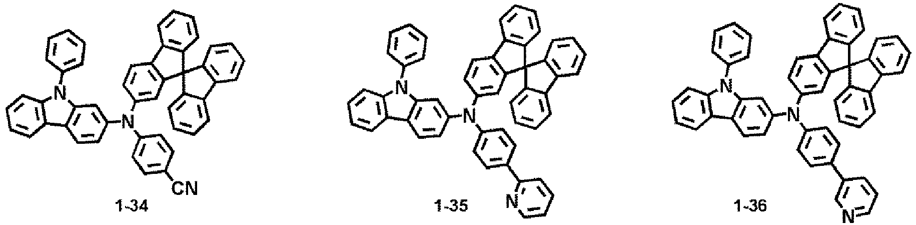

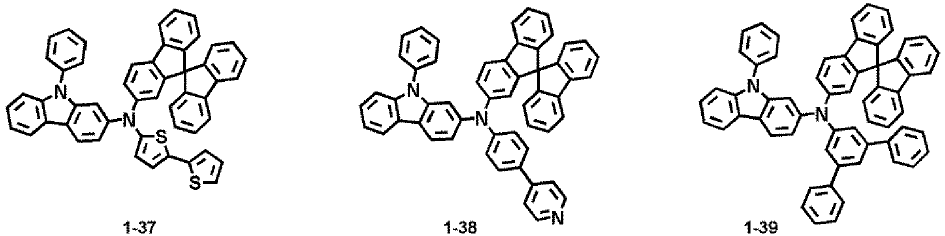

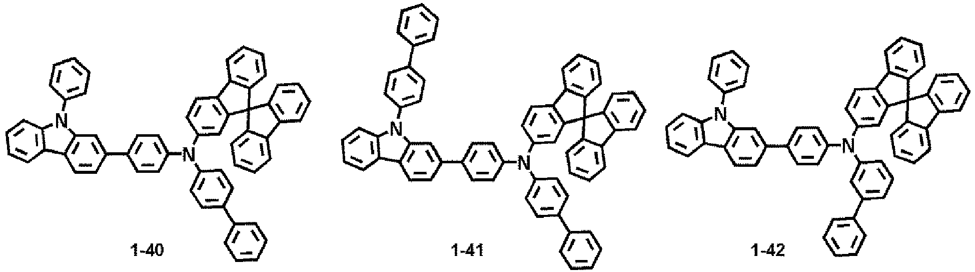

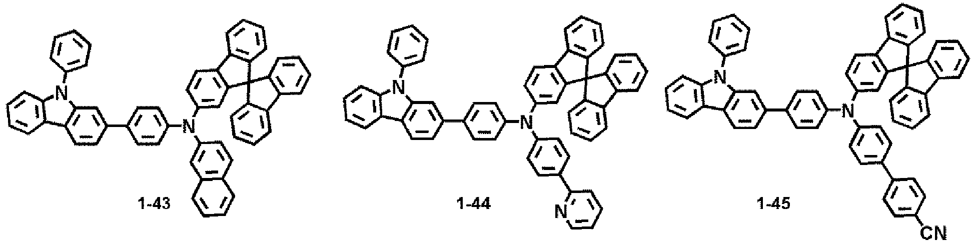

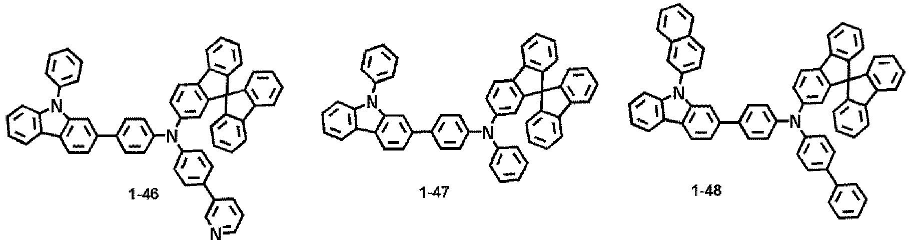

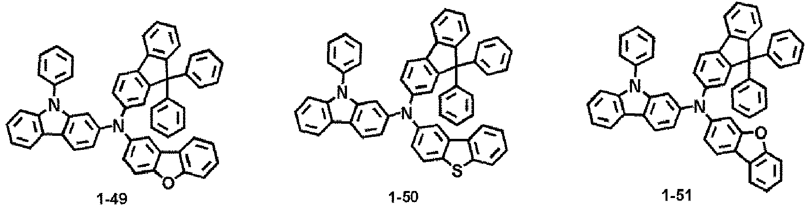

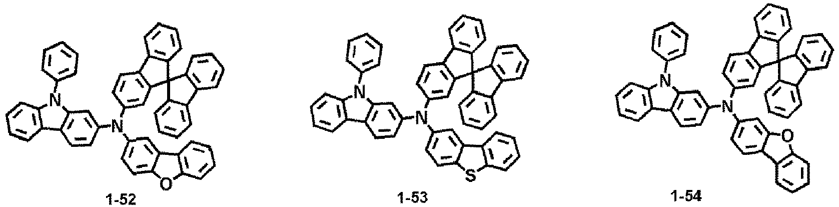

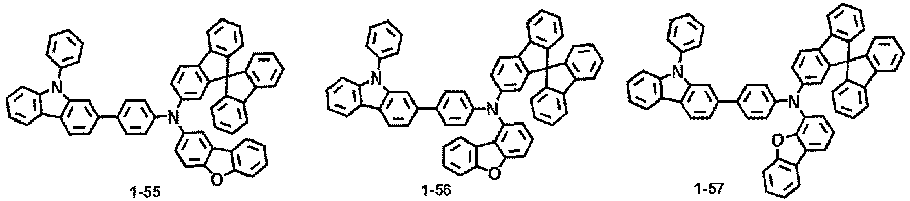

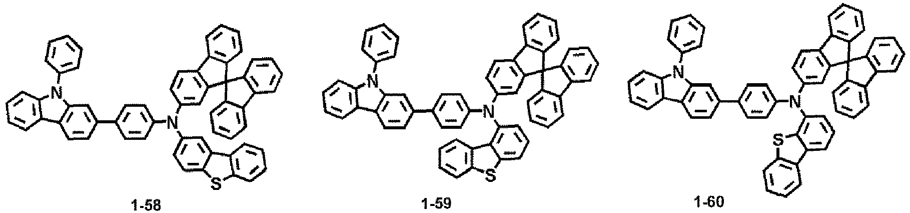

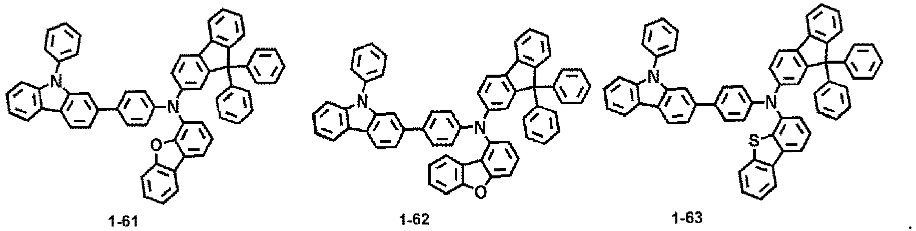

In an embodiment, Formula 2 may be represented by one selected from Formulae 2-1 to 2-7:

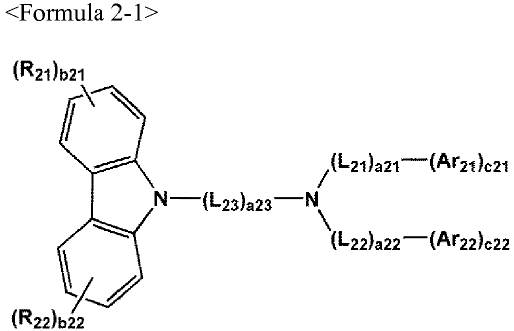

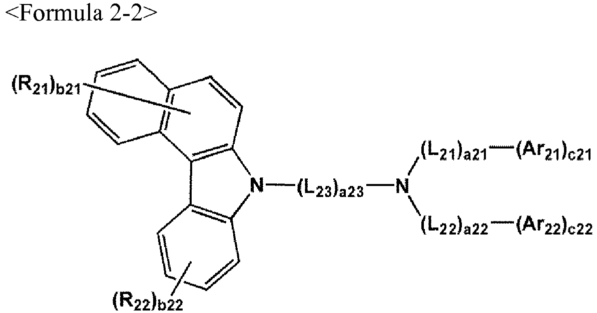

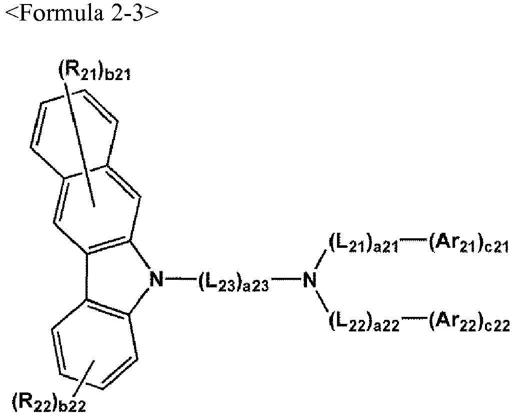

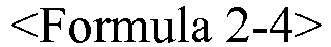

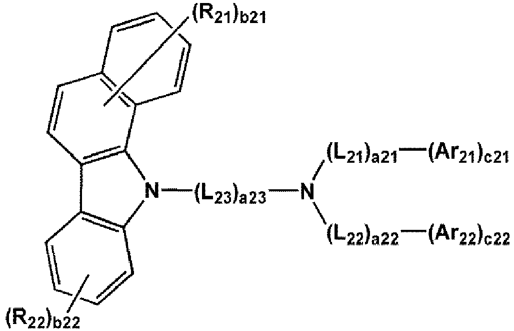

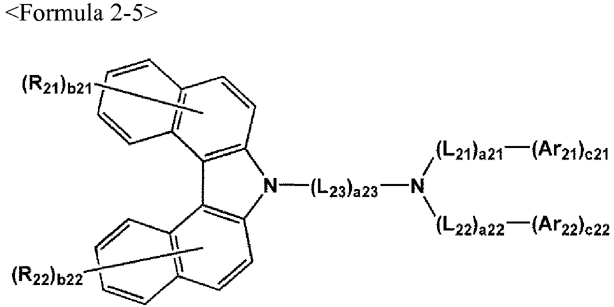

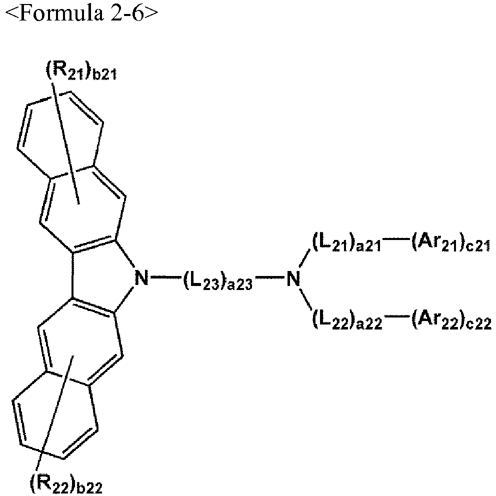

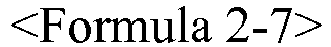

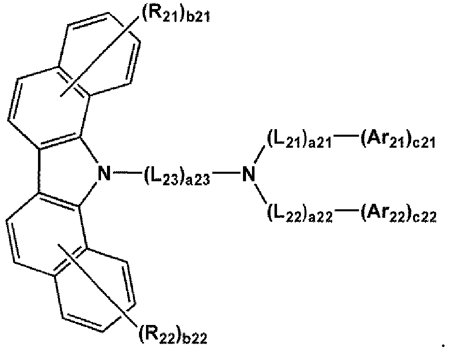

In Formulae 2-1 to 2-7,
L₂₁ to L₂₃, a21 to a23, R₂₁, R₂₂, b21, b22, Ar₂₁, Ar₂₂, c21, and c22 are respectively the same as defined above.

The compound represented by Formula 2 may be selected from Compounds 2-1 to 2-27:

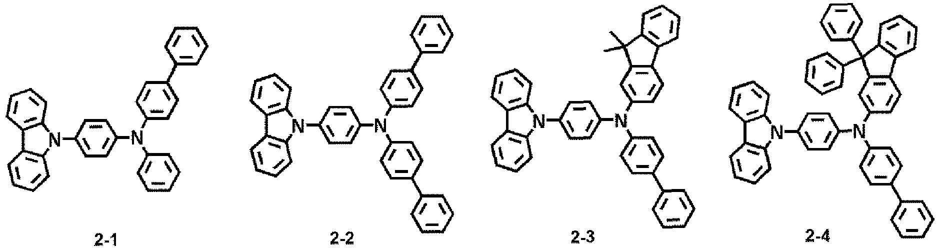

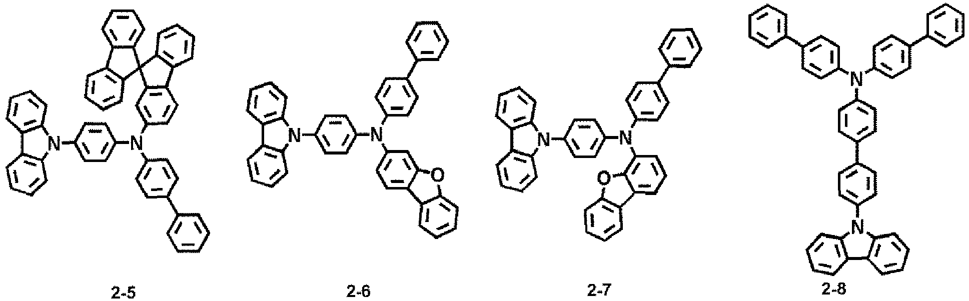

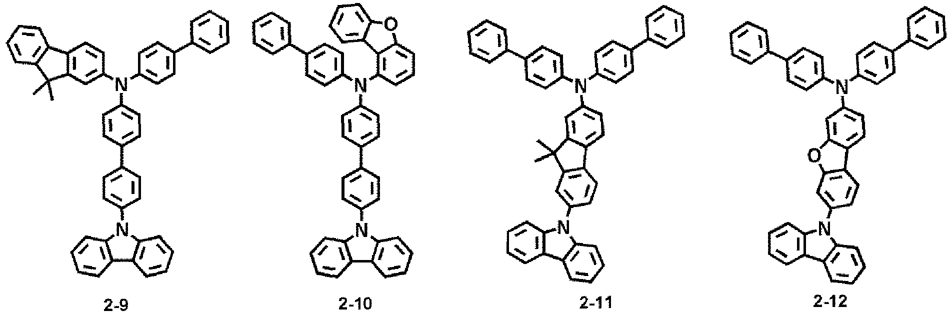

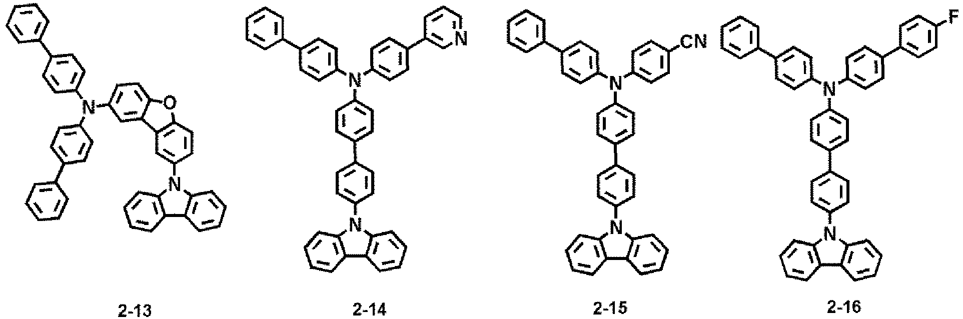

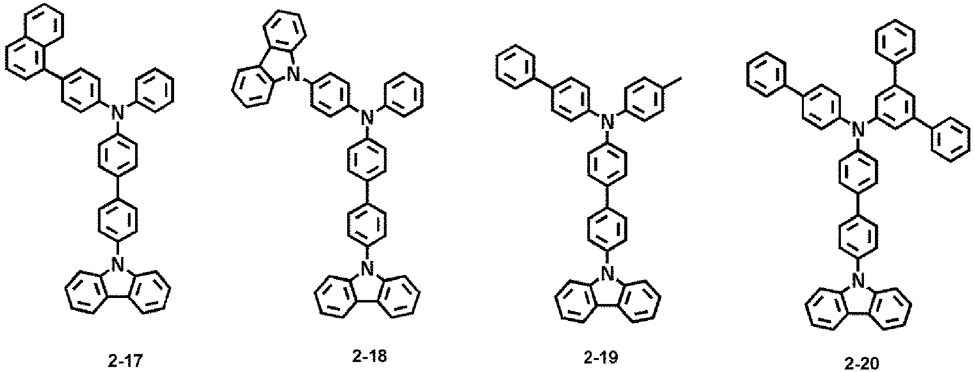

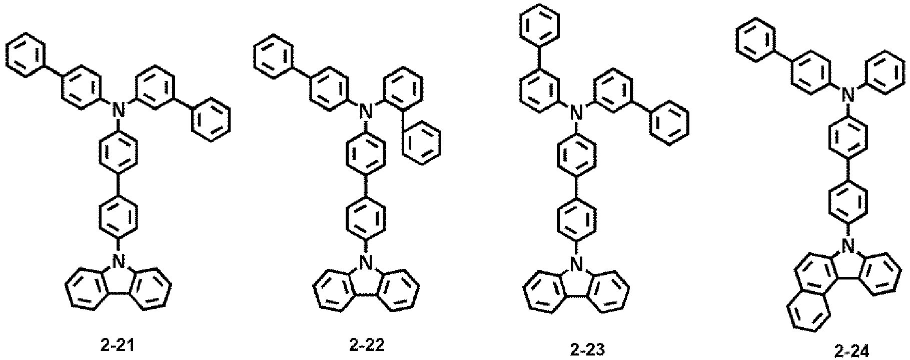

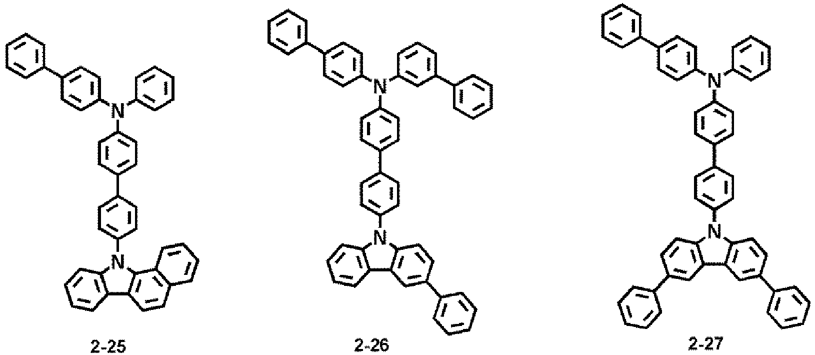

In an embodiment, in Formula 3, a moiety represented by 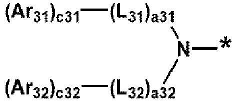 and a moiety represented by 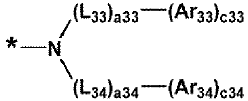 may be identical to each other.

In one or more embodiments, the compound represented by Formula 3 may have a symmetrical structure with respect to ^{∗}-(L₃₅)ₐ₃₅-^{∗}' in Formula 3.

In one or more embodiments, in Formula 3, a35 may be an integer of two or more, wherein two or more L₃₅(s) may be identical to or different from each other.

The compound represented by Formula 3 may be selected from Compounds 3-1 to 3-18:

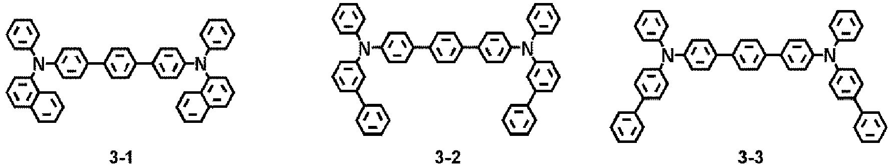

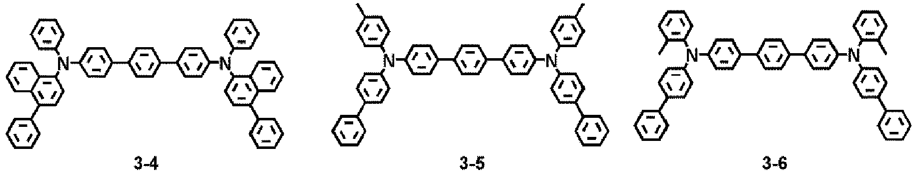

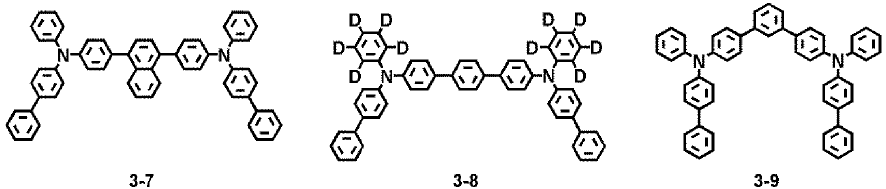

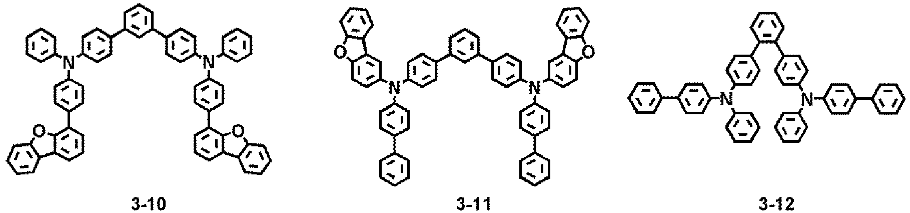

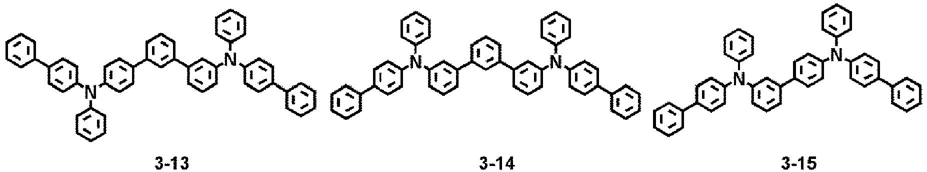

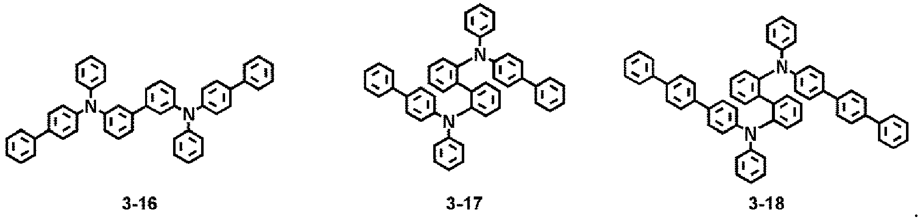

In an embodiment, Formula 4 may be represented by one selected from Formulae 4-1 to 4-4: 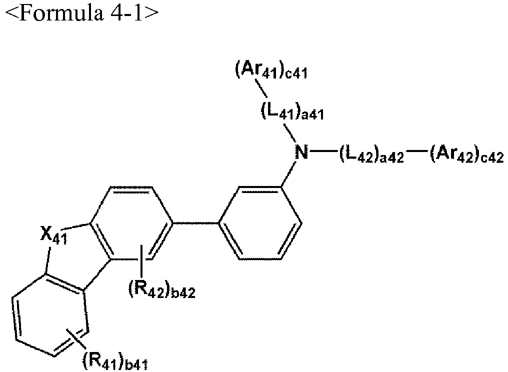 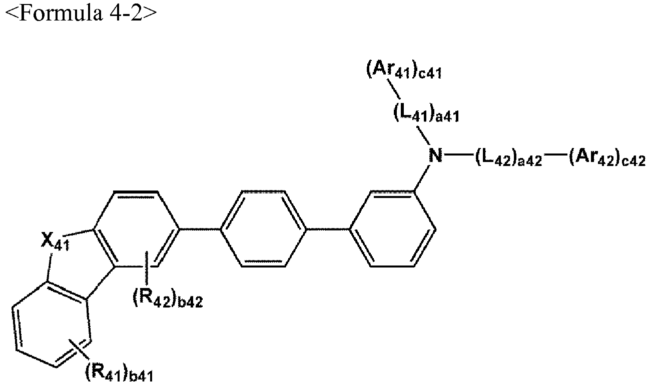 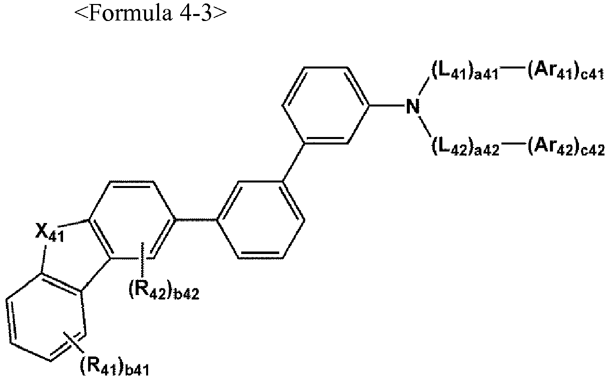 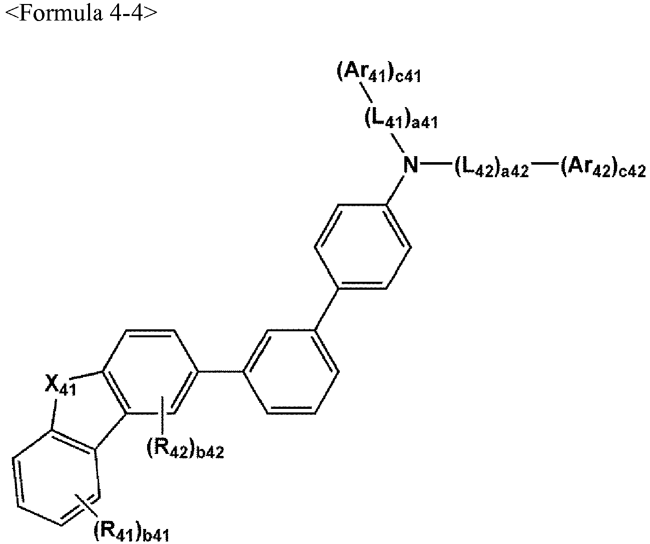 wherein in Formulae 4-1 to 4-4,
X₄₁, L₄₁, L₄₂, a41, a42, R₄₁, R₄₂, b41, b42, Ar_{41,} Ar₄₂, c41, and c42 are respectively the same as defined above.

The compound represented by Formula 4 may be selected from Compounds 4-1 to 4-15:

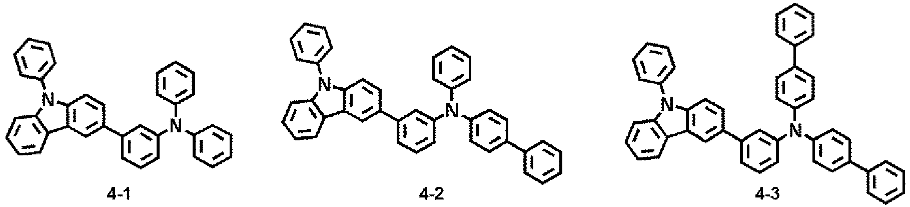

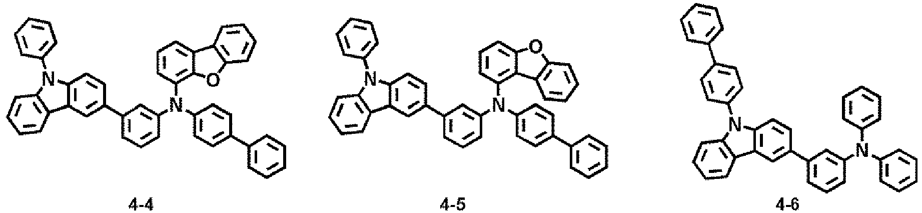

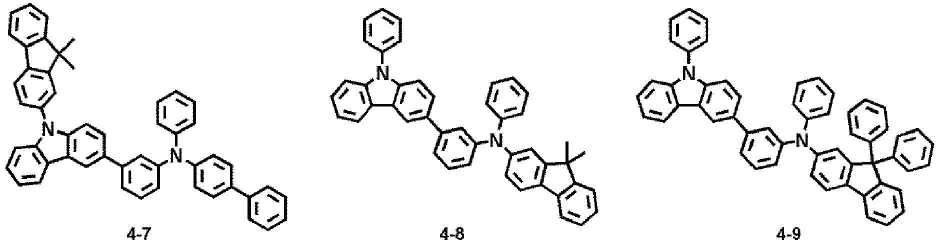

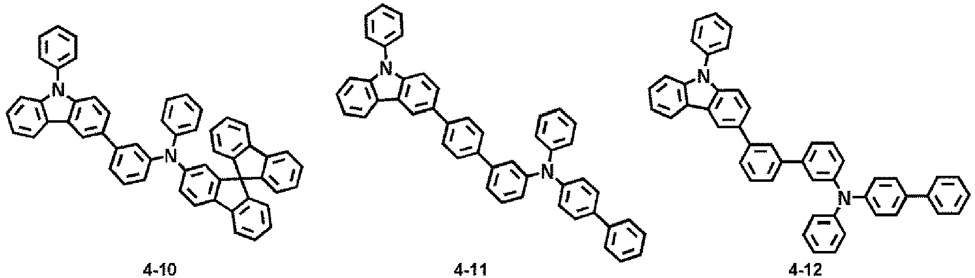

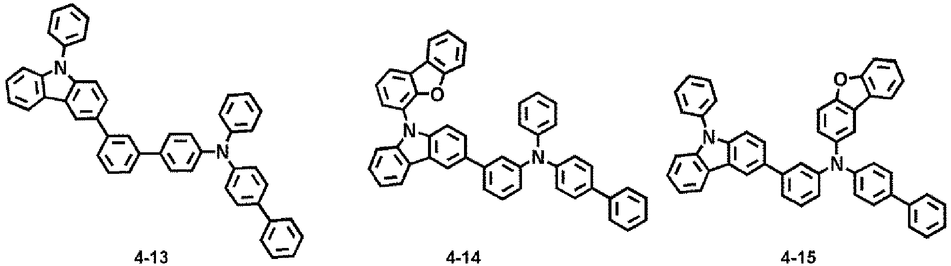

In an embodiment, Formula 5 may be represented by one selected from Formulae 5-1 to 5-3:

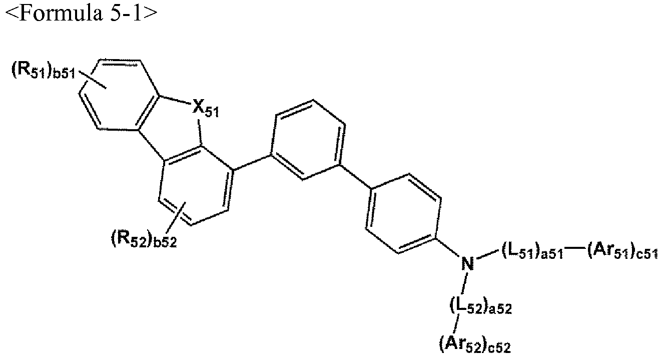

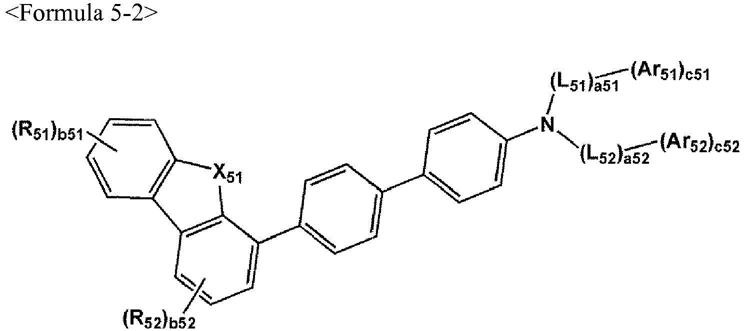

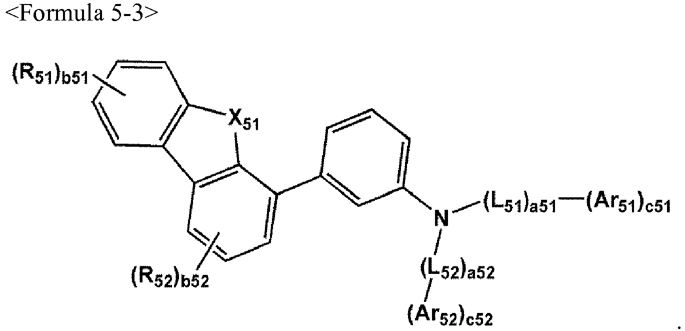

In Formulae 5-1 to 5-3,
X₅₁, L₅₁, L₅₂, a51, a52, R₅₁, R₅₂, b51, b52, Ar₅₁, Ar₅₂, c51, and c52 are respectively the same as defined above.

The compound represented by Formula 5 may be selected from Compounds 5-1 to 5-19:

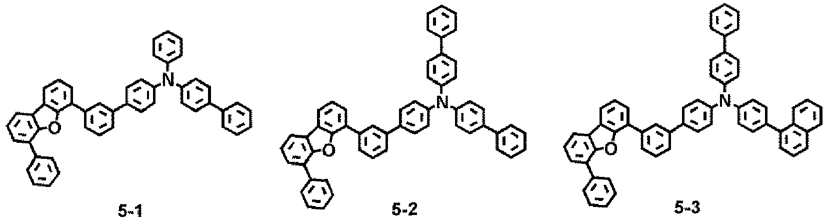

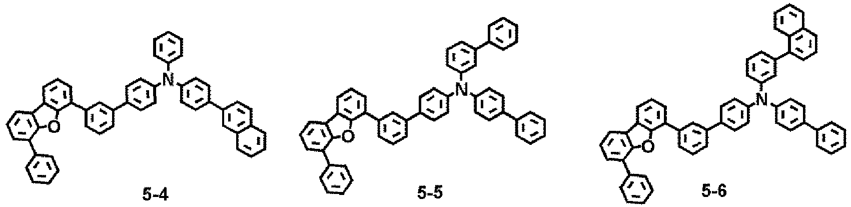

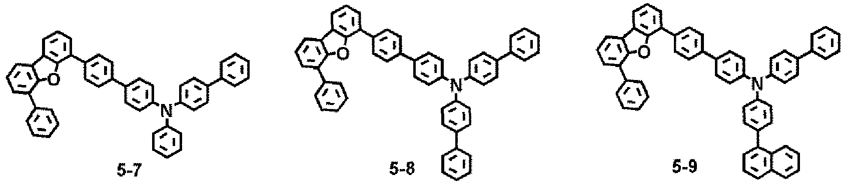

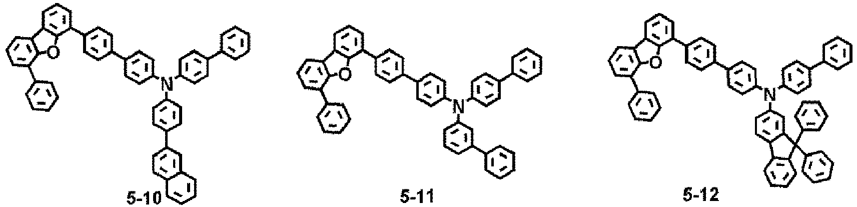

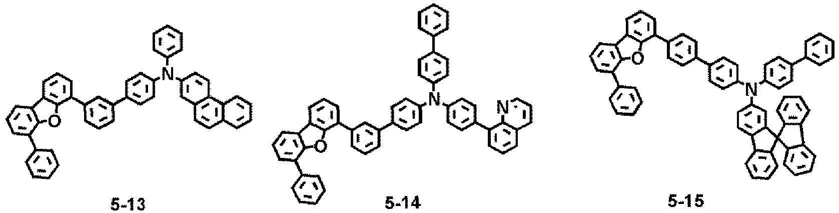

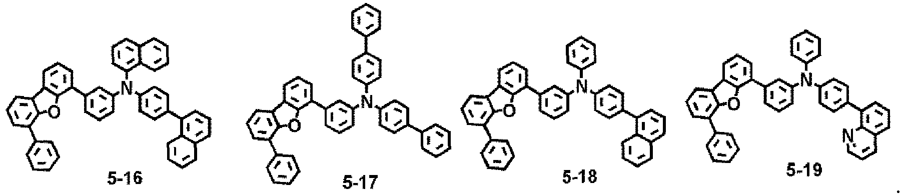

In an embodiment, Formula 6 may be represented by one selected from Formulae 6-1 to 6-4:

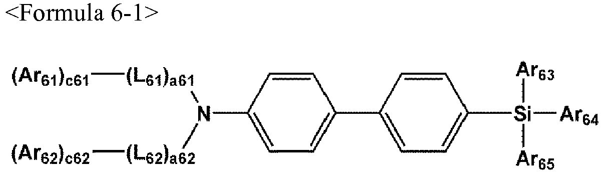

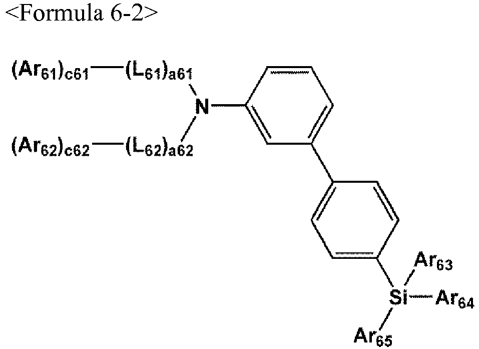

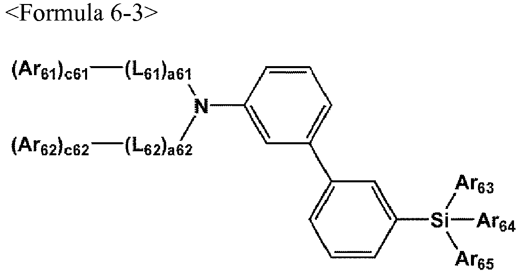

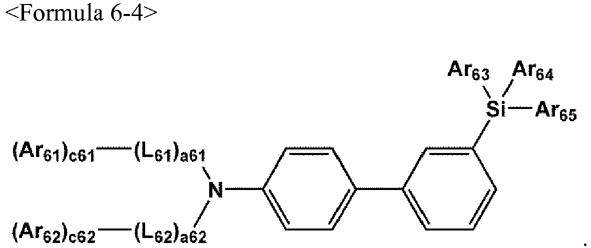

In Formulae 6-1 to 6-4,
L₆₁, L₆₂, a61, a62, Ar₆₁ to Ar₆₅, c61, and c62 are respectively the same as defined above.

The compound represented by Formula 6 may be selected from Compounds 6-1 to 6-18:

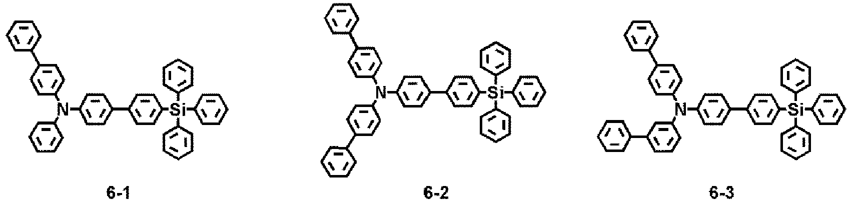

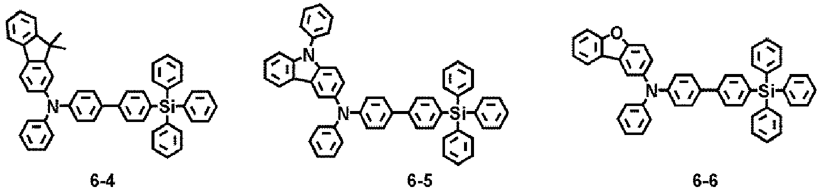

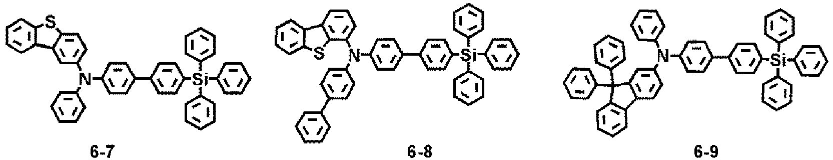

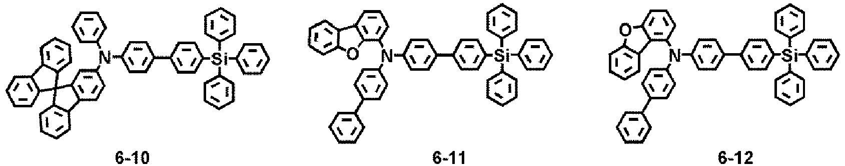

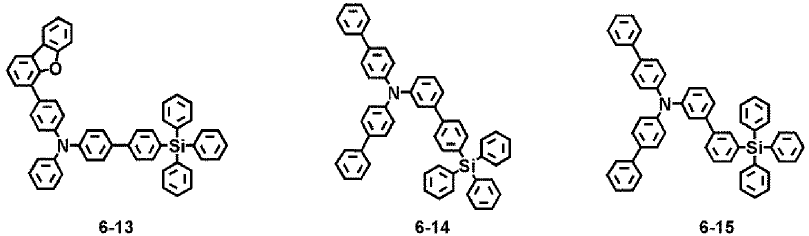

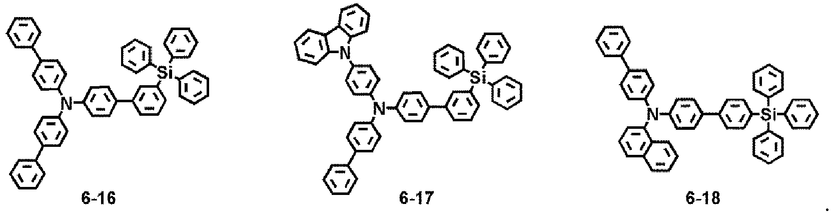

In an embodiment, the compound represented by Formula 1 may be selected from Compounds 1-1 to 1-63, and the compounds represented by Formulae 2 to 6 may each independently selected from Compounds 2-1 to 2-27, Compounds 3-1 to 3-18, Compounds 4-1 to 4-15, Compounds 5-1 to 5-19, and Compounds 6-1 to 6-18.

According to an aspect, there is provided an organic light-emitting device including: a first electrode, a second electrode, and an organic layer between the first electrode and the second electrode. The organic layer includes an emission layer and a hole transport region. The hole transport region is disposed between the first electrode and the emission layer. In addition the hole transport region includes a first layer and a second layer. The first layer may include at least one compound selected from Compounds 1-1 to 1-63. The second layer may include at least one compound selected from Compounds 2-1 to 2-27, Compounds 3-1 to 3-18, Compounds 4-1 to 4-15, Compounds 5-1 to 5-19, and Compounds 6-1 to 6-18. The compound included in the first layer is different from the compound included in the second layer include.

In one or more embodiments, the first layer may include one compound (i.e., a "first compound") selected from Compounds 1-1 to 1-63, and the second layer may include one compound (i.e., a "second compound") selected from Compounds 2-1 to 2-27, Compounds 3-1 to 3-18, Compounds 4-1 to 4-15, Compounds 5-1 to 5-19, and Compounds 6-1 to 6-18.

When the electron transport region having a low electron transfer speed is applied to the organic light-emitting device, a portion in which light is emitted may be closer to an interface of the electron transport region in the emission layer. Therefore, due to excessive holes transferred to the electron transport region, the electron transport region may be damaged, and the lifespan of the organic light-emitting device may be shortened.

On the contrary, when the electron transport region having a high electron transfer speed is applied to the organic light-emitting device, a portion in which light is emitted may be closer to an interface of the hole transport region in the emission layer. Therefore, due to excessive electrons transferred to the hole transport region, the hole transport region may be damaged, and the lifespan of the organic light-emitting device may be shortened.

Since the organic light-emitting device including at least two layers in the hole transport region facilitates the adjustment of balance between holes and electrons, the organic light-emitting device may improve both efficiency and lifespan at the same time.

The organic light-emitting device includes a first layer far *(e.g.* further) from the emission layer and a second layer close *(e.g.* closer) to the emission layer. A highest occupied molecular orbital (HOMO) level of a hole transport material included in the first layer is shallower than a HOMO level of a hole transport material included in the second layer and is close to a work function of an anode. A HOMO level of a hole transport material included in the second layer is close to a HOMO level of a host compound included in the emission layer and may reduce a hole injection barrier when holes are injected. Therefore, it is possible to obtain the effect of reducing a driving voltage and increasing efficiency when the device is driven.

The hole transport region may further include, in addition to the compounds represented by Formulae 1 to 6, at least one selected from m-MTDATA, TDATA, 2-TNATA, NPB(NPD), β-NPB, TPD, Spiro-TPD, Spiro-NPB, methylated-NPB, TAPC, HMTPD, 4,4',4"tris(N-carbazolyl)triphenylamine (TCTA), polyaniline/dodecylbenzenesulfonic acid (PA/DBSA) poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, and a compound represented by Formula 202:

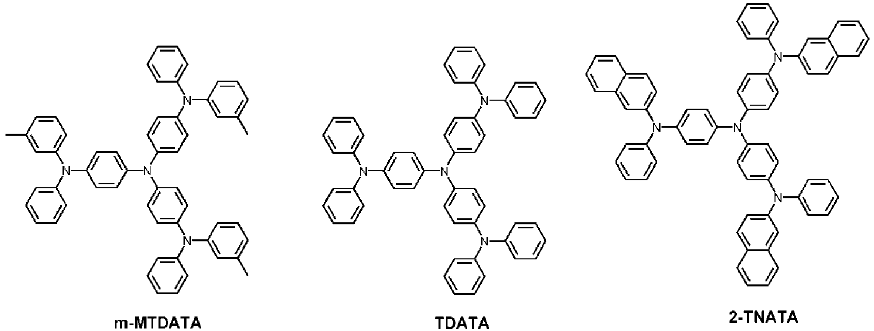

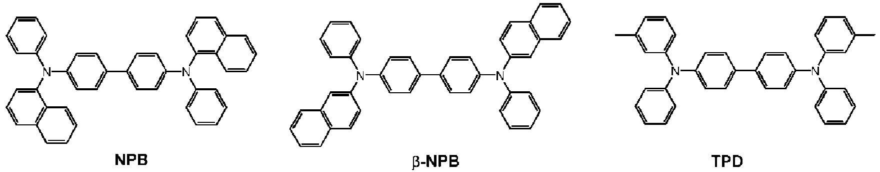

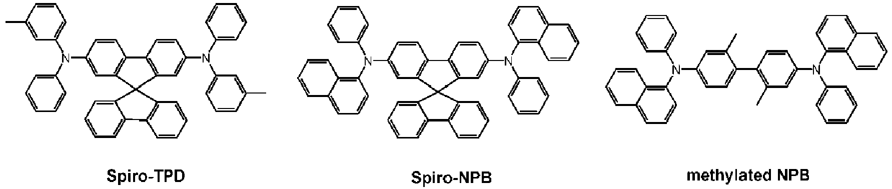

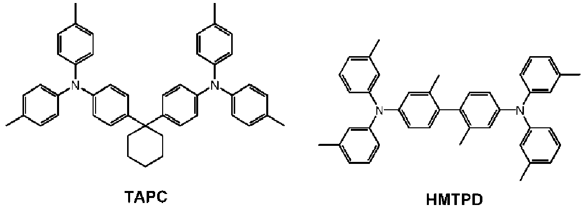

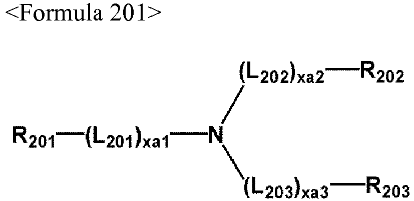

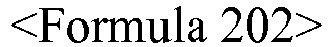

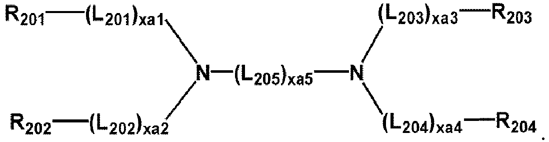

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from ^{∗}-O-^{∗}', ^{∗}-S-^{∗}', ^{∗}-N(Q₂₀₁)-^{∗}', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer of 0 to 3,
xa5 may be an integer of 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₆-C₆₀ (*e.g.* C₆-C₃₂) aryloxy group, a substituted or unsubstituted C₆-C₆₀ (*e.g.* C₆-C₃₂) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group.

For example, in Formula 202, R₂₀₁ and R₂₀₂ may optionally be linked to each other via a single bond, a dimethyl-methylene group, or a diphenyl-methylene group, and R₂₀₃ and R₂₀₄ may optionally be linked to each other via a single bond, a dimethyl-methylene group, or a diphenyl-methylene group.

In an embodiment, in Formulae 201 and 202,
L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may respectively be the same as defined above.

In one or more embodiments, in Formula 201, at least one selected from R₂₀₁ to R₂₀₃ may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments of the invention are not limited thereto.

In one or more embodiments, in Formula 202, i) R₂₀₁ and R₂₀₂ may be linked each other via a single bond, and/or ii) R₂₀₃ and R₂₀₄ may be linked each other via a single bond.

In one or more embodiments, in Formula 202, at least one selected from R₂₀₁ to R₂₀₄ may be selected from:
a carbazolyl group; and
a carbazolyl group substituted with at least one selected from deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but embodiments of the invention are not limited thereto.

The compound represented by Formula 201 may be represented by Formula 201A:

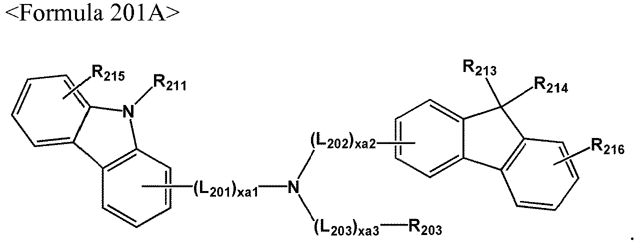

For example, the compound represented by Formula 201 may be represented by Formula 201A(1), but embodiments of the invention are not limited thereto:

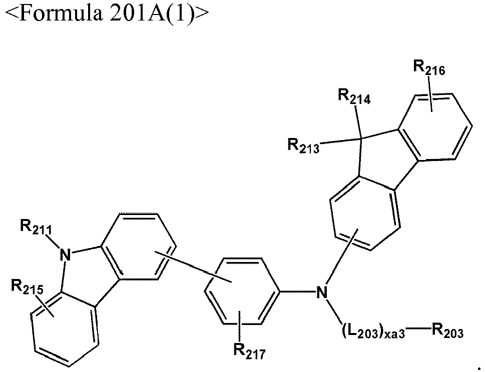

In one embodiment, the compound represented by Formula 201 may be represented by Formula 201A-1, but embodiments of the invention are not limited thereto:

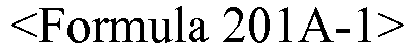

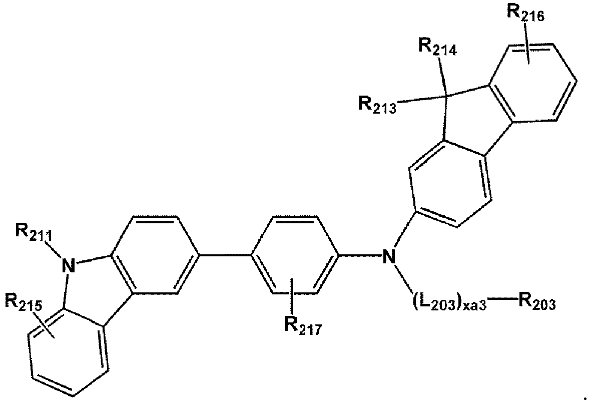

For example, the compound represented by Formula 202 may be represented by Formula 202A:

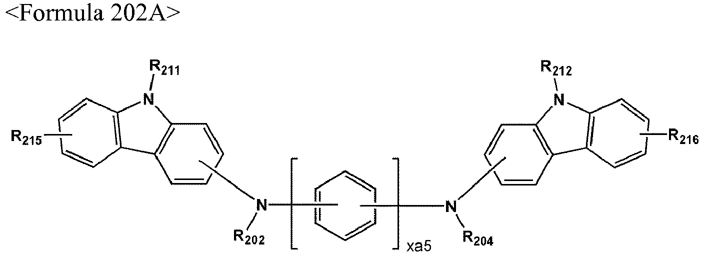

For example, the compound represented by Formula 202 may be represented by Formula 202A-1:

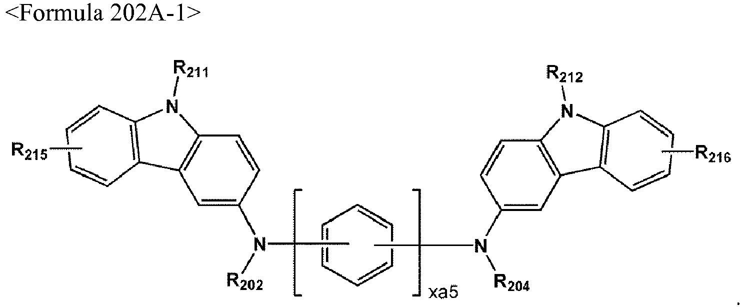

In Formulae 201A, 201A(1), 201A-1, 202A, and 202A-1,
L₂₀₁ to L₂₀₃, xa1 to xa3, xa5, and R₂₀₂ to R₂₀₄ may respectively be the same as defined above,
R₂₁₁ and R₂₁₂ may respectively be the same as defined in connection with R₂₀₃, and
R₂₁₃ to R₂₁₇ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT35, but embodiments of the invention are not limited thereto:

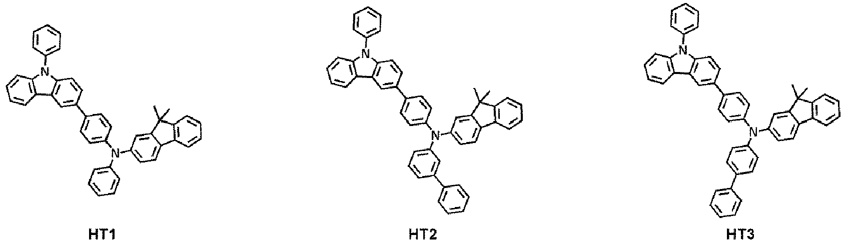

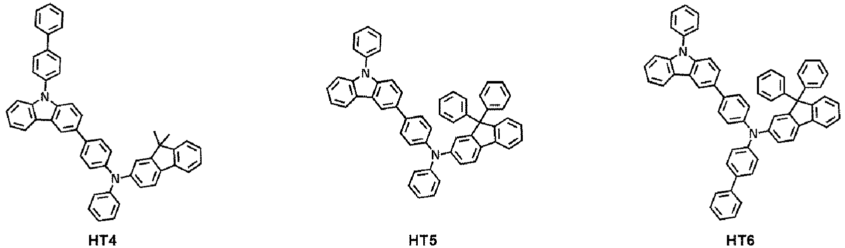

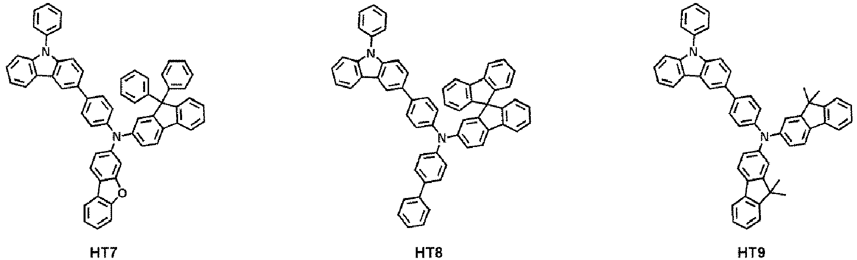

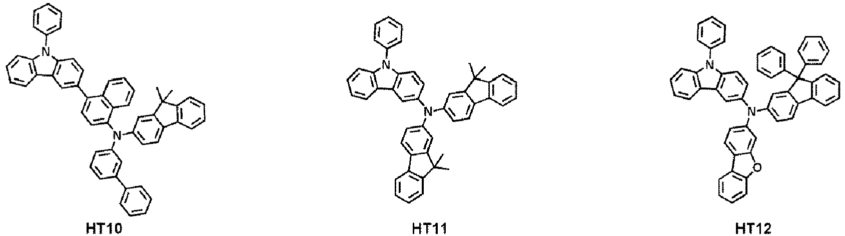

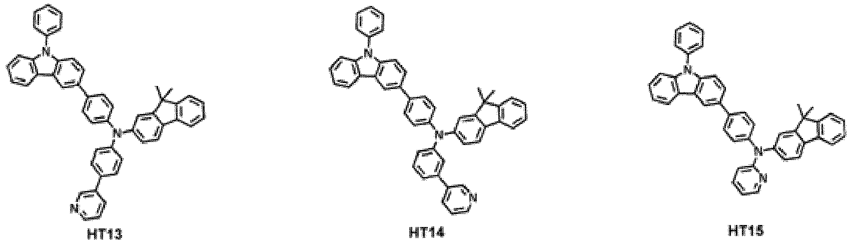

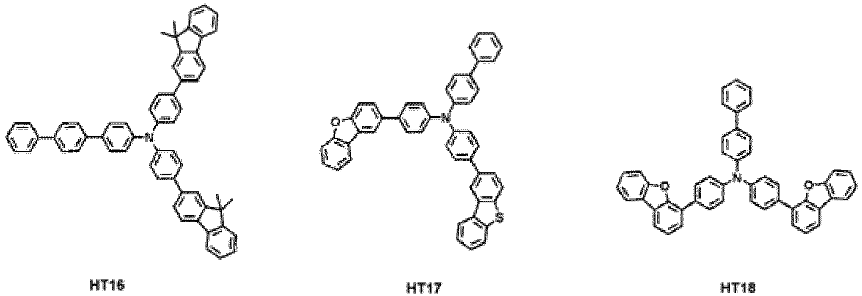

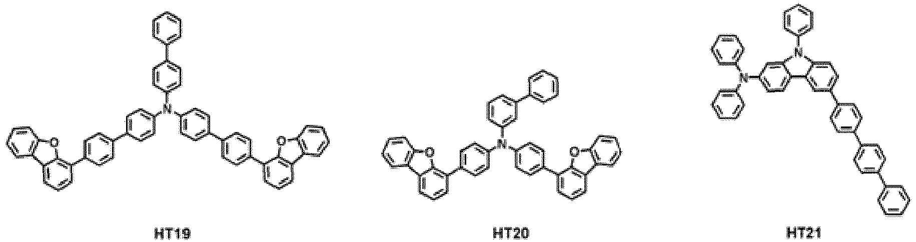

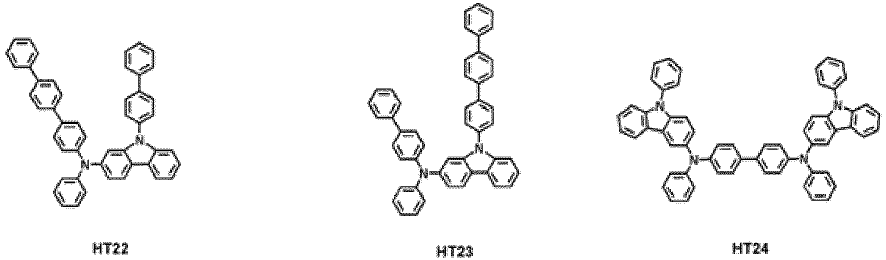

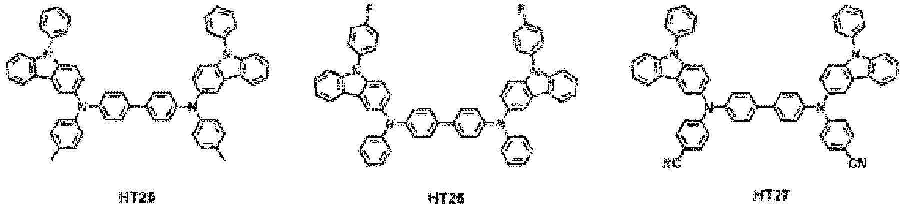

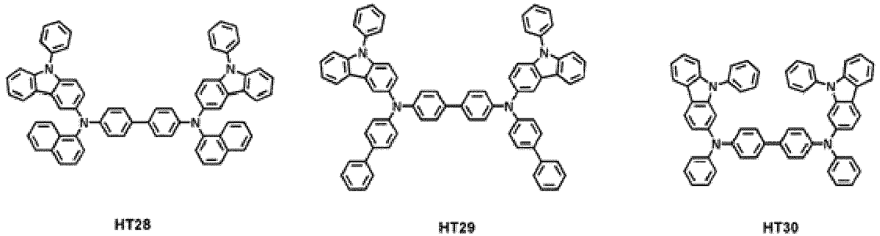

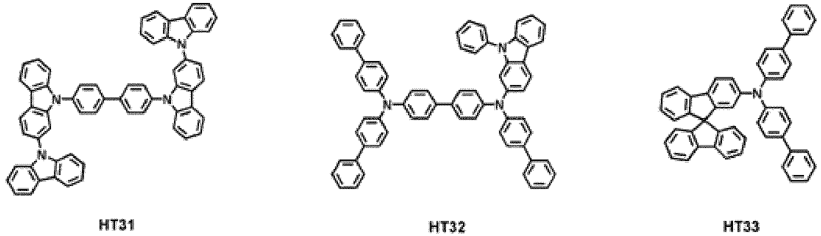

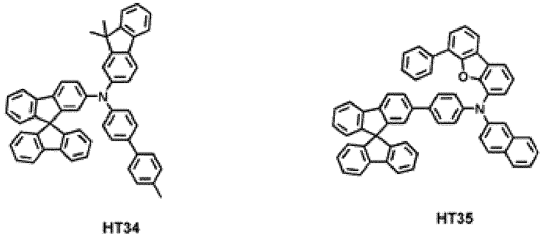

A thickness of the hole transport region may be in a range of about 100 Å to about 10,000 Å, for example, about 100 Å to about 7000 Å, about 100 Å to about 5000 Å, about 100 Å to about 3000 Å, or about 100 Å to about 1,000 Å. When the hole transport region includes at least one selected from a hole injection layer and a hole transport layer, a thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 2,000 Å or about 100 Å to about 1,000 Å, and a thickness of the hole transport layer may be in a range of about 50 Å to about 2,000 Å, for example about 100 Å to about 1,500 Å. When the thicknesses of the hole transport region, the hole injection layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block the flow of electrons from an electron transport region. The emission auxiliary layer and the electron blocking layer may include the materials as described above.

### [p-dopant]

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant.

In an embodiment, the p-dopant may have a lowest unoccupied molecular orbital (LUMO) level of about -3.5 eV or less.

The p-dopant may include at least one dopant selected from a quinone derivative, a metal oxide, and a cyano group-containing compound, but embodiments of the invention are not limited thereto.

In an embodiment, the p-dopant may include at least one dopant selected from:
a quinone derivative, such as tetracyanoquinodimethane (TCNQ) and 2,3,5,6-tetrafluoro-7,7,8,8-tetracyanoquinodimethane (F4-TCNQ);
a metal oxide, such as tungsten oxide or molybdenum oxide;
1,4,5,8,9,12-hexaazatriphenylene-hexacarbonitrile (HAT-CN); and
a compound represented by Formula 221.

However, embodiments of the invention are not limited thereto:
<HAT-CN> <F4-TCNQ>

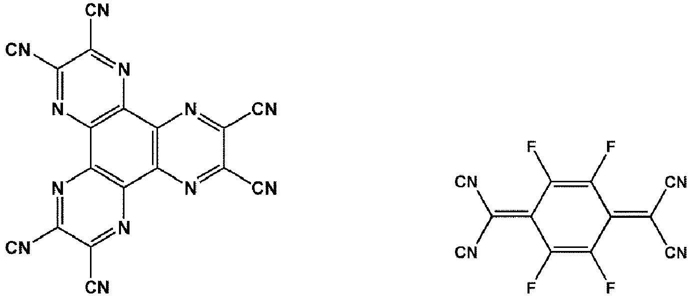

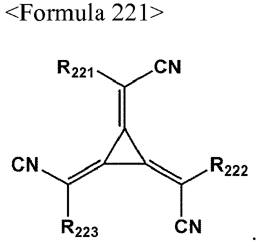

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, wherein at least one selected from R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br and a C₁-C₂₀ alkyl group substituted with -I.

[Emission layer in the organic layer 150]

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other. In one or more embodiments, the emission layer may include two or more materials selected from a red light-emitting material, a green light-emitting material, and a blue light-emitting material, in which the two or more materials are mixed with each other in a single layer to emit white light.

The emission layer may include a host and a dopant. The dopant may include at least one dopant selected from a phosphorescent dopant and a fluorescent dopant.

In the emission layer, an amount of the dopant may be generally in a range of about 0.01 parts by weight to about 30 parts by weight based on 100 parts by weight of the host, but embodiments of the invention are not limited thereto.

A thickness of the emission layer may be in a range of about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 400 Å. When the thickness of the emission layer is within this range, excellent emission characteristics may be obtained without a substantial increase in driving voltage.

[Host in the emission layer]

The host may include a compound represented by Formula 301:

<Formula 301> [Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer of 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and -P(=O)(Q₃₀₁)(Q₃₀₂),
xb21 may be an integer of 1 to 5, and
Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the invention are not limited thereto.

For example, Ar₃₀₁ may be a substituted or unsubstituted C₆-C₃₂ carbocyclic group or a substituted or unsubstituted C₁-C₁₂ heterocyclic group, but embodiments are not limited thereto.

In an embodiment, in Formula 301, Ar₃₀₁ may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the invention are not limited thereto.

In Formula 301, when xb11 is two or more, two or more Ar₃₀₁(s) may be linked via a single bond.

In one or more embodiments, the compound represented by Formula 301 may be represented by Formula 301-1 or 301-2:

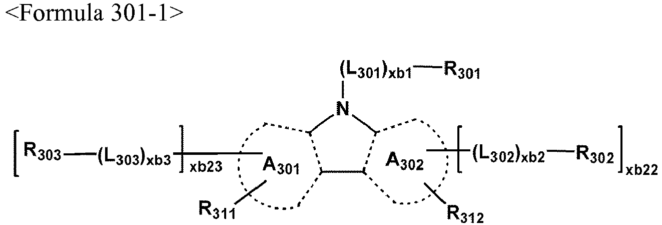

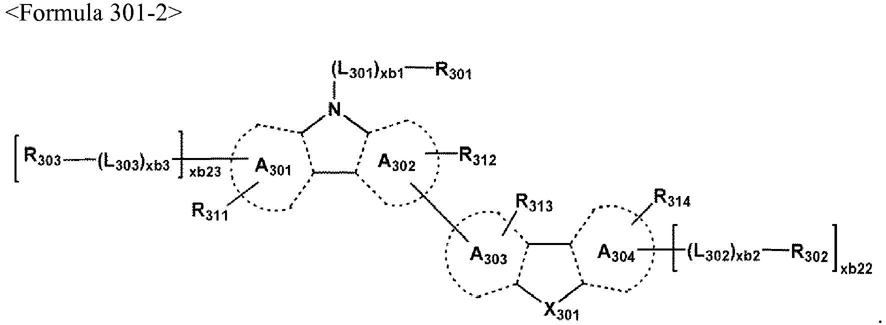

In Formulae 301-1 to 301-2,
A₃₀₁ to A₃₀₄ may each independently be selected from a benzene, a naphthalene, a phenanthrene, a fluoranthene, a triphenylene, a pyrene, a chrysene, a pyridine, a pyrimidine, an indene, a fluorene, a spiro-bifluorene, a benzofluorene, a dibenzofluorene, an indole, a carbazole, benzocarbazole, dibenzocarbazole, a furan, a benzofuran, a dibenzofuran, a naphthofuran, a benzonaphthofuran, dinaphthofuran, a thiophene, a benzothiophene, a dibenzothiophene, a naphthothiophene, a benzonaphthothiophene, and a dinaphthothiophene,
X₃₀₁ may be O, S, or N-[(L₃₀₄)_{xb4}-R₃₀₄],
R₃₁₁ to R₃₁₄ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁, and Q₃₁ to Q₃₃ may respectively be the same as defined above,
L₃₀₂ to L₃₀₄ may respectively be the same as defined in connection with L₃₀₁.

For example, L₃₀₁ to L₃₀₄ in Formulae 301, 301-1, and 301-2 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.
xb2 to xb4 may respectively be the same as defined in connection with xb1, and
R₃₀₂ to R₃₀₄ may respectively be the same as defined in connection with R₃₀₁.

For example, in Formulae 301, 301-1, and 301-2, L₃₀₁ to L₃₀₄ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂), and
Q₃₁ to Q₃₃ may respectively be the same as defined above.

As another example, R₃₀₁ to R₃₀₄ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted C₁-C₆₀ (*e.g.* C₁-C₁₀) alkyl group, a substituted or unsubstituted C₂-C₆₀ (*e.g.* C₂-C₁₀) alkenyl group, a substituted or unsubstituted C₂-C₆₀ (*e.g.* C₂-C₁₀) alkynyl group, a substituted or unsubstituted C₁-C₆₀ (*e.g.* C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

In an embodiment, in Formulae 301, 301-1, and 301-2, R₃₀₁ to R₃₀₄ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₃₁ to Q₃₃ may respectively be the same as defined above.

In an embodiment, the host may include an alkaline earth metal complex. For example, the host may include a complex selected from a Be complex (for example, Compound H55), a Mg complex, and a Zn complex. For example, the host may be selected from a Be complex (for example, Compound H55), a Mg complex, and a Zn complex.

The host may include at least one compound selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments of the invention are not limited thereto:

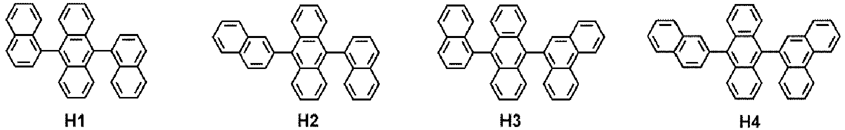

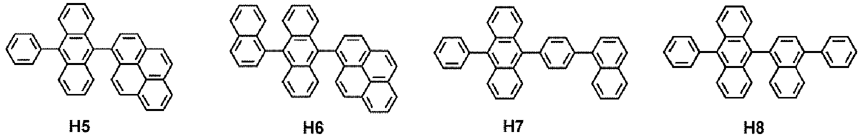

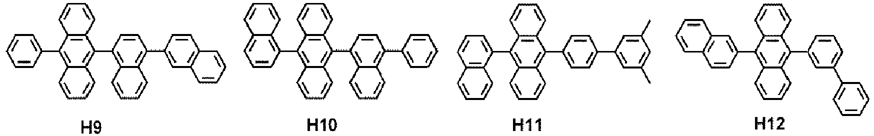

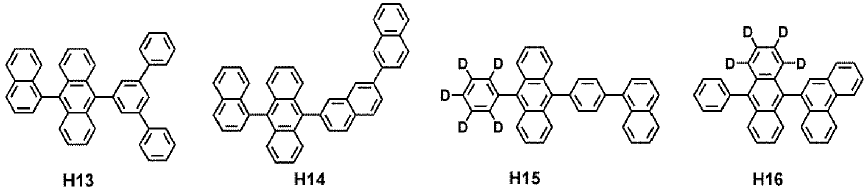

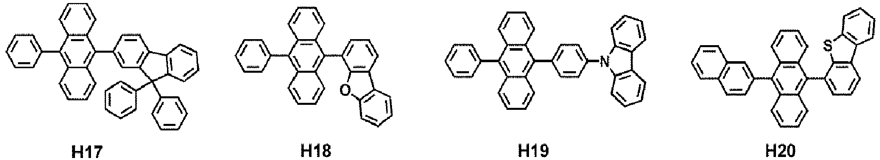

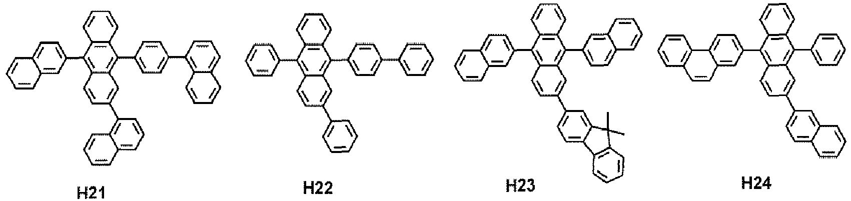

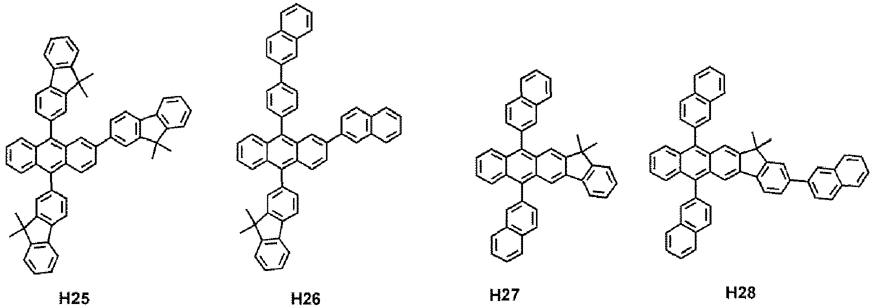

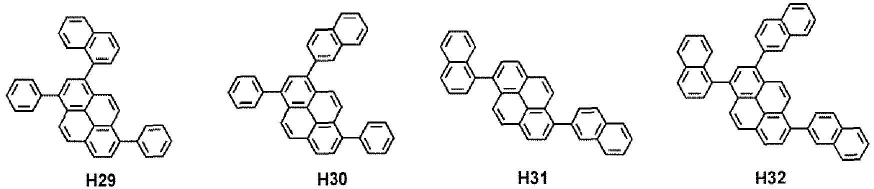

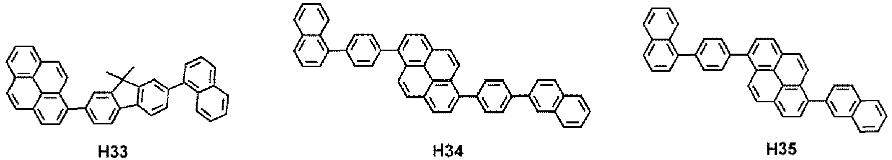

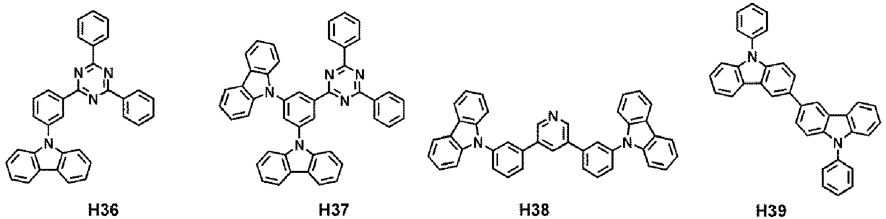

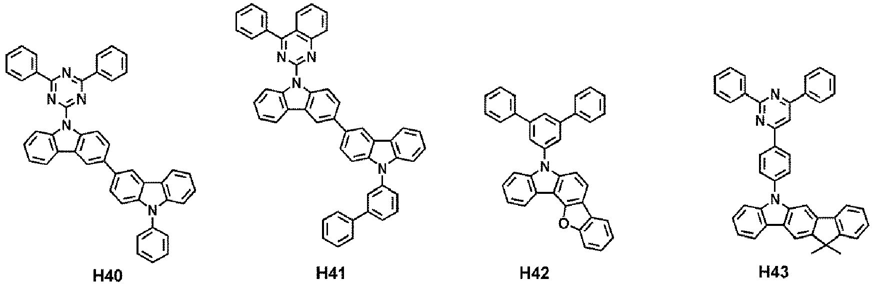

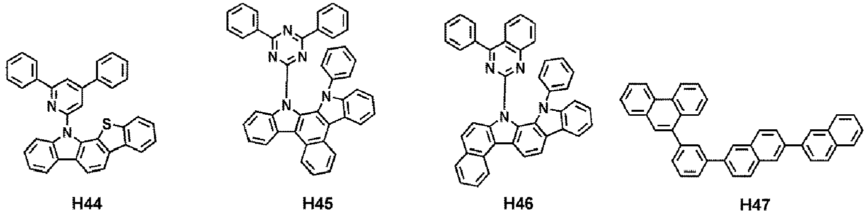

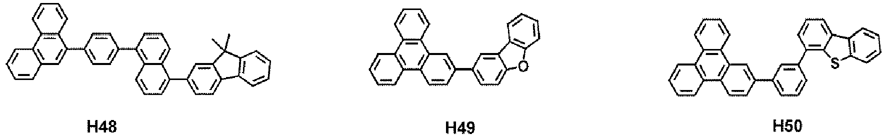

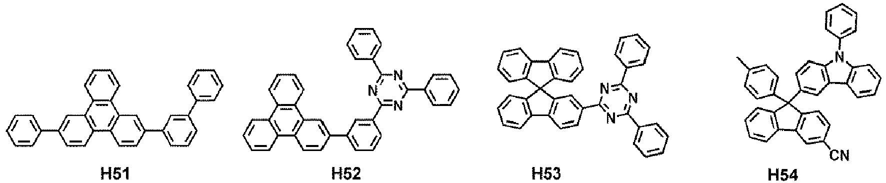

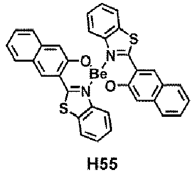

In an embodiment, the host may include at least one compound selected from a silicon-containing compound (for example, BCPDS used in Examples below) and a phosphine oxide-containing compound (for example, POPCPA used in Examples below).

The host may include only one type of a compound, or may include two different types of compounds (for example, the host used in Examples below may consist of BCPDS and POPCPA), in a various modification manner.

### [Phosphorescent dopant in the emission layer of the organic layer 150]

The phosphorescent dopant may include an organometallic complex represented by Formula 401:

<Formula 401> M(L₄₀₁)_{xc1}(L₄₀₂)_{xc2}

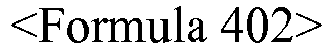

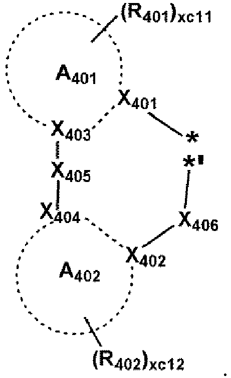

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be selected from a ligand represented by Formula 402, and xc1 may be 1, 2, or 3. When xc1 is two or more, two or more L₄₀₁(s) may be identical to or different from each other,
L₄₀₂ may be an organic ligand, and xc2 may be an integer of 0 to 4. When xc2 is two or more, two or more L₄₀₂(s) may be identical to or different from each other,
X₄₀₁ to X₄₀₄ may each independently be nitrogen or carbon,
X₄₀₁ and X₄₀₃ may be linked each other via a single bond or a double bond, and X₄₀₂ and X₄₀₄ may be linked to each other via a single bond or a double bond,
A₄₀₁ and A₄₀₂ may each independently be a C₅-C₆₀ (*e.g.* C₅-C₃₀) carbocyclic group or a C₁-C₆₀ (*e.g.* C₁-C₂₀) heterocyclic group,
X₄₀₅ may be a single bond, ^{∗}-O-^{∗}', ^{∗}-S-^{∗}', ^{∗}-C(=O)-^{∗}', ^{∗}-N(Q₄₁₁)-^{∗}', ^{∗}-C(Q₄₁₁)(Q₄₁₂)-^{∗}', ^{∗}-C(Q₄₁₁)=C(Q₄₁₂)-^{∗}', ^{∗}-C(Q₄₁₁)=^{∗}', or ^{∗}=C=^{∗}', wherein Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, - Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, -Si(Q₄₀₁)(Q₄₀₂)(Q₄₀₃),-N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer of 0 to 10, and
^{∗} and ^{∗}' in Formula 402 each indicate a binding site to M of Formula 401.

In an embodiment, in Formula 402, A₄₀₁ and A₄₀₂ may each independently be selected from a benzene group, a naphthalene group, a fluorene group, a spiro-bifluorene group, an indene group, a pyrrole group, a thiophene group, a furan(furan) group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon or ii) X₄₀₁ and X₄₀₂ may both be nitrogen.

In one or more embodiments, in Formula 402, R₄₀₁ and R₄₀₂ may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one substituent selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), and -P(=O)(Q₄₀₁)(Q₄₀₂), and
Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the invention are not limited thereto.

In one or more embodiments, in Formula 401, when xc1 is two or more, two A₄₀₁(s) among a plurality of L₄₀₁(s) may optionally be linked via a linking group, X₄₀₇, or two A₄₀₂(s) may optionally be linked via a linking group, X₄₀₈ (see Compounds PD1 to PD4 and PD7). X₄₀₇ and X₄₀₈ may each independently be a single bond, ^{∗}-O-^{∗}', ^{∗}-S-^{∗}', ^{∗}-C(=O)-^{∗}', ^{∗}-N(Q₄₁₃)-^{∗}', ^{∗}-C(Q₄₁₃)(Q₄₁₄)-^{∗}', or ^{∗}-C(Q₄₁₃)=C(Q₄₁₄)-^{∗}' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the invention are not limited thereto.

L₄₀₂ in Formula 401 may be a monovalent, divalent, or trivalent organic ligand. For example, L₄₀₂ may be selected from halogen, diketone (for example, acetylacetonate), carboxylic acid (for example, picolinate), -C(=O), isonitrile, -CN, and phosphorus (for example, phosphine, or phosphite), but exemplar embodiments of the invention are not limited thereto.

In one or more embodiments, the phosphorescent dopant may be selected from, for example, Compounds PD1 to PD25, but embodiments of the invention are not limited thereto:

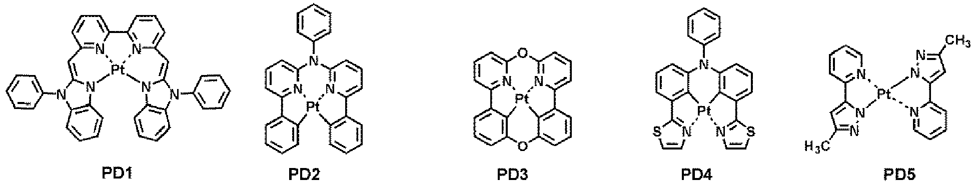

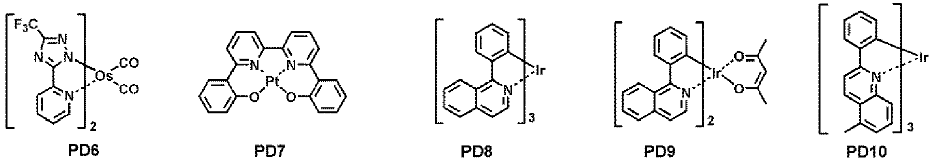

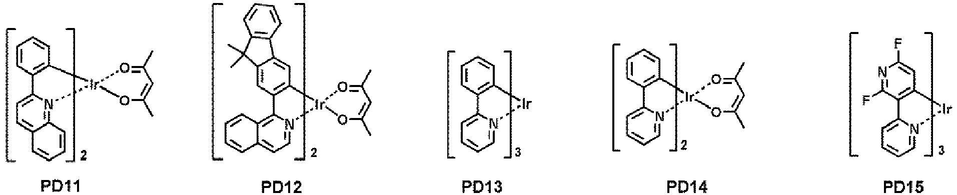

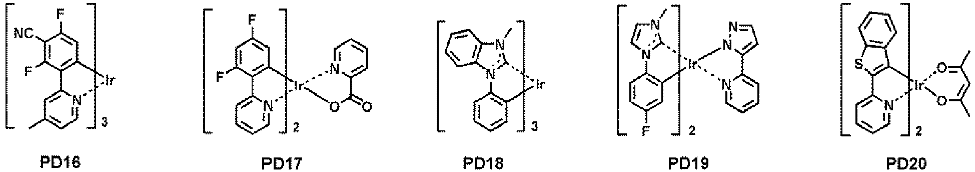

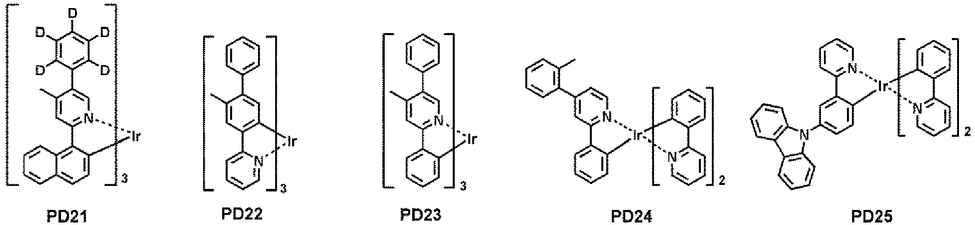

### [Fluorescent dopant in the emission layer]

The fluorescent dopant may include an arylamine compound or a styrylamine compound.

The fluorescent dopant may include a compound represented by Formula 501:

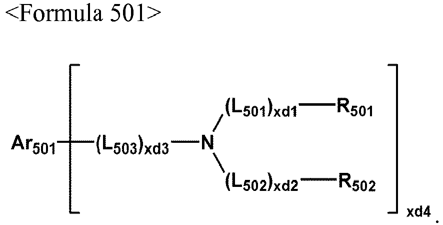

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₀) arylene group, a substituted or unsubstituted C₁-C₆₀ *(e.g.* C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer of 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ *(e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer of 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In an embodiment, in Formula 501, Ar₅₀₁ may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, in Formula 501, L₅₀₁ to L₅₀₃ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one substituent selected from deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, in Formula 501, R₅₀₁ and R₅₀₂ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and -Si(Q₃₁)(Q₃₂)(Q₃₃), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, in Formula 501, xd4 may be 2, but embodiments of the invention are not limited thereto.

For example, the fluorescent dopant may be selected from Compounds FD1 to FD22:

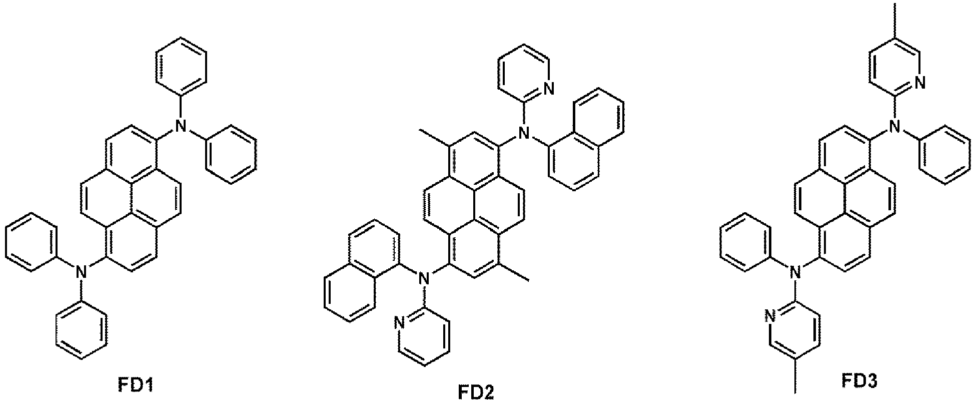

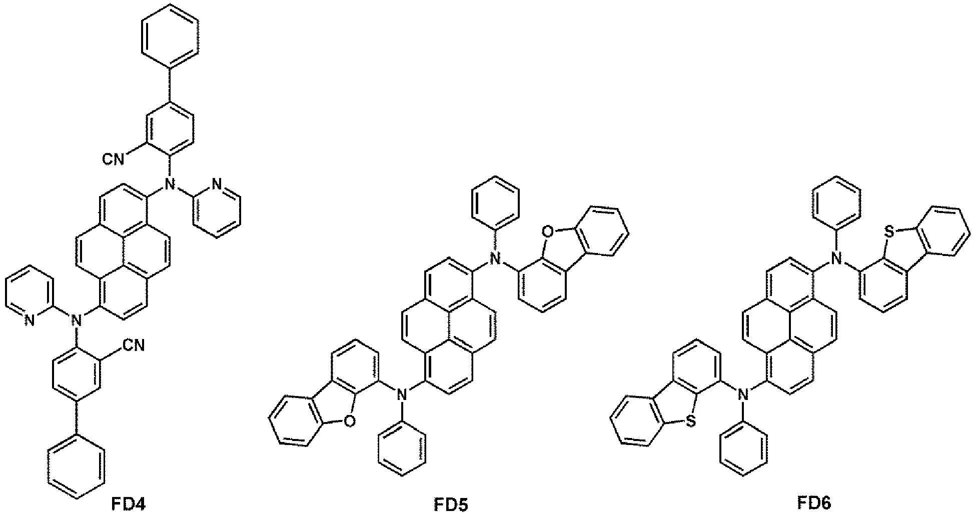

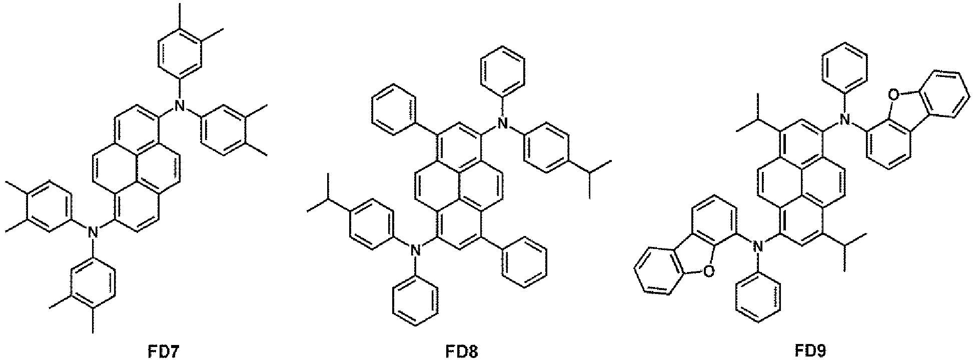

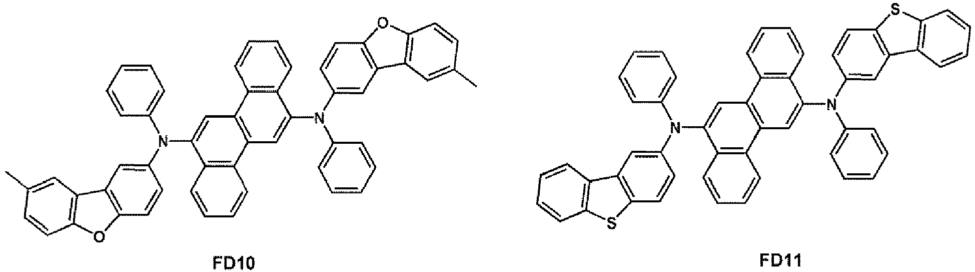

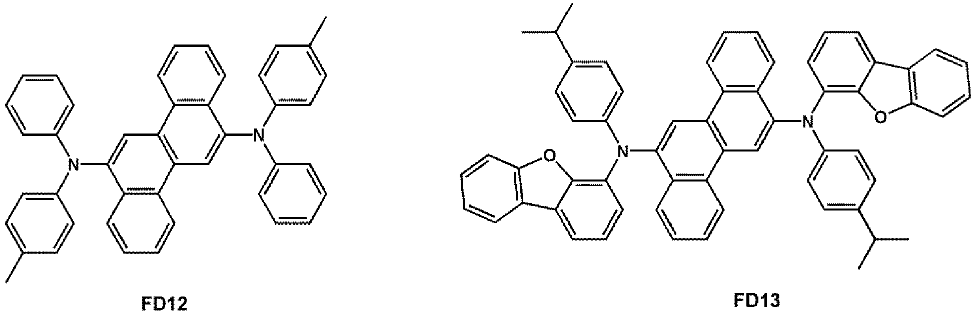

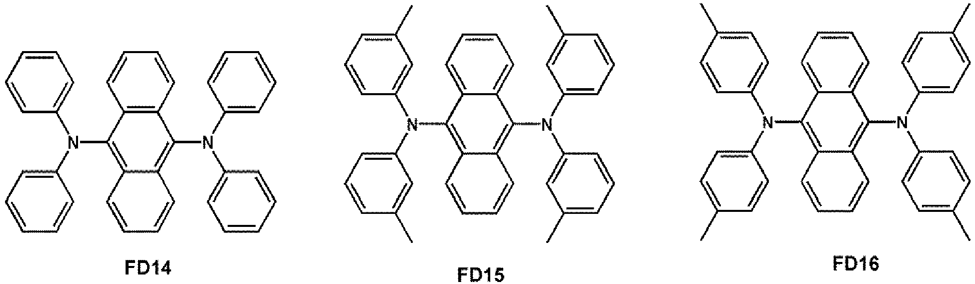

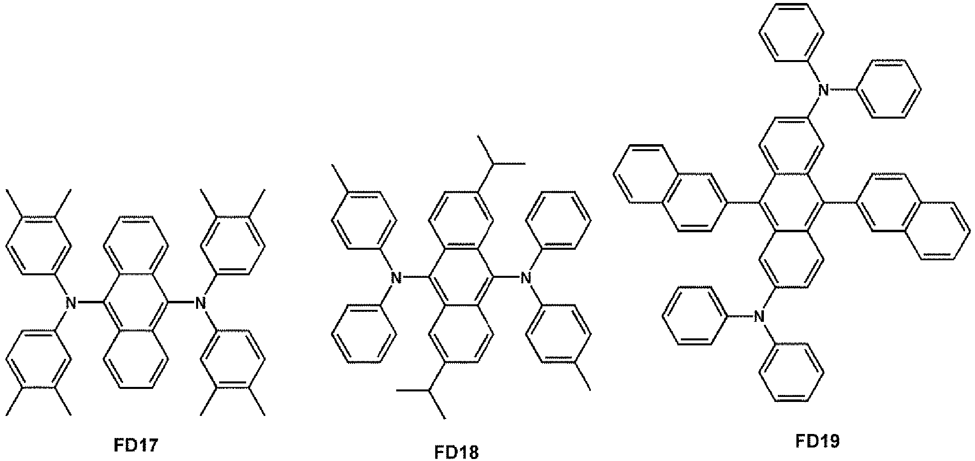

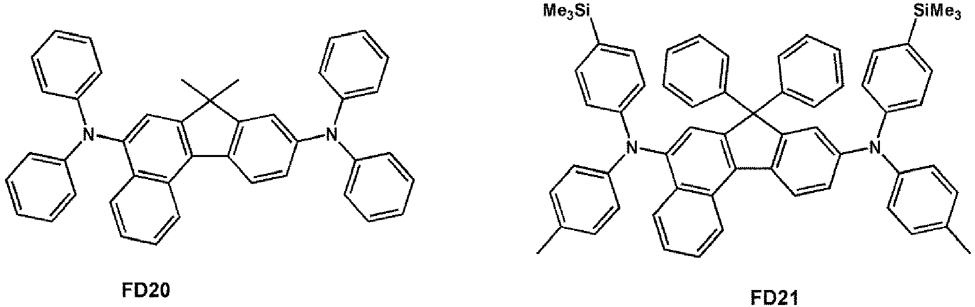

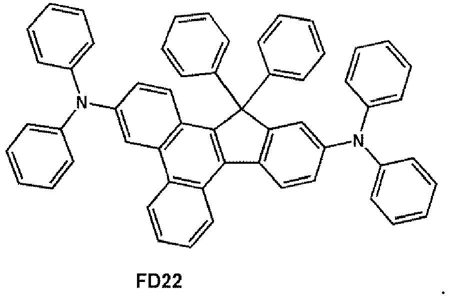

In one or more embodiments, the fluorescent dopant may be selected from compounds below, but embodiments of the invention are not limited thereto. 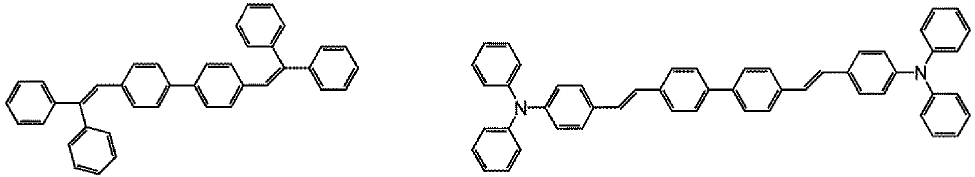 **DPVBi DPAVBi** 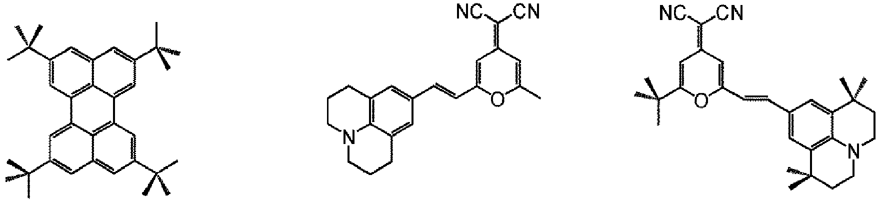 **TBPe DCM DCJTB**

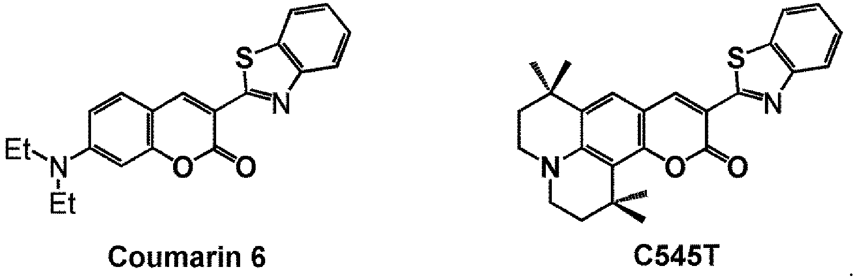

### [Electron transport region in the organic layer 150]

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one layer selected from a buffer layer, a hole blocking layer, an electron control layer, an electron transport layer, and an electron injection layer. However, embodiments of the invention are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein for each structure, constituting layers are sequentially stacked from an emission layer. However, embodiments of the structure of the electron transport region are not limited thereto,

The electron transport region (for example, a buffer layer, a hole blocking layer, an electron control layer, or an electron transport layer in the electron transport region) may include a metal-free compound including at least one π electron-depleted nitrogen-containing ring.

The "π electron-depleted nitrogen-containing ring" indicates a C₁-C₆₀ (*e.g.* a C₁-C₃₀) heterocyclic group having at least one ^{∗}-N=^{∗}' moiety as a ring-forming moiety.

For example, the "π electron-depleted nitrogen-containing ring" may be i) a 5-membered to 7-membered heteromonocyclic group having at least one ^{∗}-N=^{∗}' moiety, ii) a heteropolycyclic group in which two or more 5-membered to 7-membered heteromonocyclic groups each having at least one ^{∗}-N=^{∗}' moiety are condensed with each other, or iii) a heteropolycyclic group in which at least one of 5-membered to 7-membered heteromonocyclic groups, each having at least one ^{∗}-N=^{∗}' moiety, is condensed with at least one C₅-C₆₀ (*e.g.* a C₅-C₃₀) carbocyclic group.

Examples of the π electron-depleted nitrogen-containing ring include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, thiadiazole, an imidazopyridine, an imidazopyrimidine, and an azacarbazole, but are not limited thereto.

The electron transport region may include a compound represented by Formula 601.

<Formula 601> [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer of 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), - -C(=O)(Q₆₀₁), -S(=O)₂(Q₆₀₁), and -P(=O)(Q₆₀₁)(Q₆₀₂), and
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer of 1 to 5.

In an embodiment, at least one of Ar₆₀₁(s) in the number of xe11 and R₆₀₁(s) in the number of xe21 may include the π electron-depleted nitrogen-containing ring.

For example, Ar₆₀₁ may be a substituted or unsubstituted C₅-C₃₀ carbocyclic group or a substituted or unsubstituted C₁-C₂₀ heterocyclic group, but embodiments are not limited thereto.

In an embodiment, ring Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In Formula 601, when xe11 is two or more, two or more Ar₆₀₁(s) may be linked via a single bond.

In one or more embodiments, Ar₆₀₁ in Formula 601 may be an anthracene group.

In one or more embodiments, the compound represented by Formula 601 may be represented by Formula 601-1:

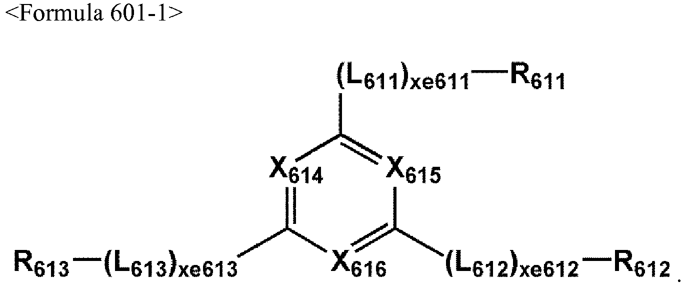

In Formula 601-1,
X₆₁₄ may be N or C(R₆₁₄), X₆₁₅ may be N or C(R₆₁₅), and X₆₁₆ may be N or C(R₆₁₆), wherein at least one selected from X₆₁₄ to X₆₁₆ may be N,
L₆₁₁ to L₆₁₃ may respectively be the same as defined in connection with L₆₀₁,
xe611 to xe613 may respectively be the same as defined in connection with xe1,
R₆₁₁ to R₆₁₃ may respectively be the same as defined in connection with R₆₀₁, and
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

In an embodiment, in Formulae 601 and 601-1, L₆₀₁ and L₆₁₁ to L₆₁₃ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group. However, embodiments of the invention are not limited thereto.

In one or more embodiments, in Formulae 601 and 601-1, xe1 and xe611 to xe613 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂).

In one or more embodiments, in Formulae 601 and 601-1, R₆₀₁ and R₆₁₁ to R₆₁₃ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂), and
Q₆₀₁ and Q₆₀₂ may respectively be the same as defined above.

The electron transport region may include at least one compound selected from Compounds ET1 to ET36, but embodiments of the invention are not limited thereto:

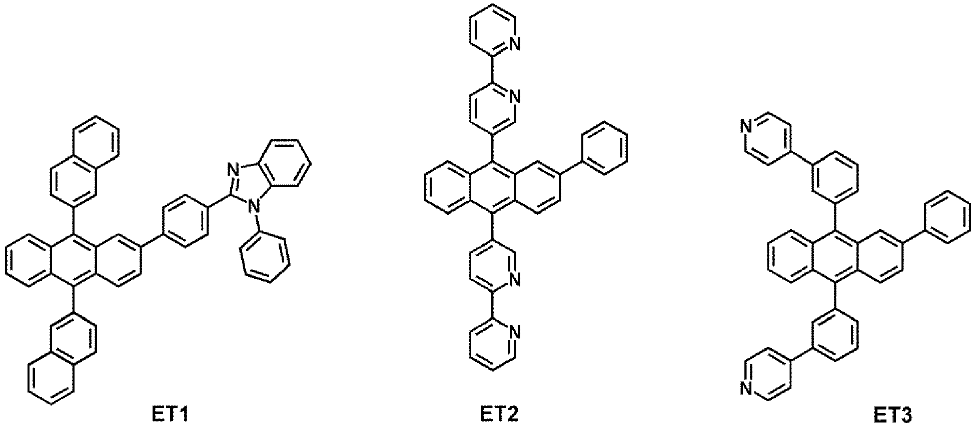

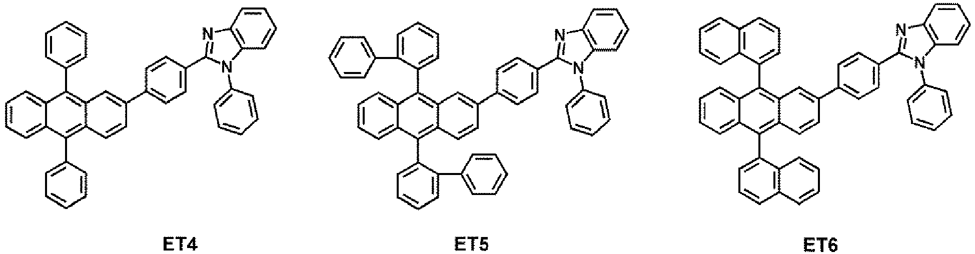

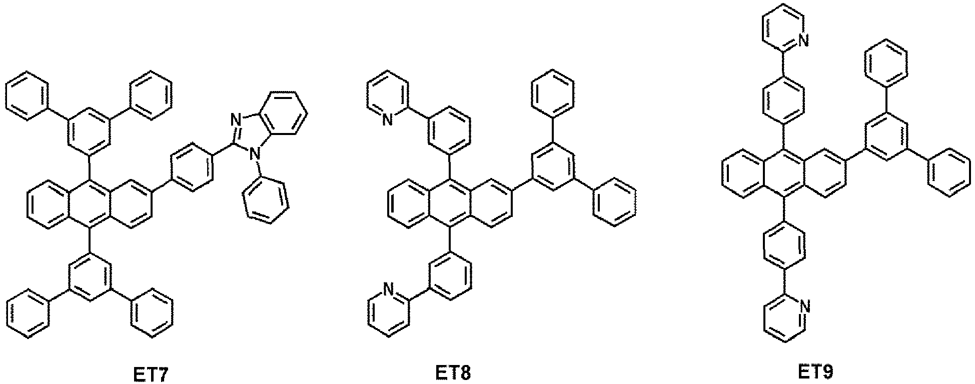

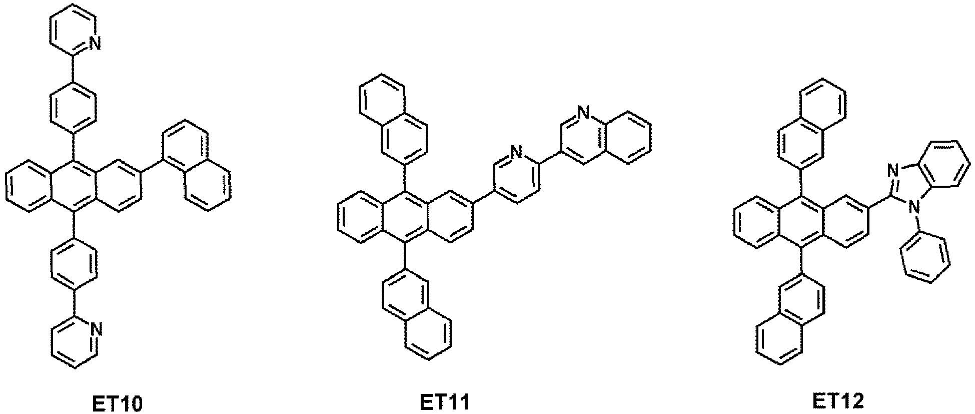

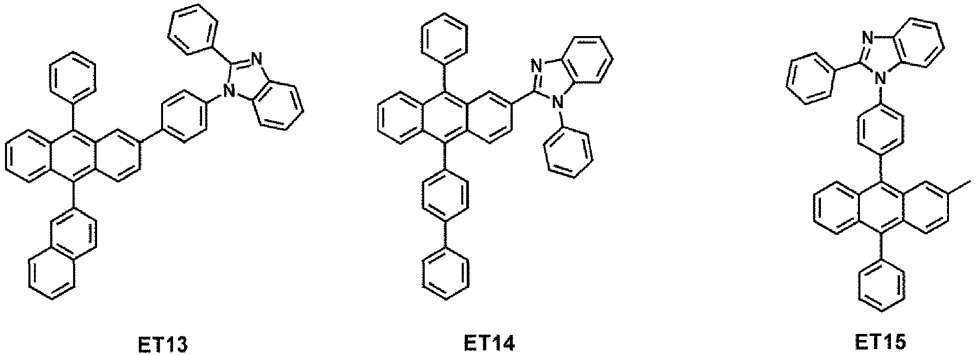

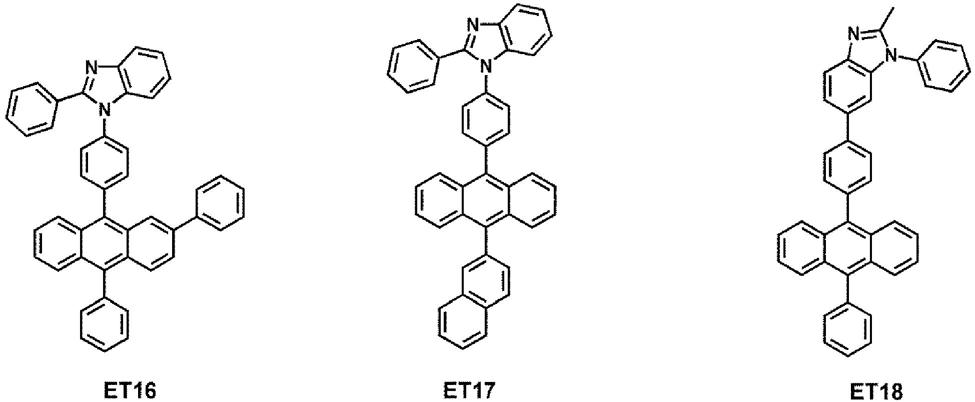

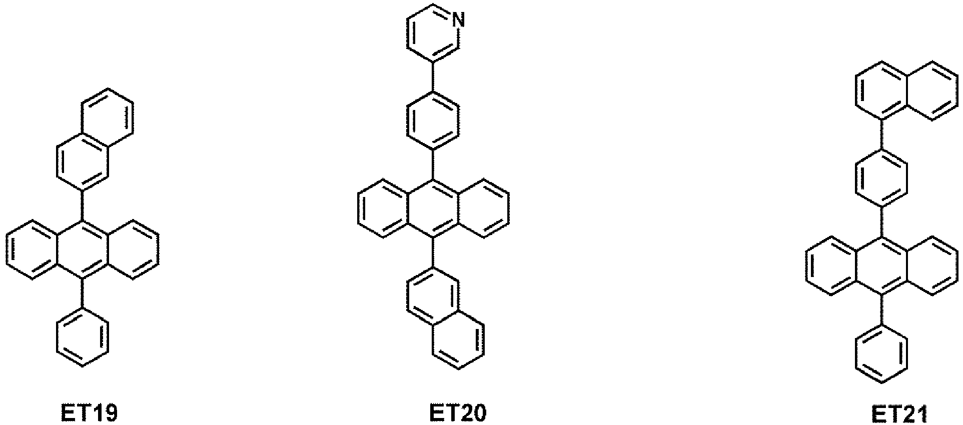

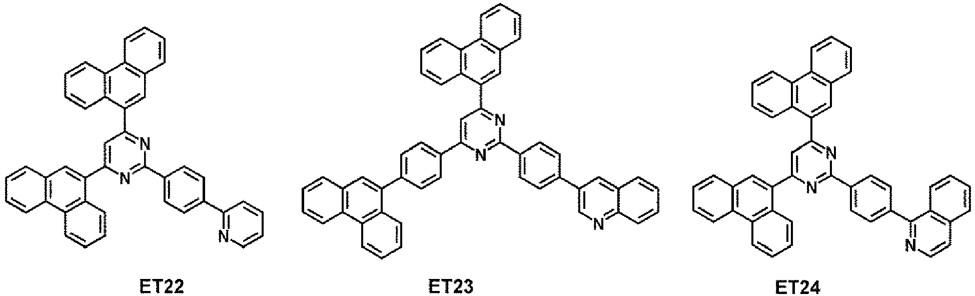

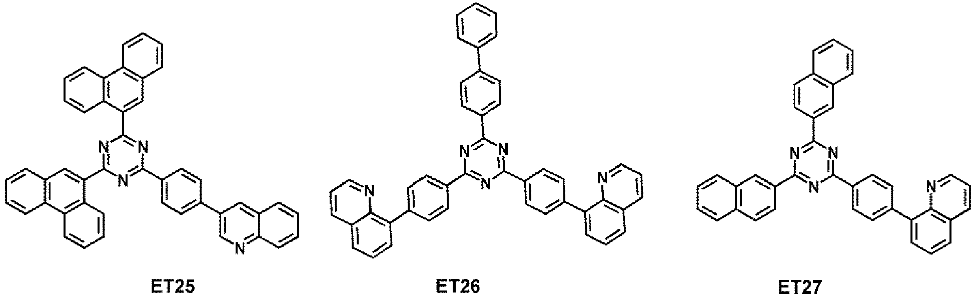

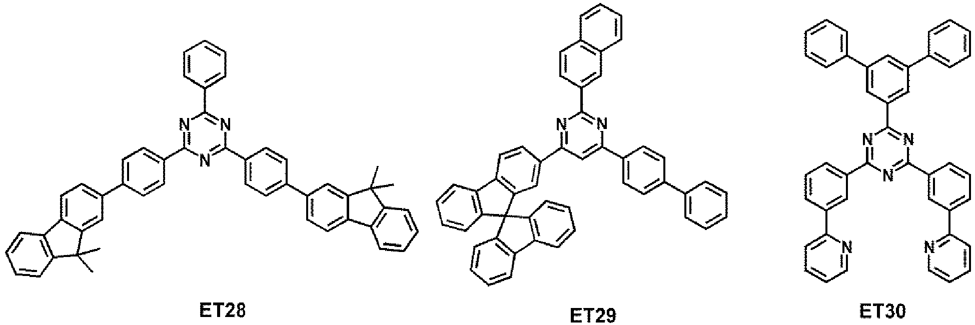

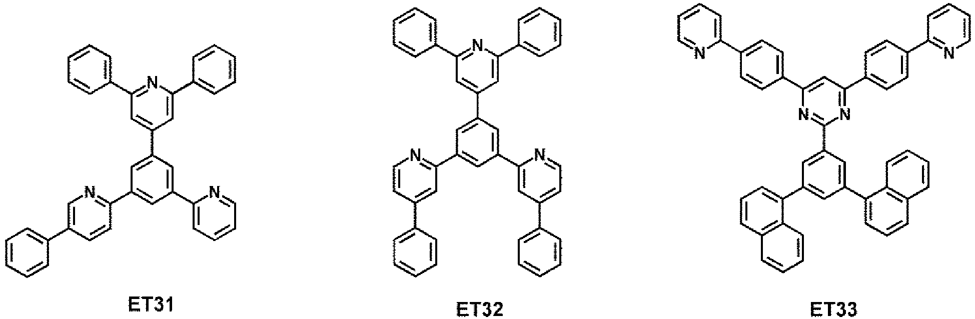

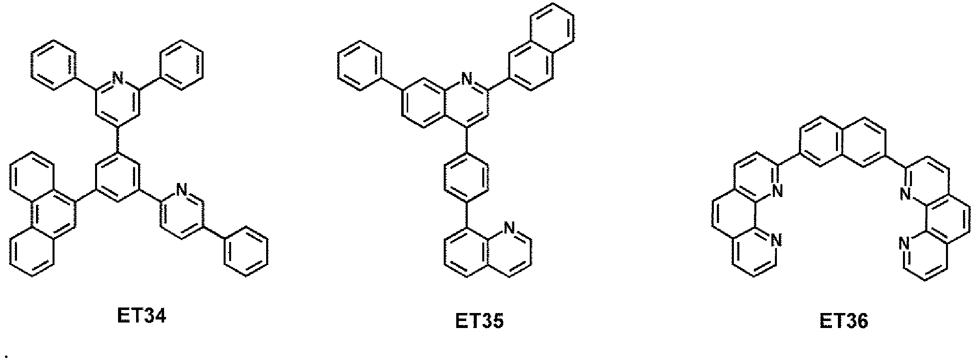

In one or more embodiments, the electron transport region may include at least one compound selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-*tert*-butylphenyl)-4-phenyl-4*H*-1,2,4-triazole (TAZ), and NTAZ:

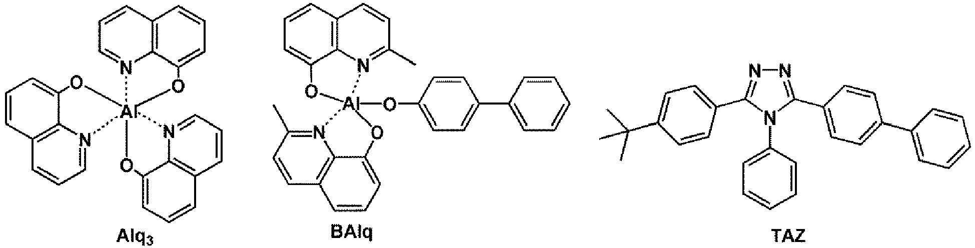

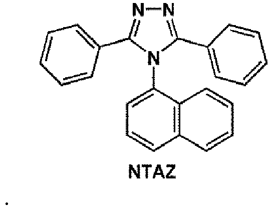

Thicknesses of the buffer layer, the hole blocking layer, and the electron control layer may each be in a range of about 20 Å to about 1,000 Å, for example, about 20 Å to about 700 Å, about 20 Å to about 500 Å, about 20 Å to about 400, about 30 Å to about 400 Å or about 30 Å to about 300 Å. When the thicknesses of the buffer layer, the hole blocking layer, and the electron control layer are within these ranges, the electron blocking layer may have excellent electron blocking characteristics or electron control characteristics without a substantial increase in driving voltage.

A thickness of the electron transport layer may be from about 100 Å to about 1,000 Å, for example, about 100 Å to about 700 Å, about 100 Å to about 600 Å, about 150 Å to about 600 Å, about 150 Å to about 500 Å or about 250 Å to about 350 Å. When the thickness of the electron transport layer is within the ranges described above, excellent electron transport characteristics may be obtained without a substantial increase in driving voltage.

The electron transport region (for example, the electron transport layer in the electron transport region) may further include, in addition to the materials described above, a metal-containing material.

The metal-containing material may include at least one selected from alkali metal complex and alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the invention are not limited thereto.

For example, the metal-containing material may include a Li complex. The Li complex may include, for example, Compound ET-D1 (lithium quinolate, LiQ) or ET-D2.

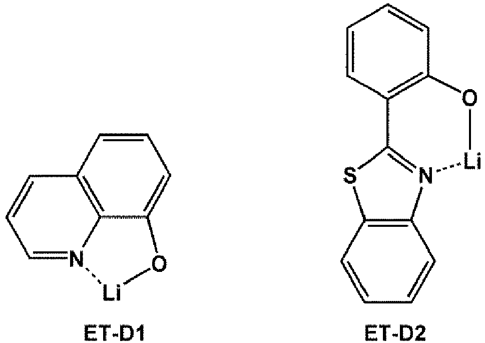

The electron transport region may include an electron injection layer that facilitates electron injection from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may be selected from Li, Na, K, Rb, and Cs. In an embodiment, the alkali metal may be Li, Na, or Cs. In one or more embodiments, the alkali metal may be Li or Cs, but embodiments of the invention are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, or iodides) of the alkali metal, the alkaline earth-metal, and the rare earth metal.

The alkali metal compound may be selected from alkali metal oxides, such as Li₂O, Cs₂O, or K₂O, and alkali metal halides, such as LiF, NaF, CsF, KF, LiI, NaI, Csl, or KI. In an embodiment, the alkali metal compound may be selected from LiF, Li₂O, NaF, LiI, NaI, Csl, and KI, but embodiments of the invention are not limited thereto.

The alkaline earth-metal compound may be selected from alkaline earth-metal oxides, such as BaO, SrO, CaO, BaₓSr₁₋ₓO (0<x<1), or BaₓCa₁₋ₓO (0<x<1). In an embodiment, the alkaline earth-metal compound may be selected from BaO, SrO, and CaO, but embodiments of the invention are not limited thereto.

The rare earth metal compound may be selected from YbF₃, ScF₃, ScO₃, Y₂O₃, Ce₂O₃, GdF₃, and TbF₃. In an embodiment, the rare earth metal compound may be selected from YbF₃, ScF₃, TbF₃, YbI₃, ScI₃, and TbI₃, but embodiments of the invention are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the invention are not limited thereto.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above, and in one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof may be homogeneously or non-homogeneously dispersed in a matrix including the organic material.

A thickness of the electron injection layer may be in a range of about 1 Å to about 100 Å, for example, about 3 Å to about 90 Å or about 3 Å to about 20 Å. If the thickness of the electron injection layer is within the ranges described above, excellent electron injection characteristics may be obtained without a substantial increase in driving voltage.

### [Second electrode 190]

The second electrode 190 may be disposed on the organic layer 150 having such a structure. The second electrode 190 may be a cathode that is an electron injection electrode. In this regard, a metal, an alloy, an electrically conductive compound, and a mixture thereof may be used for forming the second electrode 190. Each of the metal, alloy, and electrically conductive material may have a low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the invention are not limited thereto. The first electrode 190 may be a transmissive electrode, a semi-transmissive electrode, or a reflective electrode.

The first electrode 190 may have a single-layered structure, or a multi-layered structure including two or more layers.

Hereinbefore, the organic light-emitting device according to an embodiment has been described in connection with FIG. 1.

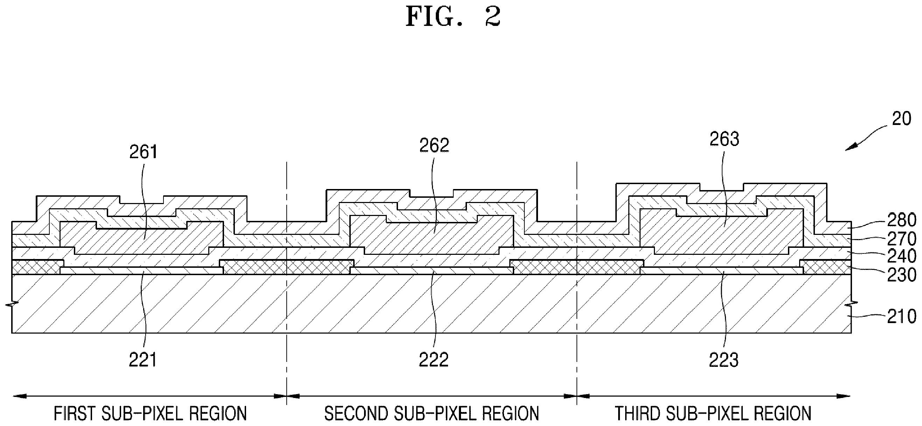

FIG. 2 is a schematic cross-sectional view of a full-color organic light-emitting device according to an embodiment.

A substrate 210 of an organic light-emitting device 20 of FIG. 2 is divided into a first sub-pixel region, a second sub-pixel region, and a third sub-pixel region.

A first sub-pixel is formed in the first sub-pixel region, a second sub-pixel is formed in the second sub-pixel region, and a third sub-pixel is formed in the third sub-pixel region.

A plurality of first electrodes 221, 222, and 223 are respectively disposed in the first sub-pixel region, the second sub-pixel region, and the third sub-pixel region of the substrate 210. That is, the first electrode 221 is disposed in the first sub-pixel region, the first electrode 222 is disposed in the second sub-pixel region, and the first electrode 223 is disposed in the third sub-pixel region.

A hole transport region 240 is disposed on the first electrodes 221, 222, and 223. The hole transport region 240 may be formed on the first electrode 221, 222, and 223 as a common layer. The hole transport region 240 includes a first hole transport region formed in the first sub-pixel region, a second hole transport region formed in the second sub-pixel region, and a third hole transport region formed in the third sub-pixel region. For example, the hole transport region may include a first compound represented by Formula 1 and a second compound represented by Formula 2.

The hole transport region 240 includes a first layer and a second layer. The second layer may be disposed between the first layer and the first electrode. The first layer includes the first compound and the second layer includes the second compound according to the claims.

The first compound represented by Formula 1 and the second compound represented by Formula 2 are respectively the same as defined above.

An emission layer including a first emission layer 261, a second emission layer 262, and a third emission layer 263 are formed on the hole transport region 240. The first emission layer 261 is disposed in the first sub-pixel region to emit first color light, the second emission layer 262 is disposed in the second sub-pixel region to emit second color light, and the third emission layer 263 is disposed in the third sub-pixel region to emit third color light. For example, at least one of the first emission layer 261, the second emission layer 262, and the third emission layer 263 may include an amine-based compound represented by Formula 1.

The first color light may be red light, the second color light may be green light, and the third color light may be blue light. The first color light, the second color light, and the third color light may be combined to emit white light.

An electron transport region 270 is formed on the emission layers 261, 262, and 263. The electron transport region 270 may be formed on the emission layers 261, 262, and 263 as a common layer. The electron transport region 270 may include an electron transport layer and an electron injection layer sequentially stacked from the emission layers 261, 262, and 263.

A second electrode 280 is formed on the electron transport region 270 as a common layer.

The term "common layer" used herein refers to a layer entirely formed in the first sub-pixel region, the second sub-pixel region, and the third sub-pixel region, without being patterned for the first sub-pixel region, the second sub-pixel region, and the third sub-pixel region.

A pixel insulating film 230 is formed at edges of the first electrodes 221, 222, and 223. The pixel insulating film 230 may define a pixel region and may include known organic insulating materials (for example, a silicon-based material), inorganic insulating materials, and/or organic/inorganic composite insulating materials.

The first electrodes 221, 222, and 223, the hole transport region 240, the emission layers 261, 262, and 263, the electron transport region 270, and the second electrode 280 may respectively be defined the same as described with reference to FIG. 1.

The organic light-emitting device 20 may be included in a flat-panel display apparatus including a thin film transistor. The thin film transistor may include a gate electrode, a source electrode, a drain electrode, a gate insulating film, and an active layer. One of the source electrode and the drain electrode may electrically contact the first electrodes 221, 222, and 223 of the organic light-emitting device. The active layer may include crystalline silicon, amorphous silicon, organic semiconductor, oxide semiconductor, or the like, but embodiments of the invention are not limited thereto.

The full-color organic light-emitting device has been described with reference to FIG. 2, but embodiments of the invention are not limited thereto. For example, the third emission layer 263 may extend to the first sub-pixel region and the second sub-pixel region and act as a common layer. In addition, the third auxiliary layer of the third sub-pixel region may be omitted. Furthermore, various modifications may be made thereto. For example, only one of the first auxiliary layer and the second auxiliary layer may be employed.

### [General definition of substituents]

The term "C₁-C₆₀ alkyl group" as used herein refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as used herein refers to a hydrocarbon group having at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as used herein refers to a hydrocarbon group having at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent saturated monocyclic group having at least one heteroatom selected from N, O, Si, P, and S as a ring-forming atom and 1 to 10 carbon atoms, and examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, Si, P, and S as a ring-forming atom, 1 to 10 carbon atoms, and at least one carbon-carbon double bond in its ring. Non-limiting examples of the C1-C10 heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group," used herein, refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other. Corresponding definitions apply to other ranges given for the number of carbon atoms in an aryl/arylene group.

The term "C₁-C₆₀ heteroaryl group" as used herein refers to a monovalent group having a heterocyclic aromatic system that has at least one heteroatom selected from N, O, Si, P, and S as a ring-forming atom, in addition to 1 to 60 carbon atoms. The term "C₁-C₆₀ heteroarylene group" as used herein refers to a divalent group having a heterocyclic aromatic system that has at least one heteroatom selected from N, O, Si, P, and S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other. Corresponding definitions apply to other ranges given for the number of carbon atoms in an heteroaryl/heteroarylene group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group). Corresponding definitions apply to other ranges given for the number of carbon atoms in an aryloxy group and an arylthio group.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, Si, P, and S, other than carbon atoms, as a ring-forming atom, and no aromaticity in its entire molecular structure. An example of the monovalent non-aromatic condensed heteropolycyclic group is a carbazolyl group. The term "divalent non-aromatic condensed heteropolycyclic group" as used herein refers to a divalent group having the same structure as the monovalent non-aromatic condensed heteropolycyclic group.

The term "C₃-C₆₀ carbocyclic group" as used herein refers to a monocyclic or polycyclic group having 3 to 60 carbon atoms in which a ring-forming atom is a carbon atom only. The C₃-C₆₀ carbocyclic group may be an aromatic carbocyclic group or a non-aromatic carbocyclic group. The C₃-C₆₀ carbocyclic group may be a ring, such as benzene, a monovalent group, such as a phenyl group, or a divalent group, such as a phenylene group. In one or more embodiments, depending on the number of substituents connected to the C₃-C₆₀ carbocyclic group, the C₃-C₆₀ carbocyclic group may be a trivalent group or a quadrivalent group. Corresponding definitions apply to other ranges given for the number of carbon atoms in a carbocyclic group.

The term "C₁-C₆₀ heterocyclic group" as used herein refers to a group having the same structure as the C₃-C₆₀ carbocyclic group, except that as a ring-forming atom, at least one heteroatom selected from N, O, Si, P, and S is used in addition to carbon (the number of carbon atoms may be in a range of 1 to 60). Corresponding definitions apply to other ranges given for the number of carbon atoms in a heterocyclic group.

At least one substituent of the substituted C₃-C₆₀ (*e.g.* C₃-C₂₀) carbocyclic group, the substituted C₁-C₆₀ *(e.g.* C₁-C₂₀) heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ *(e.g.* C₆-C₃₀) arylene group, the substituted C₁-C₆₀ *(e.g.* C₁-C₂₀) heteroarylene group, the substituted divalent non-aromatic condensed polycyclic group, the substituted divalent non-aromatic condensed heteropolycyclic group, the substituted C₁-C₆₀ *(e.g.* C₁-C₂₀) alkyl group, the substituted C₂-C₆₀ *(e.g.* C₂-C₂₀) alkenyl group, the substituted C₂-C₆₀ *(e.g.* C₂-C₂₀) alkynyl group, the substituted C₁-C₆₀ *(e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ *(e.g.* C₆-C₃₀) aryl group, the substituted C₆-C₆₀ *(e.g.* C₆-C₃₀) aryloxy group, the substituted C₆-C₆₀ *(e.g.* C₆-C₃₀) arylthio group, the substituted C₁-C₆₀ *(e.g.* C₁-C₂₀) heteroaryl group, the substituted monovalent non-aromatic condensed polycyclic group, and the substituted monovalent non-aromatic condensed heteropolycyclic group may be selected from:
deuterium, -F, -Cl, -Br, -I, a hydroxyl group, a cyano group, a nitro group, an amidino group, a hydrazino group, a hydrazono group, a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, and a C₁-C₆₀ *(e.g.* C₁-C₂₀) alkoxy group;
a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, and a C₁-C₆₀ *(e.g.* C₁-C₂₀) alkoxy group, each substituted with at least one substituent selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ *(e.g.* C₆-C₃₀) aryloxy group, a C₆-C₆₀ (*e.g.* C₆-C₃₀) arylthio group, a C₁-C₆₀ *(e.g.* C₁-C₂₀) heteroaryl group, a monovalent non-aromatic condensed polycyclic group, a monovalent non-aromatic condensed heteropolycyclic group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ (*e.g.* C₆₋C₃₀) aryloxy group, a C₆-C₆₀ *(e.g.* C₆-C₃₀) arylthio group, a C₁-C₆₀ *(e.g.* C₁-C₂₀) heteroaryl group, a monovalent non-aromatic condensed polycyclic group, a monovalent non-aromatic condensed heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ (*e.g.* C₆-C₃₀) aryloxy group, a C₆-C₆₀ *(e.g.* C₆-C₃₀) arylthio group, a C₁-C₆₀ *(e.g.* C₁-C₂₀) heteroaryl group, a monovalent non-aromatic condensed polycyclic group, and a monovalent non-aromatic condensed heteropolycyclic group, each substituted with at least one substituent selected from deuterium, -F, -Cl, -Br, -I, a hydroxyl group, a cyano group, a nitro group, an amidino group, a hydrazino group, a hydrazono group, a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, a C₁-C₆₀ *(e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₆-C₆₀ *(e.g.* C₆-C₃₀) aryloxy group, a C₆-C₆₀ *(e.g.* C₆-C₃₀) arylthio group, a C₁-C₆₀ *(e.g.* C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and - P(=O)(Q₂₁)(Q₂₂);
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ *(e.g.* C₁-C₂₀) alkyl group, a C₂-C₆₀ (*e.g.* C₂-C₂₀) alkenyl group, a C₂-C₆₀ *(e.g.* C₂-C₂₀) alkynyl group, a C₁-C₆₀ *(e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ *(e.g.* C₆-C₃₀) aryl group, a C₁-C₆₀ *(e.g.* C₁-C₂₀) heteroaryl group, a monovalent non-aromatic condensed polycyclic group, a monovalent non-aromatic condensed heteropolycyclic group, a biphenyl group, and a terphenyl group.

The term "Ph" as used herein represents a phenyl group, the term "Me" as used herein represents a methyl group, the term "Et" as used herein represents an ethyl group, and the term "ter-Bu" or "Bu^{t}" as used herein represents a tert-butyl group.

The term "biphenyl group" as used herein refers to "a phenyl group substituted with a phenyl group." In other words, the "biphenyl group" is a substituted phenyl group having a C₆-C₆₀ aryl group as a substituent.

The term "terphenyl group" as used herein refers to "a phenyl group substituted with a biphenyl group." In other words, the "terphenyl group" is a phenyl group having, as a substituent, a C₆-C₆₀ aryl group substituted with a C₆-C₆₀ aryl group.
^{∗} and ^{∗}' used herein, unless defined otherwise, each refer to a binding site to a neighboring atom in a corresponding formula.

Hereinafter, a compound according to embodiments and an organic light-emitting device according to embodiments will be described in detail with reference to Synthesis Examples and Examples. The wording "B was used instead of A" used in describing Synthesis Examples means that a molar equivalent of A was identical to a molar equivalent of B.

### [Examples]

### Synthesis Example 1: Synthesis of Compound 1-1

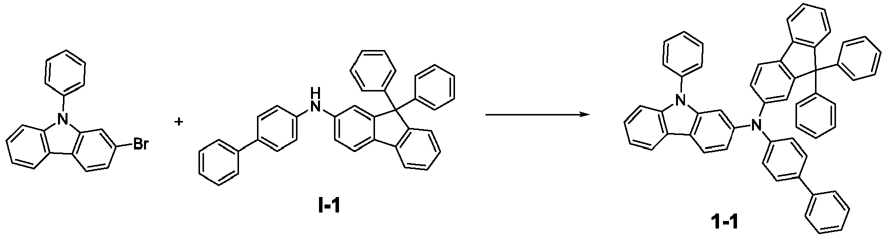

### Synthesis of Intermediate I-1

10 g of biphenyl-4-ylamine, 24.65 g (1.05 eq) of 2-bromo-9,9-diphenyl-9H-fluorene, 2.71 g (0.05 eq) of tris(dibenzylideneacetone)dipalladium(0) (Pd₂(dba)₃), 0.84 g (0.07 eq) of tri-tert-butylphosphine (P(t-Bu)₃), and 11.36 g (2.0 eq) of sodium tert-butoxide were added to a reaction container, and a vacuum environment was made therein. After changing to an N₂ atmosphere, 90 ml of toluene was added thereto and stirred at a temperature of 120 °C for 2 hours. A solvent was removed therefrom by using a rotary evaporator, and the reaction product was extracted therefrom twice by using 200 ml of dichloromethane (CH₂Cl₂) and 150 ml of water. An organic layer obtained therefrom was dried by using magnesium sulfate, and the residual obtained by evaporating the solvent therefrom was separation-purified by silica gel column chromatography to obtain 28 g (yield of 98 %) of Intermediate I-1. The obtained compound was identified by LC-MS. C₃₇H₂₇N: M+1 485.3.

### Synthesis of Compound 1-1

4.5 g of 2-bromo-9-phenyl-9H-carbazole(2-bromo-9-phenyl-9H-carbazole), 7.12 g (1.05 eq) of Intermediate I-1, 0.64 g (0.05 eq) of tris(dibenzylideneacetone)dipalladium(0) (Pd₂(dba)₃), 0.20 g (0.07 eq) of tri-tert-butylphosphine (P(t-Bu)₃), and 2.68 g (2.0 eq) of sodium tert-butoxide were added to a reaction container, and a vacuum environment was made therein. After changing to an N₂ atmosphere, 50 ml of toluene was added thereto and stirred at a temperature of 120 °C for 2 hours. A solvent was removed therefrom by using a rotary evaporator, and the reaction product was extracted therefrom twice by using 200 ml of dichloromethane (CH₂Cl₂) and 150 ml of water. An organic layer obtained therefrom was dried by using magnesium sulfate, and the residual obtained by evaporating the solvent therefrom was separation-purified by silica gel column chromatography to obtain 7.2 g (71 %) of Compound 1. The obtained compound was identified by LC-MS and NMR. C₅₅H₃₈N₂: M+1 726.4.

### Synthesis Example 2: Synthesis of Compound 1-6

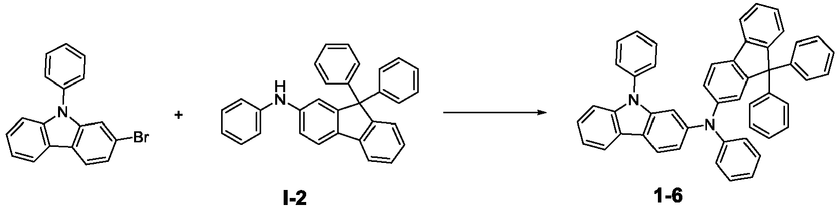

### Synthesis of Intermediate I-2

Intermediate I-2 was synthesized in the same manner as used to synthesize Intermediate I-1 in Synthesis Example I-1, except that phenylamine was used instead of biphenyl-4-ylamine in synthesizing Intermediate I-1. The obtained compound was identified by LC-MS. C₃₁H₂₃N: M+1 409.3.

### Synthesis of Compound 1-6

Compound 1-6 was synthesized in the same manner as used to synthesize Compound 1-1 in Synthesis Example 1, except that Intermediate I-2 was used instead of Intermediate I-1 in synthesizing Compound 1-1. The obtained compound was identified by LC-MS and NMR. C₄₉H₃₄N₂: M+1 650.4.

### Synthesis Example 3: Synthesis of Compound 1-12

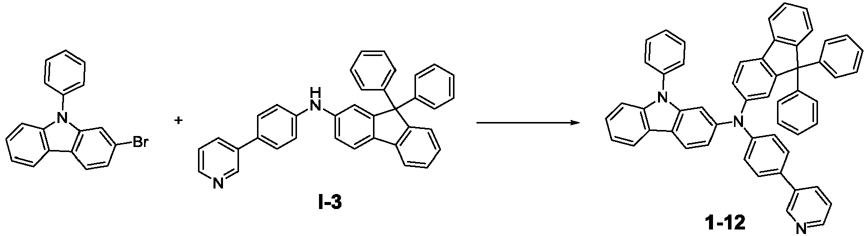

### Synthesis of Intermediate I-3

Intermediate I-3 was synthesized in the same manner as used to synthesize Intermediate I-1 in Synthesis Example 1, except that 3-(4-bromo-phenyl)-pyridine) was used instead of biphenyl-4-ylamine in synthesizing Intermediate I-1. The obtained compound was identified by LC-MS. C₃₆H₂₆N₂: M+1 486.3.

### Synthesis of Compound 1-12

Compound 1-12 was synthesized in the same manner as used to synthesize Compound 1-1 in Synthesis Example 1, except that Intermediate I-3 was used instead of Intermediate I-1 in synthesizing Compound I-1. The obtained compound was identified by LC-MS and NMR. C₅₄H₃₇N₃: M+1 727.4.

### Synthesis Example 4: Synthesis of Compound 1-16

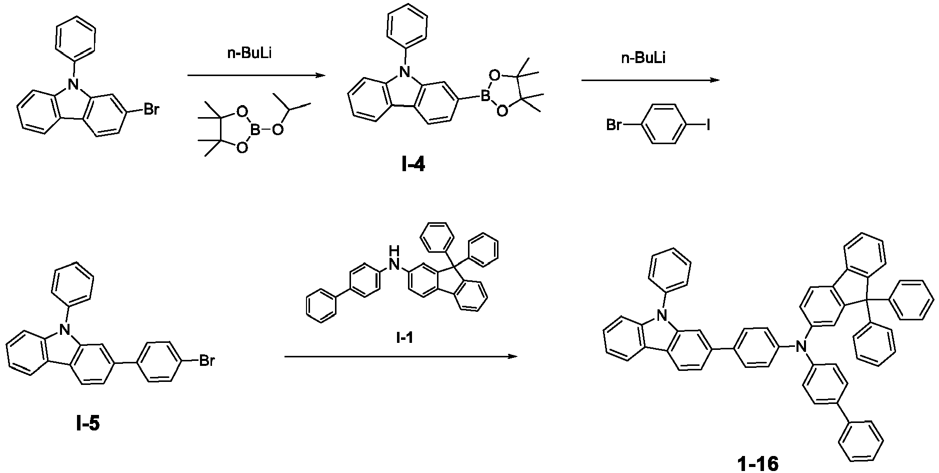

### Synthesis of Intermediate I-4

10 g of 2-bromo-9-phenyl-9H-carbazole was added to a reaction container, and a vacuum environment was made therein. After changing to an N₂ atmosphere, 60 ml of anhydrous tetrahydrofuran (THF) was added thereto and maintained at a temperature of -78 °C. Then, 13.04 ml (1.05 eq) of n-BuLi was slowly added dropwise thereto. After stirring for 2 hours while maintaining a low temperature, 7.6 ml (1.2 eq) of 2-isopropoxy-4,4,5,5-tetramethyl-1,3,2-dioxaborolane was added thereto and stirred for 2 hours. A solvent was removed therefrom by using a rotary evaporator, and the reaction product was extracted therefrom by using 200 ml of dichloromethane (CH₂Cl₂) and 150 ml of water. An organic layer obtained therefrom was dried by using magnesium sulfate, and the residual obtained by evaporating a solvent therefrom was separation-purified by silica gel column chromatography to obtain 9 g (yield of 78 %) of Intermediate I-4. The obtained compound was identified by LC-MS. C₂₄H₂₄BNO₂: M+1 369.3.

### Synthesis of Intermediate I-5

9 g of Intermediate I-4, 7.58 g (1.1 eq) of 1-bromo-4-iodo-benzene, 1.97 g (0.07 eq) of tetrakis(triphenylphosphine)palladium(0), and 5.05 g (1.5 eq) of potassium carbonate were added to a reaction container, and a vacuum environment was made therein. After changing to an N₂ atmosphere, 40 ml of THF and 20 ml of distilled water were added thereto and stirred at a temperature of 75 °C for 24 hours. A solvent was removed therefrom by using a rotary evaporator, and the reaction product was extracted therefrom twice by using 200 ml of dichloromethane (CH₂Cl₂) and 150 ml of water. An organic layer obtained therefrom was dried by using magnesium sulfate, and the residual obtained by evaporating the solvent therefrom was separation-purified by silica gel column chromatography to obtain 7.35 g (yield of 76 %) of Intermediate I-5. The obtained compound was identified by LC-MS. C₂₄H₁₆BrN: M+1 397.1.

### Synthesis of Compound 1-16

5.0 g of Intermediate I-5, 6.4 g (1.05 eq) of Intermediate I-1, 0.58 g (0.05 eq) of tris(dibenzylideneacetone)dipalladium(0) (Pd₂(dba)₃), 0.36 g (0.07 eq) of tri-tert-butylphosphine (P(t-Bu)₃), and 2.53 g (2.0 eq) of sodium tert-butoxide were added to a reaction container, and a vacuum environment was made therein. After changing to an N₂ atmosphere, 60 ml of toluene was added thereto and stirred at a temperature of 120 °C for 2 hours. A solvent was removed therefrom by using a rotary evaporator, and the reaction product was extracted therefrom twice by using 200 ml of dichloromethane (CH₂Cl₂) and 150 ml of water. An organic layer obtained therefrom was dried by using magnesium sulfate, and the residual obtained by evaporating the solvent therefrom was separation-purified by silica gel column chromatography to obtain 7.26 g (yield of 72 %) of Compound 1-16. The obtained compound was identified by LC-MS and NMR. C₆₁H₄₂N₂: M+1 802.4.

### Synthesis Example 5: Synthesis of Compound 1-30

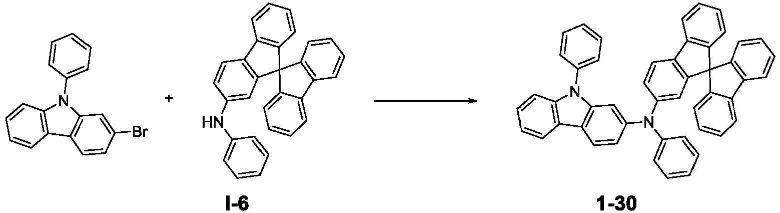

Compound 1-30 was synthesized in the same manner as used to synthesize Compound 1-1 in Synthesis Example 1, except that Intermediate I-6 was used instead of Intermediate I-1 in synthesizing Compound 1-1. The synthesized compound was identified by LC-MS and NMR. C₄₉H₃₂N₂: M+1 648.4.

### Synthesis Example 6: Synthesis of Compound 1-47

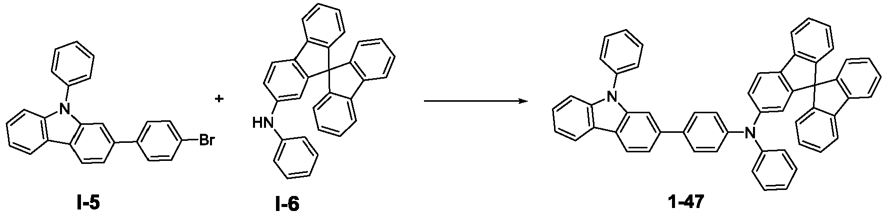

Compound 1-47 was synthesized in the same manner as used to synthesize Compound 1-30 in Synthesis Example 5, except that Intermediate I-5 was used instead of 2-bromo-9-phenyl-9H-carbazole in synthesizing Compound 1-30. The obtained compound was identified by LC-MS and NMR. C₅₅H₃₆N₂: M+1 724.4.

### Synthesis Example 7: Synthesis of Compound 1-49

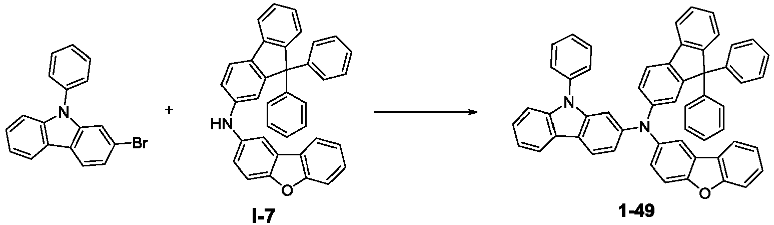

Compound 1-49 was synthesized in the same manner as used to synthesize Compound 1-1 in Synthesis Example 1, except that Intermediate I-7 was used instead of Intermediate I-1 in synthesizing Compound 1-1. The obtained compound was identified by LC-MS and NMR. C₅₅H₃₆N₂O: M+1 740.4.

### Synthesis Example 8: Synthesis of Compound 1-56

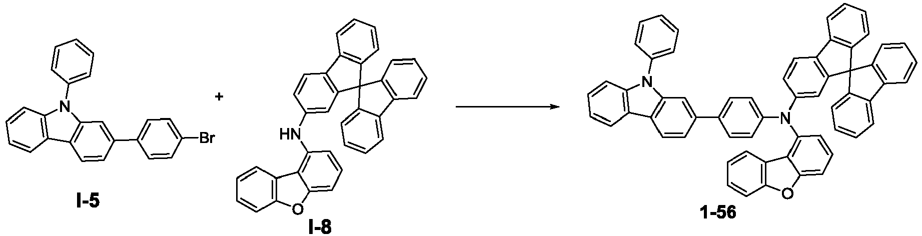

Compound 1-56 was synthesized in the same manner as used to synthesize Compound 1-47 in Synthesis Example 6, except that Intermediate I-8 was used instead of Intermediate I-6 in synthesizing Compound 1-47. The obtained compound was identified by LC-MS and NMR. C₆₁H₃₈N₂O: M+11 814.4.

### Synthesis Example 9: Synthesis of Compound 2-8

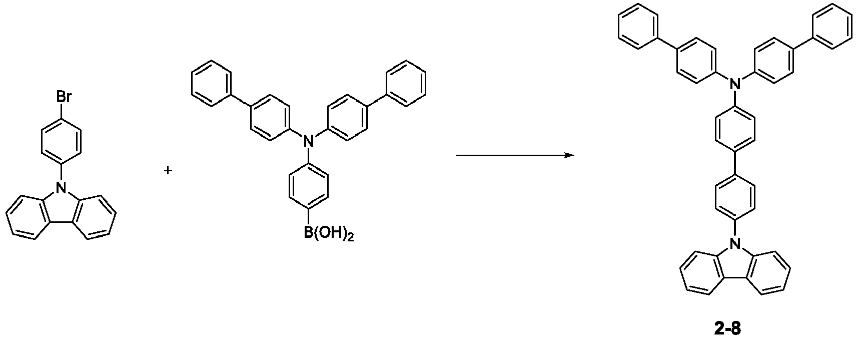

14.9 g (46.6 mmol) of 9-(4-bromophenyl)-9H-carbazole, 22.6 g (51.3 mmol) of (4-(di([1,1'-biphenyl]-4-yl)amino)phenyl)boronic acid, 19.3 g (139.8 mmol) of potassium carbonate, and 1 g (0.9 mmol) of tetrakis(triphenylphosphine)palladium(0) were added to THF and refluxed for 18 hours. After the reaction was completed, a water layer was removed therefrom, and an organic layer was dried by using magnesium sulfate, filtered, and then distilled under reduced pressure. The solid obtained therefrom was dissolved in 100 ml of chloroform, and 100 ml of ethyl acetate was added thereto. The mixture was recrystallized and dried to synthesize Compound 2-8. The obtained compound was identified by LC-MS and NMR. C₄₈H₃₄N₂: M+1 638.4.

### Synthesis Example 10: Synthesis of Compound 3-1

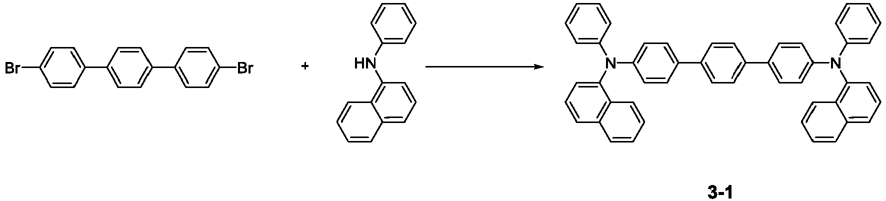

Compound 3-1 was synthesized in the same manner as used to synthesize Compound 1-1 by using 4,4"-dibromo-1,1:4',1"-terphenyl and 2 eq of N-phenylnaphthalen-1-amine. The obtained compound was identified by LC-MS and NMR. C₅₀H₃₈N₂: M+1 664.4.

### Synthesis Example 11: Synthesis of Compound 4-3

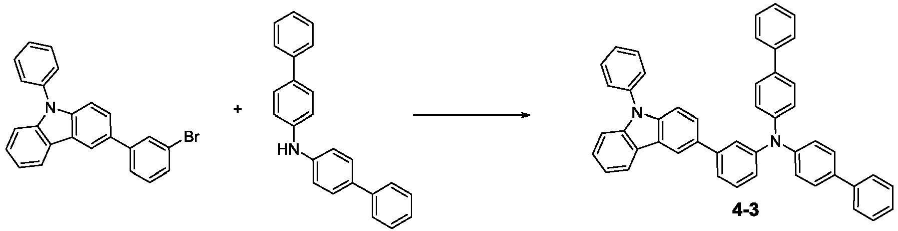

Compound 4-3 was synthesized in the same manner as in Synthesis of Compound 1-1 by using 3-(3-bromophenyl)-9-phenyl-9H-carbazole and di([1,1-biphenyl]-4-yl)amine. The obtained compound was identified by LC-MS and NMR. C₄₈H₃₄N₂: M+1 638.4.

### Synthesis Example 12: Synthesis of Compound 5-16

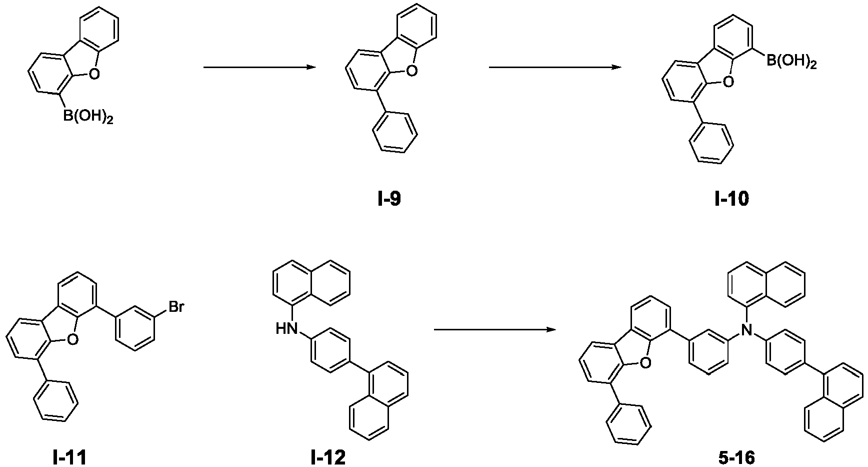

### Synthesis of Intermediate I-9

50.0 g of dibenzofuran-4-boronic acid, 57.7 g of iodobenzene, 13.6 g of Pd(PPh₃)₄, 50.0 g of Na₂CO₃, 600 mL of toluene, 150 ml of water, and 60 ml of EtOH were mixed in an Ar atmosphere and stirred at a temperature of 80 °C for 2 hours. After the reaction was completed, an organic layer was extracted therefrom, dried by using MgSO₄, and then distilled. The product obtained therefrom was purified by column chromatography (CHCl3/hexane = 0:1→1:3) to obtain 45.5 g of colorless oil Intermediate I-9.

### Synthesis of Intermediate I-10

45.5 g of Intermediate I-9 was dissolved in 300 ml of anhydrous THF in an Ar atmosphere and cooled to a temperature of -78 °C by using an acetone-dry ice bath. 140 ml of n-BuLi (1.6 M) was added dropwise to the solution while stirring the solution, and the solution was slowly heated to room temperature. The solution was stirred at room temperature for 2 hours and cooled again to a temperature of -78 °C, and 32 ml of B(OMe)₃ was added thereto. The solution was heated to room temperature and stirred for 1 hour. The reaction was terminated by adding 300 ml of saturated NH₄Cl aqueous solution thereto, and an organic layer was extracted therefrom three times by using 100 ml of CH₂Cl₂. The extracted organic layer was dried by using MgSO₄ and distilled to obtain 54 g of Intermediate I-10.

### Synthesis of Intermediate I-11

Intermediate I-10 was used in a next reaction without additional separation. 54 g of Intermediate I-10, 53.0 g of 1-bromo-3-iodobenzene, 10.8 g of Pd(PPh₃)₄, 39.7 g of Na₂CO₃, 500 ml of toluene, 200 ml of water, and 100 ml of EtOH were mixed in an Ar atmosphere and stirred at a temperature of 80 °C for 2 hours. After the reaction was terminated, an organic layer was extracted therefrom, dried by using MgSO₄, and then distilled. The product obtained therefrom was purified by column chromatography (toluene/hexane = 0:1→1:3) to obtain 51.8 g of Intermediate I-11 that was white solid.

### Synthesis of Compound 5-16

Compound 5-16 was synthesized in the same manner as in Synthesis of Compound 1-1 except that Intermediate I-11 was reacted with Intermediate I-12 instead of reacting 2-bromo-9-phenyl-9H-carbazole(2-bromo-9-phenyl-9H-carbazole) with Intermediate I-1. The obtained compound was identified by LC-MS and NMR. C₅₀H₃₃NO: M+1 663.4.

### Synthesis Example 13: Synthesis of Compound 6-9

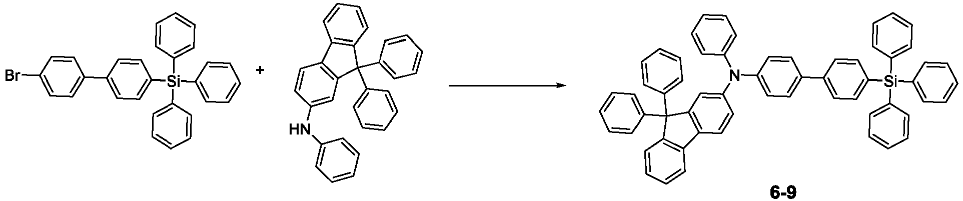

Compound 6-9 was synthesized in the same manner as in synthesis of Compound 1-1 except that (4'-bromo-[1,1'-biphenyl]-4-yl)triphenylsilane is reacted with Intermediate I-2 instead of reacting 2-bromo-9-phenyl-9H-carbazole(2-bromo-9-phenyl-9H-carbazole) with Intermediate I-1. The obtained compound was identified by LC-MS and NMR. C₆₁H₄₅NSi: M+1 819.4.

¹H NMR and MS/FAB of Compounds synthesized according to Synthesis Examples 1 to 13 are shown in Table 1.

Synthesis methods of compounds other than Compounds shown in Table 1 may also be easily recognized by those of ordinary skill in the art by referring to the synthesis mechanisms and source materials described above.

**[Table 1]**

| Compo und | ¹H NMR (CDCl₃ , 400 MHz) | LCMS | |
|---|---|---|---|
| | | found | calc. |
| 1-1 | δ = 7.84(d, 1H), 7.59(d, 1H), 7.55(d, 2H), 7.48(d, 2H), 7.4(d, 1H), 7.38(m, 1H), 7.32(m, 2H), 7.3-7.2(m, 10H) 7.14(m, 4H), 7.1-7.0 (m, 8H) 6.75 (s, 1H), 6.6(s, 1H), 6.58(d, 1H), 6.52(d, 2H), 6.2(d, 1H) | 726.4 | 726.30 |
| 1-6 | δ = 7.84(d, 1H), 7.59(d, 1H), 7.55(d, 2H), 7.40(d, 1H), 7.38(m, 1H), 7.3-7.2(m, 7H), 7.14(m, 4H), 7.1-7.0 (m, 10H) 6.75 (s, 1H), 6.62(m, 1H), 6.6(s, 1H), 6.58(d, 1H), 6.46(d, 2H), 6.2(d, 1H) | 650.4 | 650.27 |
| 1-12 | δ = 8.81(s, 1H), 8.55(d, 1H), 7.97(d, 1H), 7.84(d, 1H), 7.59(d, 1H), 7.55 (d, 2H), 7.44(m, 1H), 7.4(d, 1H), 7.38(m, 1H), 7.3-7.2(m, 9H), 7.14(m, 4H), 7.1-7.0 (m, 8H), 6.75(s, 1H), 6.6(s, 1H), 6.58(d, 1H), 6.55(d, 2H), 6.2(d, 1H) | 727.4 | 727.30 |
| 1-16 | δ = 7.84(d, 1H), 7.62(s, 1H), 7.61(d, 1H), 7.59(d, 1H), 7.55(d, 2H), 7.48(d, 2H), 7.40(d, 1H), 7.38(m, 1H), 7.32(m, 2H), 7.3-7.2(m, 12H), 7.14(m, 4H), 7.1-7.0 (m, 8H), 6.75 (s, 1H), 6.58(d, 1H), 6.52(d, 4H) | 802.4 | 802.33 |
| 1-30 | δ = 7.84(d, 1H), 7.72(d, 2H), 7.59(d, 1H), 7.55(d, 2H), 7.4(d, 1H), 7.38(m, 1H), 7.35(d, 2H), 7.3-7.2(m, 7H), 7.19(m, 2H), 7.16(m, 2H), 7.08 (m, 1H), 7.01(d, 2H), 7.0(m, 1H), 6.75(s, 1H), 6.62(m, 1H), 6.6(s, 1H), 6.58(d, 1H), 6.46(d, 2H), 6.2(d, 1H) | 648.4 | 648.26 |
| 1-47 | δ = 7.84(d, 1H), 7.72(d, 2H), 7.62(s, 1H), 7.61(d, 1H), 7.59(d, 1H), 7.55(d, 2H), 7.40(d, 1H), 7.38(m, 1H), 7.35(d, 2H), 7.3-7.2(m, 9H), 7.19(m, 2H), 7.16(m, 2H), 7.08(m, 1H), 7.01(d, 2H), 7.0 (m, 1H), 6.75 (s, 1H), 6.62(m, 1H), 6.58(d, 1H), 6.52(d, 2H). 6.46(d, 2H) | 724.4 | 724.29 |
| 1-49 | δ = 7.94 (d, 1H), 7.80 (d, 1H), 7.76-7.72 (m, 2H), 7.62 (d, 1H), 7.54-7.23 (m, 14H), 7.19-7.06 (m, 11H), 7.01-6.96 (m, 2H), 6.85-6.79 (m, 2H), 6.76-6.72 (m, 2H) | 740.4 | 740.28 |
| 1-56 | δ = 8.04 (d, 1H), 7.82-7.77 (m, 3H), 7.72-7.60 (m, 4H), 7.6 (d, 1H), 7.53-7.15 (m, 21H), 7.02 (d, 1H), 6.93-6.87 (m, 5H), 6.83 (d, 1H), 6.75 (s, 1H) | 814.4 | 814.30 |
| 2-8 | δ = 7.82 (d, 2H), 7.64-7.59 (m, 4H), 7.53-7.26 (m, 22H), 7.06-6.92 (m, 4H), 6.83-6.77 (m, 2H) | 638.4 | 638.27 |
| 3-1 | δ = 7.87 (d, 2H), 7.77 (d, 2H), 7.67 (s, 4H), 7.52-7.40 (m, 10H), 7.23 (t, 2H), 7.16-7.11 (m, 4H), 7.06-6.92 (m, 6H), 6.95-6.79 (m, 6H) | 664.4 | 664.29 |
| 4-3 | δ =7.94 (d, 1H), 7.91 (s, 1H), 7.70-7.27 (m, 24), 7.21-7.08 (m, 3H), 6.90-6.86 (m, 4H), 6.82 (d, 1H) | 638.4 | 638.27 |
| 5-16 | δ =7.83 (d, 1H), 7.79-7.73 (m, 2H), 7.69-7.63 (m, 3H), 7.61-7.50 (m, 5H), 7.48-7.34 (m, 11H), 7.26-7.09 (m, 19H), 6.93 (d, 1H), 6.83 (d, 1H) | 663.4 | 663.26 |
| 6-9 | δ = 7.76 (d, 1H), 7.60-7.39 (m, 14H), 7.33-7.12 (m, 22H), 6.96 (d, 1H), 6.93-6.84 (m, 4H), 6.81-6.76 (m, 3H) | 819.4 | 819.33 |

### Example 1

As an anode, an ITO substrate, on which ITO/Ag/ITO were respectively deposited to thicknesses of 70 Å/1,000 Å/70 Å, was cut to a size of 50 mm x 50 mm x 0.5 mm, sonicated with isopropyl alcohol and pure water each for 5 minutes, and then cleaned by exposure to ultraviolet rays and ozone for 30 minutes. Then, the ITO substrate was provided to a vacuum deposition apparatus.

Compound 1-1 and F4-TCNQ were vacuum-deposited on the ITO substrate at a weight ratio of 98:2 to form a hole injection layer having a thickness of 100 Å, Compound 1-1 was vacuum-deposited on the hole injection layer to form a first hole transport layer having a thickness of 1,200 Å, and Compound 2-8 was vacuum-deposited on the hole transport layer to form a second hole transport layer having a thickness of 100 Å. 9,10-di-naphthalene-2-yl-anthracene (ADN) which is a known blue fluorescent host and N,N,N',N'-tetraphenyl-pyrene-1,6-diamine (TPA) which is a known blue fluorescent dopant were co-deposited on the second hole transport layer at a weight ratio of 98:2 to form an emission layer having a thickness of 300 Å.

Then, 2-(4-(9,10-di(naphthalen-2-yl)anthracen-2-yl)phenyl)-1-phenyl-1H-benzo[d] imidazole (L201) and LiQ were co-deposited on the emission layer at a ratio of 5:5 to form an electron transport layer having a thickness of 300 Å, LiF, which is an alkali metal halide, was deposited on the electron transport layer to form an electron injection layer having a thickness of 10 Å, and Mg and Ag were co-deposited at a weight ratio of 90:10 to form a cathode electrode having a thickness of 120 Å, thereby completing the manufacture of an organic light-emitting device.

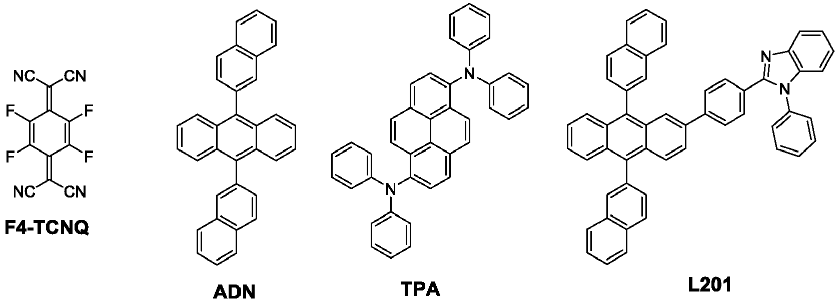

### Examples 2 to 12 and Comparative Examples 1 to 3

Organic light-emitting devices were manufactured in the same manner as in Example 1, except that Compounds shown in Table 2 were each used instead of Compounds 1-1 and 2-8 in forming a hole transport layer.

**[Table 2]**

| | First hole transport layer | Second hole transport layer | Driving voltage (V) | Current density (mA/cm²) | Efficiency (cd/A) | Color coordinates CIE(x,y) | Lifespan (T97) (@1.0 mA/ cm²) |
|---|---|---|---|---|---|---|---|
| Example 1 | Compound 1-1 | Compound 2-8 | 4.3 | 10 | 4.97 | 0.140, 0.051 | 143 |
| Example 2 | Compound 1-6 | Compound 2-8 | 4.2 | 10 | 5.33 | 0.141, 0.052 | 158 |
| Example 3 | Compound 1-12 | Compound 2-8 | 4.1 | 10 | 5.01 | 0.141, 0.050 | 128 |
| Example 4 | Compound 1-16 | Compound 2-8 | 4.3 | 10 | 4.96 | 0.140, 0.052 | 143 |
| Example 5 | Compound 1-30 | Compound 2-8 | 4.3 | 10 | 4.93 | 0.141, 0.052 | 145 |
| Example 6 | Compound 1-47 | Compound 2-8 | 4.4 | 10 | 5.10 | 0.141, 0.052 | 118 |
| Example 7 | Compound 1-49 | Compound 2-8 | 4.3 | 10 | 5.25 | 0.142, 0.051 | 136 |
| Example 8 | Compound 1-56 | Compound 2-8 | 4.3 | 10 | 4.98 | 0.140, 0.053 | 147 |
| Example 9 | Compound 1-6 | Compound 3-1 | 4.2 | 10 | 5.19 | 0.141, 0.052 | 149 |
| Example 10 | Compound 1-6 | Compound 4-3 | 4.2 | 10 | 5.21 | 0.141, 0.054 | 141 |
| Example 11 | Compound 1-6 | Compound 5-16 | 4.2 | 10 | 5.32 | 0.141, 0.052 | 177 |
| Example 12 | Compound 1-6 | Compound 6-9 | 4.3 | 10 | 5.14 | 0.141, 0.052 | 179 |
| Comparative Example 1 | NPB | Compound 2-8 | 4.6 | 10 | 4.72 | 0.141, 0.051 | 70 |
| Comparative Example 2 | HT301 | Formula 2-8 | 4.4 | 10 | 4.94 | 0.141,0.052 | 112 |
| Comparative Example 3 | Compound A | Compound B | 5.0 | 10 | 4.63 | 0.141, 0.051 | 98 |

### <Compound A> <Compound B> <HT301>

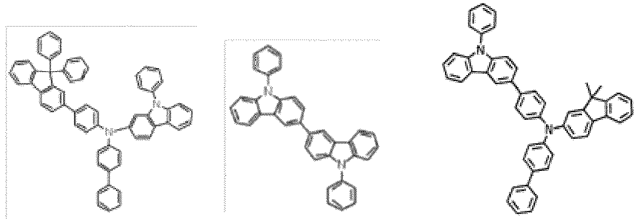

Referring to Table 2, it is shown that the organic light-emitting devices of Examples 1 to 12 have excellent driving voltage, efficiency, and lifespan characteristics, as compared with those of the organic light-emitting devices of Comparative Examples 1 to 3. In addition, the lifespan characteristics of Examples 1 to 12 are surprising and unexpected compared to Comparative Examples 1 to 3.

The organic light-emitting device according to embodiments of the invention may have a low driving voltage, high efficiency, and a long lifespan.

## Claims

1. An organic light-emitting device comprising:
a first electrode (110);
a second electrode (190); and
an organic layer (150) disposed between the first electrode and the second electrode and comprising an emission layer and a hole transport region,
wherein the hole transport region is disposed between the first electrode and the emission layer and comprises a first layer and a second layer,
wherein the first layer is disposed between the second layer and the first electrode,
wherein the second layer is in direct contact with the emission layer,
wherein the first layer comprises at least one compound of compounds represented by Formula 1,
wherein the second layer comprises at least one compound of compounds represented by Formulae 2 to 6, and
wherein the first layer and the second layer comprise different compounds from each other: 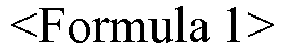 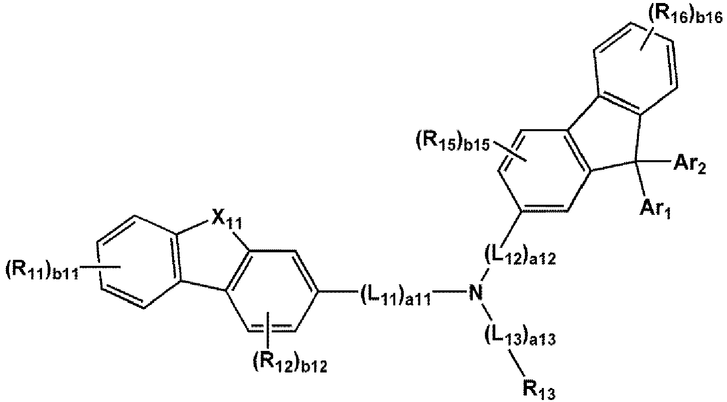 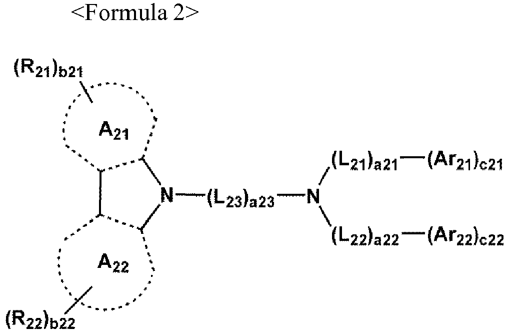 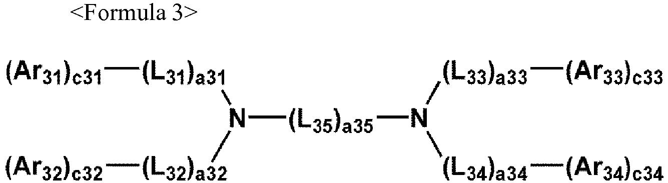 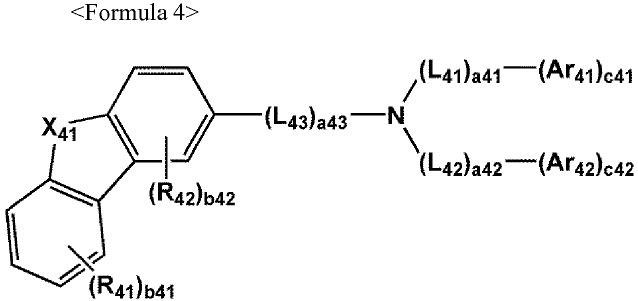 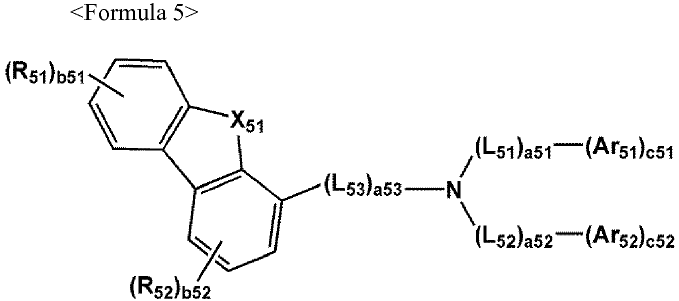 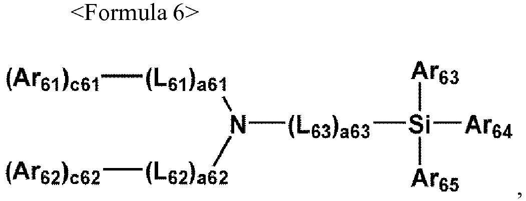 wherein, in Formulae 1 to 6,
X₁₁ is N-(L₁₄)ₐ₁₄-(R₁₄)_{b14}, O, or S,
X₄₁ is N-(L₄₄)ₐ₄₄-(R₄₃)_{b43}, O, or S,
X₅₁ is N-(L₅₄)ₐ₅₄-(R₅₃)_{b53}, O, or S,
A₂₁ and A₂₂ are each independently a C₄-C₂₀ carbocyclic group or a C₂-C₂₀ heterocyclic group,
L₁₁ to L₁₄, L₂₁ to L₂₃, L₃₁ to L₃₅, L₄₁ to L₄₄, L₅₁ to L₅₄, and L₆₁ to L₆₃ are each independently a single bond, a substituted or unsubstituted C₃-C₆₀ carbocyclic group, or a substituted or unsubstituted C₁-C₆₀ heterocyclic group,
a11 to a14, a21 to a23, a31 to a35, a41 to a44, a51 to a54, and a61 to a63 are each independently 1, 2, 3, 4, or 5,
when a11 to a14 are each independently two or more, two or more L₁₁(s) are identical to or different from each other, two or more L₁₂(s) are identical to or different from each other, two or more L₁₃(s) are identical to or different from each other, and two or more L₁₄(s) are identical to or different from each other,
when a21 to a23 are each independently two or more, two or more L₂₁(s) are identical to or different from each other, two or more L₂₂(s) are identical to or different from each other, and two or more L₂₃(s) are identical to or different from each other,
when a31 to a35 are each independently two or more, two or more L₃₁(s) are identical to or different from each other, two or more L₃₂(s) are identical to or different from each other, two or more L₃₃(s) are identical to or different from each other, two or more L₃₄(s) are identical to or different from each other, and two or more L₃₅(S) are identical to or different from each other,
when a41 to a44 are each independently two or more, two or more L₄₁(s) are identical to or different from each other, two or more L₄₂(s) are identical to or different from each other, two or more L₄₃(s) are identical to or different from each other, and two or more L₄₄(s) are identical to or different from each other,
when a51 to a54 are each independently two or more, two or more L₅₁(s) are identical to or different from each other, two or more L₅₂(s) are identical to or different from each other, two or more L₅₃(s) are identical to or different from each other, and two or more L₅₄(s) are identical to or different from each other,
when a61 to a63 are each independently two or more, two or more L₆₁(s) are identical to or different from each other, two or more L₆₂(s) are identical to or different from each other, and two or more L₆₃(s) are identical to or different from each other,
R₁₁ to R₁₆, R₂₁, R₂₂, R₄₁ to R₄₃, and R₅₁ to R₅₃ are each independently selected from
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group; and
groups represented by Formulae 8-1 to 8-12: 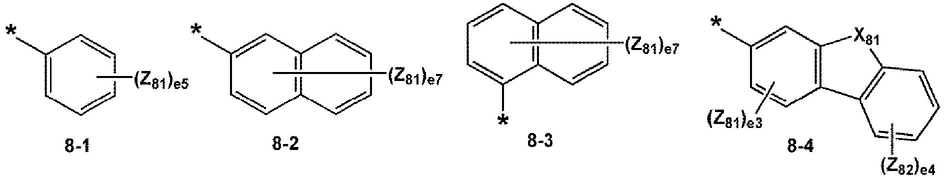 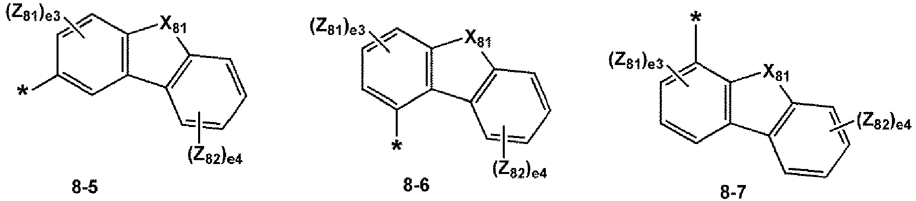 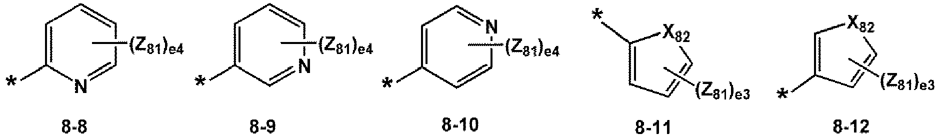 , wherein, in Formulae 8-1 to 8-12,
X₈₁ and X₈₂ are each independently selected from O, S, C(Z₈₃)(Z₈₄), N(Z₈₅), and Si(Z₈₆)(Z₈₇),
Z₈₁ to Z₈₇ are each independently selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group,
e3 is an integer of 0 to 3,
e4 is an integer of 0 to 4,
e5 is an integer of 0 to 5,
e7 is an integer of 0 to 7, and
^{∗} and ^{∗}' each indicate a binding site to a neighboring atom, and two neighboring groups selected from R₁₁ to R₁₆, R₂₁, R₂₂, R₄₁ to R₄₃, and R₅₁ to R₅₃ are optionally linked to form a condensed ring,
b11, b12 and b14 to b16, b21, b22, b41 to b43, and b51 to b53 are each independently 1, 2, 3, 4, 5, or 6,
when b11, b12 and b14 to b16 are each independently two or more, two or more R₁₁(s) are identical to or different from each other, two or more R₁₂(s) are identical to or different from each other, two or more R₁₄(s) are identical to or different from each other, two or more R₁₅(s) are identical to or different from each other, and two or more R₁₆(s) are identical to or different from each other,
when b21 and b22 are each independently two or more, two or more R₂₁(s) are identical to or different from each other, and two or more R₂₂(s) are identical to or different from each other,
when b41 to b43 are each independently two or more, two or more R₄₁(s) are identical to or different from each other, two or more R₄₂(s) are identical to or different from each other, and two or more R₄₃(s) are identical to or different from each other,
when b51 to b53 are each independently two or more, two or more R₅₁(S) are identical to or different from each other, two or more R₅₂(s) are identical to or different from each other, and two or more R₅₃(s) are identical to or different from each other,
Ar₁, Ar₂, Ar₂₁, Ar₂₂, Ar₃₁ to Ar₃₄, Ar₄₁, Ar₄₂, Ar₅₁, Ar₅₂, and Ar₆₁ to Ar₆₅ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and Ar₁ and Ar₂ are optionally linked via a single bond,
c21, c22, c31 to c34, c41, c42, c51, c52, c61, and c62 are each independently 1, 2, 3, 4, or 5,
when c21 and c22 are each independently two or more, two or more Ar₂₁(s) are identical to or different from each other, and two or more Ar₂₂(s) are identical to or different from each other,
when c31 to c34 are each independently two or more, two or more Ar₃₁(s) are identical to or different from each other, two or more Ar₃₂(s) are identical to or different from each other, two or more Ar₃₃(s) are identical to or different from each other, and two or more Ar₃₄(s) are identical to or different from each other,
when c41 and c42 are each independently two or more, two or more Ar₄₁(s) are identical to or different from each other, and two or more Ar₄₂(s) are identical to or different from each other,
when c51 and c52 are each independently two or more, two or more Ar₅₁(s) are identical to or different from each other, and two or more Ar₅₂(s) are identical to or different from each other,
when c61 and c62 are each independently two or more, two or more Ar₆₁(s) are identical to or different from each other, and two or more Ar₆₂(s) are identical to or different from each other,
at least one substituent of the substituted C₃-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one substituent selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one substituent selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

2. An organic light-emitting device according to claim 1 , wherein, in Formulae 1, 4, and 5,
X₁₁ is N-(L₁₄)ₐ₁₄-(R₁₄)ₕ₁₄,
X₄₁ is N-(L₄₄)ₐ₄₄-(R₄₃)_{b43}, and
X₅₁ is O or S.

3. An organic light-emitting device according to any one of claims 1 to 2 , wherein, in Formulae 1 to 6,
L₁₁ to L₁₄, L₂₁ to L₂₃, L₃₁ to L₃₅, L₄₁ to L₄₄, L₅₁ to L₅₄, and L₆₁ to L₆₃ are each independently selected from:
a single bond;
a benzene group, a naphthalene group, a pentalene group, an indene group, an azulene group, a heptalene group, an indacene group, an acenaphthene group, a fluorene group, a spiro-fluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an indole group, an isoindole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzimidazole group, a benzofuran group, a benzothiophene group, an isobenzothiazole group, a benzoxazole group, an isobenzoxazole group, a triazole group, a tetrazole group, an oxadiazole group, a triazine group, a dibenzofuran group, a dibenzothiophene group, a benzocarbazole group, and a dibenzocarbazole group; and
a benzene group, a naphthalene group, a pentalene group, an indene group, an azulene group, a heptalene group, an indacene group, an acenaphthene group, a fluorene group, a spiro-fluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a rubicene group, a coronene group, an ovalene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, an indole group, an isoindole group, an indazole group, a purine group, a quinoline group, an isoquinoline group, a benzoquinoline group, a phthalazine group, a naphthyridine group, a quinoxaline group, a quinazoline group, a cinnoline group, a carbazole group, a phenanthridine group, an acridine group, a phenanthroline group, a phenazine group, a benzimidazole group, a benzofuran group, a benzothiophene group, an isobenzothiazole group, a benzoxazole group, an isobenzoxazole group, a triazole group, a tetrazole group, an oxadiazole group, a triazine group, a dibenzofuran group, a dibenzothiophene group, a benzocarbazole group, and a dibenzocarbazole group, each substituted with at least one substituent selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group.

4. An organic light-emitting device according to any one of claims 1 to 3, wherein, in Formulae 1 to 6,
L₁₁ to L₁₄, L₂₁ to L₂₃, L₃₁ to L₃₅, L₄₁ to L₄₄, L₅₁ to L₅₄, and L₆₁ to L₆₃ are each independently selected from a single bond and groups represented by Formulae 7-1 to 7-21: 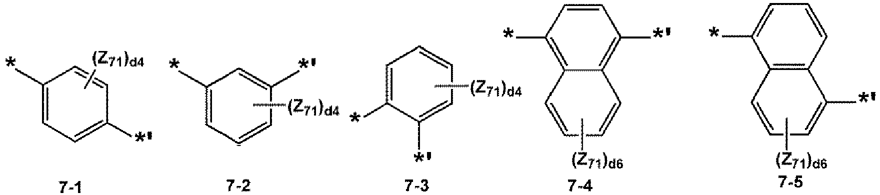 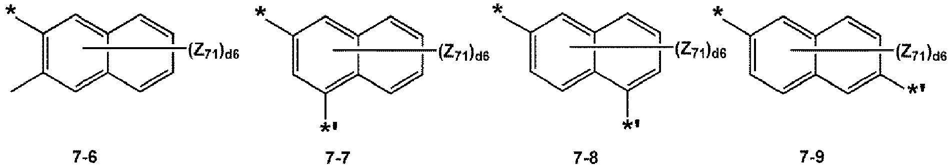 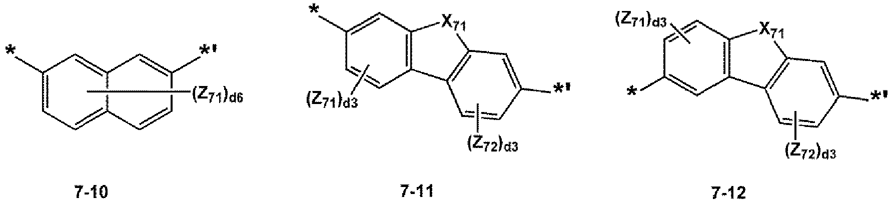 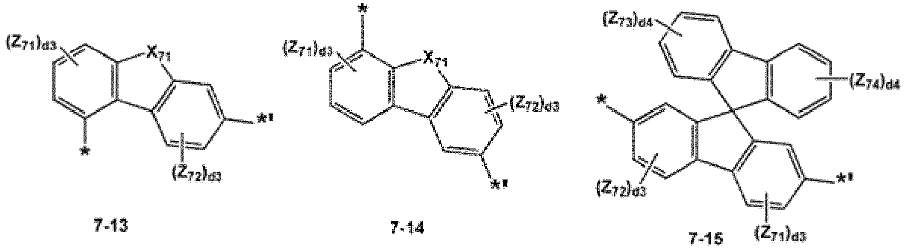 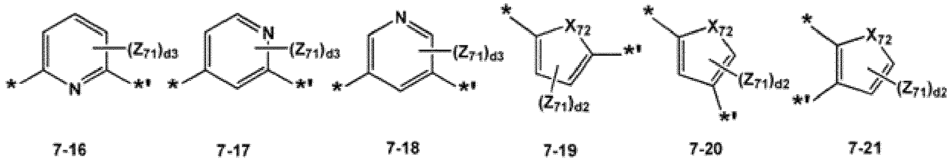
wherein X₇₁ and X₇₂ are each independently selected from O, S, C(Z₇₅)(Z₇₆), N(Z₇₇), and Si(Z₇₈)(Z₇₉),
Z₇₁ to Z₇₉ are each independently selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group,
d2 is an integer of 0 to 2,
d3 is an integer of 0 to 3,
d4 is an integer of 0 to 4,
d6 is an integer of 0 to 6, and
^{∗} and ^{∗}' each indicate a binding site to a neighboring atom.

5. An organic light-emitting device according to any one of claims 1 to 4, wherein:
Ar₁, Ar₂, Ar₂₁, Ar₂₂, Ar₃₁ to Ar₃₄, Ar₄₁, Ar₄₂, Ar₅₁, Ar₅₂, and Ar₆₁ to Ar₆₅ are each independently selected from:
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, an imidazopyrimidinyl group, a thianthrenyl group, a phenoxathiinyl group, and a dibenzodioxinyl group; and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyrimidinyl group, a thianthrenyl group, a phenoxathiinyl group, and a dibenzodioxinyl group, each substituted with at least one substituent selected from deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a phenyl group, a biphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, an imidazopyrimidinyl group, and -Si(Q₃₃)(Q₃₄)(Q₃₅), and
Q₃₃ to Q₃₅ are each independently selected from a C₁-C₆₀ alkyl group and a C₆-C₆₀ aryl group.

6. An organic light-emitting device according to any one of claims 1 to 5, wherein
Ar₁, Ar₂, Ar₂₁, Ar₂₂, Ar₃₁ to Ar₃₄, Ar₄₁, Ar₄₂, Ar₅₁, Ar₅₂, and Ar₆₁ to Ar₆₅ are each independently selected from groups represented by Formulae 9-1 to 9-22: 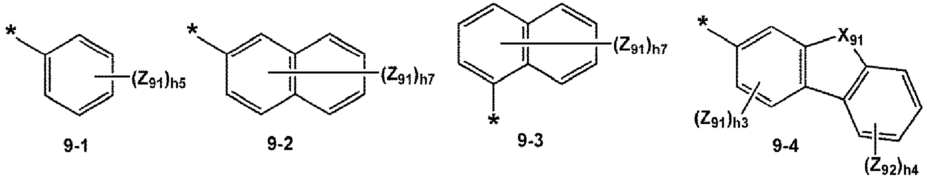 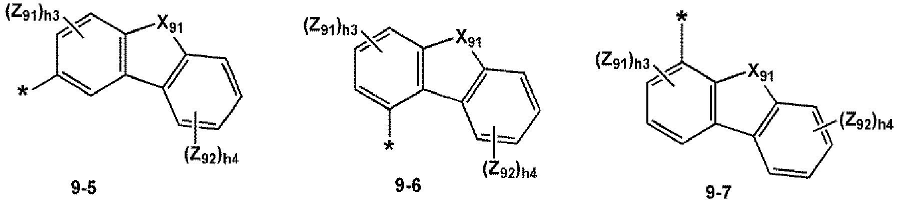 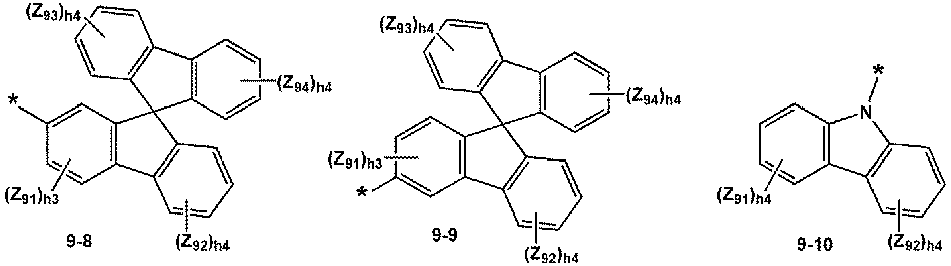 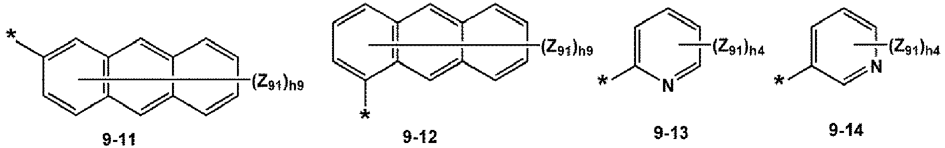 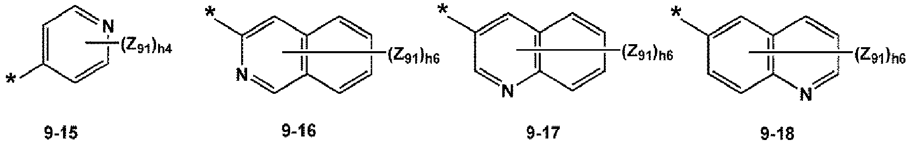 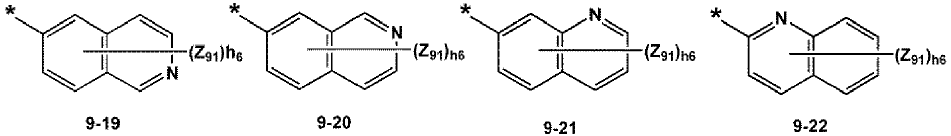
wherein, in Formulae 9-1 to 9-22,
X₉₁ is selected from O, S, C(Z₉₅)(Z₉₆), N(Z₉₇), and Si(Z₉₈)(Z₉₉),
Z₉₁ to Z₉₉ are each independently selected from:
hydrogen, deuterium, -F, -Cl, -Br, -I, a hydroxyl group, a cyano group, a nitro group, an amino group, an amidino group, a hydrazino group, a hydrazono group, a C₁-C₂₀ alkyl group, a C₁-C₂₀ alkoxy group, a phenyl group, a biphenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a benzoquinoxalinyl group, a quinazolinyl group, a benzoquinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, an imidazopyridinyl group, and an imidazopyrimidinyl group,
h3 is an integer of 0 to 3,
h4 is an integer of 0 to 4,
h5 is an integer of 0 to 5,
h6 is an integer of 0 to 6,
h7 is an integer of 0 to 7,
h9 is an integer of 0 to 9, and
^{∗} and ^{∗}' each indicate a binding site to a neighboring atom.

7. An organic light-emitting device according to any one of claims 1 to 6, wherein, in Formula 1,
^{∗}-(L₁₁)ₐ₁₁-^{∗}' and ^{∗}-(L₁₂)ₐ₁₂-^{∗}' are each a single bond,
^{∗}-(L₁₂)ₐ₁₂-^{∗}' is a single bond, or
^{∗}-(L₁₂)ₐ₁₂-^{∗}' and ^{∗}-(L₁₃)ₐ₁₃-^{∗}' are each a single bond.

8. An organic light-emitting device according to any one of claims 1 to 7, wherein Formula 1 is represented by Formula 1-1 or Formula 1-2: 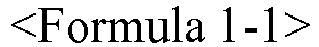 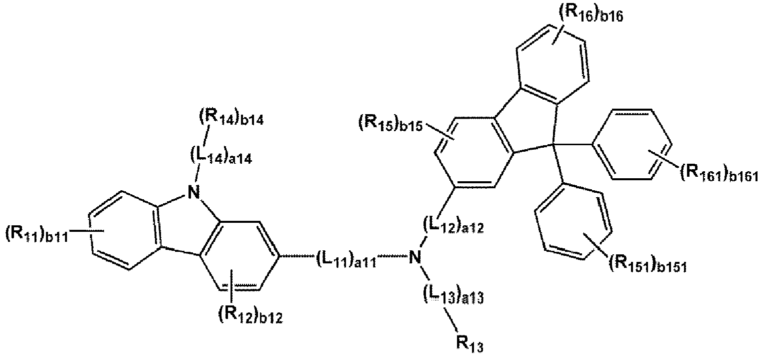 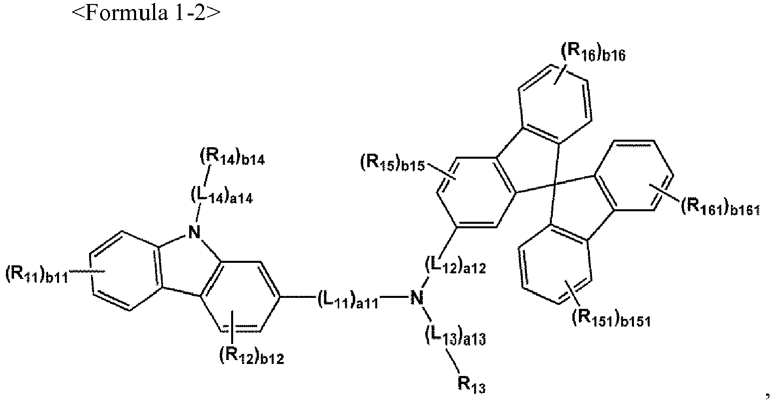 wherein, in Formulae 1-1 and 1-2,
L₁₁ to L₁₃, a11 to a13, R₁₁ to R₁₆, b11, b12, b14, b15, and b16 are respectively the same as defined in claim 1,
R₁₅₁ and R₁₆₁ are respectively defined the same as R₁₅ and R₁₆ in claim 1, and
b151 and b161 are respectively defined the same as b15 and b16 in claim 1.

9. An organic light-emitting device according to any one of claims 1 to 8, wherein, in Formula 2,
A₂₁ and A₂₂ are each independently a benzene group or a naphthalene group.

10. An organic light-emitting device according to any one of claims 1 to 9, wherein Formula 2 is represented by one selected from Formulae 2-1 to 2-7: 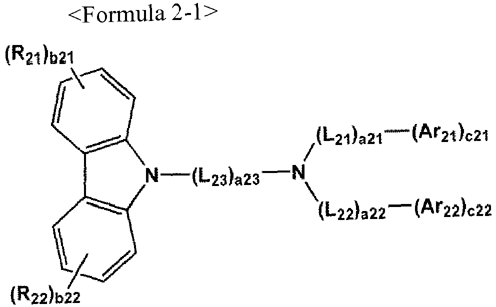 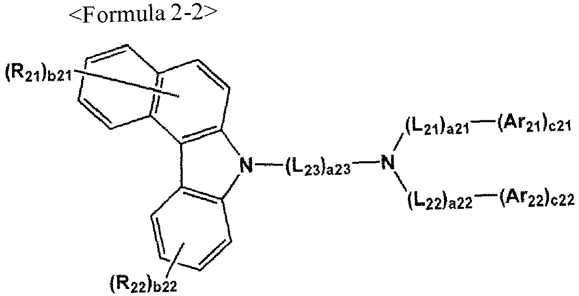 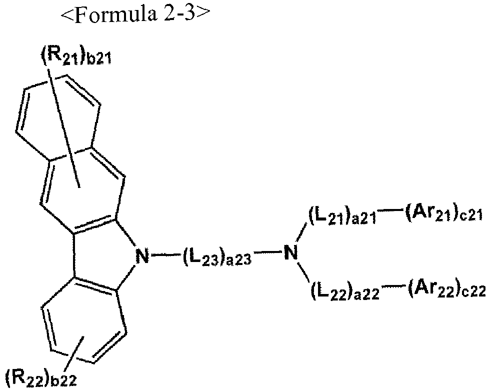 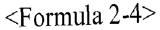 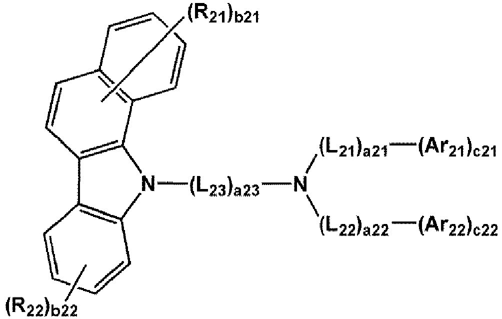 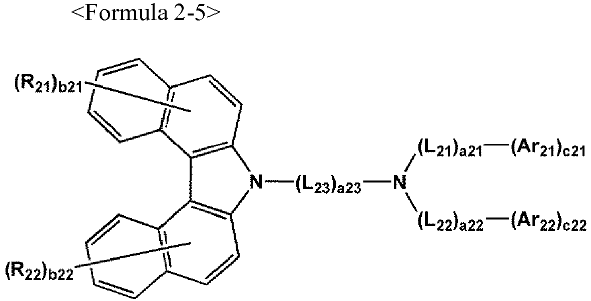 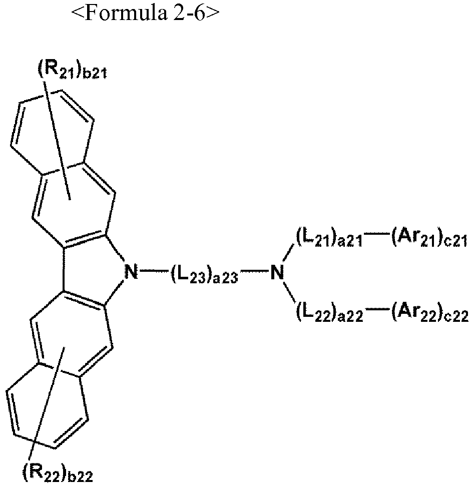 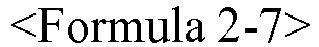 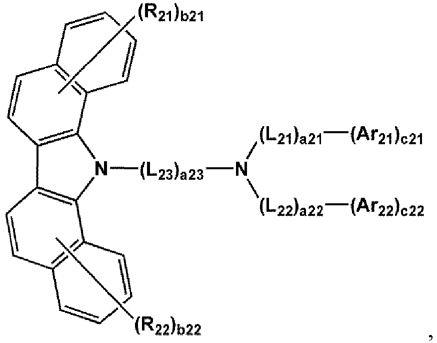 wherein, in Formulae 2-1 to 2-7,
L₂₁ to L₂₃, a21 to a23, R₂₁, R₂₂, b21, b22, Ar₂₁, Ar₂₂, c21, and c22 are respectively the same as defined in claim 1.

11. An organic light-emitting device according to any one of claims 1 to 10, wherein: a moiety represented by 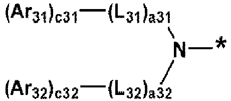 and a moiety represented by 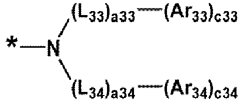 in Formula 3 are identical to each other.

12. An organic light-emitting device according to any one of claims 1 to 11, wherein Formula 4 is represented by one selected from Formulae 4-1 to 4-4; 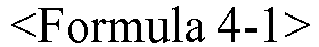 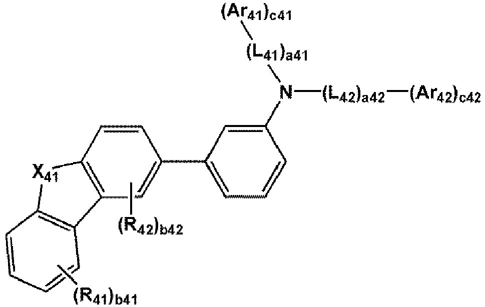 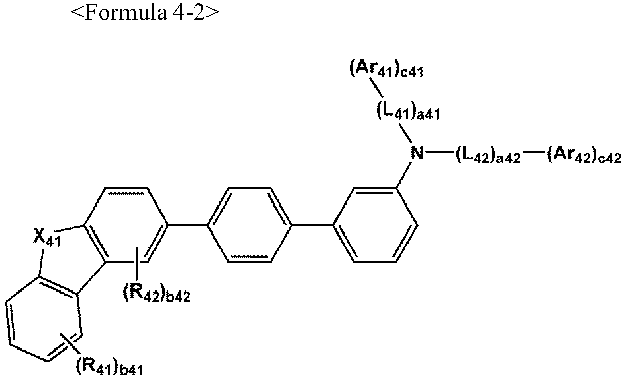 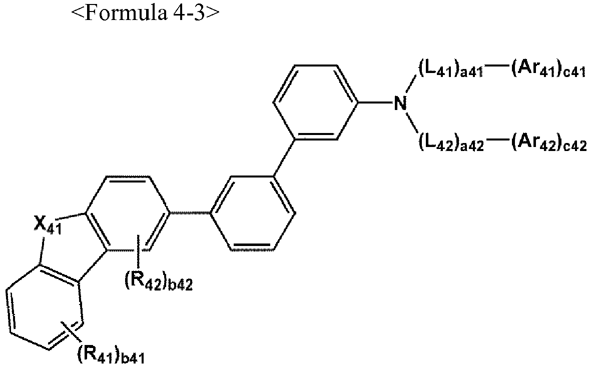 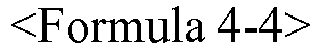 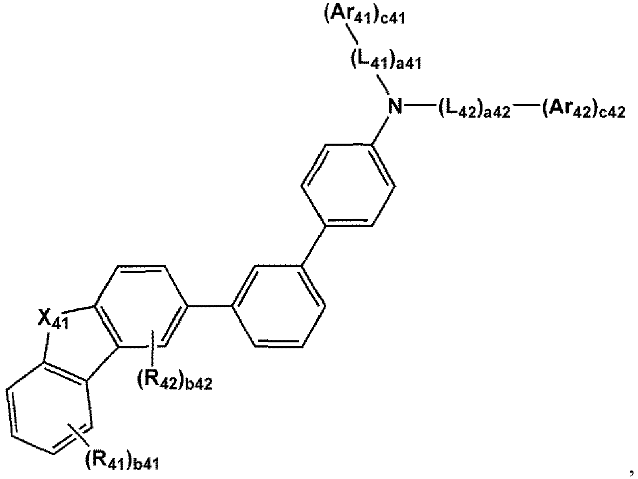 wherein, in Formulae 4-1 to 4-4,
X₄₁, L₄₁, L₄₂, a41, a42, R₄₁, R₄₂, b41, b42, Ar₄₁, Ar₄₂, c41, and c42 are respectively the same as defined in claim 1.

13. An organic light-emitting device according to any one of claims 1 to 12, wherein Formula 5 is represented by one selected from Formulae 5-1 to 5-3: 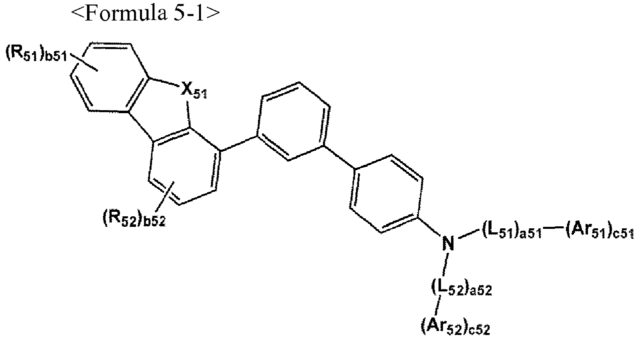 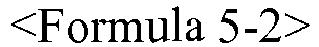 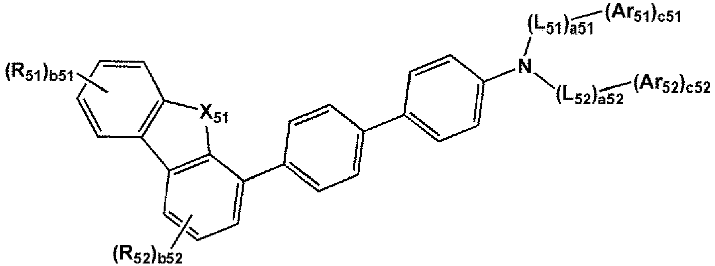 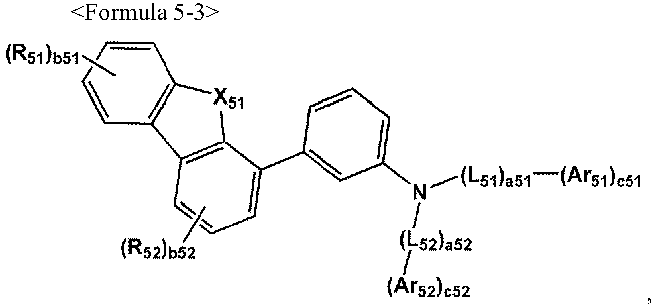 wherein, in Formulae 5-1 to 5-3,
X₅₁, L₅₁, L₅₂, a51, a52, R₅₁, R₅₂, b51, b52, Ar₅₁, Ar₅₂, c51, and c52 are respectively the same as defined in claim 1.

14. An organic light-emitting device according to any one of claims 1 to 13, wherein Formula 6 is represented by one selected from Formulae 6-1 to 6-4: 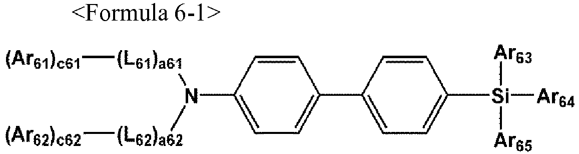 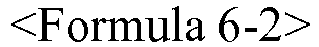 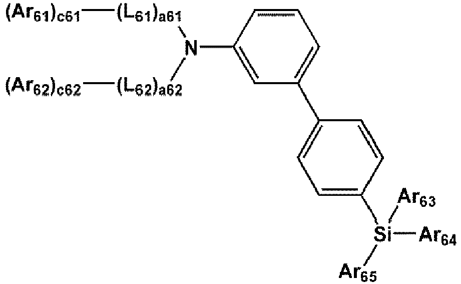 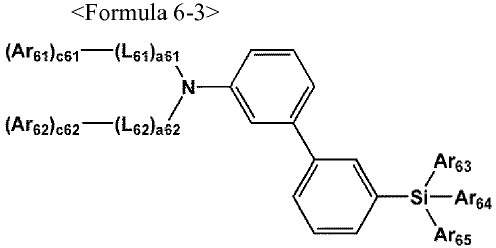 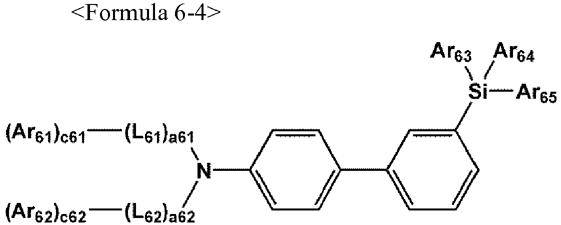 wherein, in Formulae 6-1 to 6-4,
L₆₁, L₆₂, a61, a62, Ar₆₁ to Ar₆₅, c61, and c62 are respectively the same as defined in claim 1.

15. An organic light-emitting device according to any one of claims 1 to 14, wherein:
the at least one compound of compounds represented by Formula 1 is selected from Compounds 1-1 to 1-63, and
the at least one compound of compounds represented by Formulae 2 to 6 is selected from Compounds 2-1 to 2-27, Compounds 3-1 to 3-18, Compounds 4-1 to 4-15, Compounds 5-1 to 5-19, and Compounds 6-1 to 6-18:

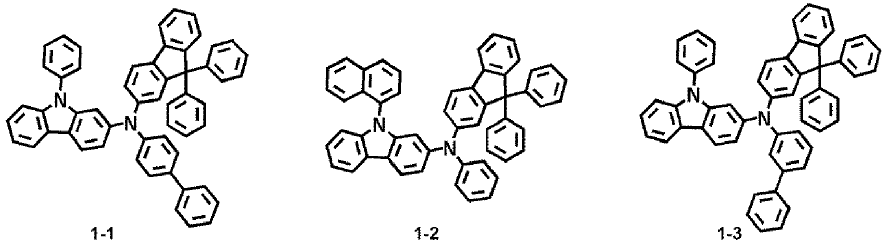

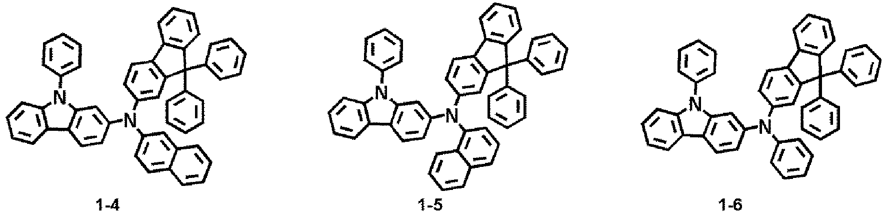

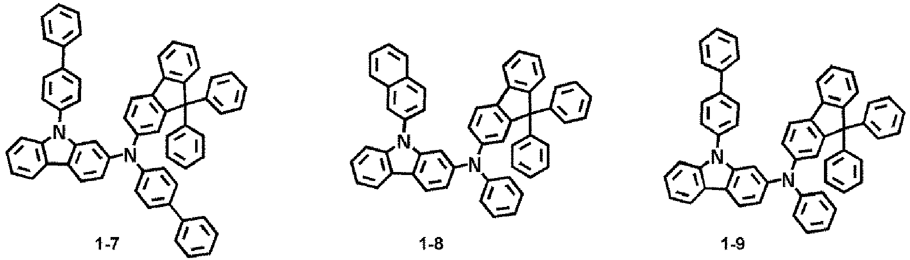

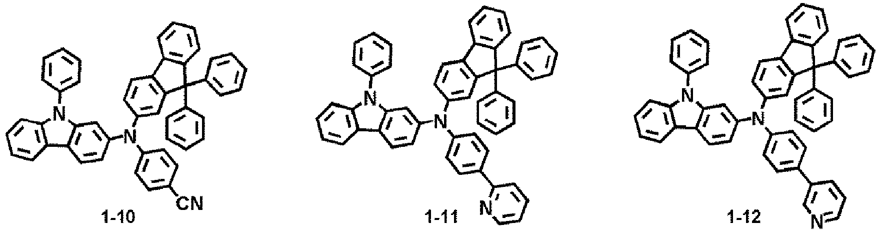

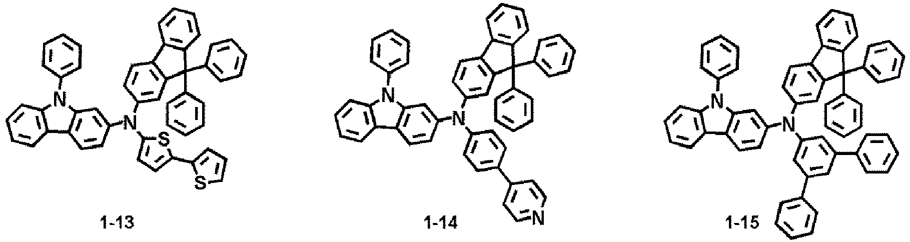

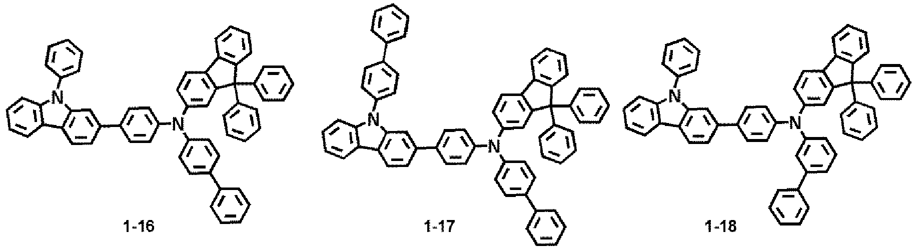

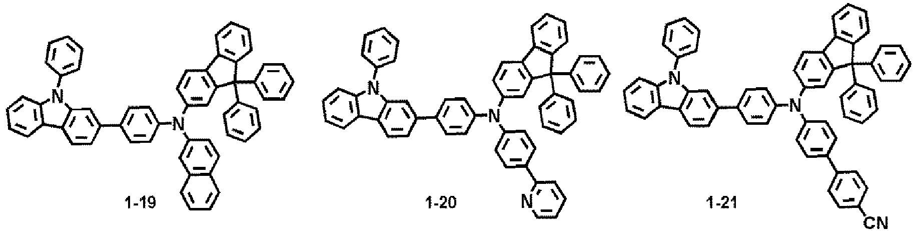

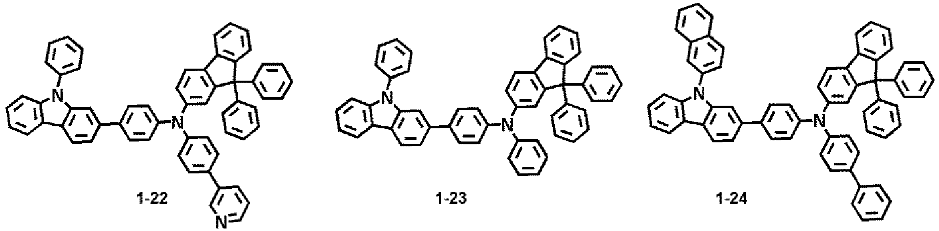

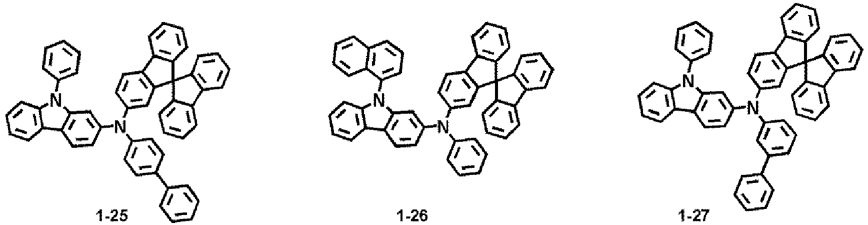

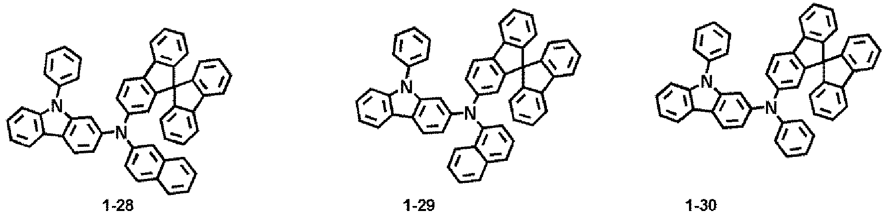

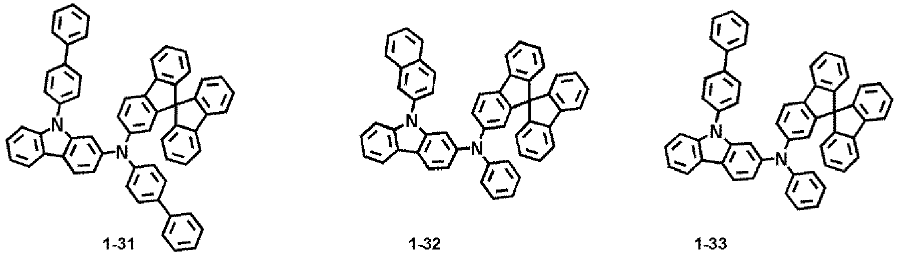

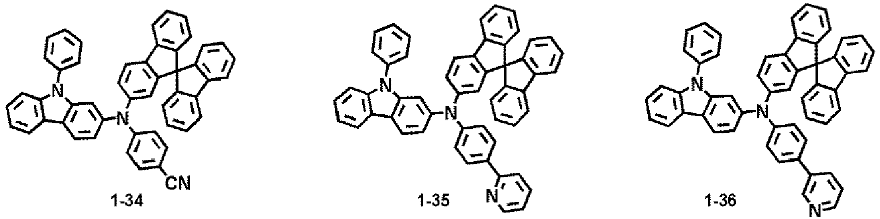

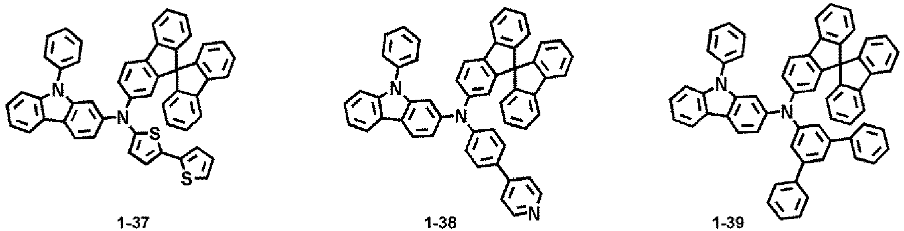

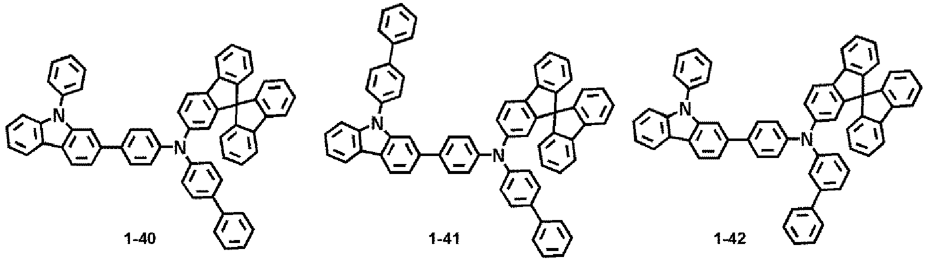

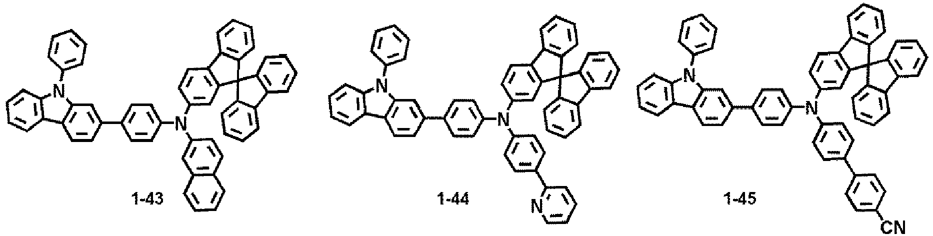

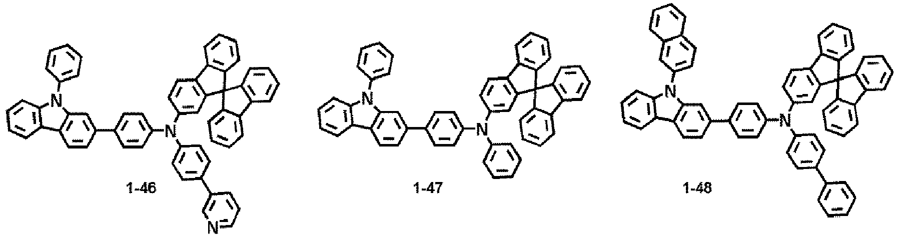

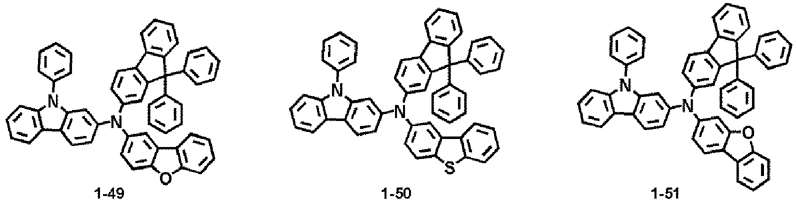

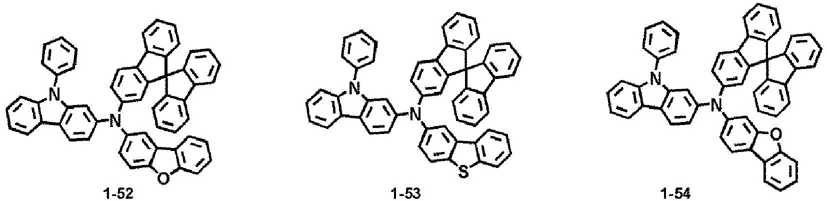

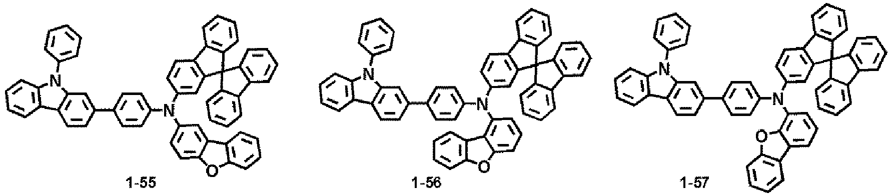

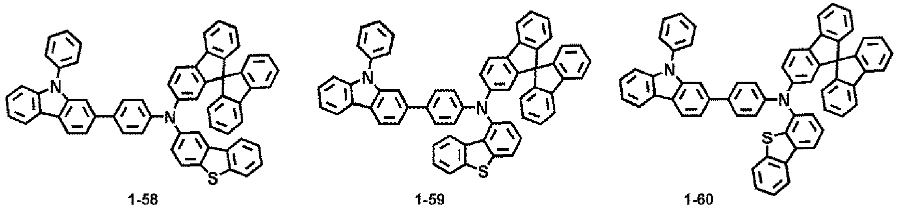

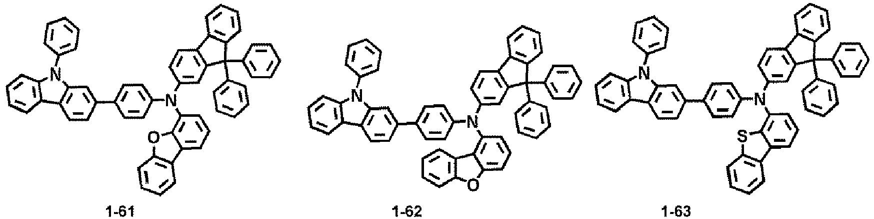

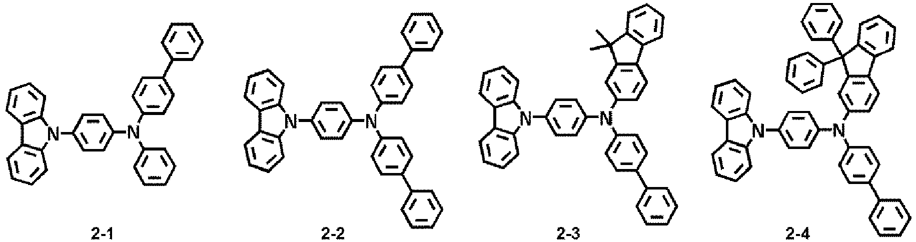

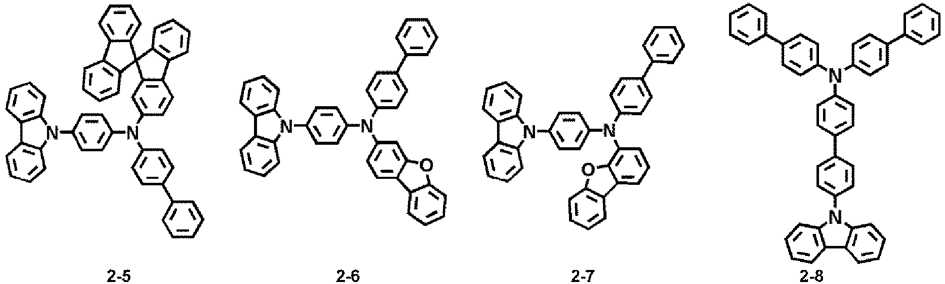

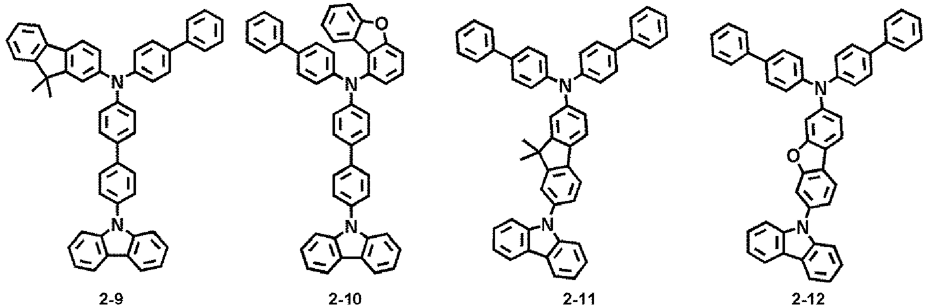

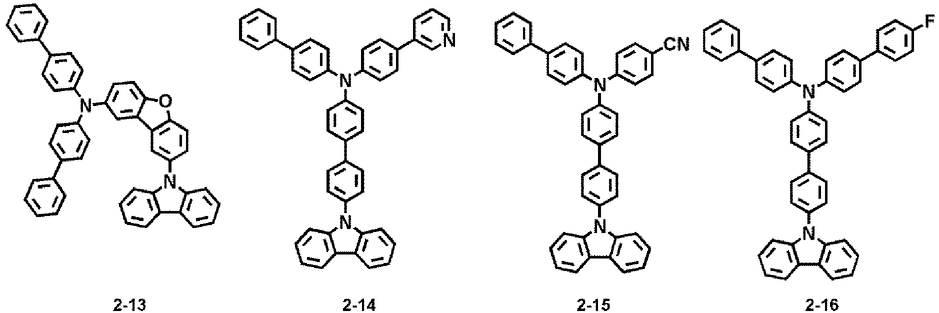

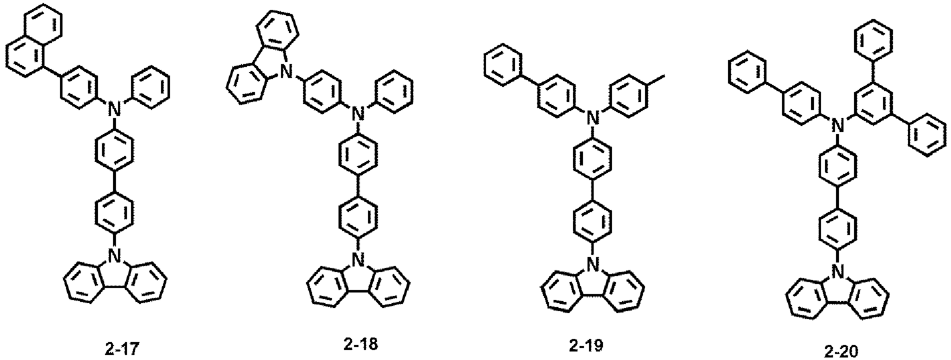

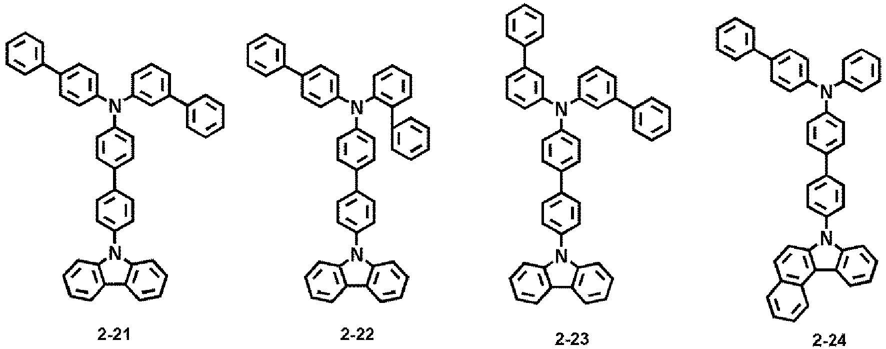

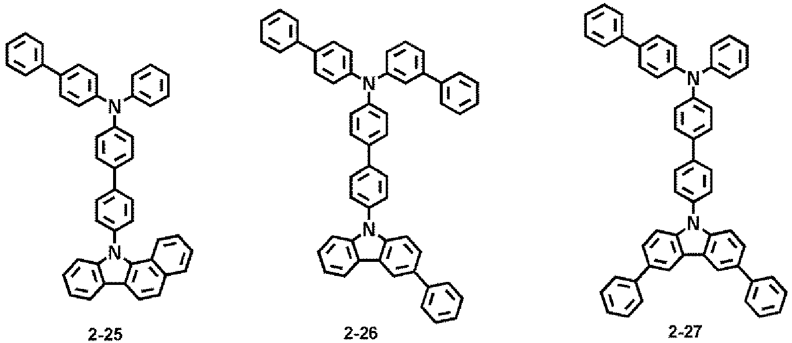

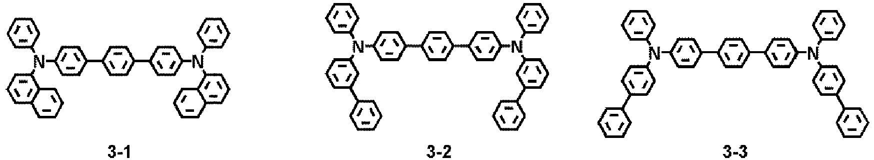

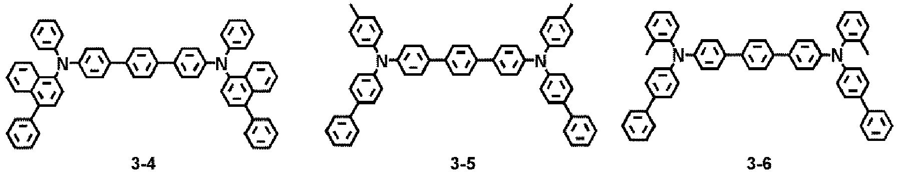

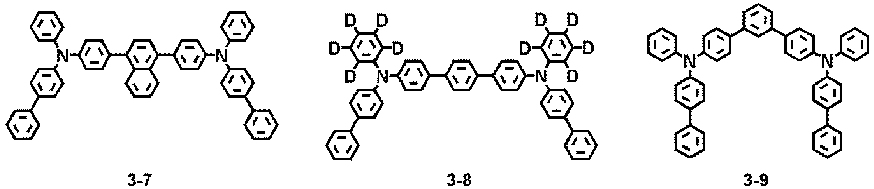

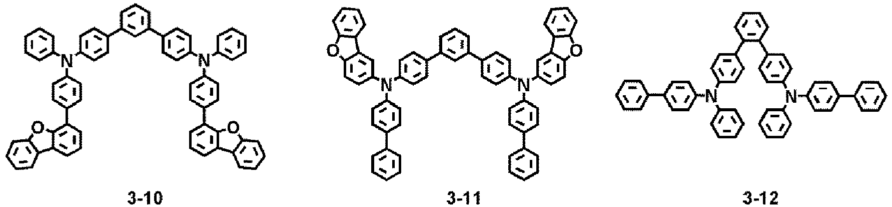

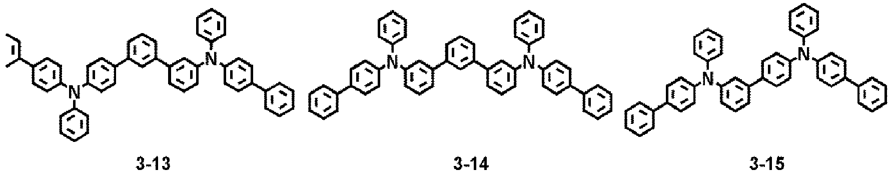

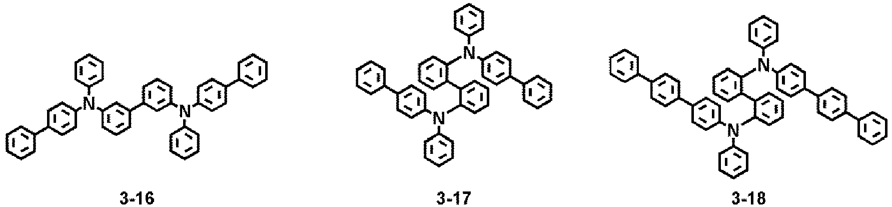

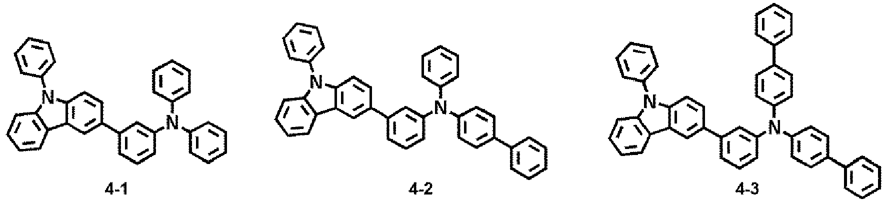

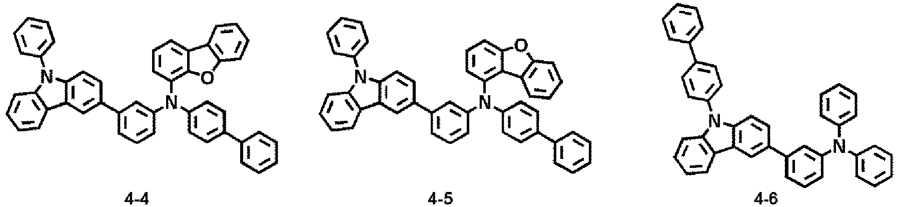

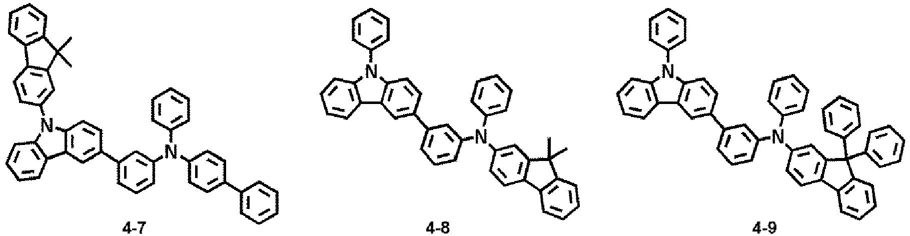

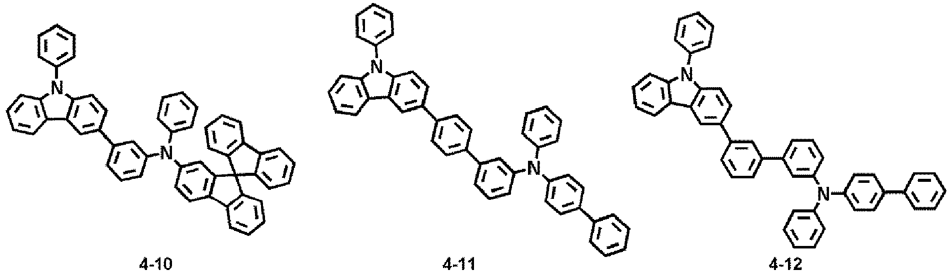

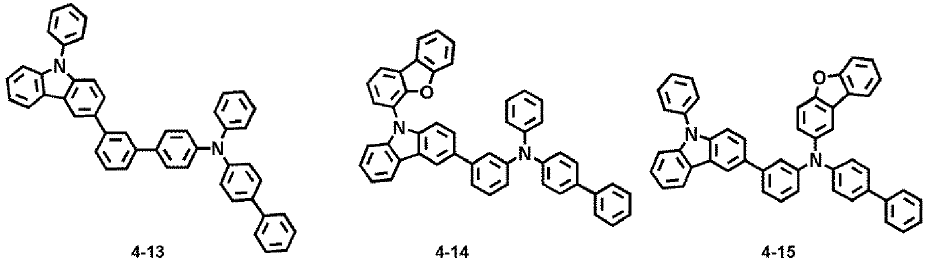

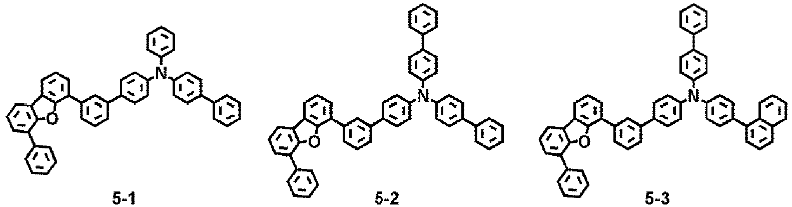

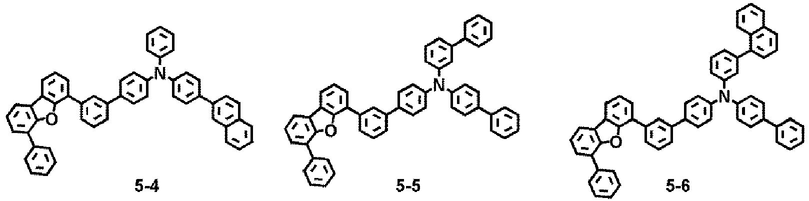

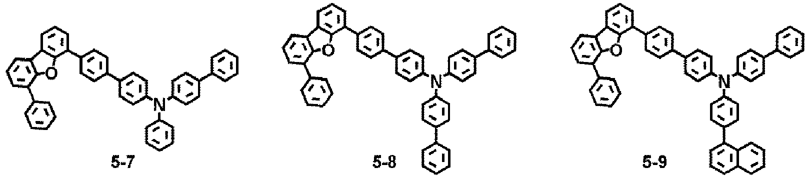

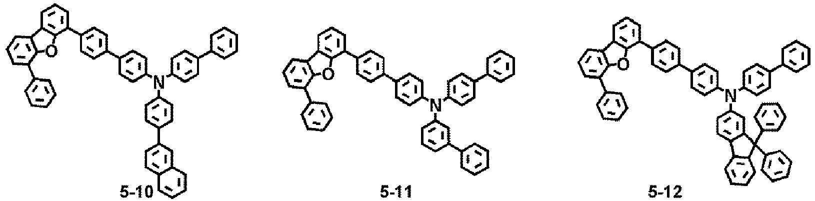

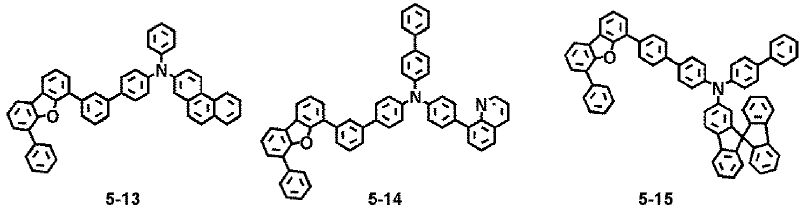

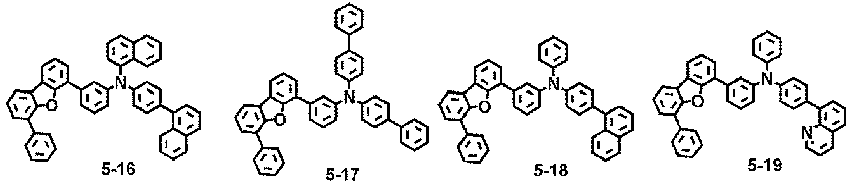

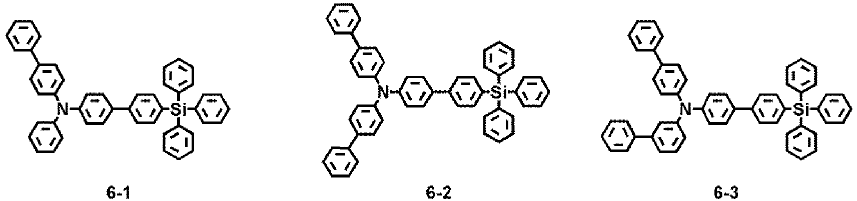

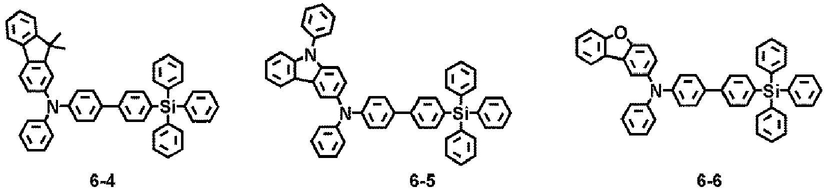

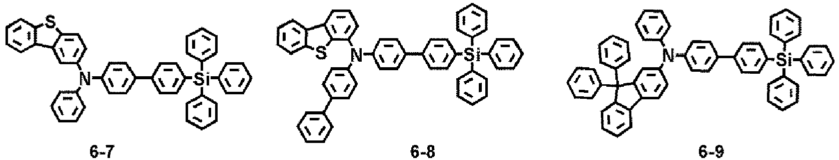

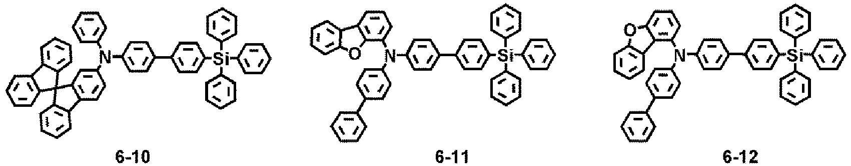

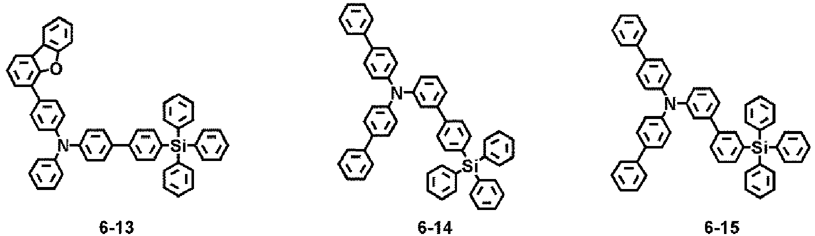

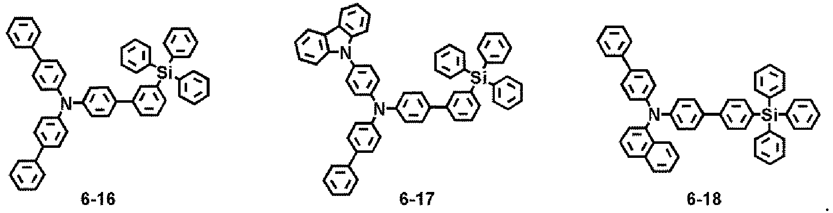

16. An organic light-emitting device according to any one of Claims 1 to 15, wherein the device further comprises:
a substrate divided into a first sub-pixel region, a second sub-pixel region, and a third sub-pixel region; and a
a plurality of first electrodes disposed in the first sub-pixel region, the second sub-pixel region, and the third sub-pixel region of the substrate, respectively;
wherein the second electrode faces the plurality of first electrodes;
the organic layer is disposed between the plurality of first electrodes and the second electrode;
the hole transport region is disposed between the plurality of first electrodes; and
the first layer of the hole transport region is disposed between the second layer and the plurality of first electrodes.

## Patentansprüche

1. Organische lichtemittierende Vorrichtung, umfassend:
eine erste Elektrode (110);
eine zweite Elektrode (190); und
eine organische Schicht (150), angeordnet zwischen der ersten Elektrode und der zweiten Elektrode und umfassend eine Emissionsschicht und eine Löchertransportregion,
wobei die Löchertransportregion zwischen der ersten Elektrode und der Emissionsschicht angeordnet ist und eine erste Schicht und eine zweite Schicht umfasst,
wobei die erste Schicht zwischen der zweiten Schicht und der ersten Elektrode angeordnet ist,
wobei die zweite Schicht in direktem Kontakt mit der Emissionsschicht ist,
wobei die erste Schicht mindestens eine Verbindung von Verbindungen umfasst, die durch Formel 1 dargestellt sind,
wobei die zweite Schicht mindestens eine Verbindung von Verbindungen umfasst, die durch Formeln 2 bis 6 dargestellt sind, und
wobei die erste Schicht und die zweite Schicht voneinander verschiedene Verbindungen umfassen: 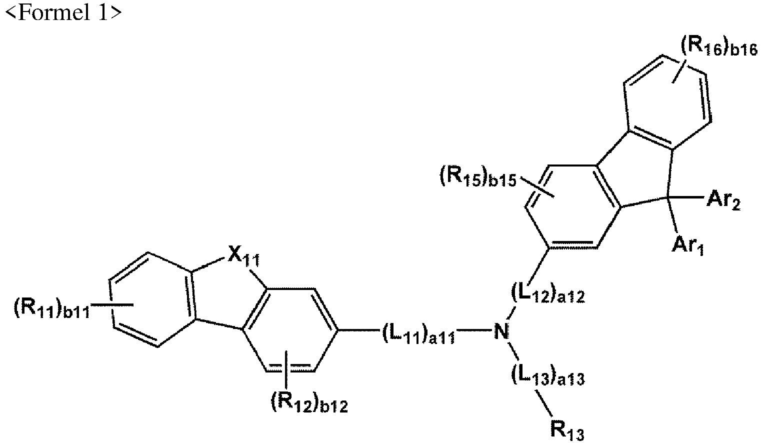 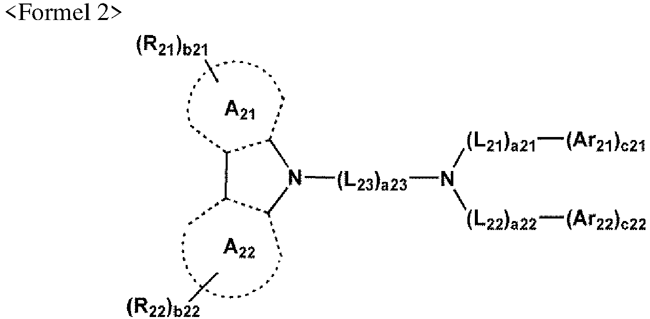 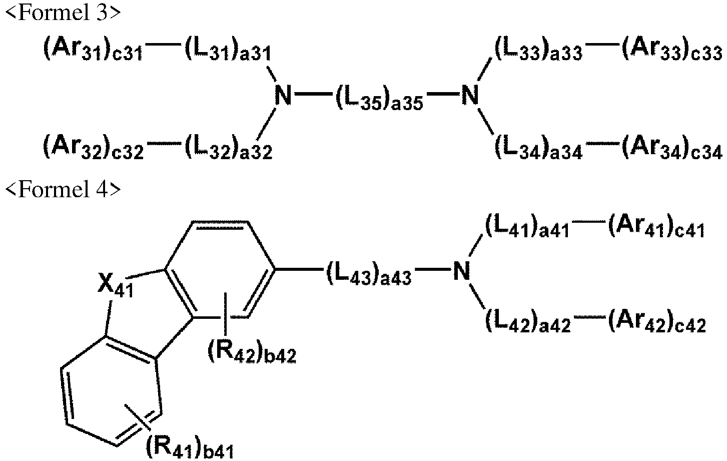 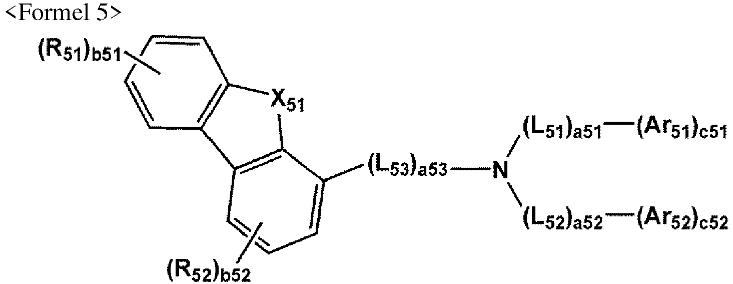 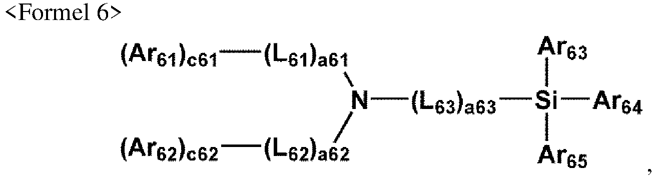 wobei, in Formeln 1 bis 6,
X₁₁ N-(L₁₄)ₐ₁₄-(R₁₄)_{b14}, O oder S ist,
X₄₁ N-(L₄₄)ₐ₄₄-(R₄₃)_{b43}, O oder S ist,
X₅₁ N-(L₅₄)ₐ₅₄-(R₅₃)_{b53}, O oder S ist,
A₂₁ und A₂₂ jeweils unbahängig eine C₄-C₂₀-carbocyclische Gruppe oder eine C₂-C₂₀-heterocyclische Gruppe sind,
L₁₁ bis L₁₄, L₂₁ bis L₂₃, L₃₁ bis L₃₅, L₄₁ bis L₄₄, L₅₁ bis L₅₄, und L₆₁ bis L₆₃ jeweils unabhängig eine Einfachbindung, eine substituierte oder unsubstituierte C₃-C₆₀-carbocyclische Gruppe, oder eine substituierte oder unsubstituierte C₁-C₆₀-heterocyclische Gruppe sind,
a11 bis a14, a21 bis a23, a31 bis a35, a41 bis a44, a51 bis a54, und a61 bis a63 jeweils unabhängig 1, 2, 3, 4 oder 5 sind,
wenn a11 bis a14 jeweils unabhängig zwei oder mehr sind, zwei oder mehr L₁₁ identisch miteinander oder verschieden voneinander sind, zwei oder mehr L₁₂ identisch miteinander oder verschieden voneinander sind, zwei oder mehr L₁₃ identisch miteinander oder verschieden voneinander sind, und zwei oder mehr L₁₄ identisch miteinander oder verschieden voneinander sind,
wenn a21 bis a23 jeweils unabhängig zwei oder mehr sind, zwei oder mehr L₂₁ identisch miteinander oder verschieden voneinander sind, zwei oder mehr L₂₂ identisch miteinander oder verschieden voneinander sind, und zwei oder mehr L₂₃ identisch miteinander oder verschieden voneinander sind,
wenn a31 bis a35 jeweils unabhängig zwei oder mehr sind, zwei oder mehr L₃₁ identisch miteinander oder verschieden voneinander sind, zwei oder mehr L₃₂ identisch miteinander oder verschieden voneinander sind, zwei oder mehr L₃₃ identisch miteinander oder verschieden voneinander sind, zwei oder mehr L₃₄ identisch miteinander oder verschieden voneinander sind, und zwei oder mehr L₃₅ identisch miteinander oder verschieden voneinander sind,
wenn a41 bis a44 jeweils unabhängig zwei oder mehr sind, zwei oder mehr L₄₁ identisch miteinander oder verschieden voneinander sind, zwei oder mehr L₄₂ identisch miteinander oder verschieden voneinander sind, zwei oder mehr L₄₃ identisch miteinander oder verschieden voneinander sind, und zwei oder mehr L₄₄ identisch miteinander oder verschieden voneinander sind,
wenn a51 bis a54 jeweils unabhängig zwei oder mehr sind, zwei oder mehr L₅₁ identisch miteinander oder verschieden voneinander sind, zwei oder mehr L₅₂ identisch miteinander oder verschieden voneinander sind, zwei oder mehr L₅₃ identisch miteinander oder verschieden voneinander sind, und zwei oder mehr L₅₄ identisch miteinander oder verschieden voneinander sind,
wenn a61 bis a63 jeweils unabhängig zwei oder mehr sind, zwei oder mehr L₆₁ identisch miteinander oder verschieden voneinander sind, zwei oder mehr L₆₂ identisch miteinander oder verschieden voneinander sind, und zwei oder mehr L₆₃ identisch miteinander oder verschieden voneinander sind,
R₁₁ bis R₁₆, R₂₁, R₂₂, R₄₁ bis R₄₃, und R₅₁ bis R₅₃ jeweils unabhängig ausgewählt sind aus
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe und einer C₁-C₂₀-Alkoxygruppe;
einer C₁-C₂₀-Alkylgruppe und einer C₁-C₂₀-Alkoxygruppe, jeweils substituiert mit mindestens einem Substituenten, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe und einer C₁-C₂₀-Alkoxygruppe; und
Gruppen, dargestellt durch Formeln 8-1 bis 8-12: 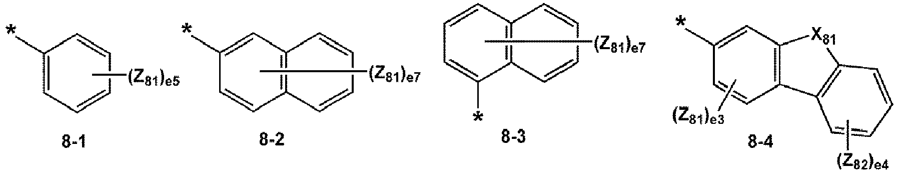 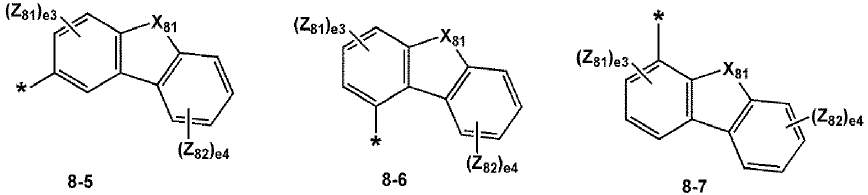 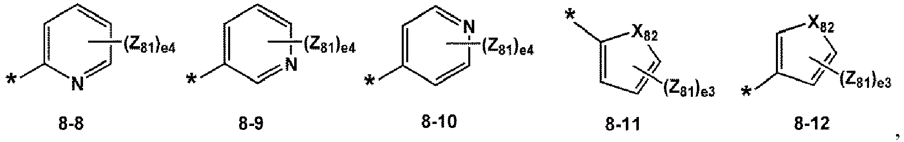
wobei, in Formeln 8-1 bis 8-12,
X₈₁ und X₈₂ jeweils unabhängig ausgewählt sind aus O, S, C(Z₈₃)(Z₈₄), N(Z₈₅) und Si(Z₈₆)(Z₈₇),
Z₈₁ bis Z₈₇ jeweils unabhängig ausgewählt sind aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe und einer Imidazopyridinylgruppe,
e3 eine ganze Zahl von 0 bis 3 ist,
e4 eine ganze Zahl von 0 bis 4 ist,
e5 eine ganze Zahl von 0 bis 5 ist,
e7 eine ganze Zahl von 0 bis 7 ist, und
^{∗} und ^{∗}' jeweils eine Bindungsstelle zu einem benachbarten Atom angeben, und zwei benachbarte Gruppen, ausgewählt aus R₁₁ bis R₁₆, R₂₁, R₂₂, R₄₁ bis R₄₃, und R₅₁ bis R₅₃, wahlweise zur Bildung eines kondensierten Rings verknüpft sind,
b11, b12 und b14 bis b16, b21, b22, b41 bis b43, und b51 bis b53 jeweils unabhängig 1, 2, 3, 4, 5 oder 6 sind,
wenn b11, b12 und b14 bis b16 jeweils unabhängig zwei oder mehr sind, zwei oder mehr R₁₁ identisch miteinander oder verschieden voneinander sind, zwei oder mehr R₁₂ identisch miteinander oder verschieden voneinander sind, zwei oder mehr R₁₄ identisch miteinander oder verschieden voneinander sind, zwei oder mehr R₁₅ identisch miteinander oder verschieden voneinander sind, und zwei oder mehr R₁₆ identisch miteinander oder verschieden voneinander sind,
wenn b21 und b22 jeweils unabhängig zwei oder mehr sind, zwei oder mehr R₂₁ identisch miteinander oder verschieden voneinander sind, und zwei oder mehr R₂₂ identisch miteinander oder verschieden voneinander sind,
wenn b41 bis b43 jeweils unabhängig zwei oder mehr sind, zwei oder mehr R₄₁ identisch miteinander oder verschieden voneinander sind, zwei oder mehr R₄₂ identisch miteinander oder verschieden voneinander sind, und zwei oder mehr R₄₃ identisch miteinander oder verschieden voneinander sind,
wenn b51 bis b53 jeweils unabhängig zwei oder mehr sind, zwei oder mehr R₅₁ identisch miteinander oder verschieden voneinander sind, zwei oder mehr R₅₂ identisch miteinander oder verschieden voneinander sind, und zwei oder mehr R₅₃ identisch miteinander oder verschieden voneinander sind,
Ar₁, Ar₂, Ar₂₁, Ar₂₂, Ar₃₁ bis Ar₃₄, Ar₄₁, Ar₄₂, Ar₅₁, Ar₅₂, und Ar₆₁ bis Ar₆₅ jeweils unabhängig ausgewählt sind aus einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe, und einer substituierten oder unsubstituierten einwertigen nichtaromatischen kondensierten heteropolycyclischen Gruppe, und Ar₁ und Ar₂ wahlweise *via* eine Einfachbindung verknüpft sind,
c21, c22, c31 bis c34, c41, c42, c51, c52, c61 und c62 jeweils unabhängig 1, 2, 3, 4 oder 5 sind,
wenn c21 und c22 jeweils unabhängig zwei oder mehr sind, zwei oder mehr Ar₂₁ identisch miteinander oder verschieden voneinander sind, und zwei oder mehr Ar₂₂ identisch miteinander oder verschieden voneinander sind,
wenn c31 bis c34 jeweils unabhängig zwei oder mehr sind, zwei oder mehr Ar₃₁ identisch miteinander oder verschieden voneinander sind, zwei oder mehr Ar₃₂ identisch miteinander oder verschieden voneinander sind, zwei oder mehr Ar₃₃ identisch miteinander oder verschieden voneinander sind, und zwei oder mehr Ar₃₄ identisch miteinander oder verschieden voneinander sind,
wenn c41 und c42 jeweils unabhängig zwei oder mehr sind, zwei oder mehr Ar₄₁ identisch miteinander oder verschieden voneinander sind, und zwei oder mehr Ar₄₂ identisch miteinander oder verschieden voneinander sind,
wenn c51 und c52 jeweils unabhängig zwei oder mehr sind, zwei oder mehr Ar₅₁ identisch miteinander oder verschieden voneinander sind, und zwei oder mehr Ar₅₂ identisch miteinander oder verschieden voneinander sind,
wenn c61 und c62 jeweils unabhängig zwei oder mehr sind, zwei oder mehr Ar₆₁ identisch miteinander oder verschieden voneinander sind, und zwei oder mehr Ar₆₂ identisch miteinander oder verschieden voneinander sind,
mindestens ein Substituent der substituierten C₃-C₆₀-carbocyclischen Gruppe, der substituierten C₁-C₆₀-heterocyclischen Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nichtaromatischen kondensierten polycyclischen Gruppe und der substituierten einwertigen nichtaromatischen kondensierten heteropolycyclischen Gruppe ausgewählt ist aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem Substituenten, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe, jeweils substituiert mit mindestens einem Substituenten, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
Q₁ bis Q₃, Q₁₁ bis Q₁₃, Q₂₁ bis Q₂₃, und Q₃₁ bis Q₃₃ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, einer Biphenylgruppe und einer Terphenylgruppe.

2. Organische lichtemittierende Vorrichtung nach Anspruch 1, wobei, in Formeln 1, 4 und 5,
X₁₁ N-(L₁₄)ₐ₁₄-(R₁₄)_{b14} ist,
X₄₁ N-(L₄₄)ₐ₄₄-(R₄₃)_{b43} ist, und
X₅₁ O oder S ist.

3. Organische lichtemittierende Vorrichtung nach einem der Ansprüche 1 bis 2, wobei, in Formeln 1 bis 6,
L₁₁ bis L₁₄, L₂₁ bis L₂₃, L₃₁ bis L₃₅, L₄₁ bis L₄₄, L₅₁ bis L₅₄, und L₆₁ bis L₆₃ jeweils unabhängig ausgewählt sind aus:
einer Einfachbindung;
einer Benzengruppe, einer Naphthalingruppe, einer Pentalengruppe, einer Indengruppe, einer Azulengruppe, einer Heptalengruppe, einer Indacengruppe, einer Acenaphthengruppe, einer Fluorengruppe, einer Spirofluorengruppe, einer Benzofluorengruppe, einer Dibenzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentacengruppe, einer Hexacengruppe, einer Rubicengruppe, einer Coronengruppe, einer Ovalengruppe, einer Pyrrolgruppe, einer Thiophengruppe, einer Furangruppe, einer Imidazolgruppe, einer Pyrazolgruppe, einer Thiazolgruppe, einer Isothiazolgruppe, einer Oxazolgruppe, einer Isoxazolgruppe, einer Pyridingruppe, einer Pyrazingruppe, einer Pyrimidingruppe, einer Pyridazingruppe, einer Indolgruppe, einer Isoindolgruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Carbazolgruppe, einer Phenanthridingruppe, einer Acridingruppe, einer Phenanthrolingruppe, einer Phenazingruppe, einer Benzimidazolgruppe, einer Benzofurangruppe, einer Benzothiophengruppe, einer Isobenzothiazolgruppe, einer Benzoxazolgruppe, einer Isobenzoxazolgruppe, einer Triazolgruppe, einer Tetrazolgruppe, einer Oxadiazolgruppe, einer Triazingruppe, einer Dibenzofurangruppe, einer Dibenzothiophengruppe, einer Benzocarbazolgruppe und einer Dibenzocarbazolgruppe; und
einer Benzengruppe, einer Naphthalingruppe, einer Pentalengruppe, einer Indengruppe, einer Azulengruppe, einer Heptalengruppe, einer Indacengruppe, einer Acenaphthengruppe, einer Fluorengruppe, einer Spirofluorengruppe, einer Benzofluorengruppe, einer Dibenzofluorengruppe, einer Phenalengruppe, einer Phenanthrengruppe, einer Anthracengruppe, einer Fluoranthengruppe, einer Triphenylengruppe, einer Pyrengruppe, einer Chrysengruppe, einer Naphthacengruppe, einer Picengruppe, einer Perylengruppe, einer Pentacengruppe, einer Hexacengruppe, einer Rubicengruppe, einer Coronengruppe, einer Ovalengruppe, einer Pyrrolgruppe, einer Thiophengruppe, einer Furangruppe, einer Imidazolgruppe, einer Pyrazolgruppe, einer Thiazolgruppe, einer Isothiazolgruppe, einer Oxazolgruppe, einer Isoxazolgruppe, einer Pyridingruppe, einer Pyrazingruppe, einer Pyrimidingruppe, einer Pyridazingruppe, einer Indolgruppe, einer Isoindolgruppe, einer Indazolgruppe, einer Puringruppe, einer Chinolingruppe, einer Isochinolingruppe, einer Benzochinolingruppe, einer Phthalazingruppe, einer Naphthyridingruppe, einer Chinoxalingruppe, einer Chinazolingruppe, einer Cinnolingruppe, einer Carbazolgruppe, einer Phenanthridingruppe, einer Acridingruppe, einer Phenanthrolingruppe, einer Phenazingruppe, einer Benzimidazolgruppe, einer Benzofurangruppe, einer Benzothiophengruppe, einer Isobenzothiazolgruppe, einer Benzoxazolgruppe, einer Isobenzoxazolgruppe, einer Triazolgruppe, einer Tetrazolgruppe, einer Oxadiazolgruppe, einer Triazingruppe, einer Dibenzofurangruppe, einer Dibenzothiophengruppe, einer Benzocarbazolgruppe und einer Dibenzocarbazolgruppe, jeweils substituiert mit mindestens einem Substituenten, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe und einer Imidazopyridinylgruppe.

4. Organische lichtemittierende Vorrichtung nach einem der Ansprüche 1 bis 3, wobei, in Formeln 1 bis 6,
L₁₁ bis L₁₄, L₂₁ bis L₂₃, L₃₁ bis L₃₅, L₄₁ bis L₄₄, L₅₁ bis L₅₄, und L₆₁ bis L₆₃ jeweils unabhängig ausgewählt sind aus einer Einfachbindung und Gruppen, dargestellt durch Formeln 7-1 bis 7-21: 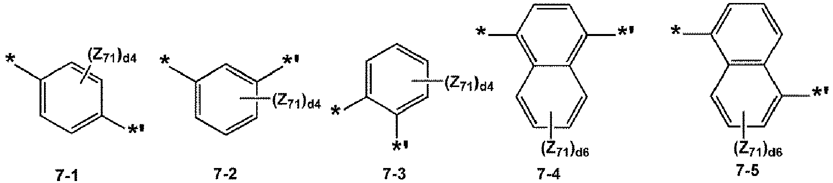 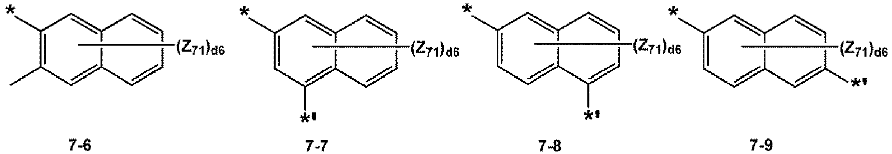 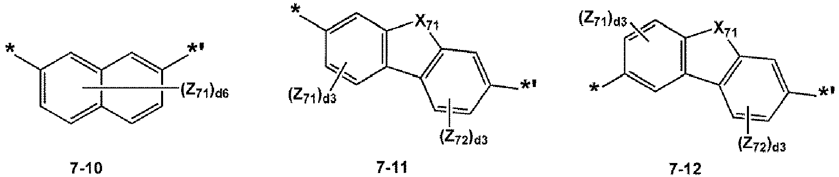 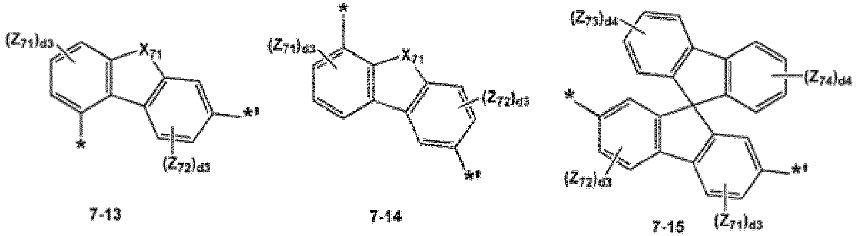 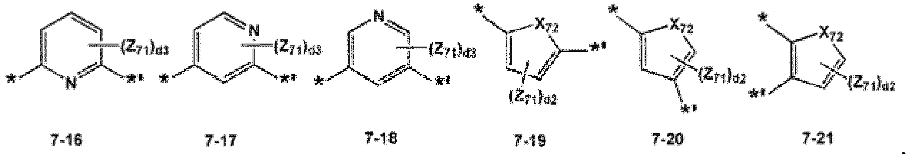 wobei X₇₁ und X₇₂ jeweils unabhängig ausgewählt sind aus O, S, C(Z₇₅)(Z₇₆), N(Z₇₇) und Si(Z₇₈)(Z₇₉),
Z₇₁ bis Z₇₉ jeweils unabhängig ausgewählt sind aus:
Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe und einer Imidazopyridinylgruppe,
d2 eine ganze Zahl von 0 bis 2 ist,
d3 eine ganze Zahl von 0 bis 3 ist,
d4 eine ganze Zahl von 0 bis 4 ist,
d6 eine ganze Zahl von 0 bis 6 ist, und
^{∗} und ^{∗}' jeweils eine Bindungsstelle zu einem benachbarten Atom angeben.

5. Organische lichtemittierende Vorrichtung nach einem der Ansprüche 1 bis 4, wobei:
Ar₁, Ar₂, Ar₂₁, Ar₂₂, Ar₃₁ bis Ar₃₄, Ar₄₁, Ar₄₂, Ar₅₁, Ar₅₂, und Ar₆₁ bis Ar₆₅ jeweils unabhängig ausgewählt sind aus:
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Thianthrenylgruppe, einer Phenoxathiinylgruppe, und einer Dibenzodioxinylgruppe; und
einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyrimidinylgruppe, einer Thianthrenylgruppe, einer Phenoxathiinylgruppe und einer Dibenzodioxinylgruppe, jeweils substituiert mit mindestens einem Substituenten, ausgewählt aus Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridinylgruppe, einer Imidazopyrimidinylgruppe und -Si(Q₃₃)(Q₃₄)(Q₃₅), und
Q₃₃ bis Q₃₅ jeweils unabhängig ausgewählt sind aus einer C₁-C₆₀-Alkylgruppe und einer C₆-C₆₀-Arylgruppe.

6. Organische lichtemittierende Vorrichtung nach einem der Ansprüche 1 bis 5, wobei
Ar₁, Ar₂, Ar₂₁, Ar₂₂, Ar₃₁ bis Ar₃₄, Ar₄₁, Ar₄₂, Ar₅₁, Ar₅₂, und Ar₆₁ bis Ar₆₅ jeweils unabhängig ausgewählt sind aus Gruppen, dargestellt durch Formeln 9-1 bis 9-22: 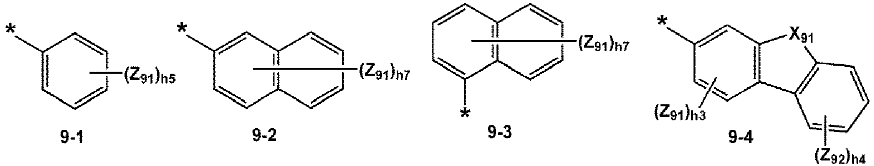 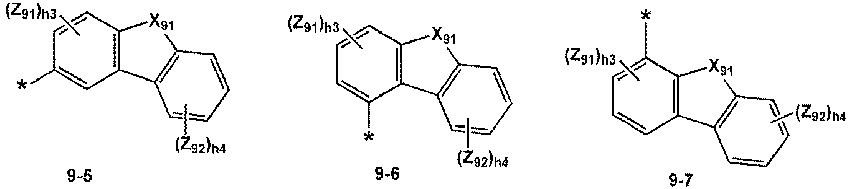 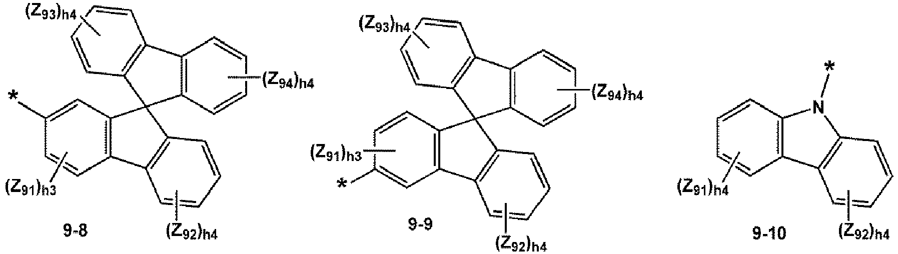 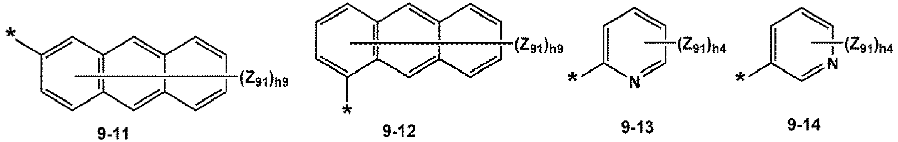 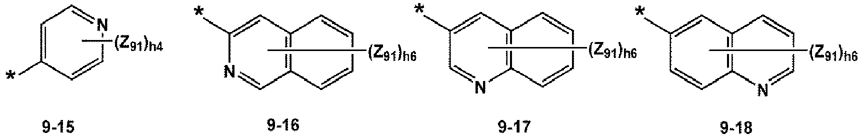 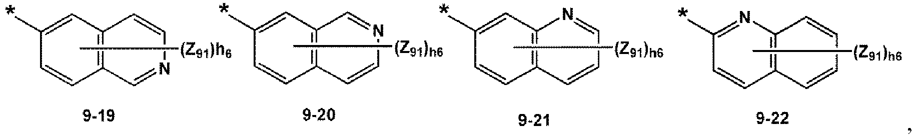 wobei, in Formeln 9-1 bis 9-22,
X₉₁ ausgewählt ist aus O, S, C(Z₉₅)(Z₉₆), N(Z₉₇) und Si(Z₉₈)(Z₉₉),
Z₉₁ bis Z₉₉ jeweils unabhängig ausgewählt sind aus:
Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Benzochinoxalinylgruppe, einer Chinazolinylgruppe, einer Benzochinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe, einer Imidazopyridinylgruppe und einer Imidazopyrimidinylgruppe,
h3 eine ganze Zahl von 0 bis 3 ist,
h4 eine ganze Zahl von 0 bis 4 ist,
h5 eine ganze Zahl von 0 bis 5 ist,
h6 eine ganze Zahl von 0 bis 6 ist,
h7 eine ganze Zahl von 0 bis 7 ist,
h9 eine ganze Zahl von 0 bis 9, und
^{∗} und ^{∗}' jeweils eine Bindungsstelle zu einem benachbarten Atom angeben.

7. Organische lichtemittierende Vorrichtung nach einem der Ansprüche 1 bis 6, wobei, in Formel 1,
^{∗}-(L₁₁)ₐ₁₁-^{∗}' und ^{∗}-(L₁₂)ₐ₁₂-^{∗}' jeweils eine Einfachbindung sind,
^{∗}-(L₁₂)ₐ₁₂-^{∗}' eine Einfachbindung ist, oder
^{∗}-(L₁₂)ₐ₁₂-^{∗}' und ^{∗}-(L₁₃)ₐ₁₃-^{∗}' jeweils eine Einfachbindung sind.

8. Organische lichtemittierende Vorrichtung nach einem der Ansprüche 1 bis 7, wobei Formel 1 durch Formel 1-1 oder Formel 1-2 dargestellt ist: 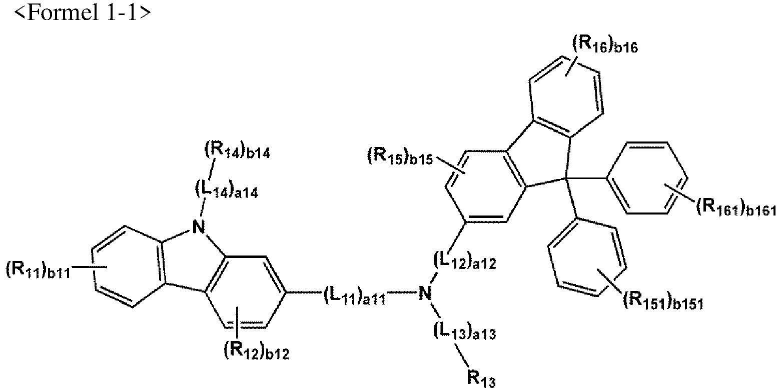 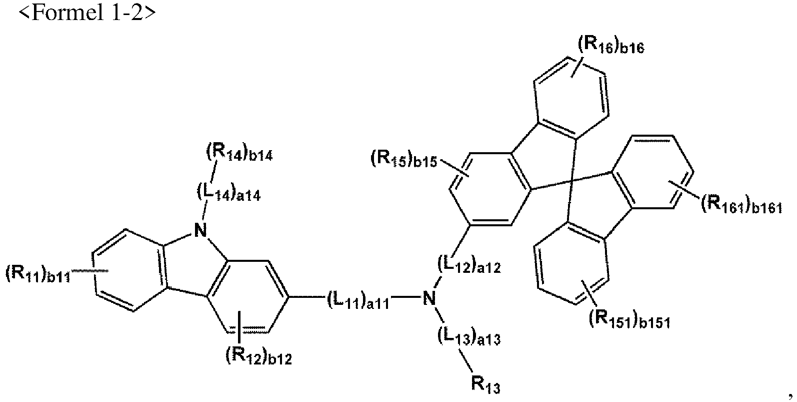 wobei, in Formeln 1-1 und 1-2,
L₁₁ bis L₁₃, a11 bis a13, R₁₁ bis R₁₆, b11, b12, b14, b15 und b16 jeweils die gleichen sind, wie definiert in Anspruch 1 ,
R₁₅₁ und R₁₆₁ so wie jeweils R₁₅ und R₁₆ in Anspruch 1 definiert sind, und
b151 und b161 so wie jeweils b15 und b16 in Anspruch 1 definiert sind.

9. Organische lichtemittierende Vorrichtung nach einem der Ansprüche 1 bis 8, wobei, in Formel 2,
A₂₁ und A₂₂ jeweils unabhängig eine Benzengruppe oder eine Naphthalingruppe sind.

10. Organische lichtemittierende Vorrichtung nach einem der Ansprüche 1 bis 9, wobei Formel 2 dargestellt ist durch eine Formel, ausgewählt aus Formeln 2-1 bis 2-7: 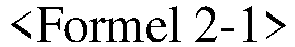 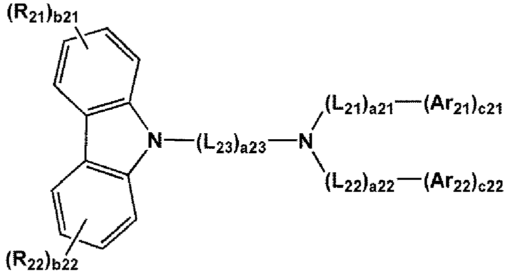 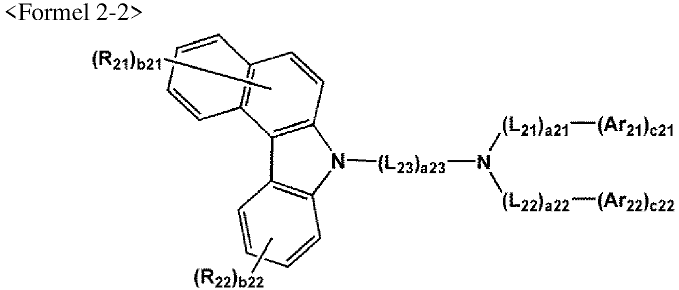 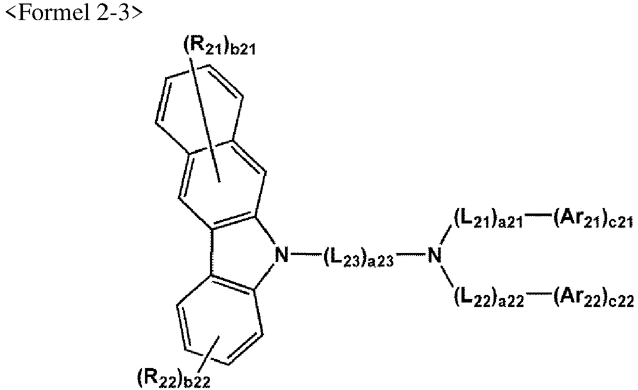 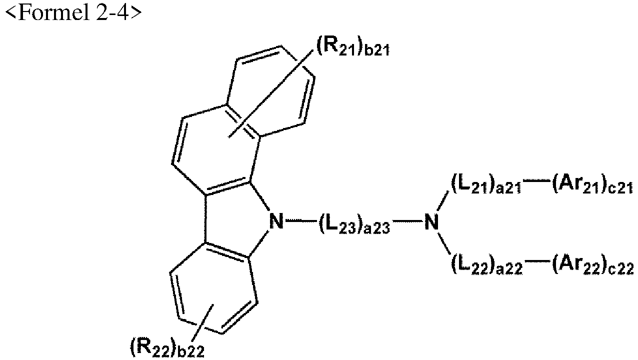 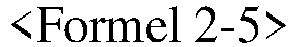 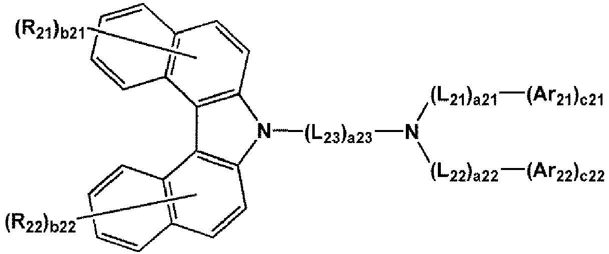 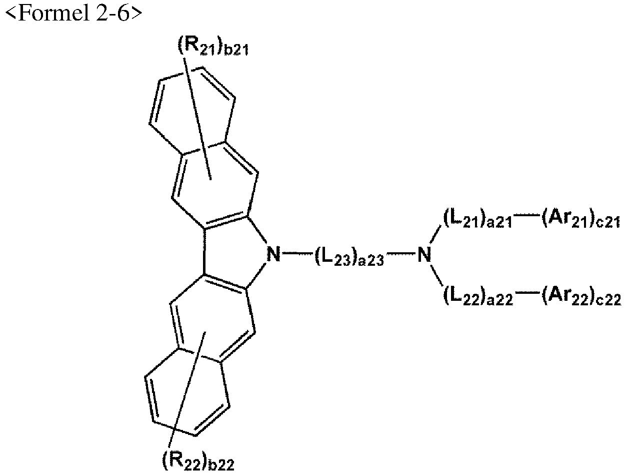 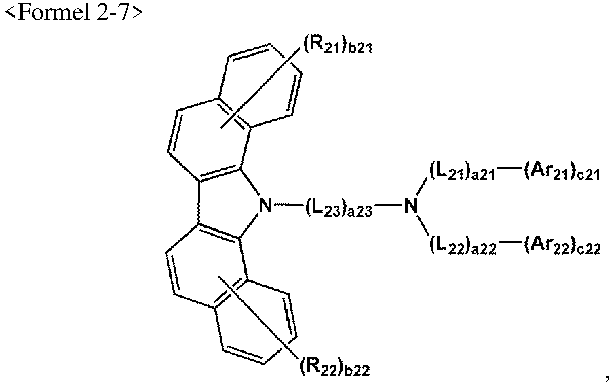 wobei, in Formeln 2-1 bis 2-7,
L₂₁ bis L₂₃, a21 bis a23, R₂₁, R₂₂, b21, b22, Ar₂₁, Ar₂₂, c21 und c22 jeweils die gleichen sind, wie definiert in Anspruch 1.

11. Organische lichtemittierende Vorrichtung nach einem der Ansprüche 1 bis 10, wobei:
ein Teil, dargestellt durch 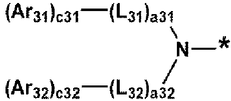 , und ein Teil, dargestellt durch 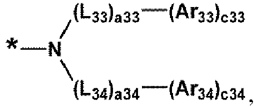 in Formel 3 identisch miteinander sind.

12. Organische lichtemittierende Vorrichtung nach einem der Ansprüche 1 bis 11, wobei Formel 4 durch eine Formel dargestellt ist, ausgewählt aus Formeln 4-1 bis 4-4; 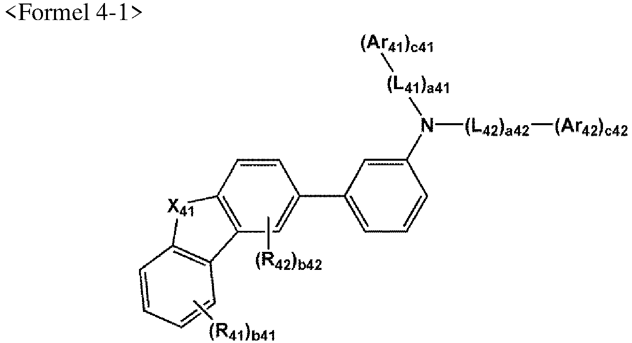 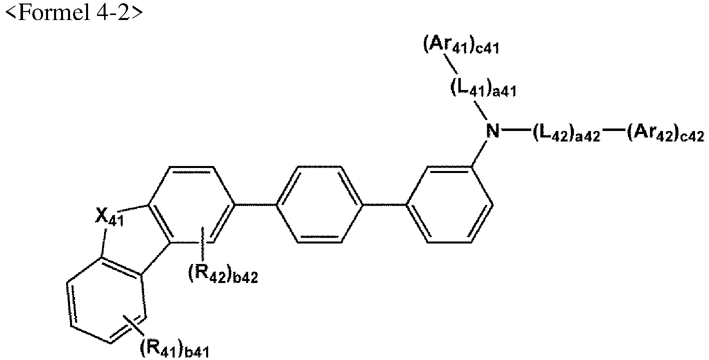 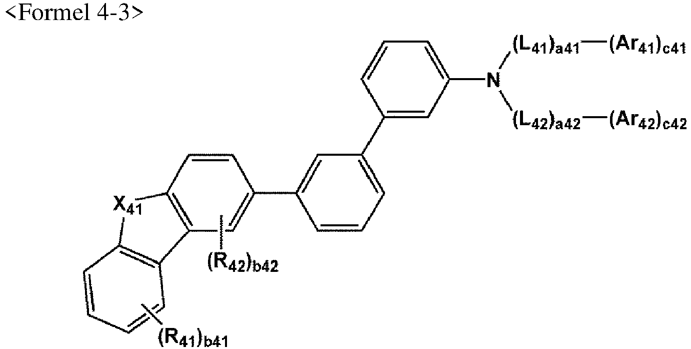 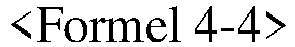 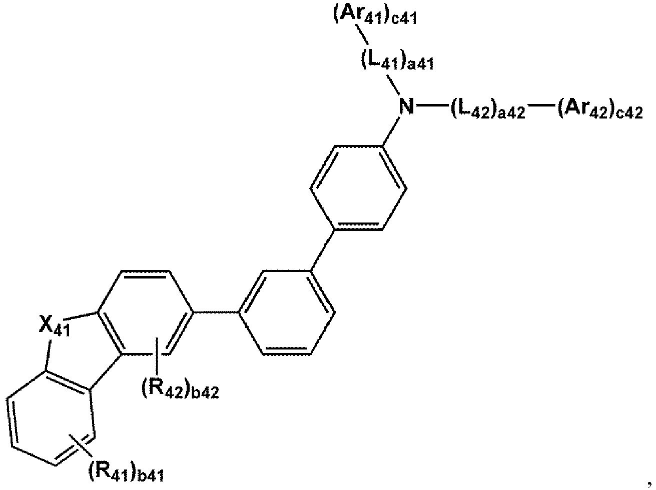 wobei, in Formeln 4-1 bis 4-4,
X₄₁, L₄₁, L₄₂, a41, a42, R₄₁, R₄₂, b41, b42, Ar₄₁, Ar₄₂, c41 und c42 jeweils die gleichen sind, wie definiert in Anspruch 1..

13. Organische lichtemittierende Vorrichtung nach einem der Ansprüche 1 bis 12, wobei Formel 5 dargestellt ist durch eine Formel, ausgewählt aus Formeln 5-1 bis 5-3: 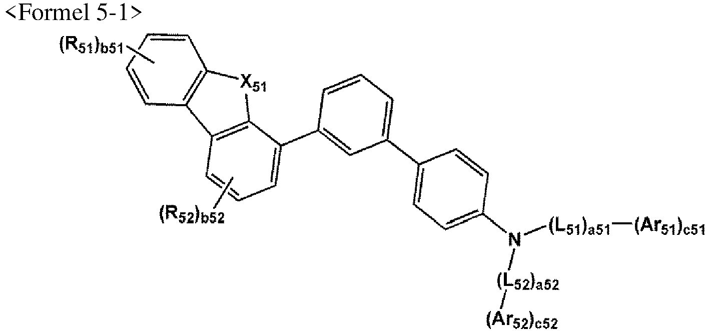 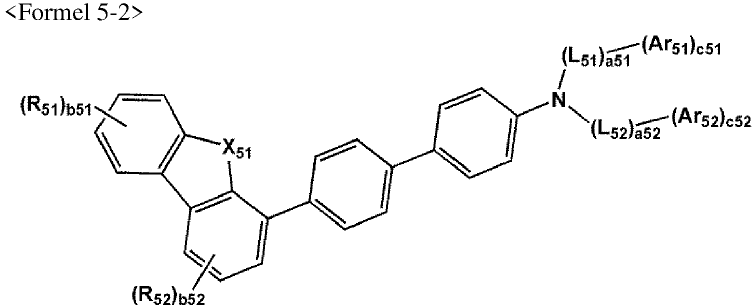 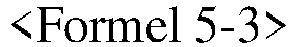 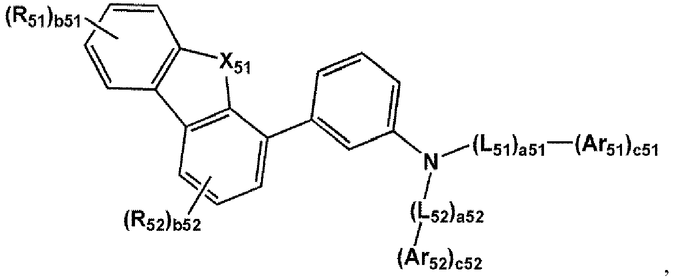 wobei, in Formeln 5-1 bis 5-3,
X₅₁, L₅₁, L₅₂, a51, a52, R₅₁, R₅₂, b51, b52, Ar₅₁, Ar₅₂, c51 und c52 jeweils die gleichen sind, wie definiert in Anspruch 1.

14. Organische lichtemittierende Vorrichtung nach einem der Ansprüche 1 bis 13, wobei Formel 6 dargestellt ist durch eine Formel, ausgewählt aus Formeln 6-1 bis 6-4: 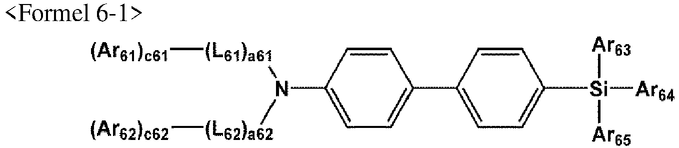 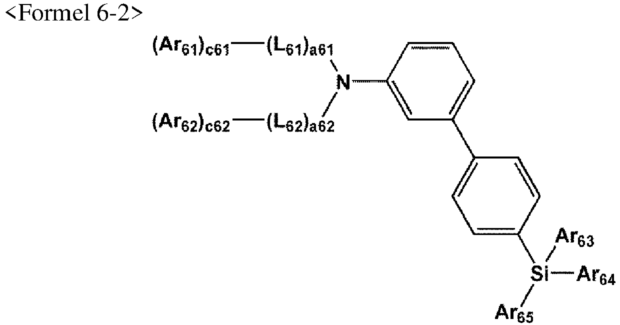 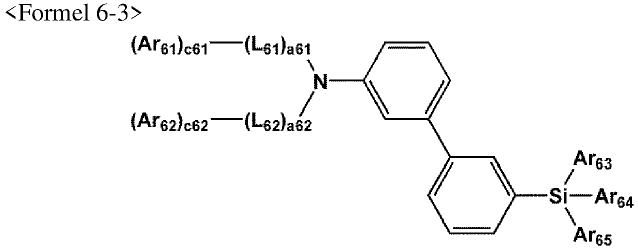 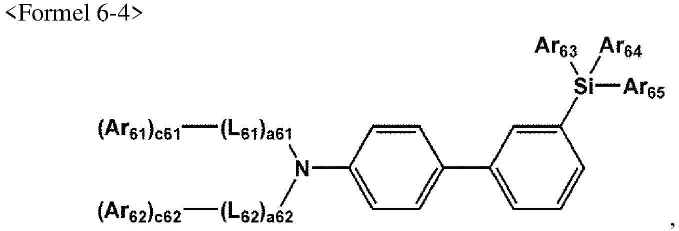 wobei, in Formeln 6-1 bis 6-4,
L₆₁, L₆₂, a61, a62, Ar₆₁ bis Ar₆₅, c61 und c62 jeweils die gleichen sind, wie definiert in Anspruch 1.

15. Organische lichtemittierende Vorrichtung nach einem der Ansprüche 1 bis 14, wobei:
die mindestens eine Verbindung von Verbindungen, die durch Formel 1 dargestellt sind, aus Verbindungen 1-1 bis 1-63 ausgewählt ist, und
die mindestens eine Verbindung von Verbindungen, die durch Formeln 2 bis 6 dargestellt sind, aus Verbindungen 2-1 bis 2-27, Verbindungen 3-1 bis 3-18, Verbindungen 4-1 bis 4-15, Verbindungen 5-1 bis 5-19 und Verbindungen 6-1 bis 6-18 ausgewählt ist:

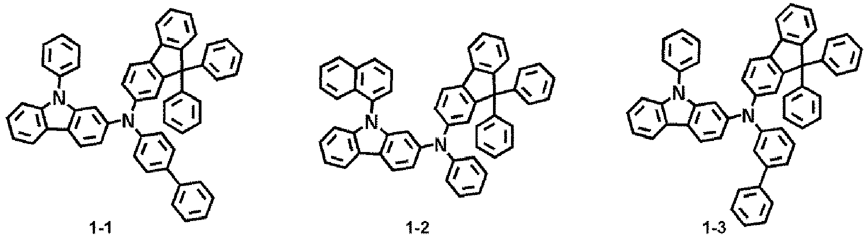

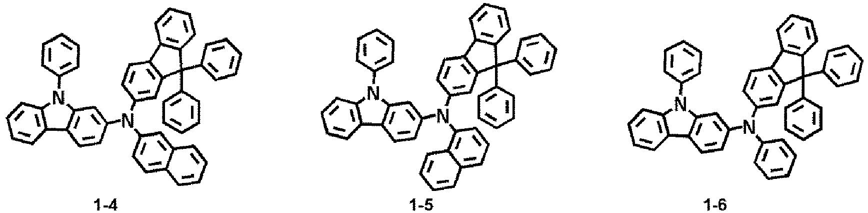

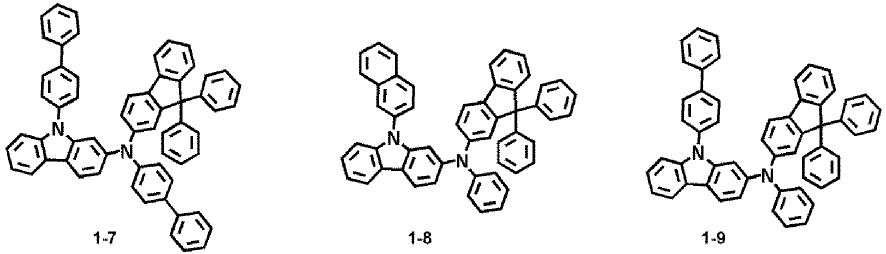

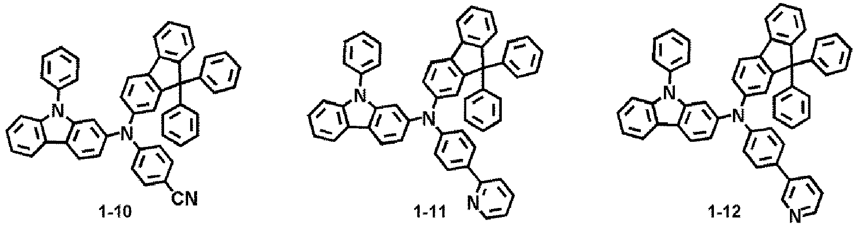

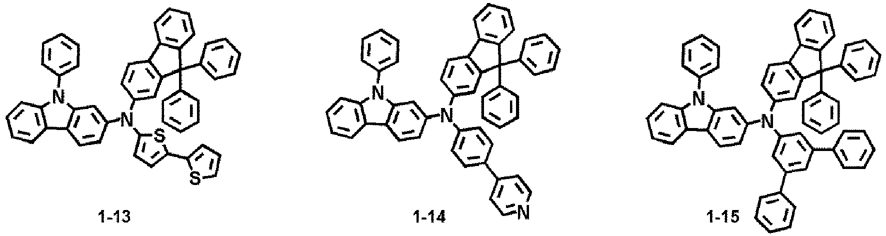

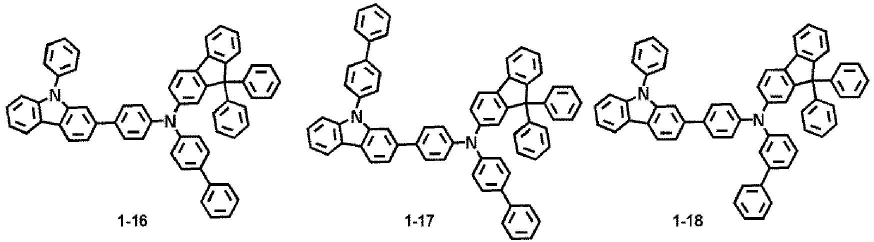

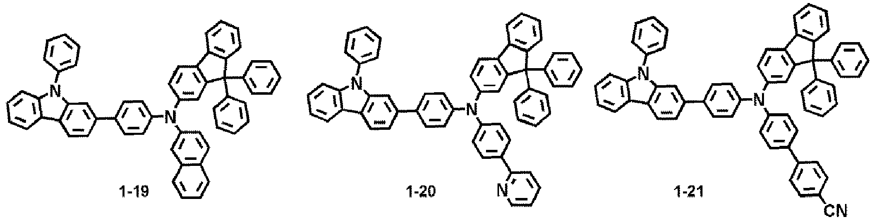

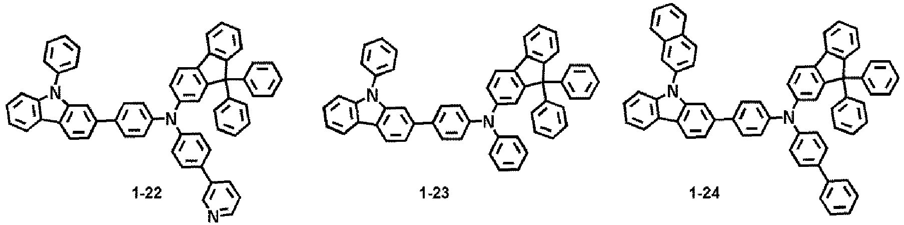

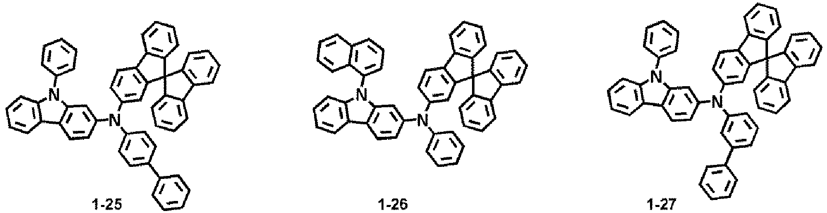

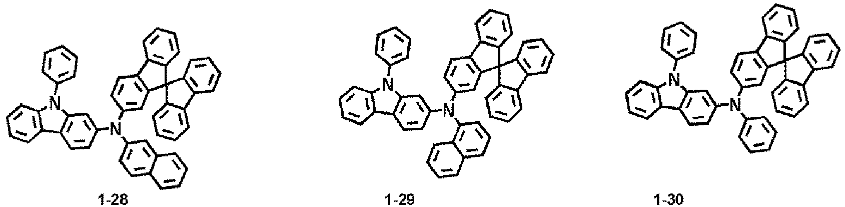

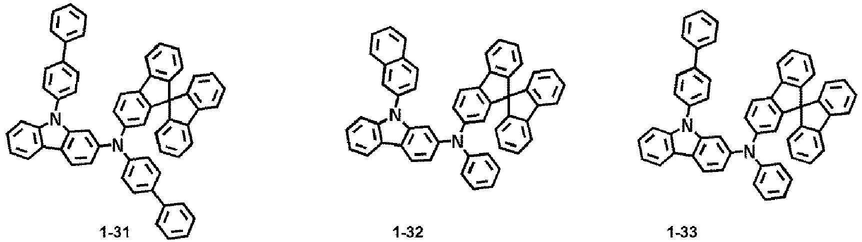

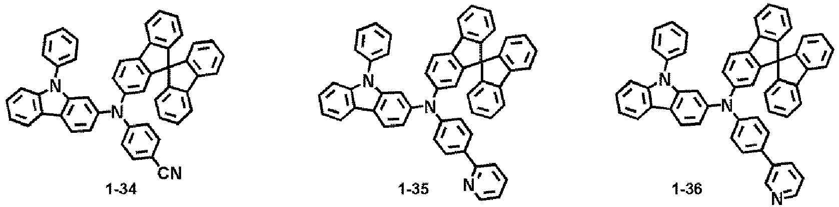

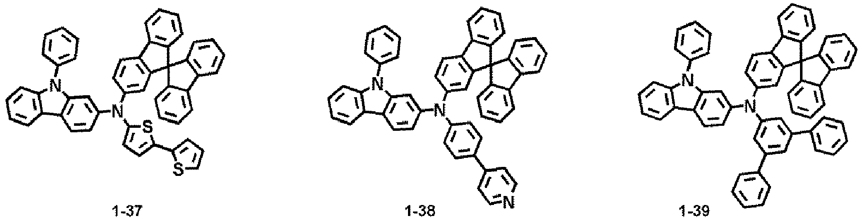

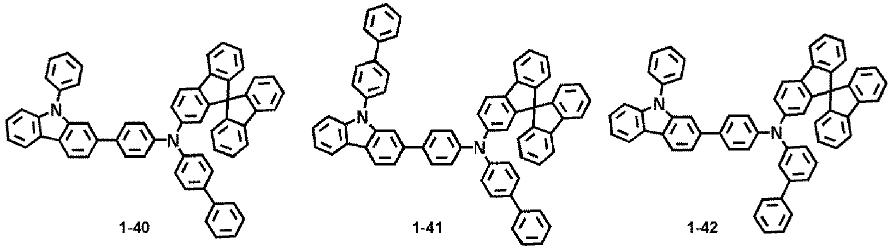

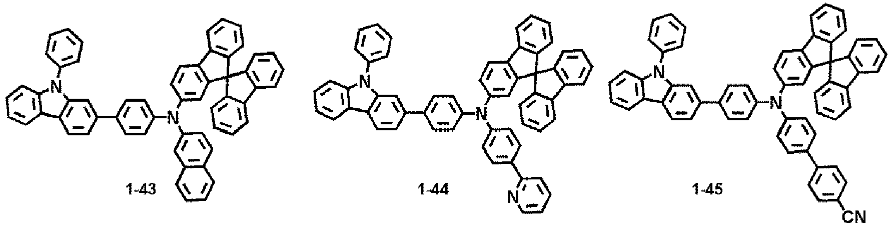

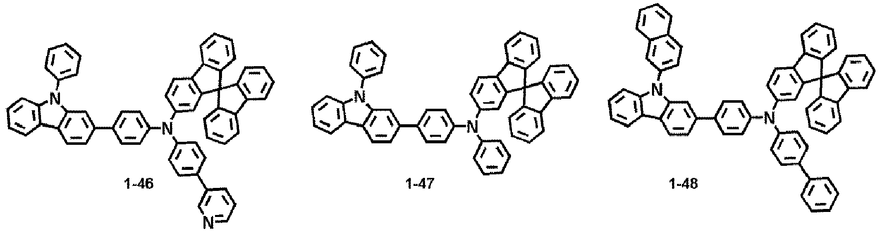

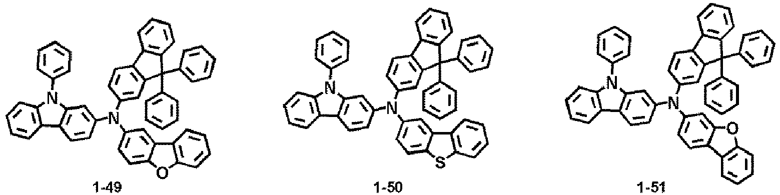

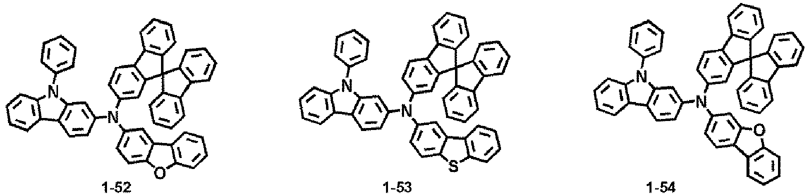

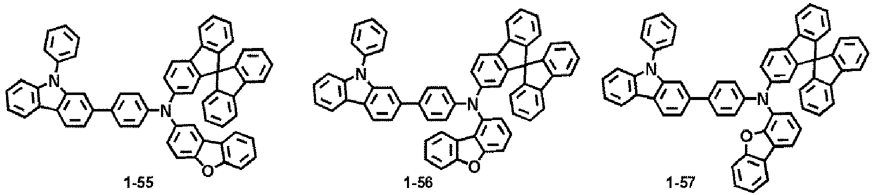

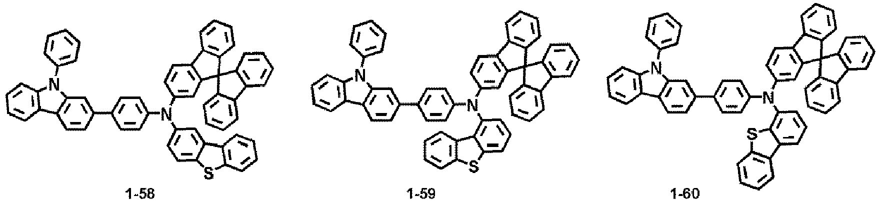

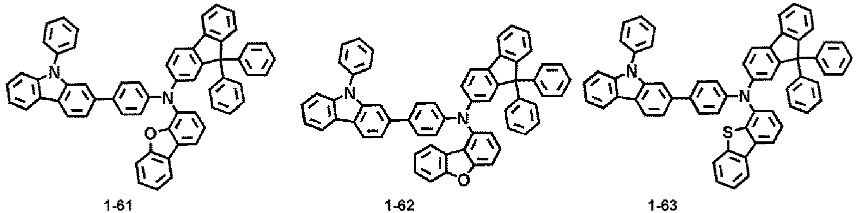

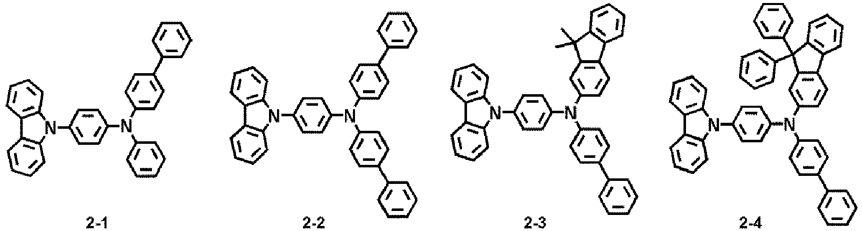

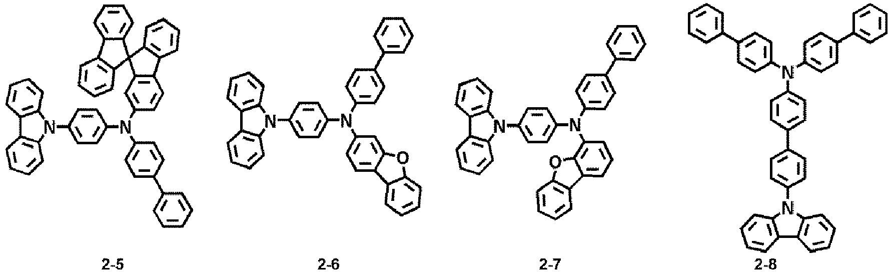

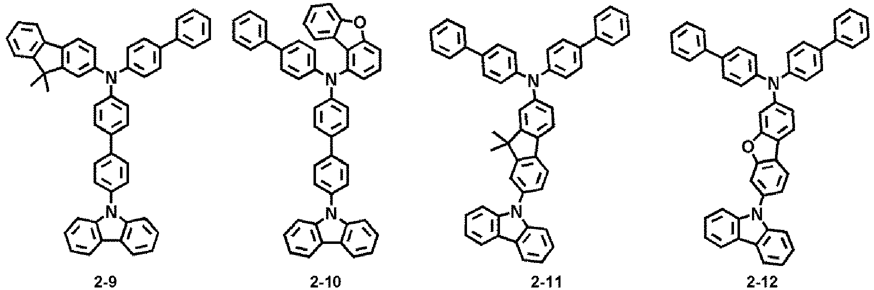

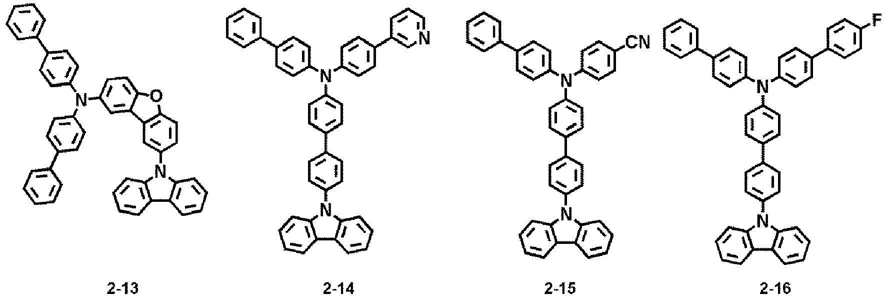

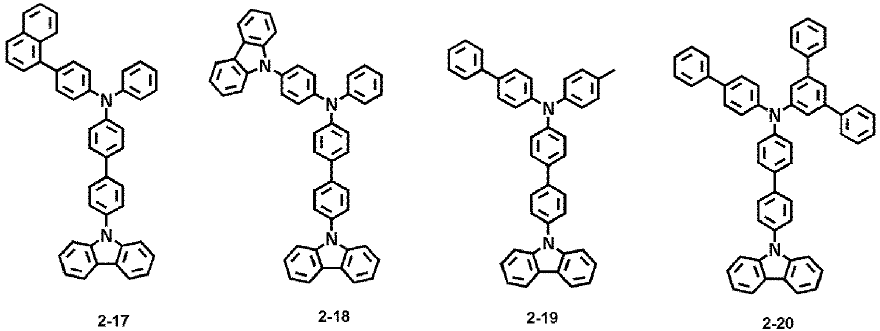

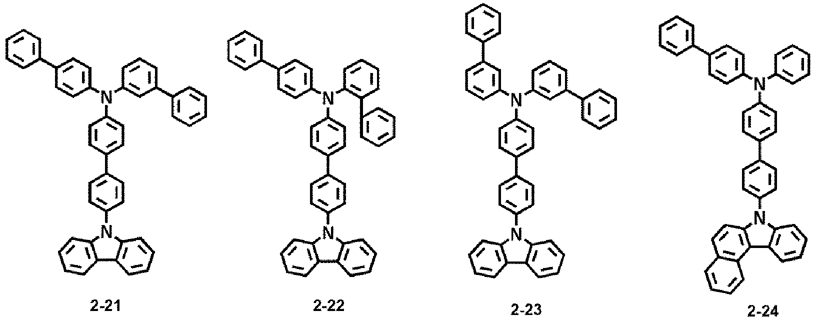

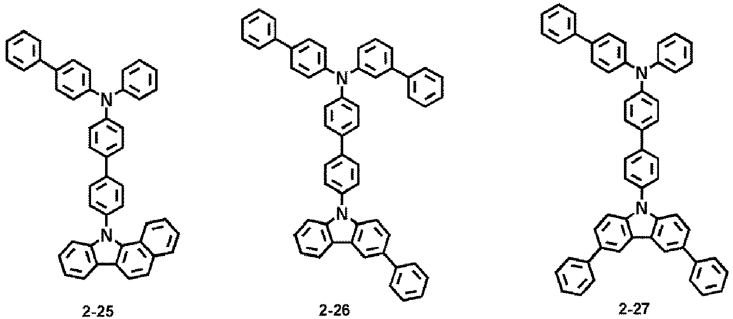

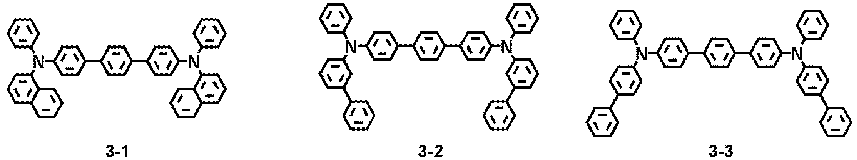

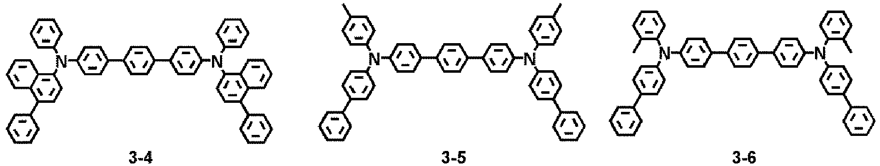

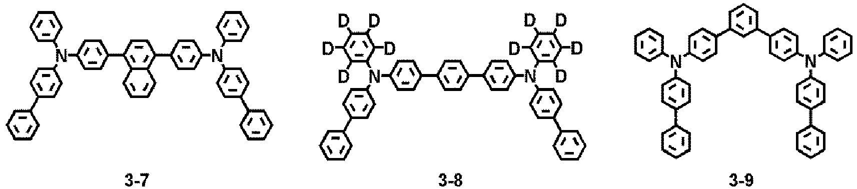

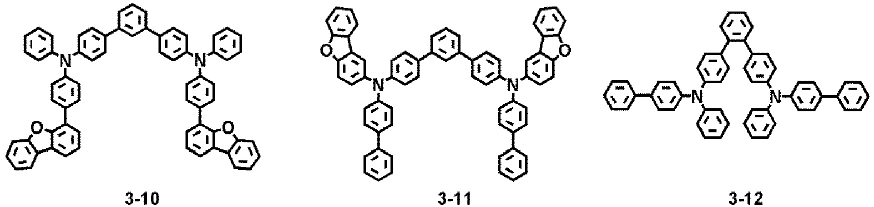

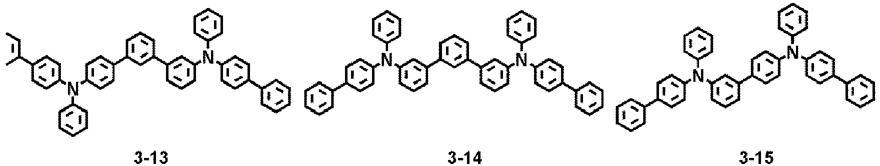

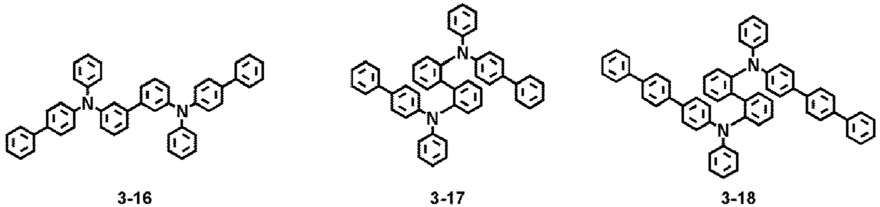

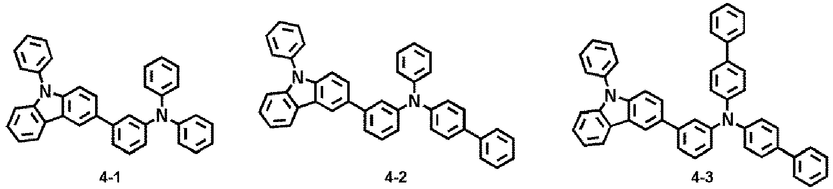

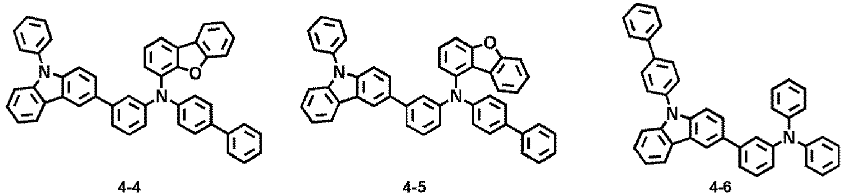

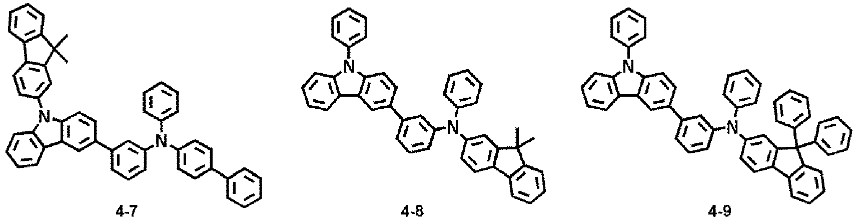

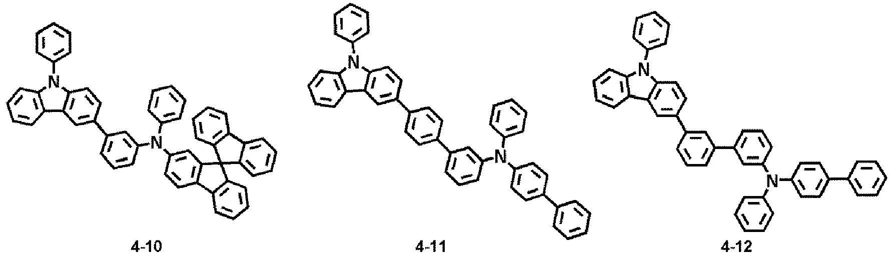

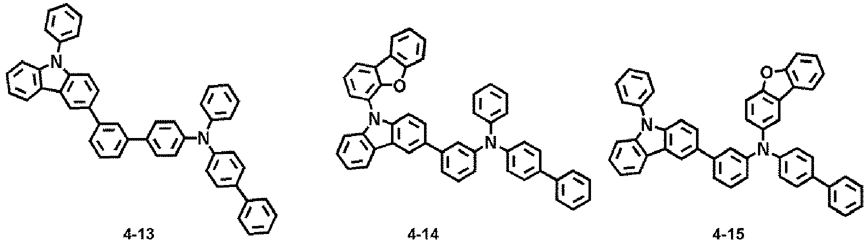

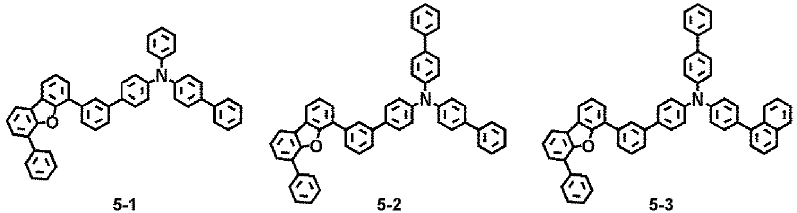

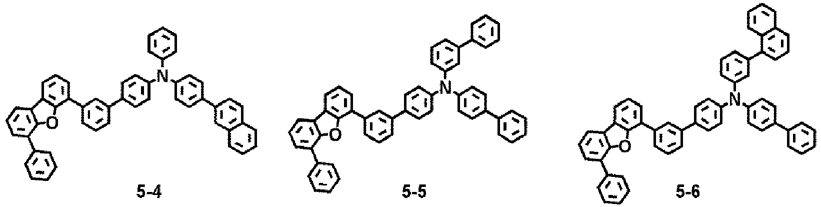

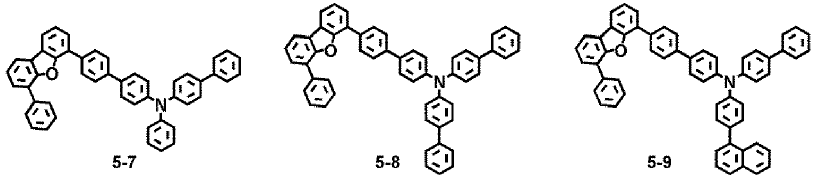

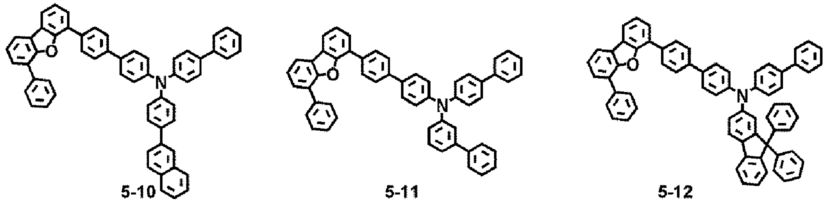

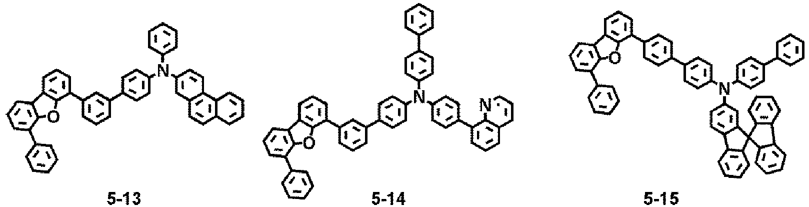

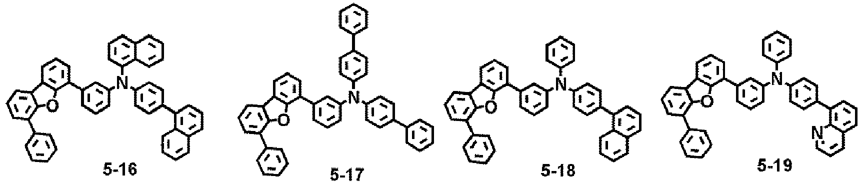

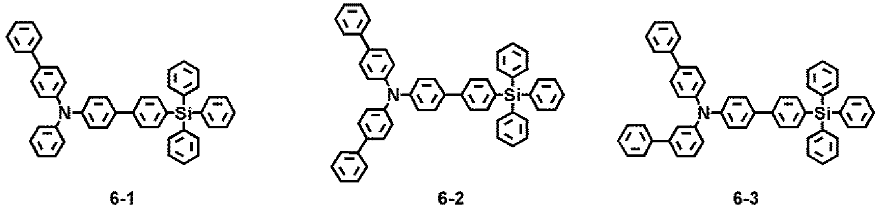

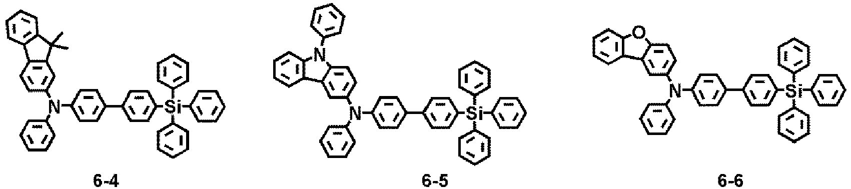

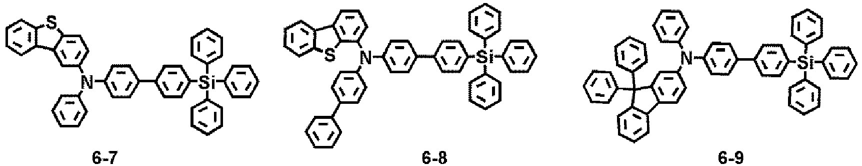

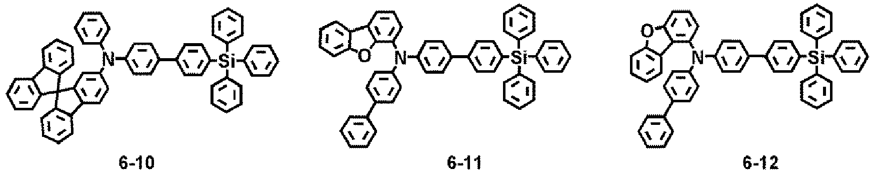

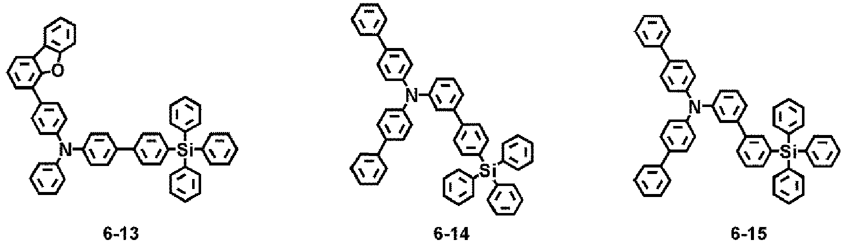

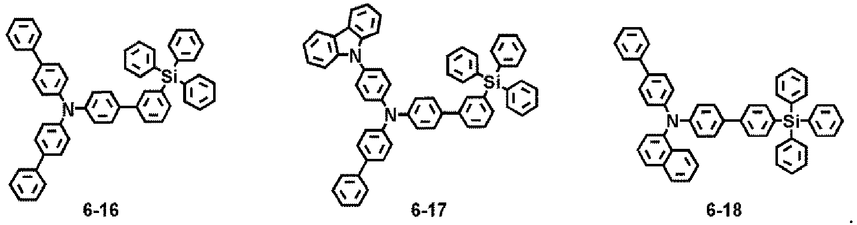

16. Organische lichtemittierende Vorrichtung nach einem der Ansprüche 1 bis 15, wobei die Vorrichtung ferner umfasst:
ein Substrat, aufgeteilt in eine erste Sub-Pixel-Region, eine zweite Sub-Pixel-Region und eine dritte Sub-Pixel-Region; und
eine Mehrzahl von ersten Elektroden, jeweils angeordnet in der ersten Sub-Pixel-Region, der zweiten Sub-Pixel-Region und der dritten Sub-Pixel-Region des Substrats;
wobei die zweite Elektrode der Mehrzahl von ersten Elektroden zugewandt ist;
die organische Schicht zwischen der Mehrzahl von ersten Elektroden und der zweiten Elektrode angeordnet ist;
die Löchertransportregion zwischen der Mehrzahl von ersten Elektroden angeordnet ist; und
die erste Schicht der Löchertransportregion zwischen der zweiten Schicht und der Mehrzahl von ersten Elektroden angeordnet ist.

## Revendications

1. Dispositif organique électroluminescent comprenant :
une première électrode (110) ;
une deuxième électrode (190) ; et
une couche organique (150) disposée entre la première électrode et la deuxième électrode et comprenant une couche d'émission et une région de transport de trous,
dans lequel la région de transport de trous est disposée entre la première électrode et la couche d'émission et comprend une première couche et une deuxième couche,
dans lequel la première couche est disposée entre la deuxième couche et la première électrode,
dans lequel la deuxième couche est en contact direct avec la couche d'émission,
dans lequel la première couche comprend au moins un composé des composés représentés par la Formule 1,
dans lequel la deuxième couche comprend au moins un composé des composés représentés par les Formules 2 à 6, et
dans lequel la première couche et la deuxième couche comprennent des composés différents les uns des autres : 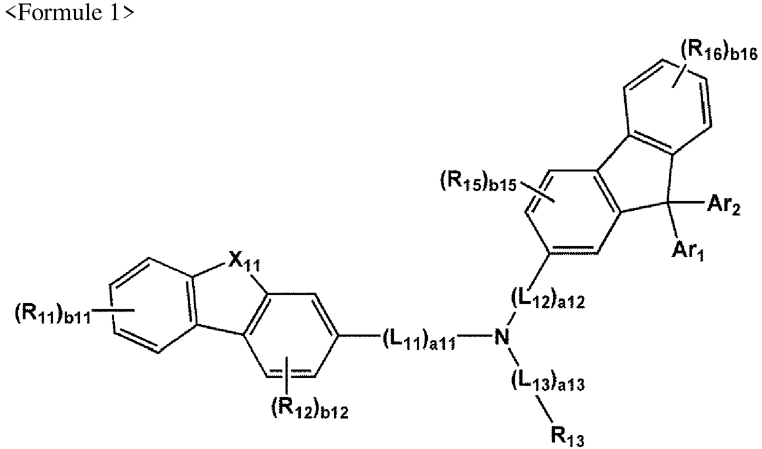 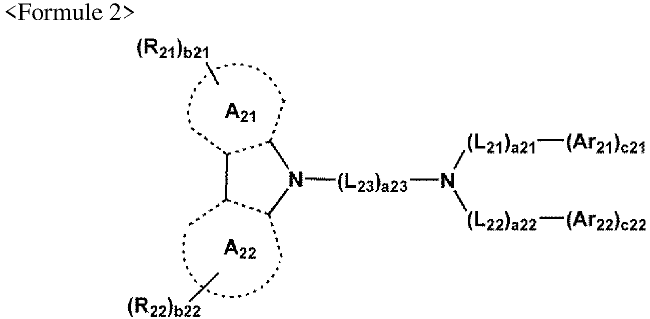 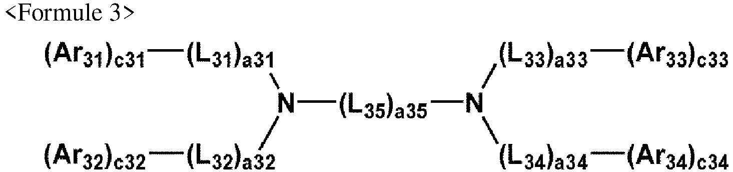 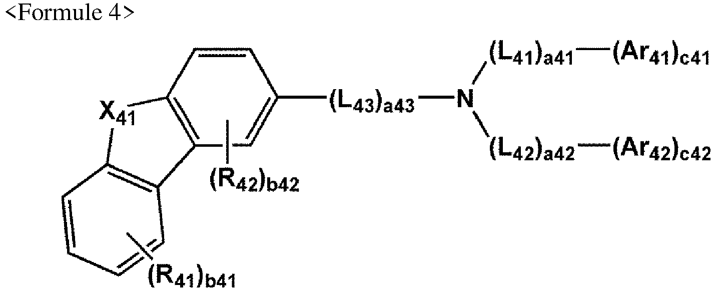 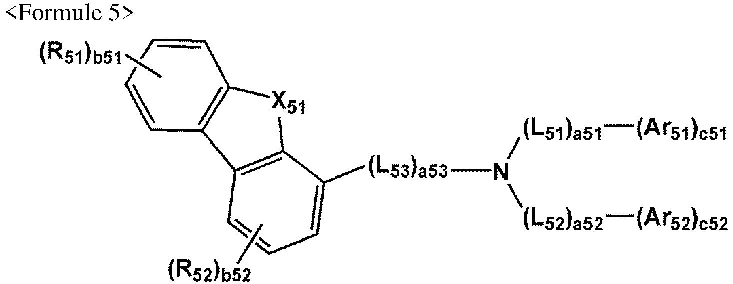 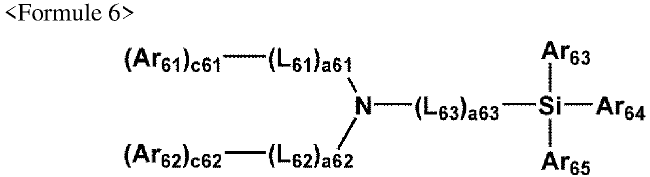 dans lequel, dans les Formule 1 à 6,
X₁₁ est N-(L₁₄)ₐ₁₄-(R₁₄)_{b14}, O ou S,
X₄₁ est N-(L₄₄)ₐ₄₄-(R₄₃)_{b43}, O ou S,
X₅₁ est N-(L₅₄)ₐ₅₄-(R₅₃)_{b53}, O ou S,
A₂₁ et A₂₂ sont chacun indépendamment un groupe carbocyclique en C₄-C₂₀ ou un groupe hétérocyclique en C₂-C₂₀,
L₁₁ à L₁₄, L₂₁ à L₂₃, L₃₁ à L₃₅, L₄₁ à L₄₄, L₅₁ à L₅₄ et L₆₁ à L₆₃ sont chacun indépendamment une liaison simple, un groupe carbocyclique en C₃-C₆₀ substitué ou non substitué ou un groupe hétérocyclique en C₁-C₆₀ substitué ou non substitué,
a11 à a14, a21 à a23, a31 à a35, a41 à a44, a51 à a54 et a61 à a63 sont chacun indépendamment 1, 2, 3, 4 ou 5,
lorsque a11 à a14 sont chacun indépendamment deux ou plus, deux L₁₁(s) ou plus sont identiques ou différents les uns des autres, deux L₁₂(s) ou plus sont identiques ou différents les uns des autres, deux L₁₃(s) ou plus sont identiques ou différents les uns des autres et deux L₁₄ ou plus sont identiques ou différents les uns des autres,
lorsque a21 à a23 sont chacun indépendamment deux ou plus, deux L₂₁(s) ou plus sont identiques ou différents les uns des autres, deux L₂₂(s) ou plus sont identiques ou différents les uns des autres et deux L₂₃(s) ou plus sont identiques ou différents les uns des autres,
lorsque a31 à a35 sont chacun indépendamment deux ou plus, deux L₃₁(s) ou plus sont identiques ou différents les uns des autres, deux L₃₂(s) ou plus sont identiques ou différents les uns des autres, deux L₃₃(s) ou plus sont identiques ou différents les uns des autres, deux L₃₄(s) ou plus sont identiques ou différents les uns des autres et deux L₃₅(s) ou plus sont identiques ou différents les uns des autres,
lorsque a41 à a44 sont chacun indépendamment deux ou plus, deux L₄₁(s) ou plus sont identiques ou différents les uns des autres, deux L₄₂(s) ou plus sont identiques ou différents les uns des autres, deux L₄₃(s) ou plus sont identiques ou différents les uns des autres et deux L₄₄(s) ou plus sont identiques ou différents les uns des autres,
lorsque a51 à a54 sont chacun indépendamment deux ou plus, deux L₅₁(s) ou plus sont identiques ou différents les uns des autres, deux L₅₂(s) ou plus sont identiques ou différents les uns des autres, deux L₅₃(s) ou plus sont identiques ou différents les uns des autres et deux L₅₄(s) ou plus sont identiques ou différents les uns des autres,
lorsque a61 à a63 sont chacun indépendamment deux ou plus, deux L₆₁(s) ou plus sont identiques ou différents les uns des autres, deux L₆₂(s) ou plus sont identiques ou différents les uns des autres et deux L₆₃(s) ou plus sont identiques ou différents les uns des autres,
R₁₁ à R₁₆, R₂₁, R₂₂, R₄₁ à R₄₃, et R₅₁ à R₅₃ sont sélectionnés chacun indépendamment parmi
hydrogène, deutérium, -F, -Cl, -Br, -I, un groupe hydroxyle, un groupe cyano, un groupe nitro, un groupe amidino, un groupe hydrazino, un groupe hydrozono, un groupe alkyle en C₁-C₂₀ et un groupe alcoxy en C₁-C₂₀ ;
un groupe alkyle en C₁-C₂₀ et un groupe alcoxy en C₁-C₂₀, substitués chacun par au moins un substituant sélectionné parmi deutérium, -F, -Cl, -Br, -I, un groupe hydroxyle, un groupe cyano, un groupe nitro, un groupe amidino, un groupe hydrazino, un groupe hydrozono, un groupe alkyle en C₁-C₂₀ et un groupe alcoxy en C₁-C₂₀ ; et
des groupes représentés par les Formules 8-1 à 8-12 : 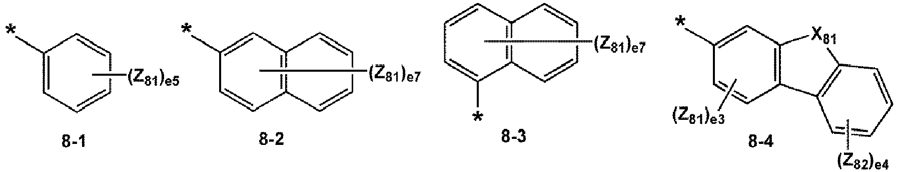 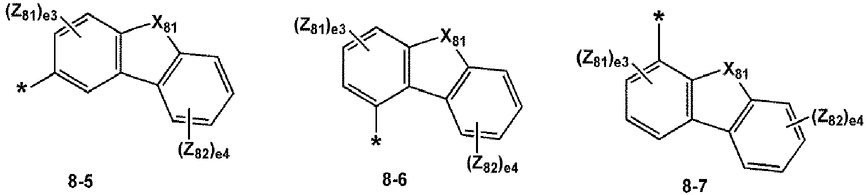 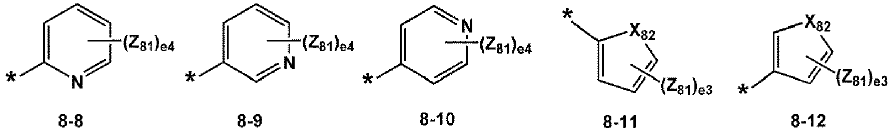
dans lequel, dans les Formule 8-1 à 8-12,
X₈₁ et X₈₂ sont sélectionnés chacun indépendamment parmi O, S, C(Z₈₃)(Z₈₄), N(Z₈₅) et Si(Z₈₆)(Z₈₇),
Z₈₁ à Z₈₇ sont sélectionnés chacun indépendamment parmi :
hydrogène, deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₂₀, un groupe alcoxy en C₁-C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acenaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle et un groupe imidazopyridinyle,
e3 est un entier de 0 à 3,
e4 est un entier de 0 à 4,
e5 est un entier de 0 à 5,
e7 est un entier de 0 à 7, et
^{∗} et ^{∗}' indiquent chacun un site de liaison à un atome voisin, et deux groupes voisins sélectionnés parmi R₁₁ à R₁₆, R₂₁, R₂₂, R₄₁ à R₄₃ et R₅₁ à R₅₃ sont optionnellement liés pour former un cycle condensé,
b11, b12 et b14 à b16, b21, b22, b41 à b43 et b51 à b53 sont chacun indépendamment 1, 2, 3, 4, 5 ou 6,
lorsque b11, b12 et b14 à b16 sont chacun indépendamment deux ou plus, deux R₁₁(s) ou plus sont identiques ou différents les uns des autres, deux R₁₂(s) ou plus sont identiques ou différents les uns des autres, deux R₁₄(s) ou plus sont identiques ou différents les uns des autres, deux R₁₅(s) ou plus sont identiques ou différents les uns des autres et deux R₁₆(s) ou plus sont identiques ou différents les uns des autres,
lorsque b21 et b22 sont chacun indépendamment deux ou plus, deux R₂₁(s) ou plus sont identiques ou différents les uns des autres et deux R₂₂(s) ou plus sont identiques ou différents les uns des autres,
lorsque b41 à b43 sont chacun indépendamment deux ou plus, deux R₄₁(s) ou plus sont identiques ou différents les uns des autres, deux R₄₂(s) ou plus sont identiques ou différents les uns des autres et deux R₄₃(s) ou plus sont identiques ou différents les uns des autres,
lorsque b51 à b53 sont chacun indépendamment deux ou plus, deux R₅₁(s) ou plus sont identiques ou différents les uns des autres, deux R₅₂(s) ou plus sont identiques ou différents les uns des autres et deux R₅₃(s) ou plus sont identiques ou différents les uns des autres,
Ar₁, Ar₂, Ar₂₁, Ar₂₂, Ar₃₁ à Ar₃₄, Ar₄₁, Ar₄₂, Ar₅₁, Ar₅₂ et Ar₆₁ à Ar₆₅ sont sélectionnés chacun indépendamment parmi un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué et un groupe hétéropolycyclique condensé non aromatique monovalent substitué ou non substitué, et Ar₁ et Ar₂ sont optionnellement liés via une liaison simple,
c21, c22, c31 à c34, c41, c42, c51, c52, c61 et c62 sont chacun indépendamment 1, 2, 3, 4 ou 5,
lorsque c21 et c22 sont chacun indépendamment deux ou plus, deux Ar₂₁(s) ou plus sont identiques ou différents les uns des autres et deux Ar₂₂(s) ou plus sont identiques ou différents les uns des autres,
lorsque c31 à c34 sont chacun indépendamment deux ou plus, deux Ar₃₁(s) ou plus sont identiques ou différents les uns des autres, deux Ar₃₂(s) ou plus sont identiques ou différents les uns des autres, deux Ar₃₃(s) ou plus sont identiques ou différents les uns des autres et deux Ar₃₄(s) ou plus sont identiques ou différents les uns des autres,
lorsque c41 et c42 sont chacun indépendamment deux ou plus, deux Ar₄₁(s) ou plus sont identiques ou différents les uns des autres et deux Ar₄₂(s) ou plus sont identiques ou différents les uns des autres,
lorsque c51 et c52 sont chacun indépendamment deux ou plus, deux Ar₅₁(s) ou plus sont identiques ou différents les uns des autres et deux Ar₅₂(s) ou plus sont identiques ou différents les uns des autres,
lorsque c61 et c62 sont chacun indépendamment deux ou plus, deux Ar₆₁(s) ou plus sont identiques ou différents les uns des autres et deux Ar₆₂(s) ou plus sont identiques ou différents les uns des autres,
au moins un substituant du groupe carbocyclique en C₃-C₆₀ substitué, du groupe hétérocyclique en C₁-C₆₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non aromatique monovalent substitué et du groupe hétéropolycyclique condensé non aromatique monovalent substitué, est sélectionné parmi :
deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀ et un groupe alcoxy en C₁-C₆₀ ;
un groupe alkyle en C₁-C₆₀, un groupe alcényle en C₂-C₆₀, un groupe alcynyle en C₂-C₆₀ et un groupe alcoxy en C₁-C₆₀, substitués chacun par au moins un substituant sélectionné parmi deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) et -P(=O)(Q₁₁)(Q₁₂) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, un groupe biphényle et un groupe terphényle ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent et un groupe hétéropolycyclique condensé non aromatique monovalent, substitués chacun par au moins un substituant sélectionné parmi deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) et -P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂), et
Q₁ à Q₃, Q₁₁ à Q₁₃, Q₂₁ à Q₂₃ et Q₃₁ à Q₃₃ sont sélectionnés chacun indépendamment parmi hydrogène, deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe hétéroaryle en C₁-C₆₀, un groupe polycyclique condensé non aromatique monovalent, un groupe hétéropolycyclique condensé non aromatique monovalent, un groupe biphényle et un groupe terphényle.

2. Composé organique électroluminescent selon la revendication 1, dans lequel, dans les Formules 1, 4 et 5,
X₁₁ est N-(L₁₄)ₐ₁₄-(R₁₄)_{b14},
X₄₁ est N-(L₄₄)ₐ₄₄-(R₄₃)_{b43}, et
X₅₁ est O ou S.

3. Composé organique électroluminescent selon l'une quelconque des revendications 1 à 2, dans lequel, dans les Formules 1 à 6,
L₁₁ à L₁₄, L₂₁ à L₂₃, L₃₁ à L₃₅, L₄₁ à L₄₄, L₅₁ à L₅₄ et L₆₁ à L₆₃ sont sélectionnés chacun indépendamment parmi :
une liaison simple ;
un groupe benzène, un groupe naphtalène, un groupe pentalène, un groupe indène, un groupe azulène, un groupe heptalène, un groupe indacène, un groupe acénaphtène, un groupe fluorène, un groupe spiro-fluorène, un groupe benzofluorène, un groupe dibenzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentacène, un groupe hexacène, un groupe rubicène, un groupe coronène, un groupe ovalène, un groupe pyrrole, un groupe thiophène, un groupe furane, un groupe imidazole, un groupe pyrazole, un groupe thiazole, un groupe isothiazole, un groupe oxazole, un groupe isoxazole, un groupe pyridine, un groupe pyrazine, un groupe pyrimidine, un groupe pyridazine, un groupe indole, un groupe isoindole, un groupe indazole, un groupe purine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe carbazole, un groupe phénanthridine, un groupe acridine, un groupe phénanthroline, un groupe phénazine, un groupe benzimidazole, un groupe benzofurane, un groupe benzothiophène, un groupe isobenzothiazole, un groupe benzoxazole, un groupe isobenzoxazole, un groupe triazole, un groupe tétrazole, un groupe oxadiazole, un groupe triazine, un groupe dibenzofurane, un groupe dibenzothiophène, un groupe benzocarbazole et un groupe dibenzocarbazole ; et
un groupe benzène, un groupe naphtalène, un groupe pentalène, un groupe indène, un groupe azulène, un groupe heptalène, un groupe indacène, un groupe acénaphtène, un groupe fluorène, un groupe spiro-fluorène, un groupe benzofluorène, un groupe dibenzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentacène, un groupe hexacène, un groupe rubicène, un groupe coronène, un groupe ovalène, un groupe pyrrole, un groupe thiophène, un groupe furane, un groupe imidazole, un groupe pyrazole, un groupe thiazole, un groupe isothiazole, un groupe oxazole, un groupe isoxazole, un groupe pyridine, un groupe pyrazine, un groupe pyrimidine, un groupe pyridazine, un groupe indole, un groupe isoindole, un groupe indazole, un groupe purine, un groupe quinoline, un groupe isoquinoline, un groupe benzoquinoline, un groupe phtalazine, un groupe naphtyridine, un groupe quinoxaline, un groupe quinazoline, un groupe cinnoline, un groupe carbazole, un groupe phénanthridine, un groupe acridine, un groupe phénanthroline, un groupe phénazine, un groupe benzimidazole, un groupe benzofurane, un groupe benzothiophène, un groupe isobenzothiazole, un groupe benzoxazole, un groupe isobenzoxazole, un groupe triazole, un groupe tétrazole, un groupe oxadiazole, un groupe triazine, un groupe dibenzofurane, un groupe dibenzothiophène, un groupe benzocarbazole et un groupe dibenzocarbazole, substitués chacun par au moins un substituant sélectionné parmi deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₂₀, un groupe alcoxy en C₁-C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle et un groupe imidazopyridinyle.

4. Composé organique électroluminescent selon l'une quelconque des revendications 1 à 3, dans lequel, dans les Formules 1 à 6,
L₁₁ à L₁₄, L₂₁ à L₂₃, L₃₁ à L₃₅, L₄₁ à L₄₄, L₅₁ à L₅₄ et L₆₁ à L₆₃ sont sélectionnés chacun indépendamment parmi une liaison simple et des groupes représentés par les Formules 7-1 à 7-21 : 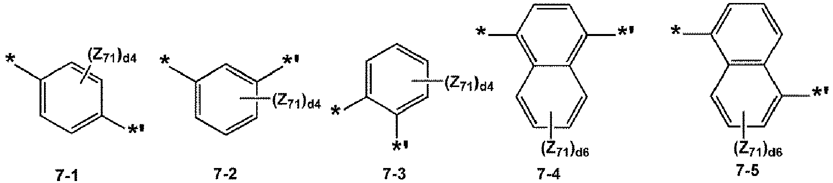 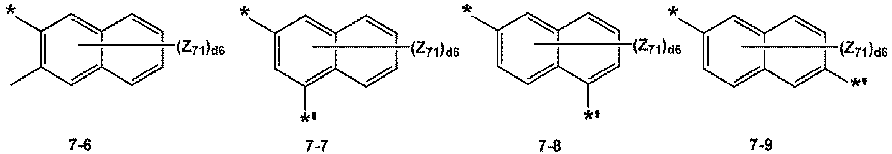 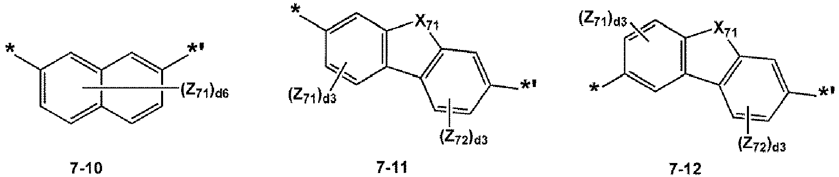 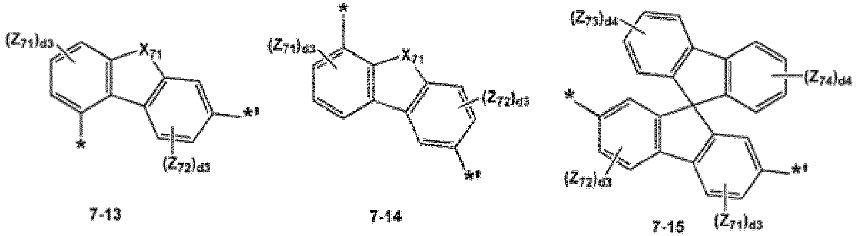 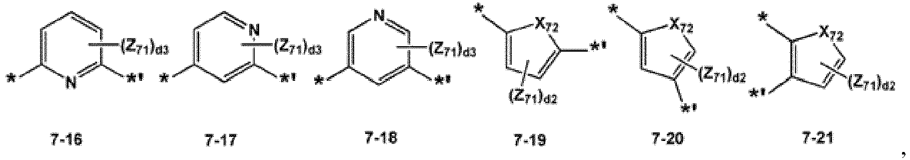
dans lequel X₇₁ et X₇₂ sont sélectionnés chacun indépendamment parmi O, S, C(Z₇₅)(Z₇₆), N(Z₇₇) et Si(Z₇₈)(Z₇₉),
Z₇₁ à Z₇₉ sont sélectionnés chacun indépendamment parmi :
hydrogène, deutérium, -F, -Cl, -Br, -I, un groupe hydroxyle, un groupe cyano, un groupe nitro, un groupe amidino, un groupe hydrazino, un groupe hydrazono, un groupe alkyle en C₁-C₂₀, un groupe alcoxy en C₁-C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle et un groupe imidazopyridinyle,
d2 est un entier de 0 à 2,
d3 est un entier de 0 à 3,
d4 est un entier de 0 à 4,
d6 est un entier de 0 à 6, et
^{∗} et ^{∗}' indiquent chacun un site de liaison à un atome voisin.

5. Dispositif organique électroluminescent selon l'une quelconque des revendications 1 à 4, dans lequel :
Ar₁, Ar₂, Ar₂₁, Ar₂₂, Ar₃₁ à Ar₃₄, Ar₄₁, Ar₄₂, Ar₅₁, Ar₅₂ et Ar₆₁ à Ar₆₅ sont sélectionnés chacun indépendamment parmi :
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, un groupe imidazopyridinyle, un groupe imidazopyrimidinyle, un groupe thianthrényle, un groupe phénoxathiinyle et un groupe dibenzodioxinyle ; et
un groupe phényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, un groupe imidazopyrimidinyle, un groupe thianthrényle, un groupe phénoxathiinyle et un groupe dibenzodioxinyle, substitués chacun par au moins un substituant sélectionné parmi deutérium, -F, -Cl, -Br, -I, un groupe hydroxyle, un groupe cyano, un groupe nitro, un groupe amino, un groupe amidino, un groupe hydrazino, un groupe hydrazono, un groupe alkyle en C₁-C₂₀, un groupe alcoxy en C₁-C₂₀, un groupe phényle, un groupe biphényle, un groupe pentalényle, un groupe indényle, un groupe naphtyle, un groupe azulényle, un groupe heptalényle, un groupe indacényle, un groupe acenaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylenyle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, un groupe imidazopyridinyle, un groupe imidazopyrimidinyle et -Si(Q₃₃)(Q₃₄)(Q₃₅), et
Q₃₃ à Q₃₅ sont sélectionnés chacun indépendamment parmi un groupe alkyle en C₁-C₆₀ et un groupe aryle en C₆-C₆₀.

6. Dispositif organique électroluminescent selon l'une quelconque des revendications 1 à 5, dans lequel
Ar₁, Ar₂, Ar₂₁, Ar₂₂, Ar₃₁ à Ar₃₄, Ar₄₁, Ar₄₂, Ar₅₁, Ar₅₂ et Ar₆₁ à Ar₆₅ sont sélectionnés chacun indépendamment parmi des groupes représentés par les Formules 9-1 à 9-22 : 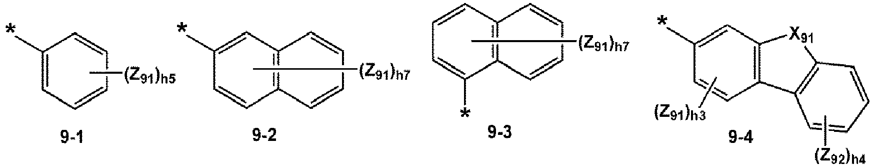 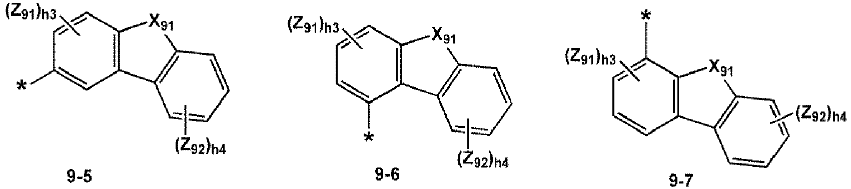 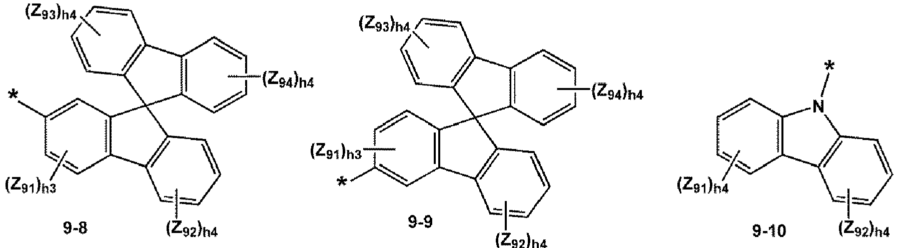 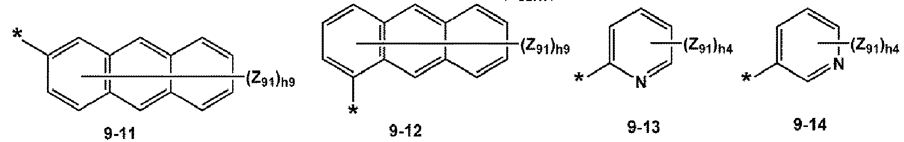 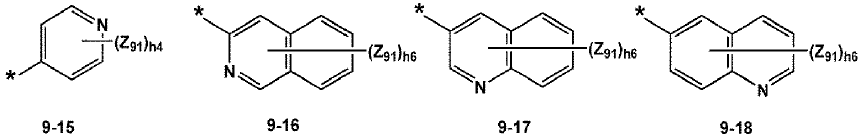 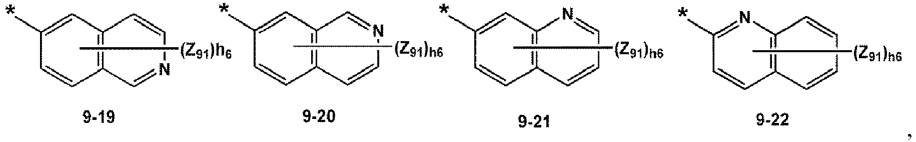 dans lequel, dans les Formules 9-1 à 9-22,
X₉₁ est sélectionné parmi O, S, C(Z₉₅)(Z₉₆), N(Z₉₇) et Si(Z₉₈)(Z₉₉),
Z₉₁ à Z₉₉ sont sélectionnés chacun indépendamment parmi :
hydrogène, deutérium, -F, -Cl, -Br, -I, un groupe hydroxyle, un groupe cyano, un groupe nitro, un groupe amino, un groupe amidino, un groupe hydrazino, un groupe hydrazono, un groupe alkyle en C₁-C₂₀, un groupe alcoxy en C₁-C₂₀, un groupe phényle, un groupe biphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, un groupe imidazopyridinyle et un groupe imidazopyrimidinyle,
h3 est un entier de 0 à 3
h4 est un entier de 0 à 4
h5 est un entier de 0 à 5
h6 est un entier de 0 à 6
h7 est un entier de 0 à 7,
h9 est un entier de 0 à 9, et
^{∗} et ^{∗}' indiquent chacun un site de liaison à un atome voisin.

7. Dispositif organique électroluminescent selon l'une quelconque des revendications 1 à 6,
dans lequel, dans la Formule 1,
^{∗}-(L₁₁)ₐ₁₁-^{∗}' et ^{∗}-(L₁₂)ₐ₁₂-^{∗}' sont chacun une liaison simple,
^{∗}-(L₁₂)ₐ₁₂-^{∗}' est une liaison simple, ou
^{∗}-(L₁₂)ₐ₁₂-^{∗}' et ^{∗}-(L₁₃)ₐ₁₃-^{∗}' sont chacun une liaison simple.

8. Dispositif organique électroluminescent selon l'une quelconque des revendications 1 à 7, dans lequel la Formule 1 est représentée par la Formule 1-1 ou la Formule 1-2 : 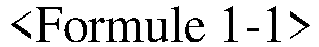 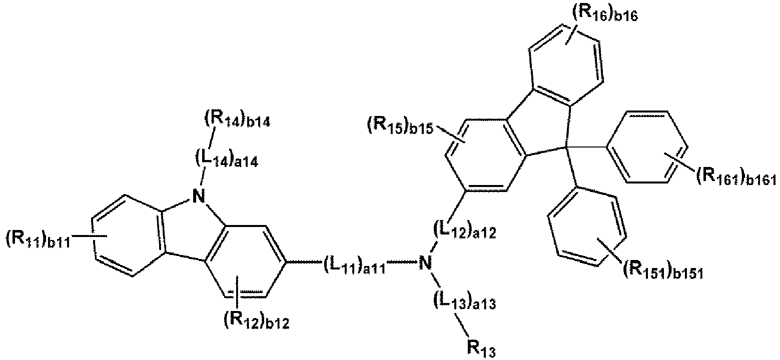 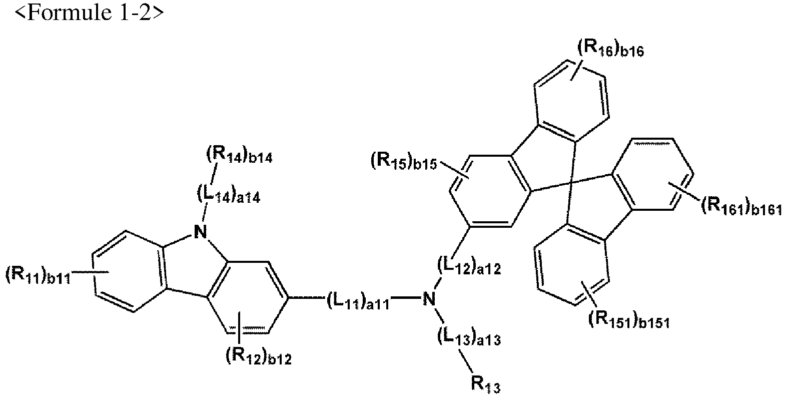 dans lequel, dans les Formules 1-1 et 1-2,
L₁₁ à L₁₃, a11 à a13, R₁₁ à R₁₆, b11, b12, b14, b15 et b16 sont respectivement les mêmes que définis dans la revendication 1,
R₁₅₁ et R₁₆₁ sont définis respectivement de la même manière que R₁₅ et R₁₆ dans la revendication 1, et
b151 et b161 sont définis respectivement de la même manière que b15 et b16 dans la revendication 1.

9. Dispositif organique électroluminescent selon l'une quelconque des revendications 1 à 8, dans lequel, dans la Formule 2,
A₂₁ et A₂₂ sont chacun indépendamment un groupe benzène ou un groupe naphtalène.

10. Dispositif organique électroluminescent selon l'une quelconque des revendications 1 à 9, dans lequel la Formule 2 est représentée par l'une sélectionnée parmi les Formules 2-1 à 2-7 : 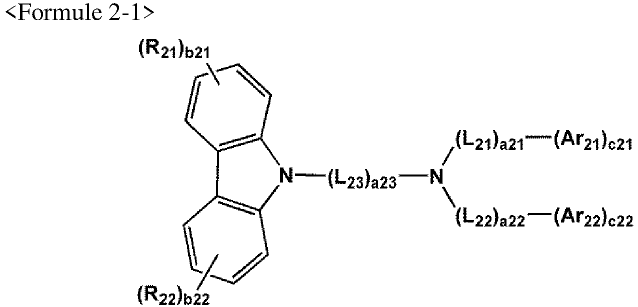 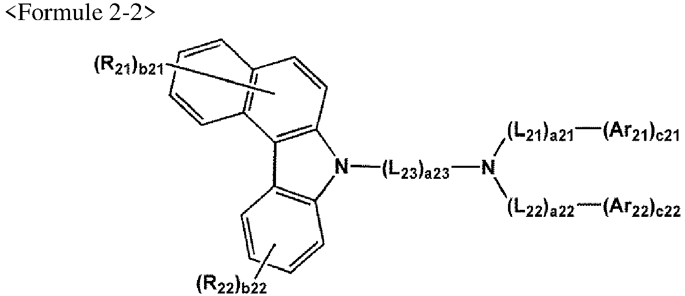 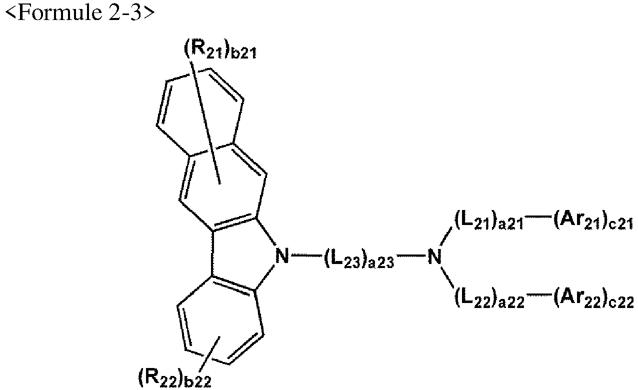 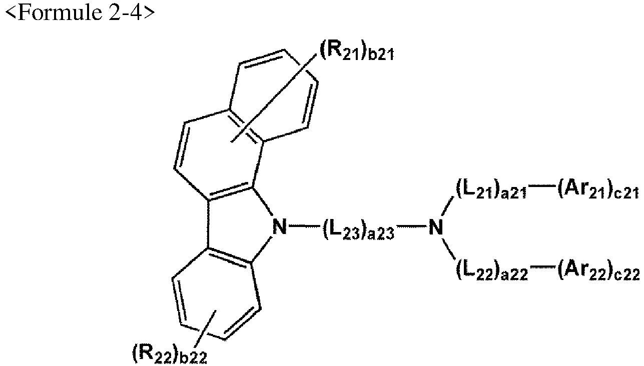 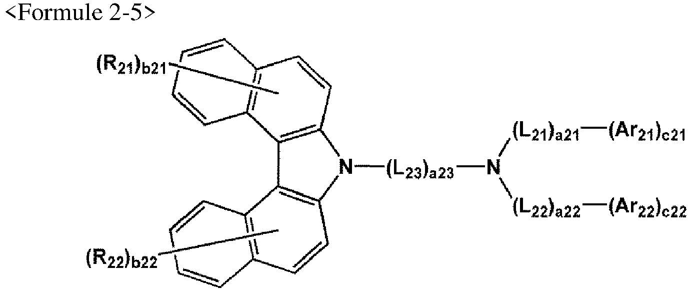 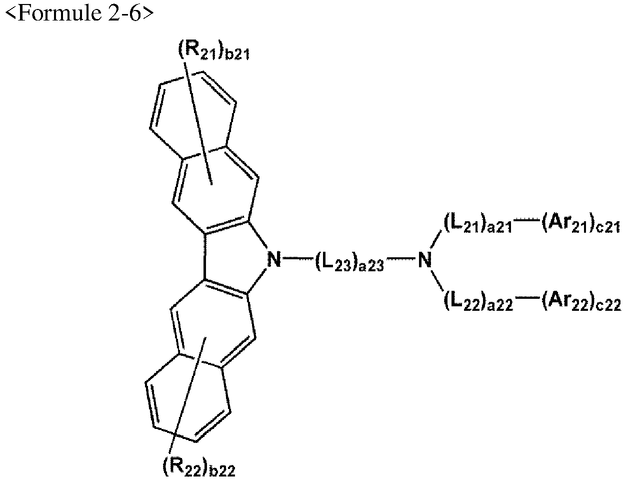 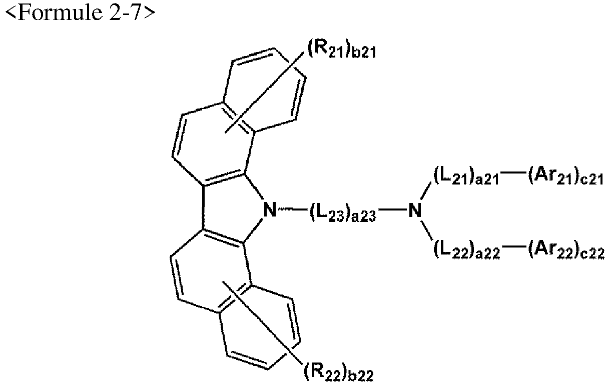 dans lequel, dans les Formules 2-1 à 2-7,
L₂₁ à L₂₃, a21 à a23, R₂₁, R₂₂, b21, b22, Ar₂₁, Ar₂₂, c21 et c22 sont respectivement les mêmes que définis dans la revendication 1.

11. Dispositif organique électroluminescent selon l'une quelconque des revendications 1 à 10, dans lequel :
une fraction représentée par 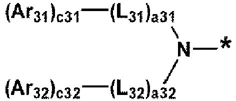 et une fraction représentée par 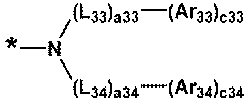 dans la Formule 3 sont identiques l'une à l'autre.

12. Dispositif organique électroluminescent selon l'une quelconque des revendications 1 à 11, dans lequel la Formule 4 est représentée par l'une sélectionnée parmi les Formules 4-1 à 4-4 ; 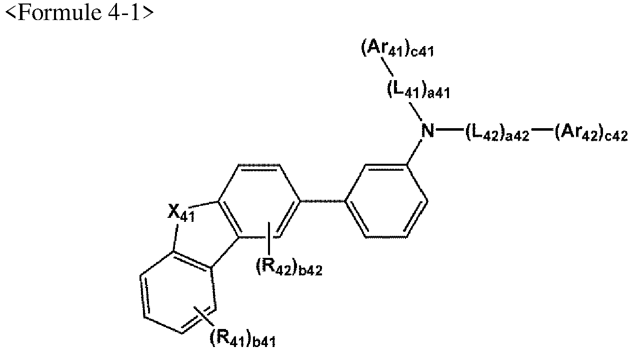 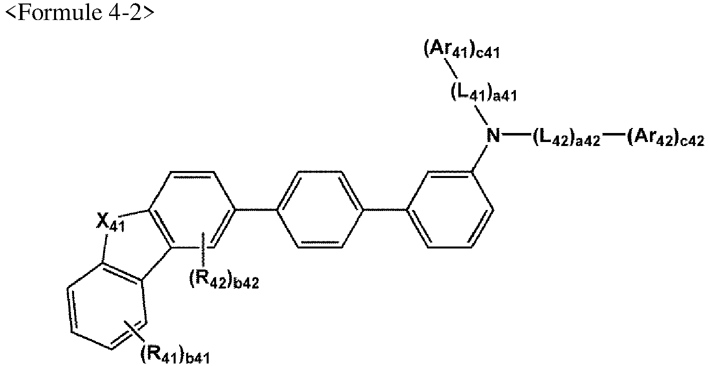 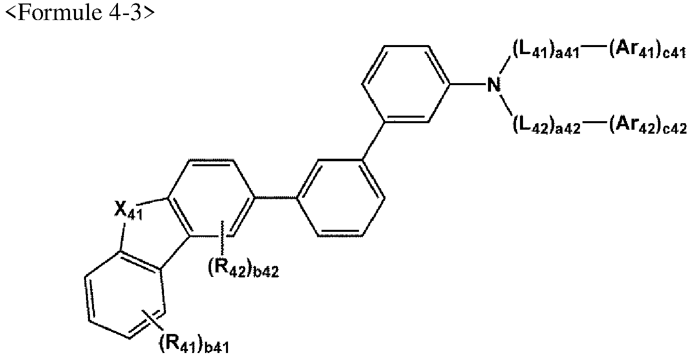 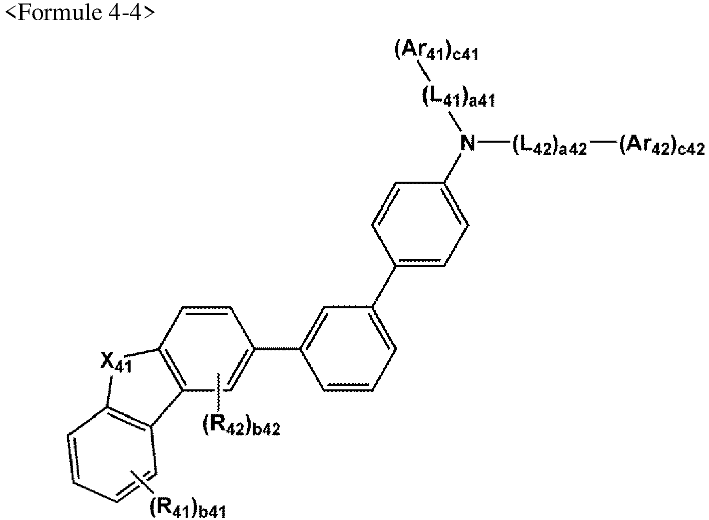 dans lequel, dans les Formules 4-1 à 4-4,
X₄₁, L₄₁, L₄₂, a41, a42, R₄₁, R₄₂, b41, b42, Ar₄₁, Ar₄₂, c41 et c42 sont respectivement les mêmes que définis dans la revendication 1.

13. Dispositif organique électroluminescent selon l'une quelconque des revendications 1 à 12, dans lequel la Formule 5 est représentée par l'une sélectionnée parmi les Formules 5-1 à 5-3 : 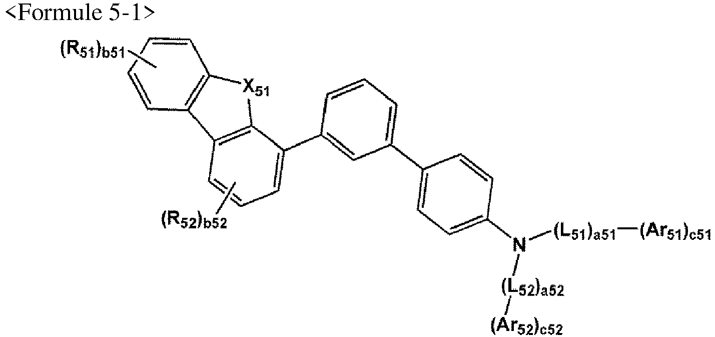 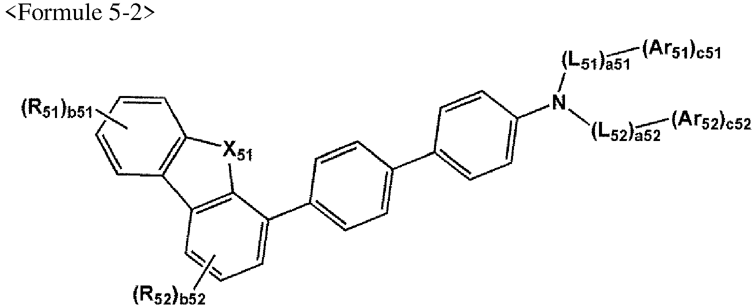 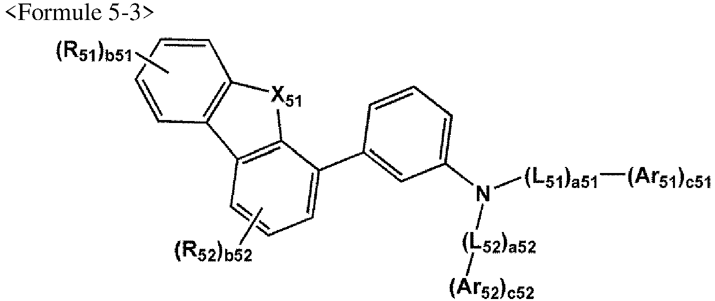 dans lequel, dans les Formules 5-1 à 5-3,
X₅₁, L₅₁, L₅₂, a51, a52, R₅₁, R₅₂, b51, b52, Ar₅₁, Ar₅₂, c51 et c52 sont respectivement les mêmes que définis dans la revendication 1.

14. Dispositif organique électroluminescent selon l'une quelconque des revendications 1 à 13, dans lequel la Formule 6 est représentée par l'une sélectionnée parmi les Formules 6-1 à 6-4 : 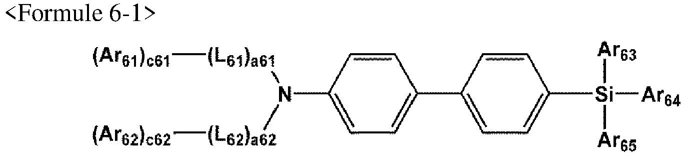 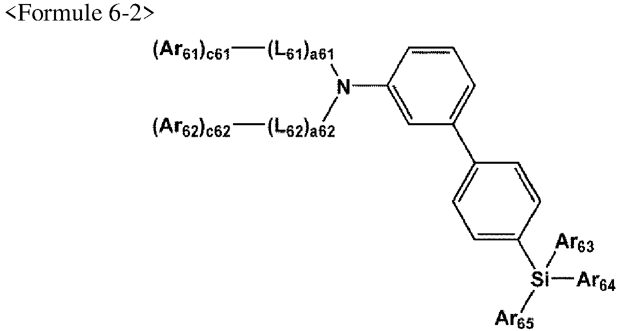 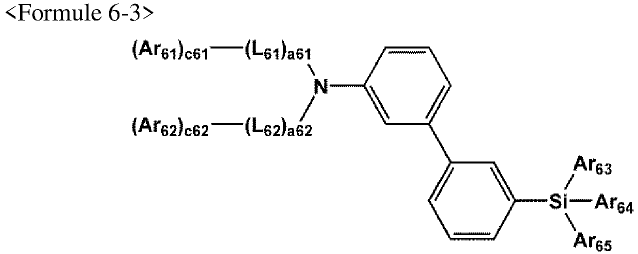 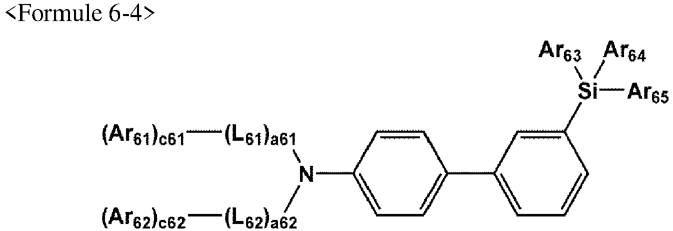 dans lequel, dans les Formules 6-1 à 6-4,
L₆₁, L₆₂, a61, a62, Ar₆₁ à Ar65, c61 et c62 sont respectivement les mêmes que définis dans la revendication 1.

15. Dispositif organique électroluminescent selon l'une quelconque des revendications 1 à 14, dans lequel :
le au moins un composé des composés représentés par la Formule 1 est sélectionné parmi les Composés 1-1 à 1-63, et
le au moins un composé des composés représentés par les Formules 2 à 6 est sélectionné parmi les Composés 2-1 à 2-27, les Composés 3-1 à 3-18, les Composés 4-1 à 4-15, les Composés 5-1 à 5-19 et les Composés 6-1 à 6-18 :

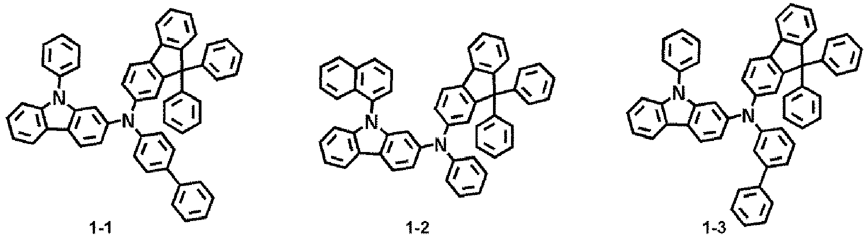

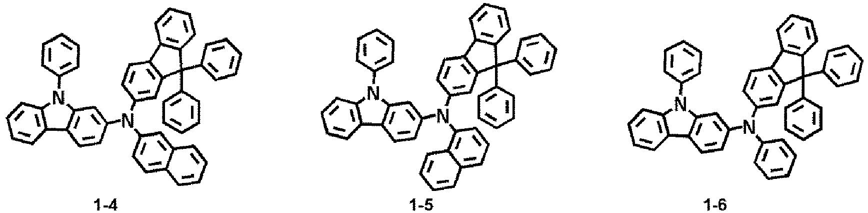

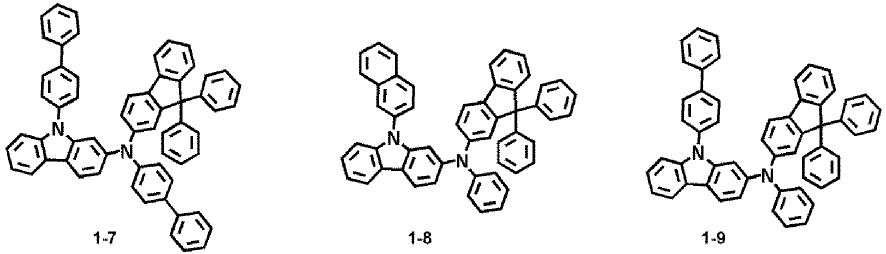

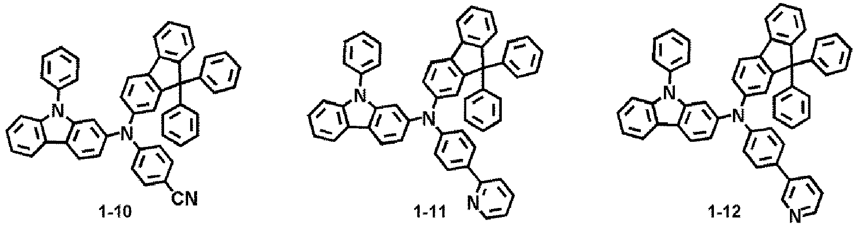

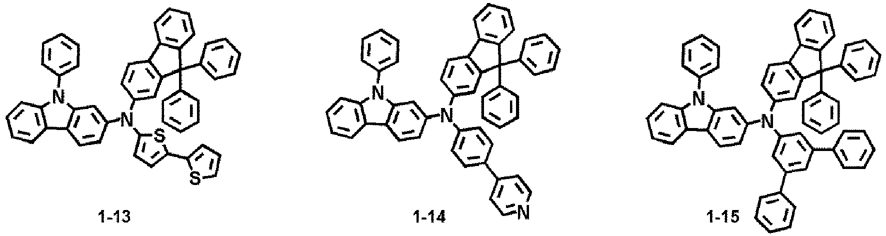

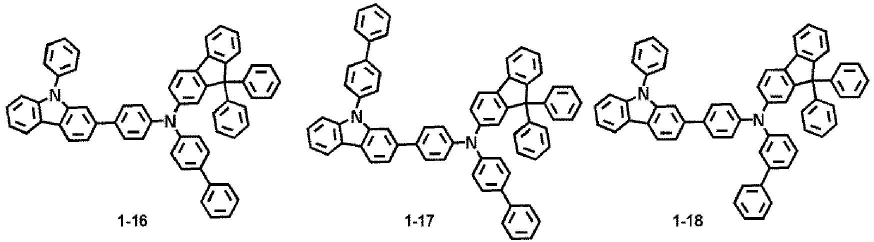

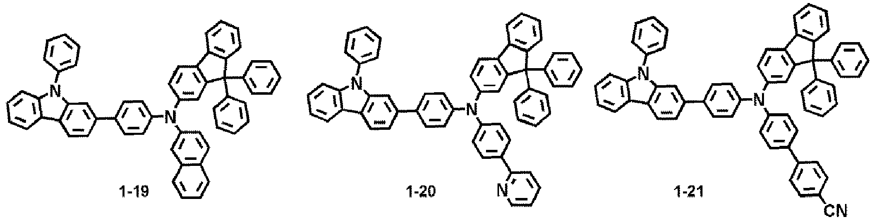

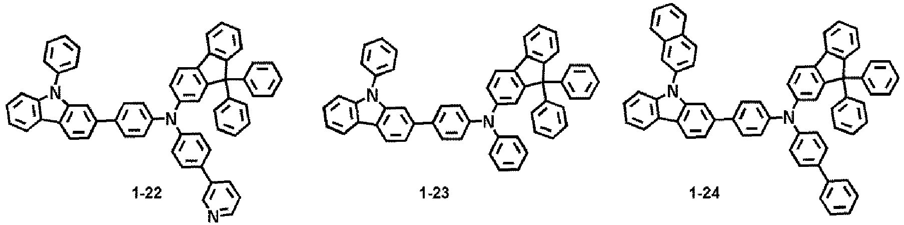

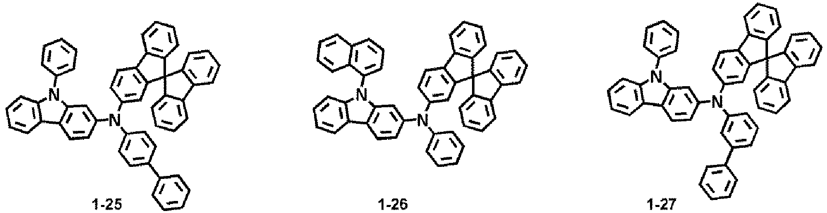

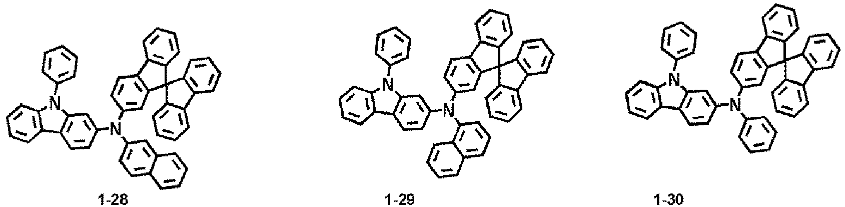

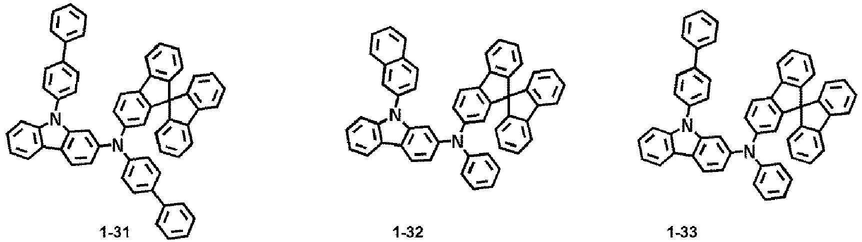

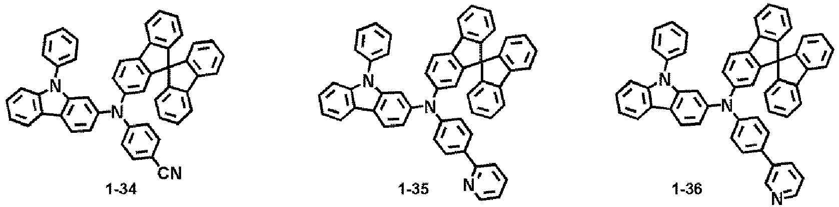

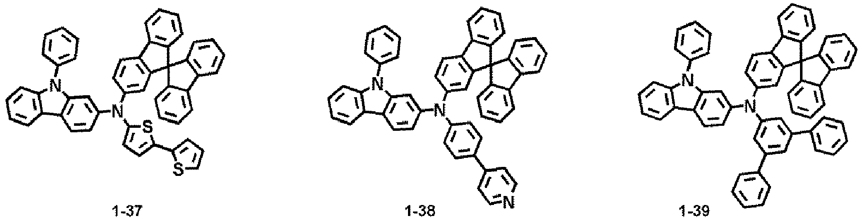

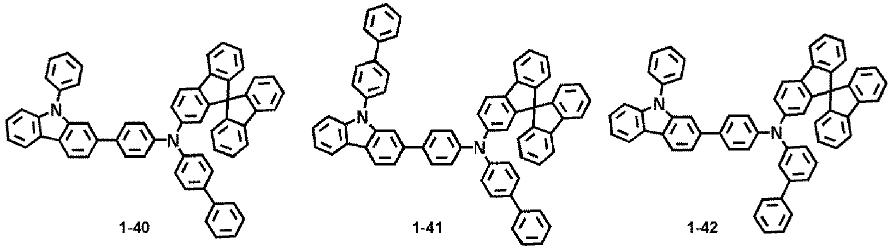

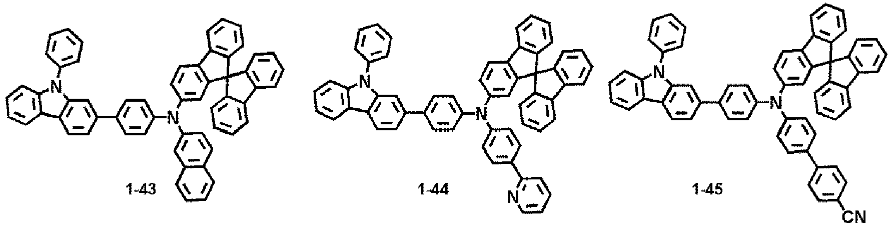

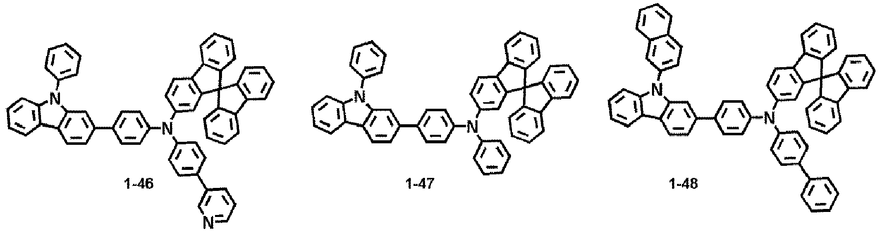

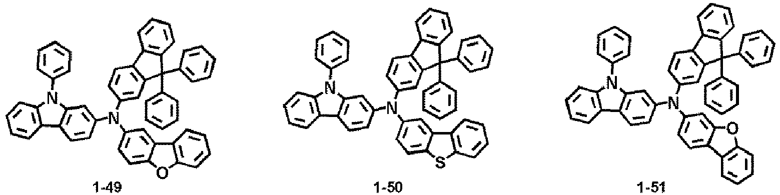

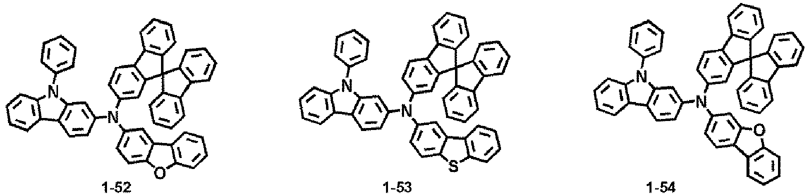

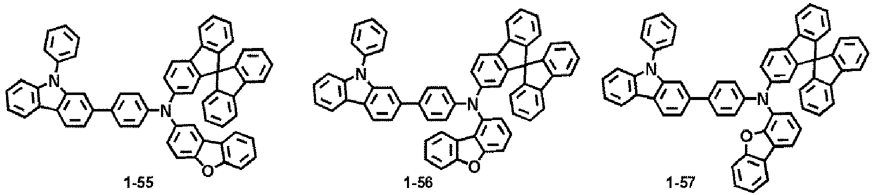

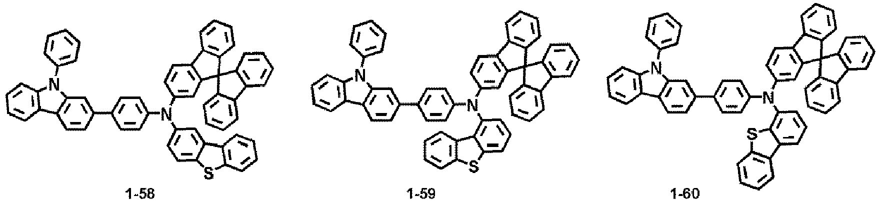

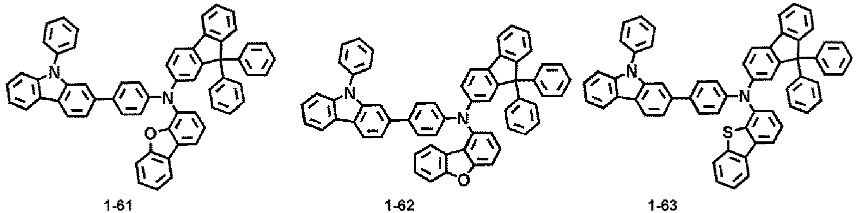

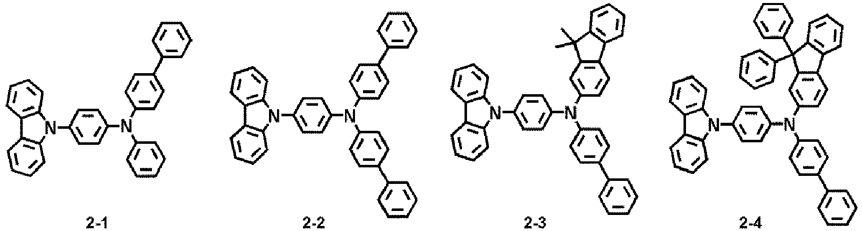

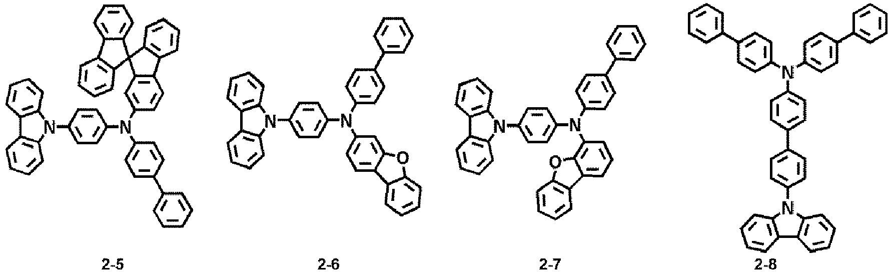

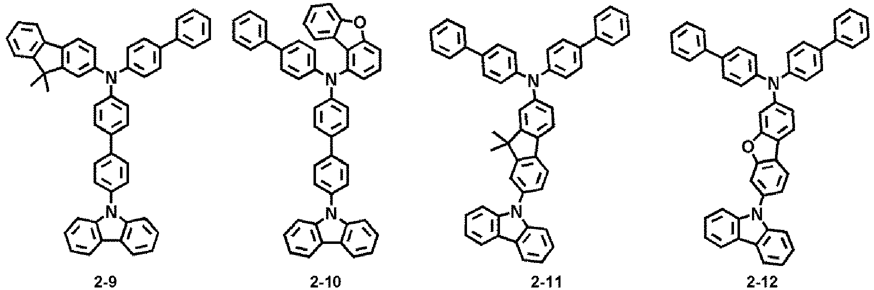

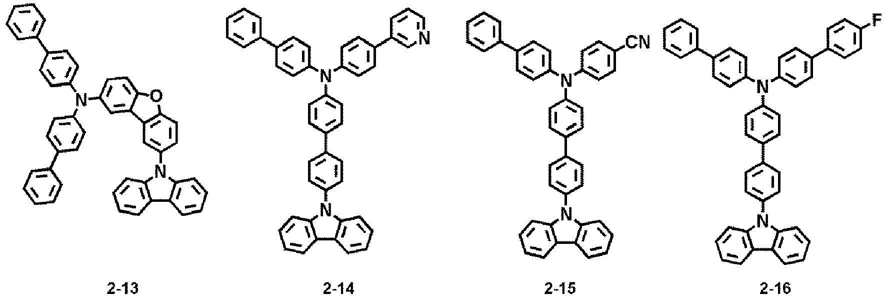

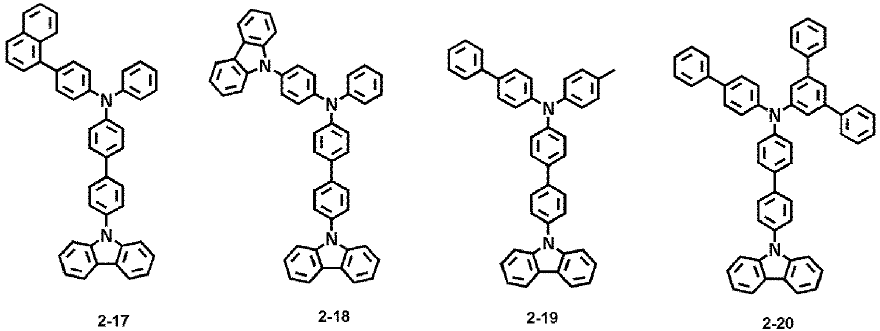

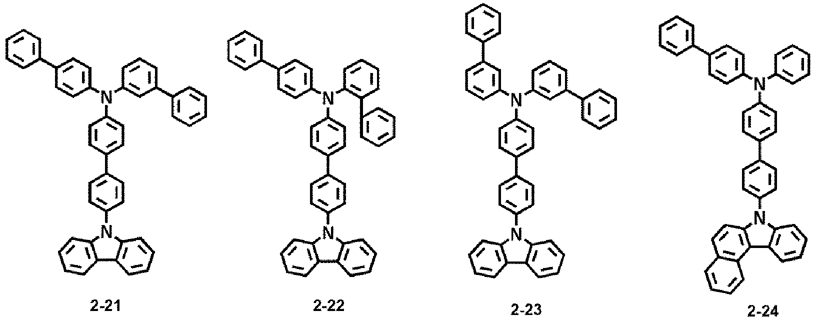

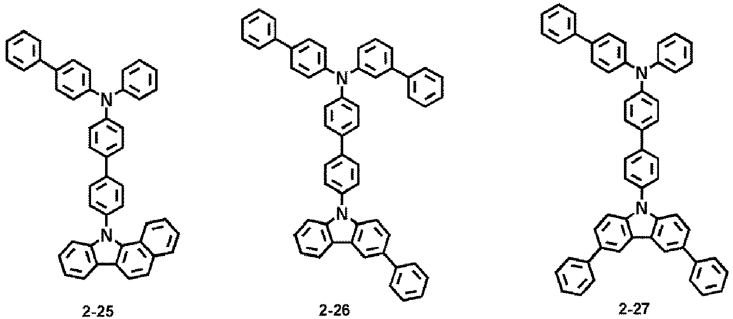

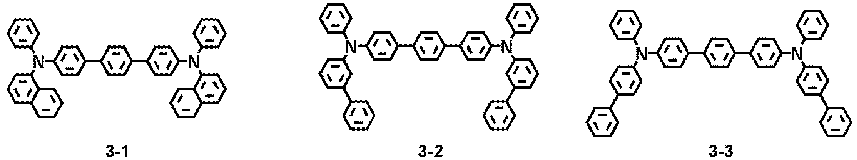

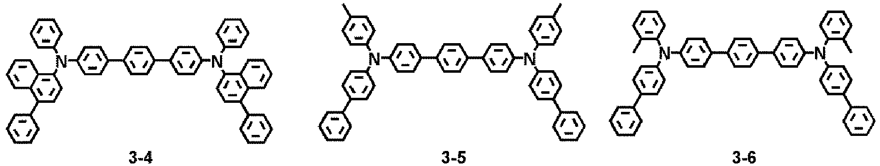

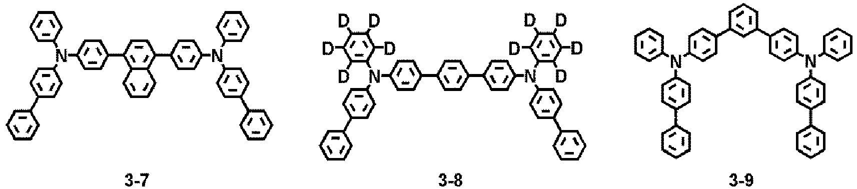

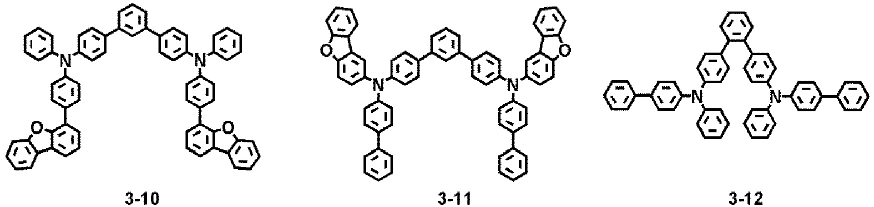

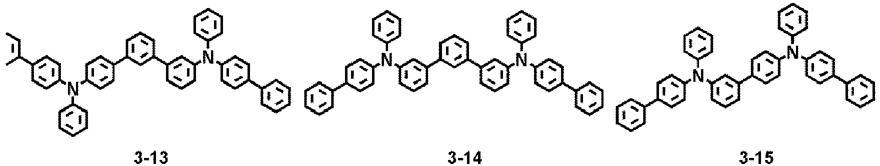

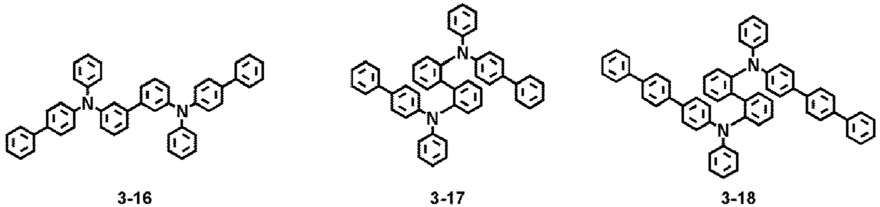

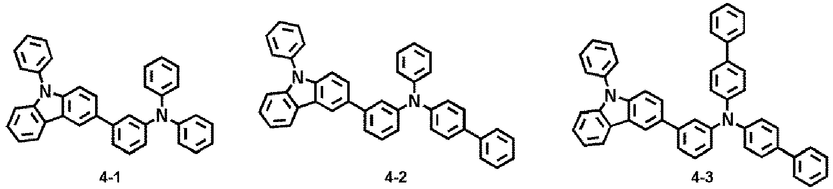

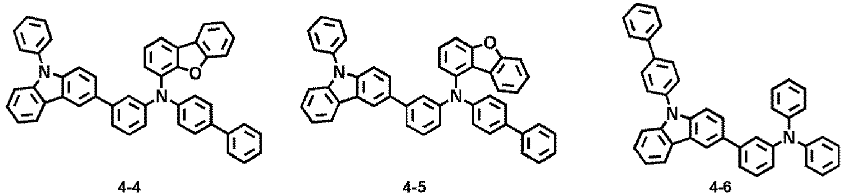

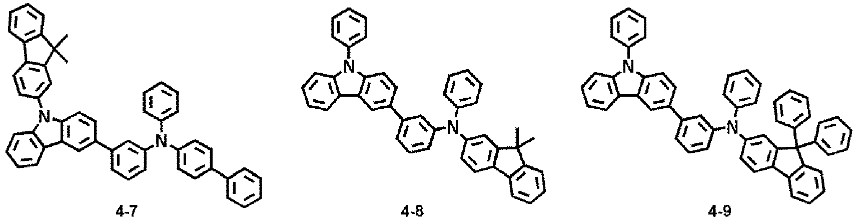

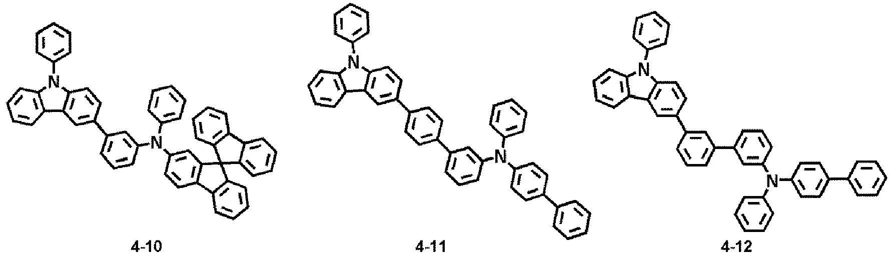

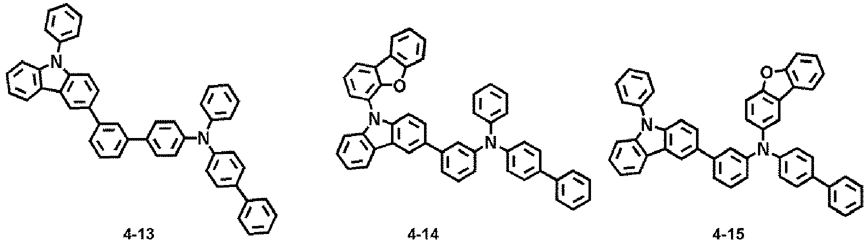

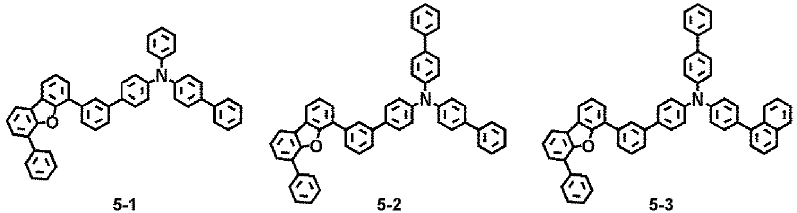

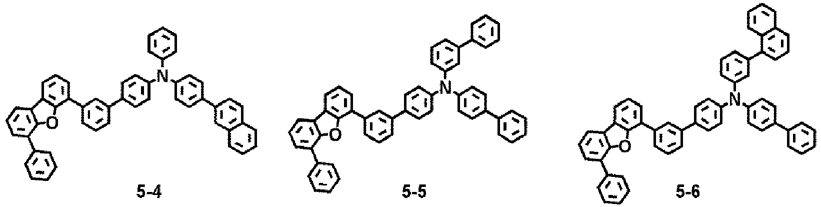

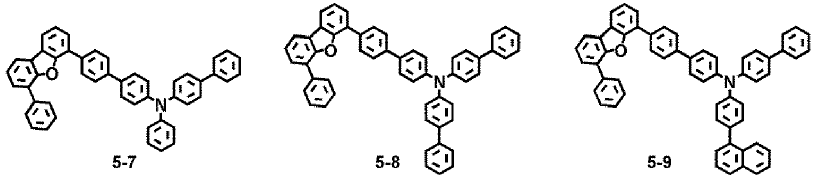

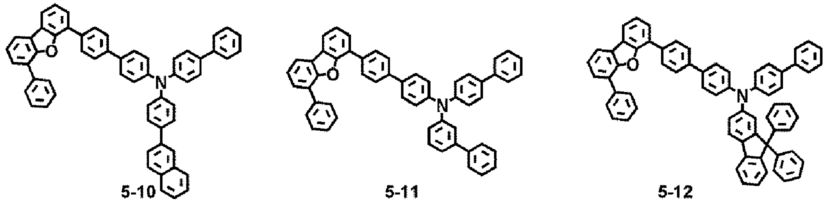

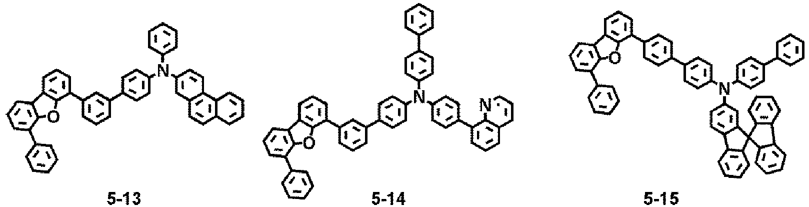

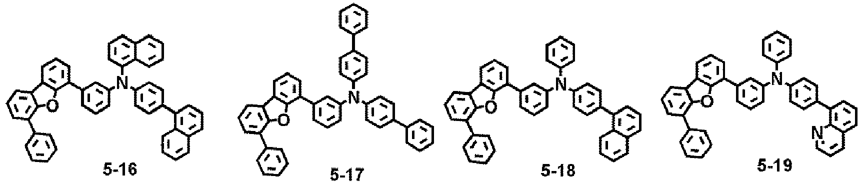

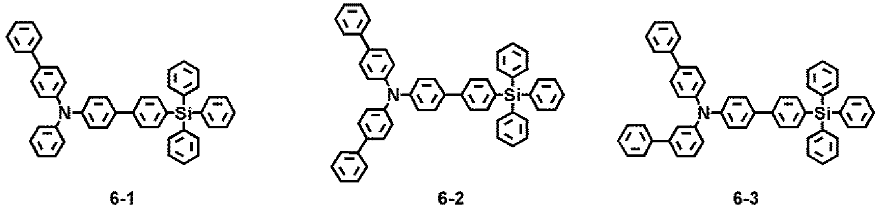

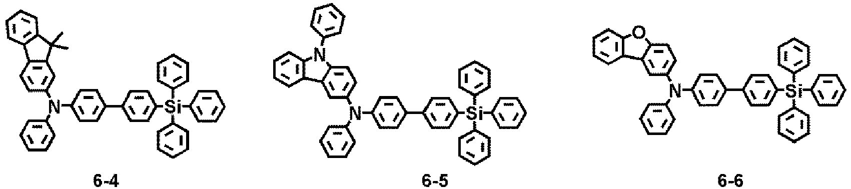

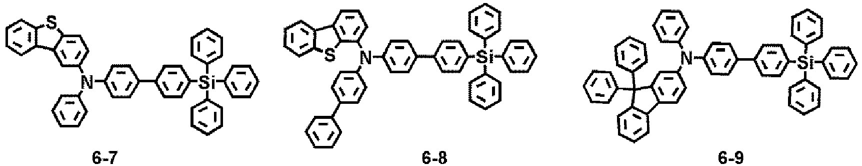

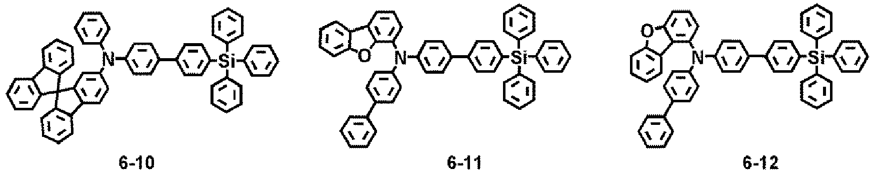

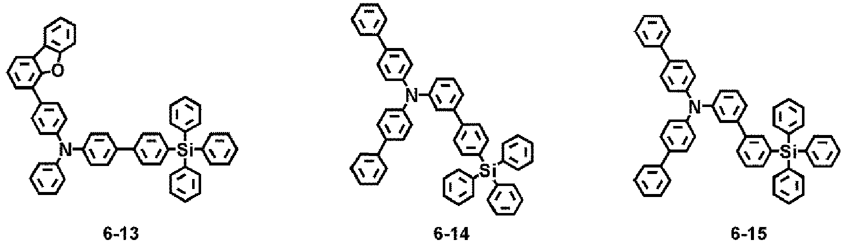

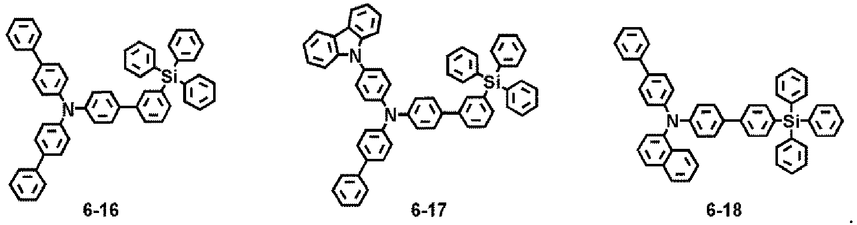

16. Dispositif organique électroluminescent selon l'une quelconque des revendications 1 à 15, où le dispositif comprend en outre :
un substrat divisé en une première région de sous-pixels, une deuxième région de sous-pixels et une troisième région de sous-pixels ; et
une pluralité de premières électrodes disposées dans la première région de sous-pixels, la deuxième région de sous-pixels et la troisième région de sous-pixels du substrat, respectivement ;
dans lequel la deuxième électrode fait face à la pluralité de premières électrodes ;
la couche organique est disposée entre la pluralité de premières électrodes et la deuxième électrode
la région de transport de trous est disposée entre la pluralité de premières électrodes ; et
la première couche de la région de transport de trous est disposée entre la deuxième couche et la pluralité de premières électrodes.
